# EUROPEAN PATENT SPECIFICATION

(11) **EP 3 010 066 B1**
(45) Date of publication and mention of the grant of the patent: **27.02.2019**
(21) Application number: 15190327.5
(22) Date of filing: 19.10.2015
(51) Int. Cl.: H01L 51/54

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 17.10.2014 KR 20140141197
(43) Date of publication of application: 20.04.2016
(73) Proprietor: Samsung Display Co., Ltd., Gyeonggi-do 17113 (KR)
(72) Inventor: CHO, Hwan-Hee, Yongin-si, Gyeonggi-do (KR); KIM, Myeong-Suk, Yongin-si, Gyeonggi-do (KR); KIM, Sung-Wook, Yongin-si, Gyeonggi-do (KR); CHU, Chang-Woong, Yongin-si, Gyeonggi-do (KR); KIM, Youn-Sun, Yongin-si, Gyeonggi-do (KR); ITO, Naoyuki, Yongin-si, Gyeonggi-do (KR)
(74) Representative: Gulde & Partner

(56) References cited:
- WO-A1-2014/007564
- WO-A1-2014/007565
- US-A1- 2014 197 386

## Description

### BACKGROUND

Organic light emitting devices are self-emission devices that have wide viewing angles, high contrast ratios, short response times, and excellent brightness, driving voltage, and response speed characteristics, and produce full-color images.

An organic light-emitting device may include a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons change from an excited state to a ground state, thereby generating light.

WO 2014/007565 A1 and WO 2014/007564 A1 each disclose an OLED comprising a first electrode, a second electrode facing the first electrode, an emission layer disposed between said electrodes, a hole transport region disposed between the first electrode and the emission layer, and a second hole transport layer. The hole transport region comprises a compound falling under below mentioned Formula 2.

US 2014/197386 A1 discloses another exemplary embodiment of an OLED device including organometallic compounds in an emission layer.

### SUMMARY

One or more exemplary embodiments include an organic light-emitting device.

Additional aspects will be set forth in part in the description which follows and, in part, will be apparent from the description, or may be learned by practice of the presented exemplary embodiments.

According to the present invention, there is provided an organic light-emitting device as defined in claim 1.

### BRIEF DESCRIPTION OF THE DRAWINGS

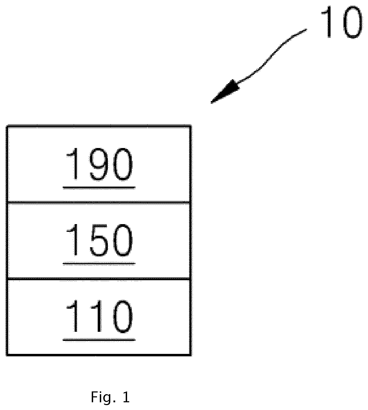

These and/or other aspects will become apparent and more readily appreciated from the following description of the exemplary embodiments, taken in conjunction with FIG. 1 that is a schematic cross-sectional view of an organic light-emitting device according to an embodiment.

### DETAILED DESCRIPTION

Reference will now be made in detail to exemplary embodiments, examples of which are illustrated in the accompanying drawings, wherein like reference numerals refer to like elements throughout.

Hereinafter, embodiments are described in detail by referring to the attached drawings, and in the drawings, like reference numerals denote like elements, and a redundant explanation thereof will not be provided herein.

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "on" or "onto" another layer, region, or component, it may be directly or indirectly formed on the other layer, region, or component. That is, for example, intervening layers, regions, or components may be present.

Sizes of components in the drawings may be exaggerated for convenience of explanation. In other words, since sizes and thicknesses of components in the drawings are arbitrarily illustrated for convenience of explanation, the following embodiments are not limited thereto.

A first electrode may be an anode, which is a hole injection electrode, and a second electrode may be a cathode, which is an electron injection electrode. In some embodiments, the first electrode may be a cathode, which is an electron injection electrode, or the second electrode may be an anode, which is a hole injection electrode.

The term "organic layer" used herein refers to a single layer and/or a plurality of layers disposed between the first electrode and the second electrode of an organic light-emitting device. A material included in the "organic layer" is not limited to an organic material.

FIG. 1 is a schematic view of an organic light-emitting device 10 according to an embodiment. The organic light-emitting device 10 includes a first electrode 110, an organic layer 150, and a second electrode 190.

Hereinafter, the structure of an organic light-emitting device according to an embodiment and a method of manufacturing an organic light-emitting device according to an embodiment will be described in connection with FIG. 1.

In FIG. 1, a substrate may be additionally disposed under the first electrode 110 or above the second electrode 190. The substrate may be a glass substrate or transparent plastic substrate, each with excellent mechanical strength, thermal stability, transparency, surface smoothness, ease of handling, and water-resistance.

The first electrode 110 may be formed by depositing or sputtering a material for forming a first electrode on the substrate. When the first electrode 110 is an anode, the material for the first electrode 110 may be selected from materials with a high work function to facilitate hole injection. The first electrode 110 may be a reflective electrode or a transmissive electrode. The material for the first electrode 110 may be a transparent and highly conductive material, and examples of such a material are indium tin oxide (ITO), indium zinc oxide (IZO), tin oxide (SnO₂), and zinc oxide (ZnO). When the first electrode 110 is a semi-transmissive electrode or a reflective electrode, as a material for forming the first electrode 110, at least one of magnesium (Mg), aluminum(AI), aluminum-lithium(AI-Li), calcium (Ca), magnesium-indium(Mg-In), magnesium-silver (Mg-Ag) may be used.

The first electrode 110 may have a single-layer structure, or a multi-layer structure including two or more layers. For example, the first electrode 110 may have a three-layered structure of ITO/Ag/ITO, but the structure of the first electrode 110 is not limited thereto.

The organic layer 150 is disposed on the first electrode 110. The organic layer 150 may include an emission layer.

The organic layer 150 comprises a hole transport region disposed between the first electrode 110 and the emission layer. The organic layer 150 may further include an electron transport region disposed between the emission layer and the second electrode 190.

The hole transport region comprises an amine-based compound represented by Formula 2:

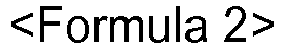

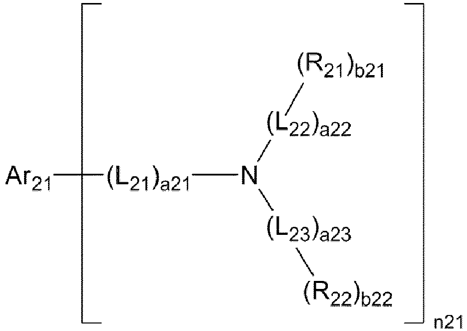

In Formula 2,
Ar₂₁ is represented by one of Formulae 8-1 and 8-2:

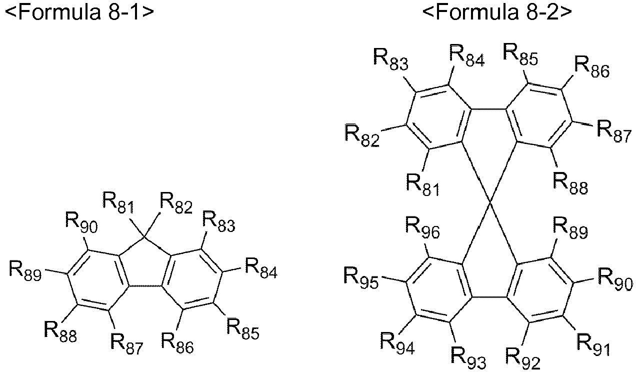

Descriptions of substituents in Formulae 8-1 and 8-2 will be provided below.
L₂₁ to L₂₃ in Formula 2 may be each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group; and at least one of substituents of the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed polycyclic group, and substituted divalent non-aromatic condensed heteropolycyclic group is selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and -N(Q₃₁)(Q₃₂), -Si(Q₃₃)(Q₃₄)(Q₃₅), and -B(Q₃₆)(Q₃₇),
wherein Q₁₁ to Q₁₇, Q₂₁ to Q₂₇, and Q₃₁ to Q₃₇ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, L₂₁ to L₂₃ in Formula 2 may be each independently selected from a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, an triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group, but they are not limited thereto.

In some embodiments, L₂₁ to L₂₃ in Formula 2 may be each independently selected from a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a naphthyridinylene group, a quinoxalinylene group, a quinazolinylene group, a cinnolinylene group, a carbazolylene group, a phenanthridinylene group, a benzimidazolylene group, a benzofuranylene group, a benzothiophenylene group, a triazolylene group, a dibenzofuranylene group, and a dibenzothiophenylene group; and
a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a naphthyridinylene group, a quinoxalinylene group, a quinazolinylene group, a cinnolinylene group, a carbazolylene group, a phenanthridinylene group, a benzimidazolylene group, a benzofuranylene group, a benzothiophenylene group, a triazolylene group, a dibenzofuranylene group, and a dibenzothiophenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, but they are not limited thereto.

In some embodiments, L₂₁ to L₂₃ in Formula 2 may be each independently represented by one of Formulae 3-1 to 3-21, but they are not limited thereto:

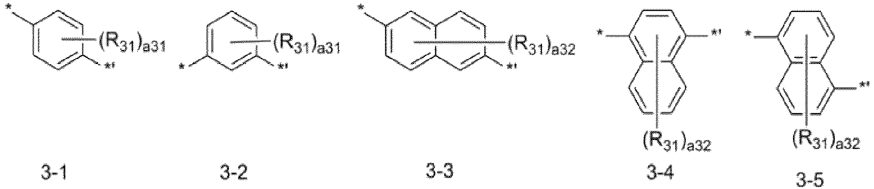

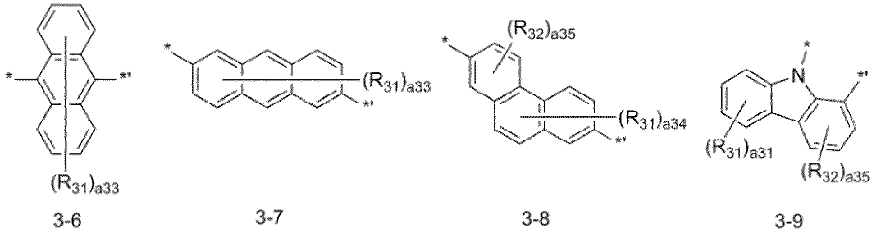

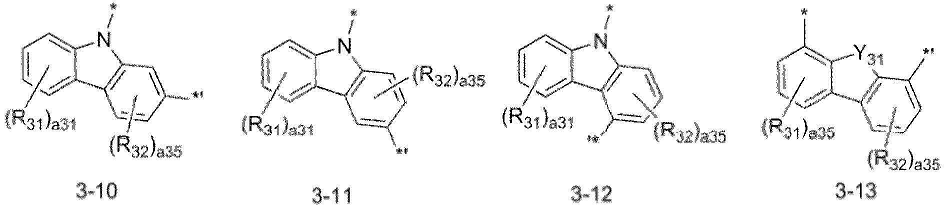

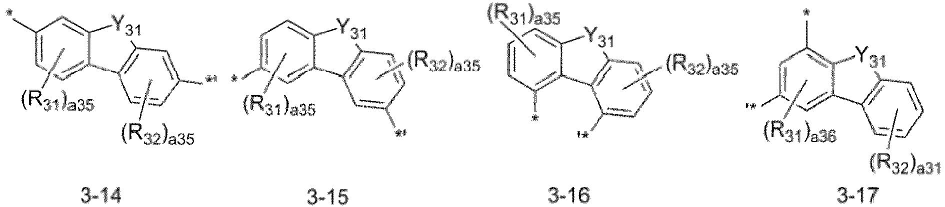

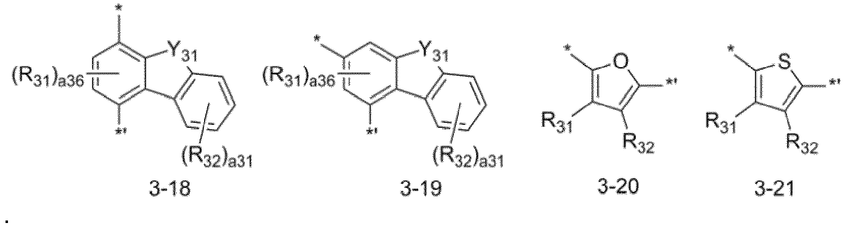

In Formulae 3-1 to 3-21,
Y₃₁ is selected from C(R₃₃)(R₃₄), N(R₃₃), O, S, and Si(R₃₃)(R₃₄);
R₃₁ to R₃₄ may be each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁ to C₂₀ alkyl group, a C₁ to C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
a31 may be selected from 1, 2, 3, and 4; and
a32 may be selected from 1, 2, 3, 4, 5, and 6;
a33 may be selected from 1, 2, 3, 4, 5, 6, 7, and 8;
a34 may be selected from 1, 2, 3, 4, and 5;
a35 may be selected from 1, 2, and 3;
a36 may be selected from 1 and 2; and
each of * and *' indicates a binding site to a neighboring atom.

In some embodiments, L₂₁ to L₂₃ in Formula 2 may be each independently represented by one of Formulae 4-1 to 4-42, but they are not limited thereto:

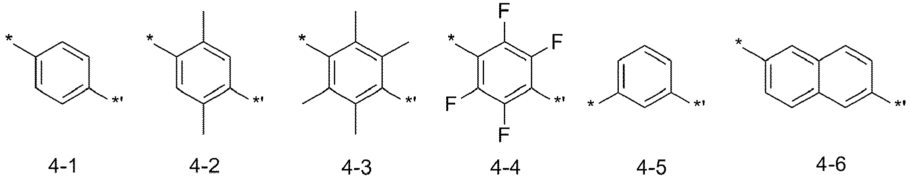

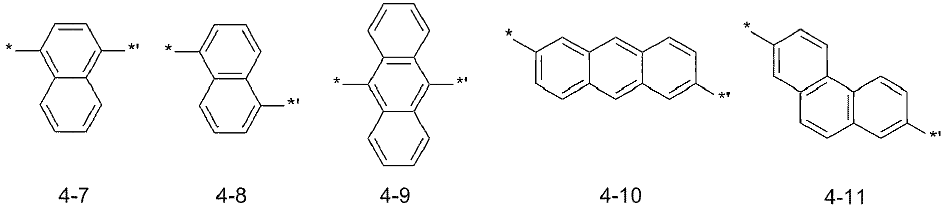

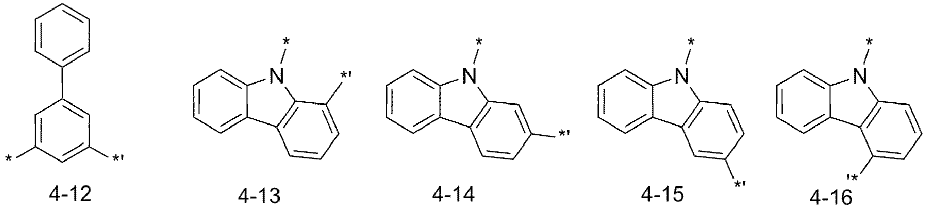

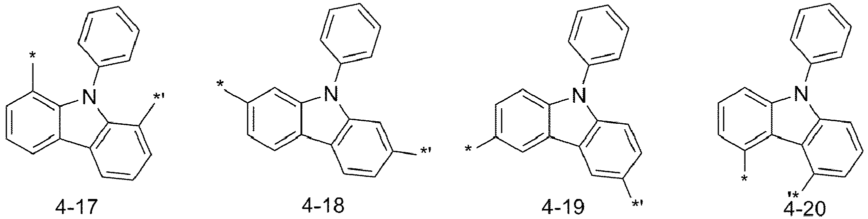

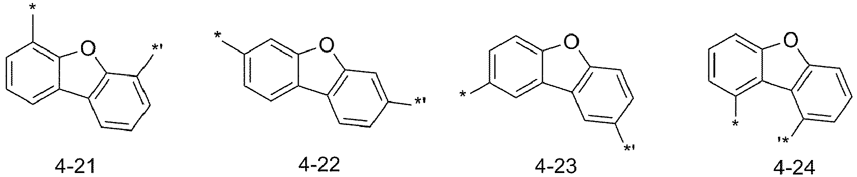

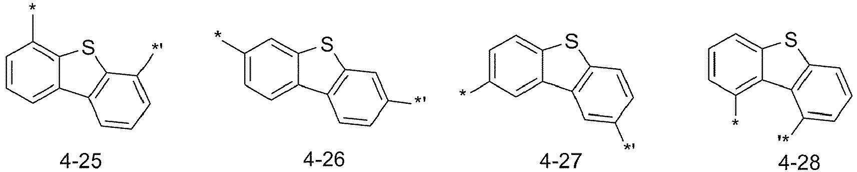

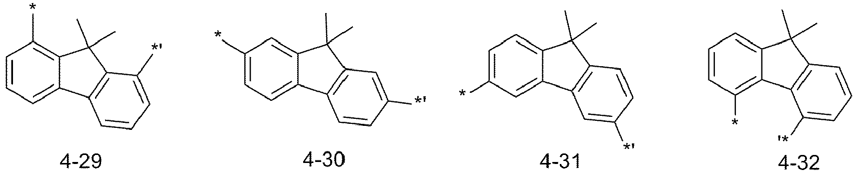

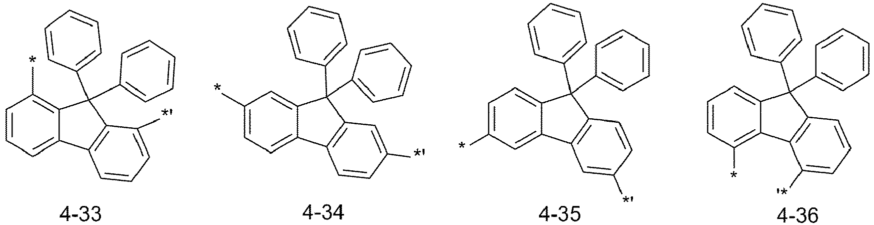

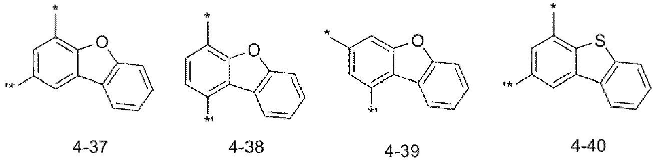

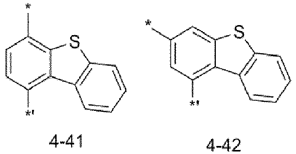

In Formulae 4-1 to 4-42,
each of * and *' indicates a binding site to a neighboring atom; and
a21 in Formula 2 indicates the number of L₂₁(s), and a21 may be selected from 0, 1, 2, and 3. When a21 is 0, (L₂₁)ₐ₂₁ indicates a single bond, and when a21 is 2 or more, a plurality of L₂₁(s) may be identical to or different from each other. For example, a21 may be selected from 0 and 1, but is not limited thereto. a22 and a23 may be understood by referring to the descriptions of a21 and the structure of Formula 2.
a22 and a23 in Formula 2 may be each independently selected from 0, 1, 2, and 3. For example, a22 and a23 may be each independently selected from 0 and 1, but they are not limited thereto.
R₂₁ and R₂₂ in Formula 2 may be each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; and
at least one of substituents of the substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₁-C₆₀ heteroaryl group, substituted monovalent non-aromatic condensed polycyclic group, and substituted monovalent non-aromatic condensed heteropolycyclic group may be selected from
deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and -N(Q₃₁)(Q₃₂), -Si(Q₃₃)(Q₃₄)(Q₃₅), and -B(Q₃₆)(Q₃₇);
wherein Q₁₁ to Q₁₇, Q₂₁ to Q₂₇, and Q₃₁ to Q₃₇ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, R₂₁ and R₂₂ in Formula 2 may be each independently selected from a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxaliny group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, a thiadiazolyl group, an imidazopyridinyl group, and an imidazopyrimidinyl group; and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxaliny group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, a thiadiazolyl group, an imidazopyridinyl group, and an imidazopyrimidinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a biphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxaliny group, a quinazolinyl group, a benzoquinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, and an imidazopyrimidinyl group, but they are not limited thereto.

In some embodiments, R₂₁ and R₂₂ in Formula 2 may be each independently selected from a phenyl group, a naphthyl group, a fluorenyl group, a spiro-fluorenyl group, a benzofluorenyl group, a dibenzofluorenyl group, a phenanthrenyl group, a pyridinyl group, a pyrazinyl group, a pyrimidinyl group, a quinolinyl group, an isoquinolinyl group, a naphthyridinyl group, a quinoxalinyl group, a quinazolinyl group, a cinnolinyl group, a triazinyl group, a dibenzofuranyl group, and a dibenzothiophenyl group; and
a phenyl group, a naphthyl group, a fluorenyl group, a spiro-fluorenyl group, a benzofluorenyl group, a dibenzofluorenyl group, a phenanthrenyl group, a pyridinyl group, a pyrazinyl group, a pyrimidinyl group, a quinolinyl group, an isoquinolinyl group, a naphthyridinyl group, a quinoxalinyl group, a quinazolinyl group, a cinnolinyl group, a triazinyl group, a dibenzofuranyl group, and a dibenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, but they are not limited thereto.

In some embodiments, R₂₁ and R₂₂ in Formula 2 may be each independently selected from ligands represented by Formulae 5-1 to 5-14, but they are not limited thereto:

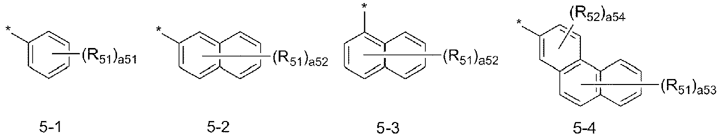

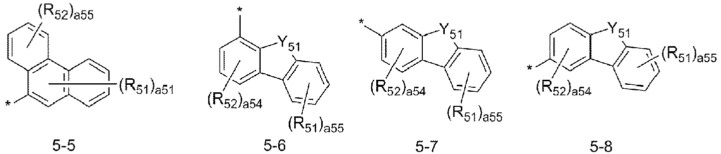

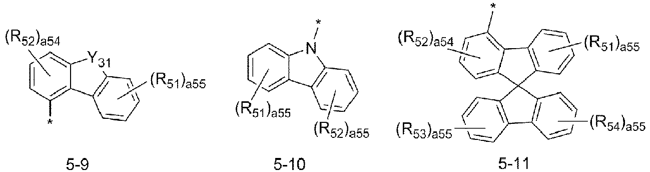

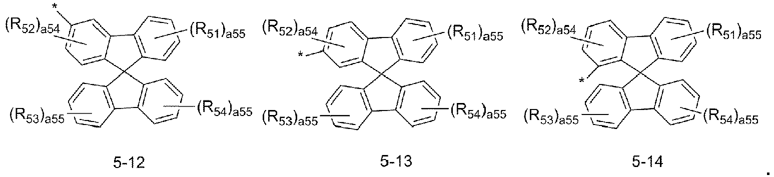

In Formulae 5-1 to 5-14,
Y₅₁ is selected from C(R₅₃)(R₅₄), N(R₅₃), O, and S;
R₅₁ to R₅₄ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, -CD₃, -CF₃, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
a51 may be selected from 1, 2, 3, 4, and 5;
a52 may be selected from 1, 2, 3, 4, 5, 6, and 7;
a53 may be selected from 1, 2, 3, 4, 5, and 6;
a54 may be selected from 1, 2, and 3;
a55 may be selected from 1, 2, 3, and 4; and
* indicates a binding site to a neighboring site.

In some embodiments, R₂₁ and R₂₂ in Formula 2 may be each independently selected from groups represented by one of Formulae 6-1 to 6-55, but they are not limited thereto:

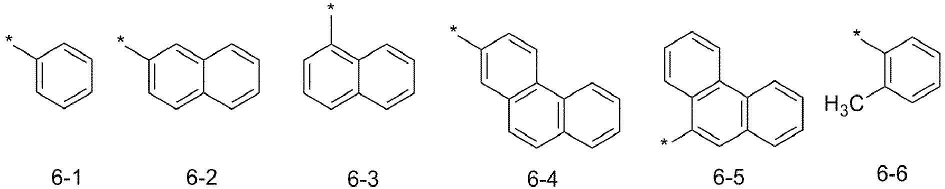

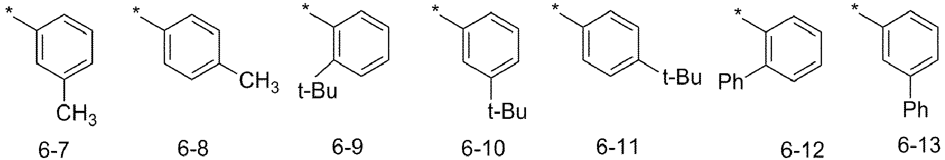

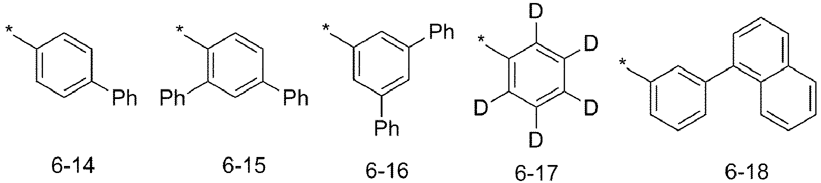

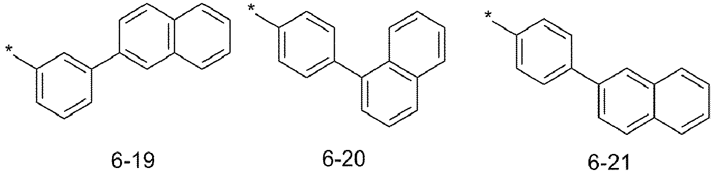

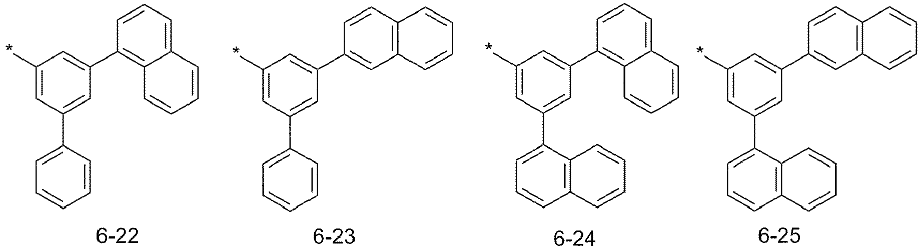

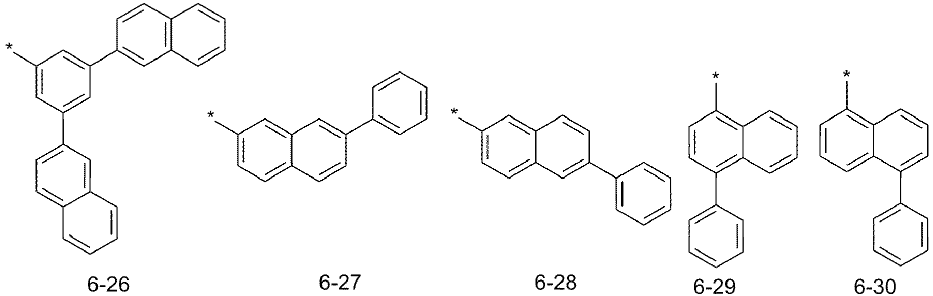

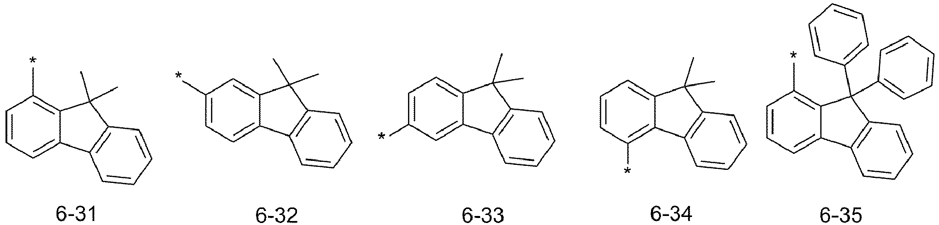

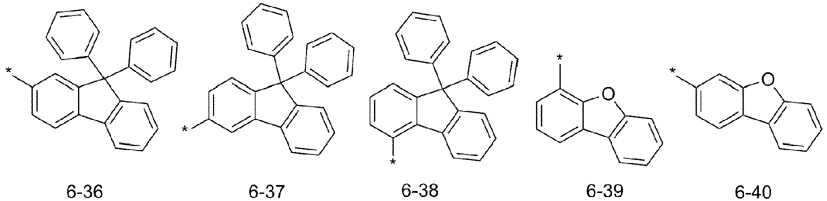

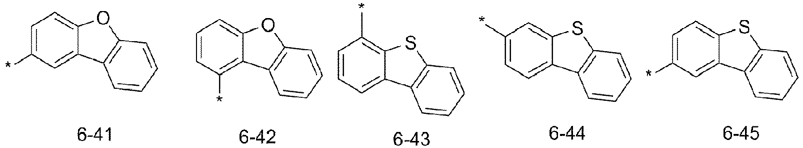

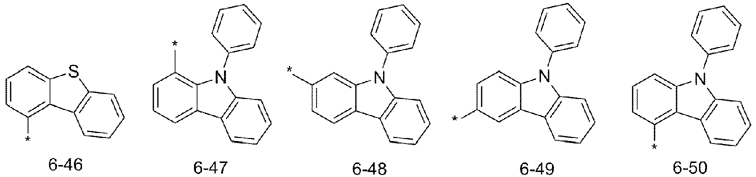

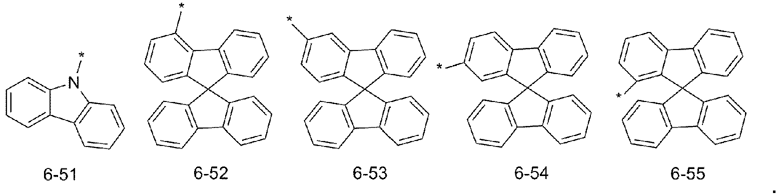

In Formulae 6-1 to 6-55,
* indicates a binding site to a neighboring atom.
b21 in Formula 2 indicates the number of R₂₁(s), and b21 may be selected from 1, 2, and 3.

When b21 is 2 or more, a plurality of R₂₁(s) may be identical to or different from each other. For example, b21 may be 1, but is not limited thereto.
b22 in Formula 2 indicates the number of R₂₂(s), and b22 may be selected from 1, 2, and 3. When b22 is 2 or more, a plurality of R₂₂(s) may be identical to or different from each other. For example, b22 may be 1, but is not limited thereto.
R₈₁ to R₉₆ in Formulae 8-1 and 8-2 may be each independently selected from 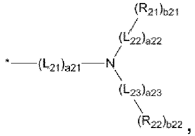 hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that substituents in the number of n21 selected from R₈₁ to

R₉₆ are each 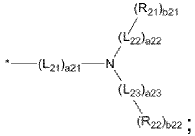 and at least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and a substituted monovalent non-aromatic condensed heteropolycyclic group may be selected from
deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);

a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and -N(Q₃₁)(Q₃₂), -Si(Q₃₃)(Q₃₄)(Q₃₅), and -B(Q₃₆)(Q₃₇);
wherein Q₁₁ to Q₁₇, Q₂₁ to Q₂₇, and Q₃₁ to Q₃₇ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, R₈₁ to R₉₆ in Formulae 8-1 and 8-2 may be each independently selected from 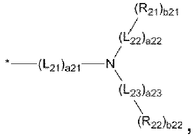 hydrogen, deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group, provided that substituents in the number of n21 selected from R₈₁ to R₉₆ are each 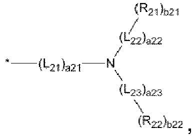 but they are not limited thereto.

In some embodiments, R₈₁ to R₉₆ in Formulae 8-1 and 8-2 may be each independently selected from 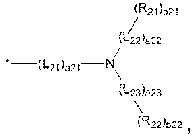 hydrogen, deuterium, -F, -Cl, -Br, -I, a cyano group, a nitro group, a C₁-C₆₀ alkyl group, a C₁-C₆₀ alkoxy group, and groups represented by Formulae 6-1 to 6-55, provided that substituents in the number of n21 selected from R₈₁ to R₉₆ are each 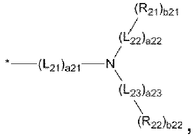 but they are not limited thereto: 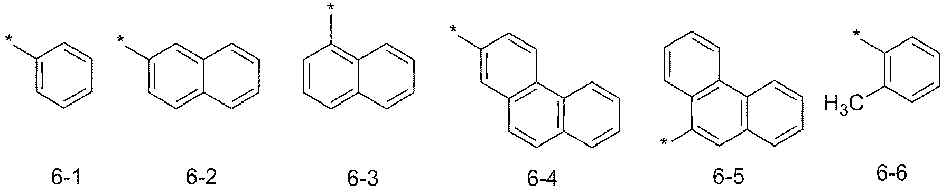 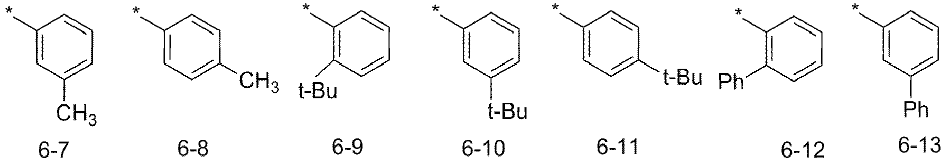 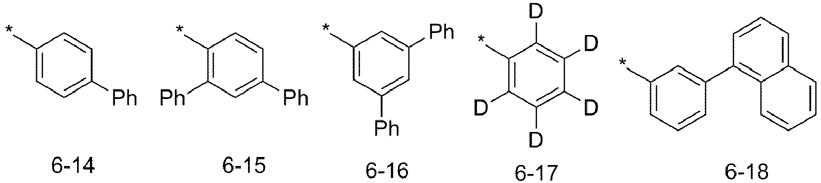 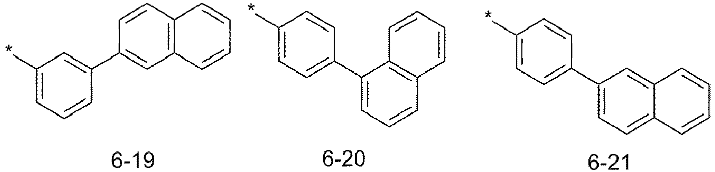 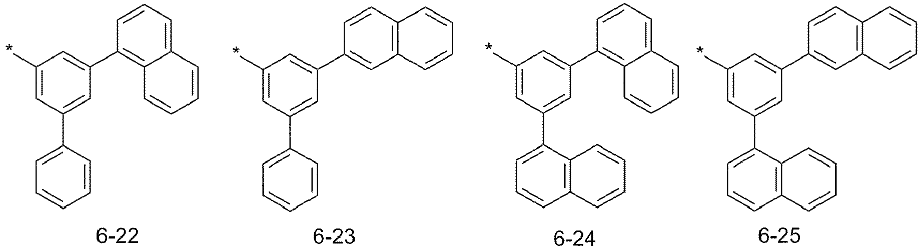 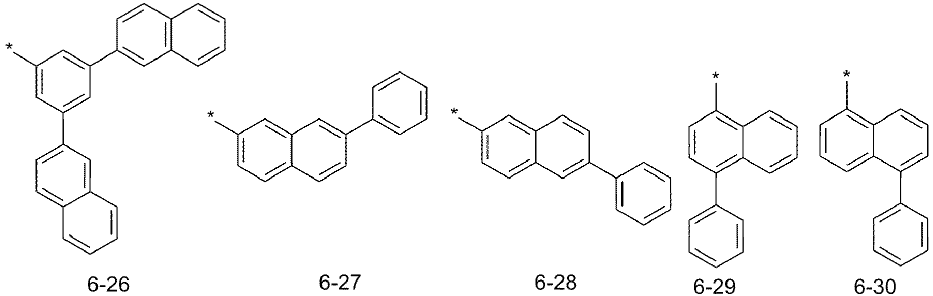 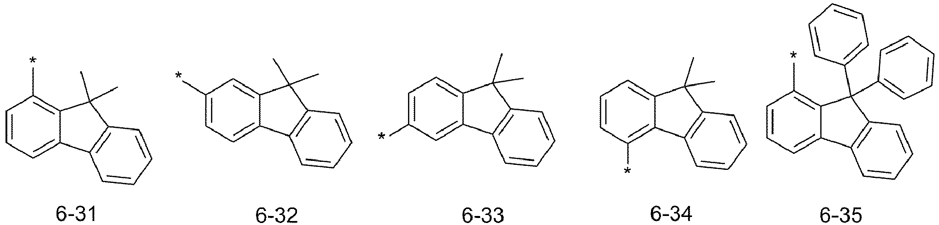 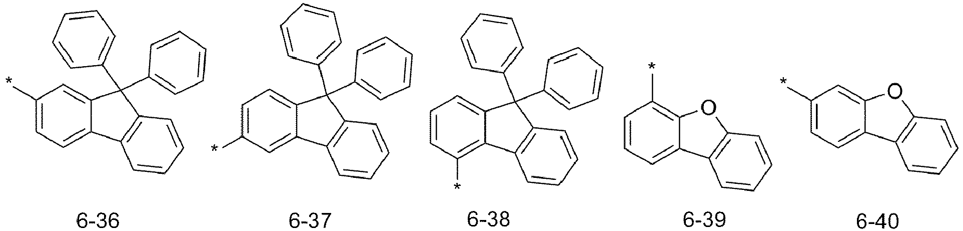 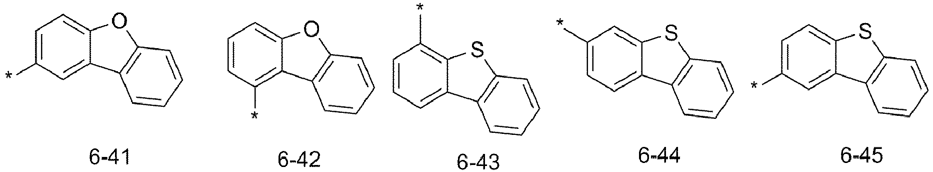 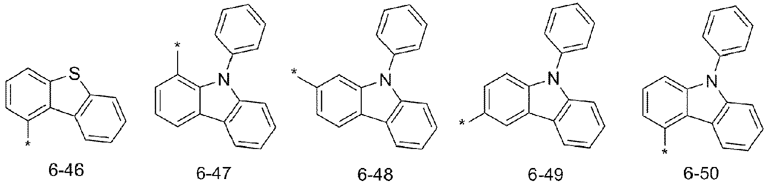 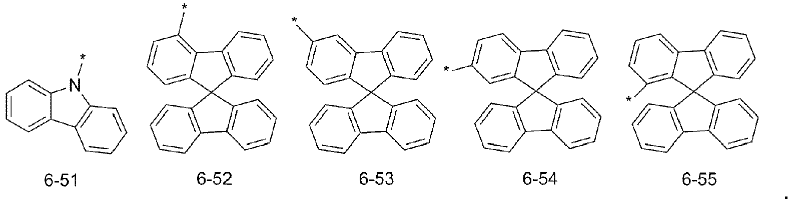 * in Formulae 6-1 to 6-55 indicates a binding site to a neighboring site.

In some embodiments, R₈₁ to R₉₆ in Formulae 8-1 and 8-2 may be each independently selected from 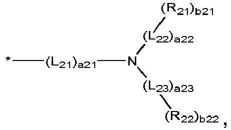 hydrogen, groups represented by Formulae 6-1 to 6-3, and groups represented by Formulae 6-31 to 6-55, provided that substituents in the number of n21 selected from R₈₁ to R₉₆ are 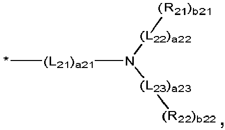 but they are not limited thereto: 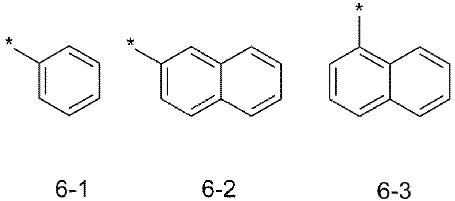 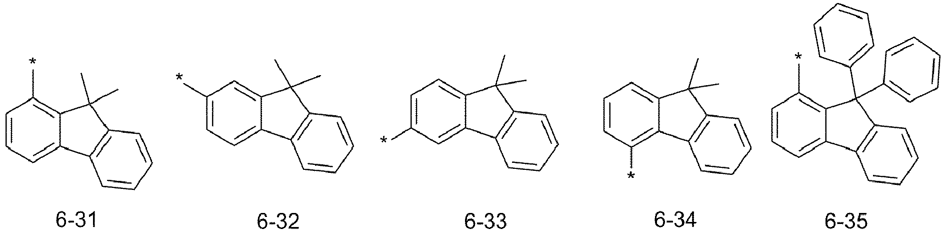 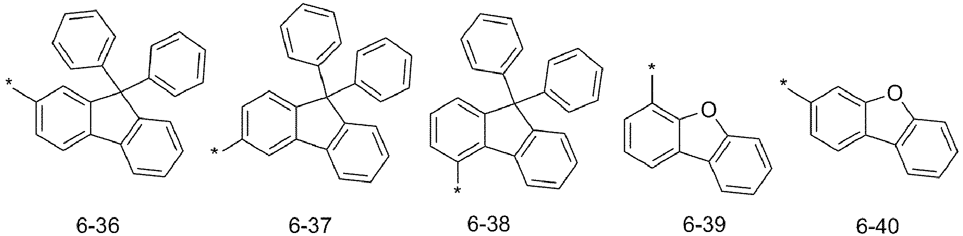 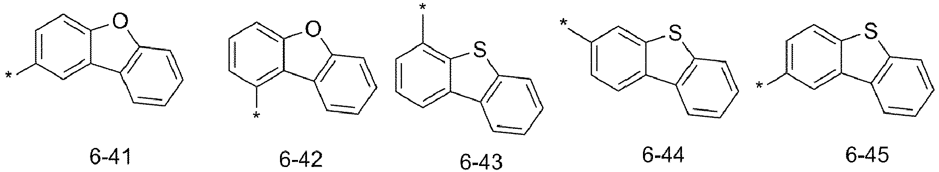 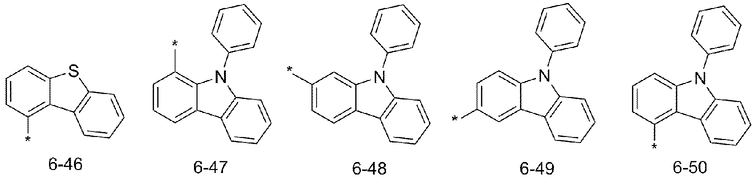 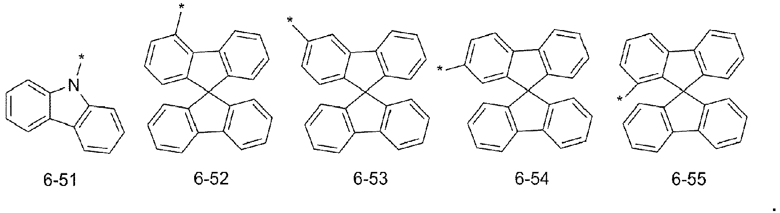 * in Formulae 6-1 to 6-3 and Formulae 6-31 to 6-55 indicates a binding site to a neighboring site. n21 in Formula 2 indicates the number of a moiety represented by 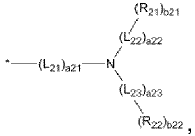 and
n21 may be selected from 1, 2, 3, and 4. When n21 is 2 or more, a plurality of 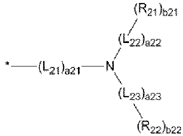 (s) may be identical to or different from each other. For example, n21 may be selected from 1, 2, and 4, but is not limited thereto.

For example, the amine-based compound may be represented by one of Formulae 2-1 to 2-6, but they are not limited thereto:

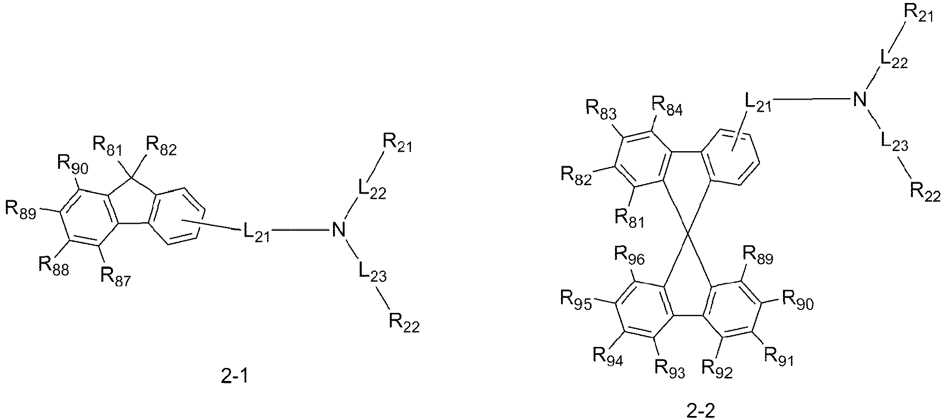

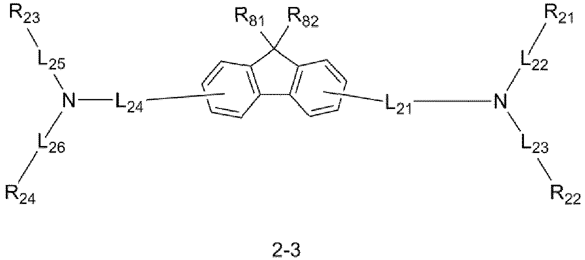

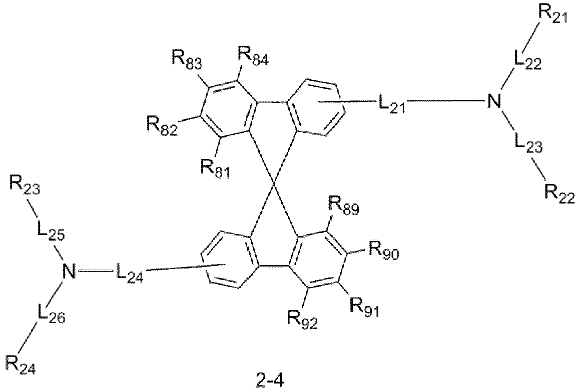

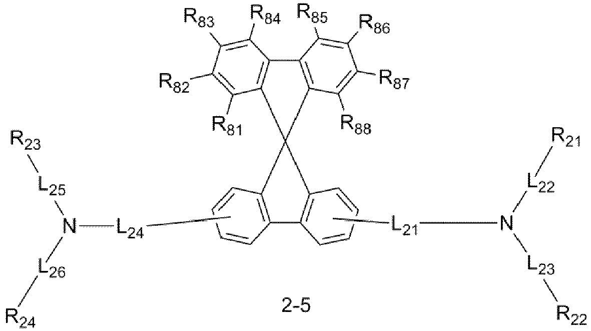

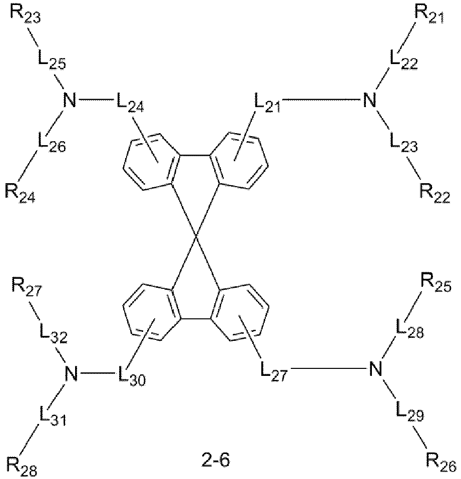

Regarding Formulae 2-1 to 2-6,
L₂₁ to L₂₃, R₂₁, R₂₂, and R₈₁ to R₉₆ are already described above;
L₂₄ to L₃₂ may be understood by referring to the descriptions of L₂; and
R₂₃ to R₂₈ may be understood by referring to the descriptions of R₂₁.

In some embodiments, the amine-based compound may be selected from compounds illustrated below, but they are not limited thereto:

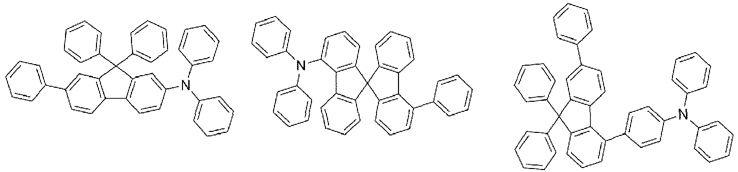

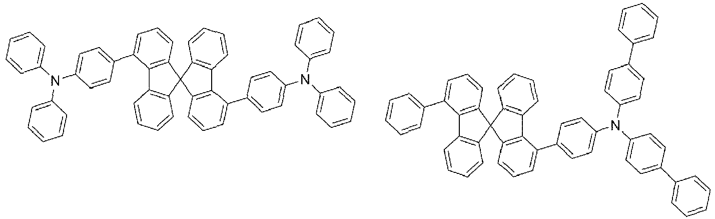

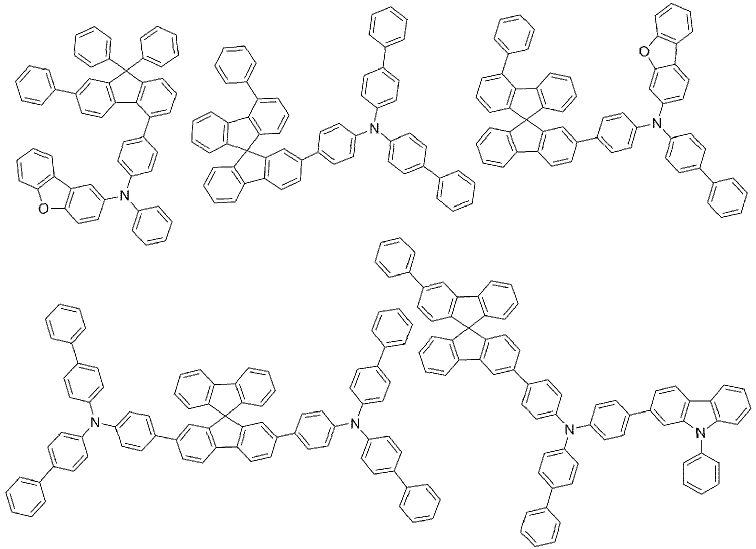

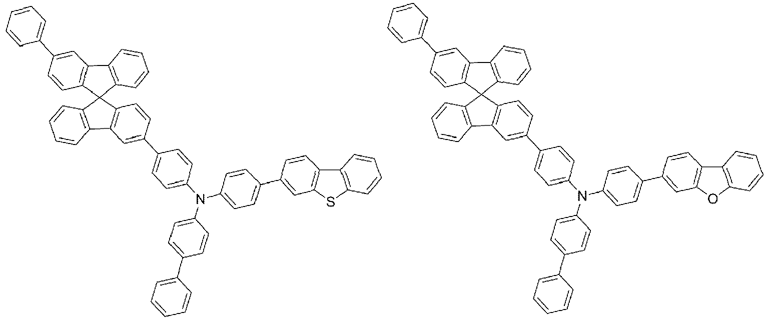

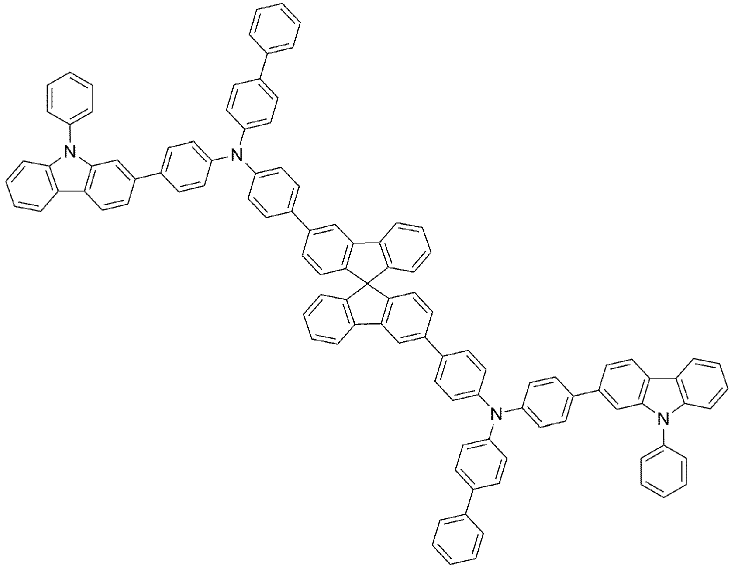

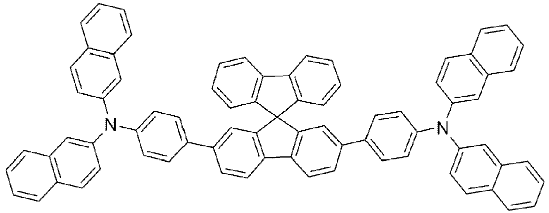

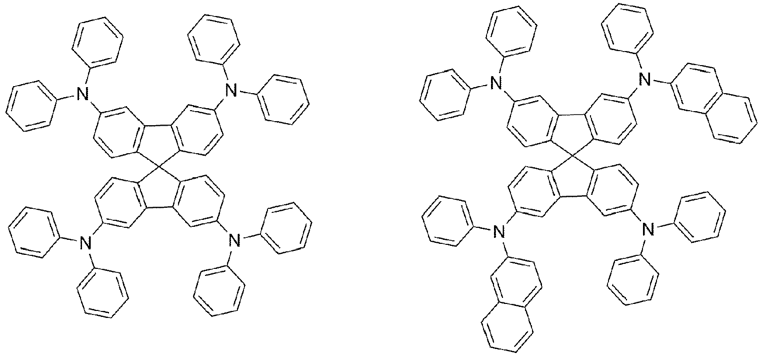

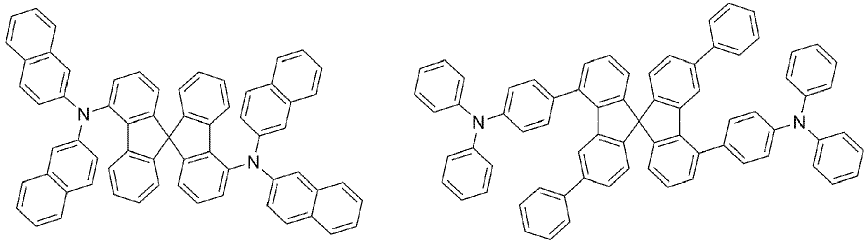

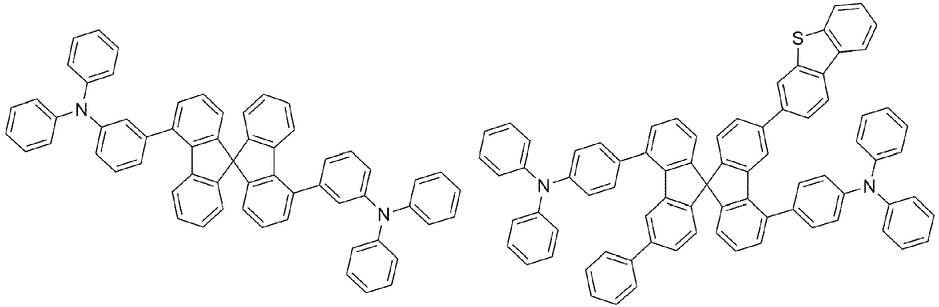

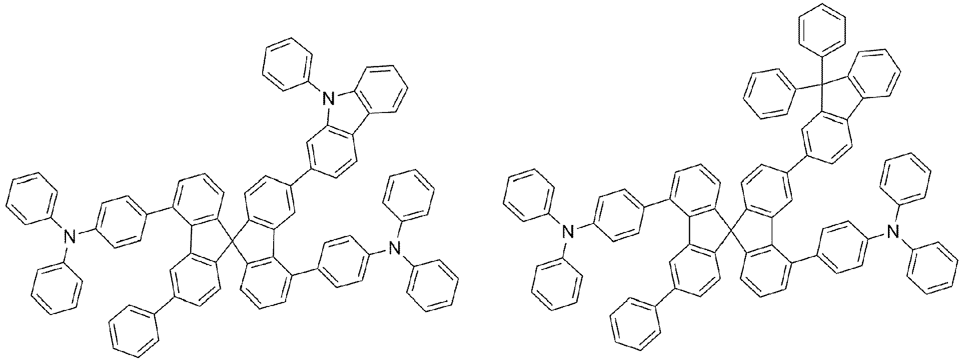

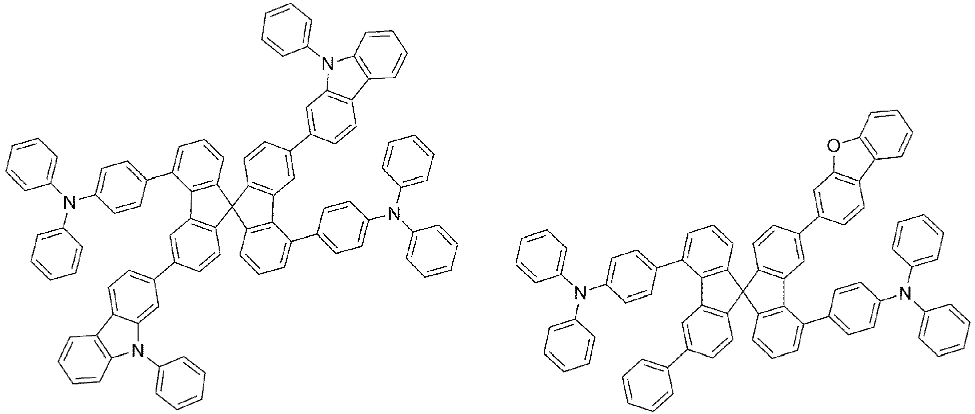

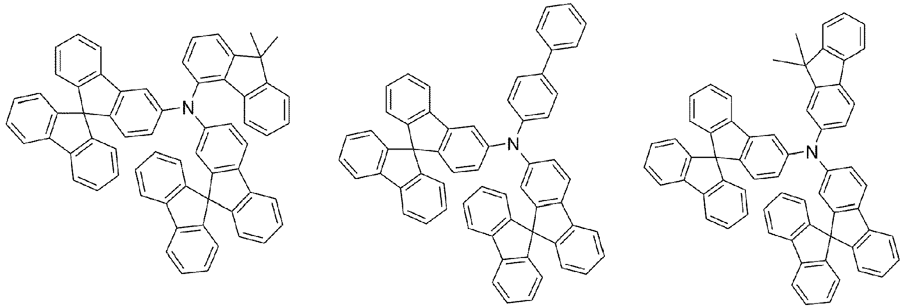

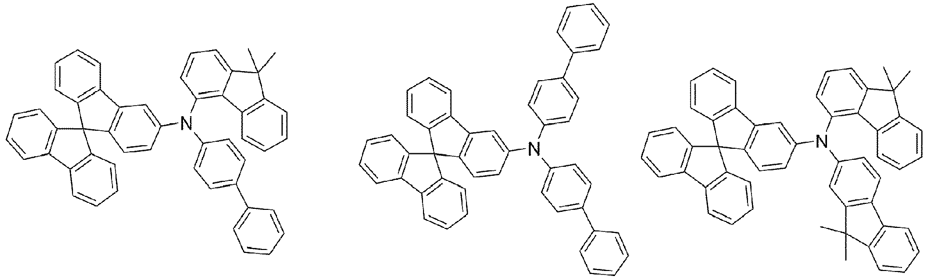

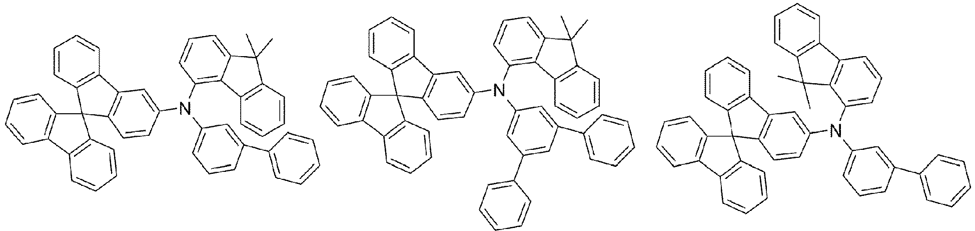

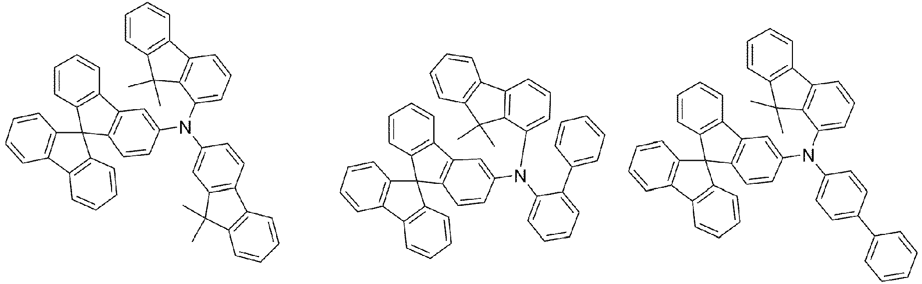

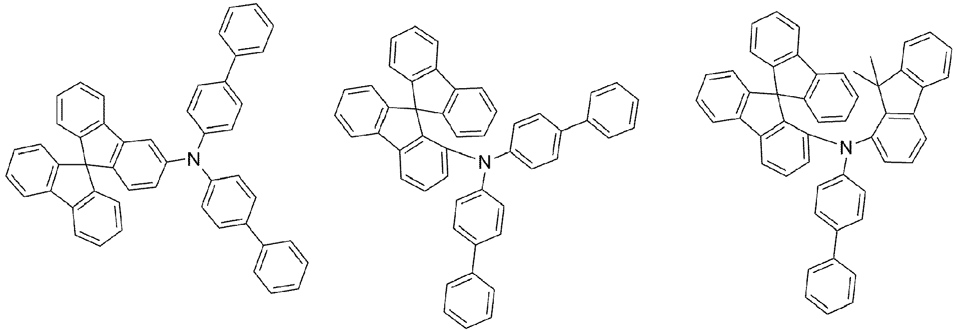

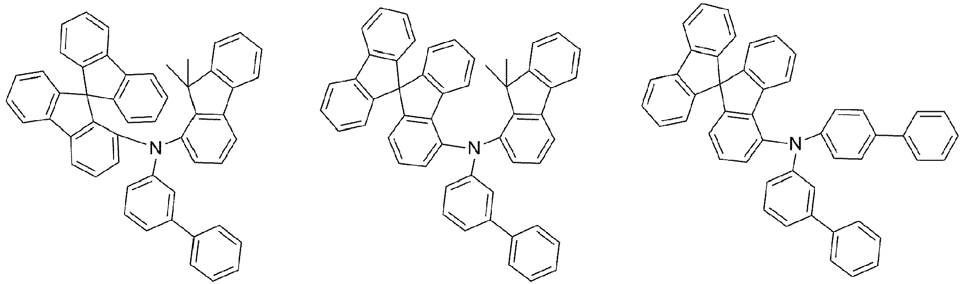

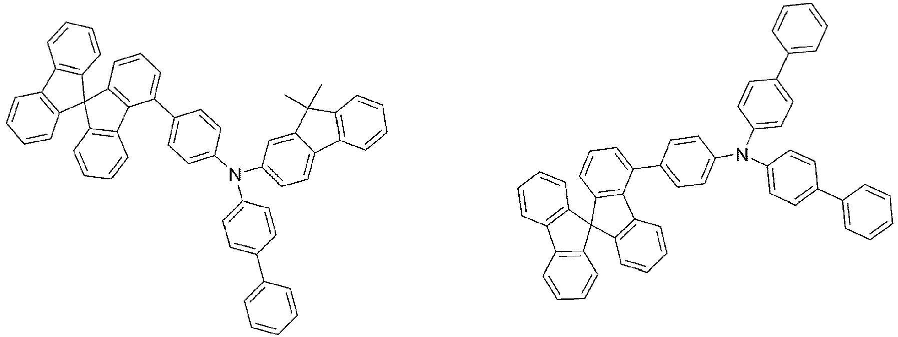

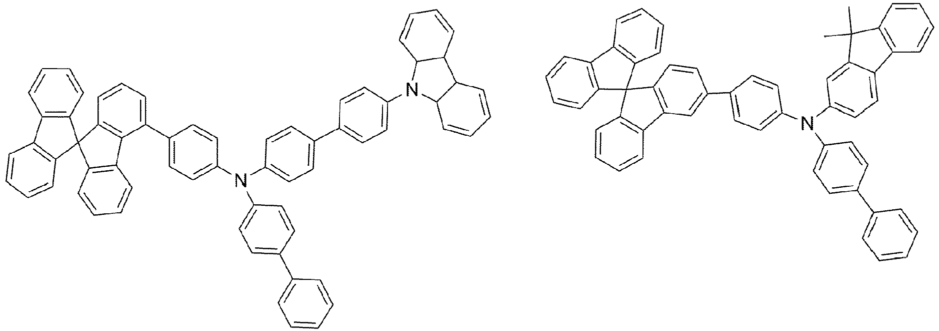

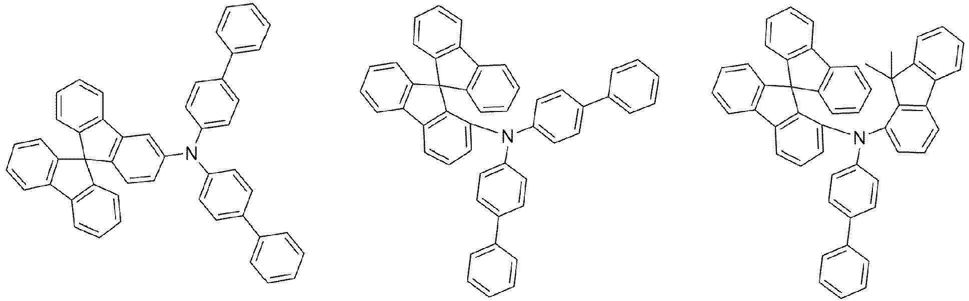

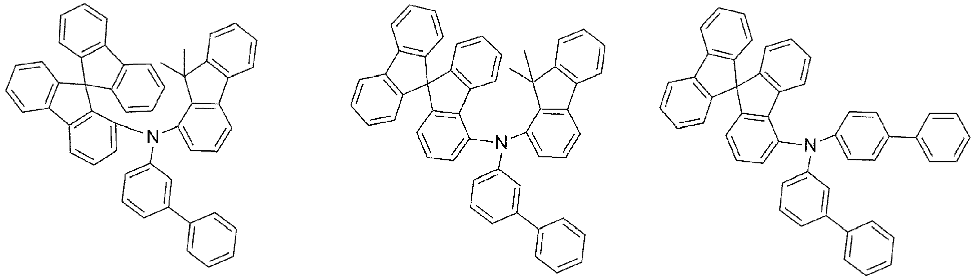

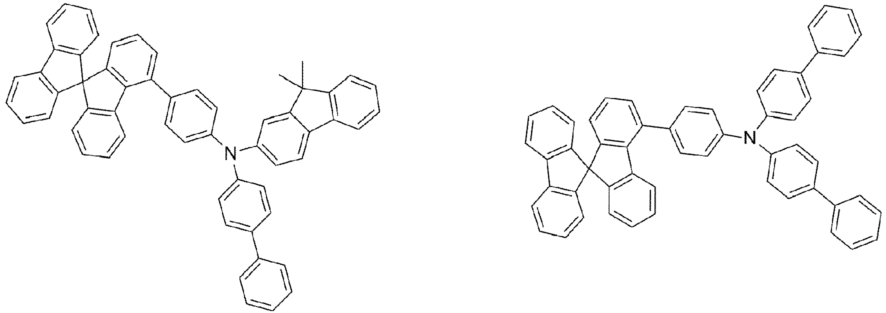

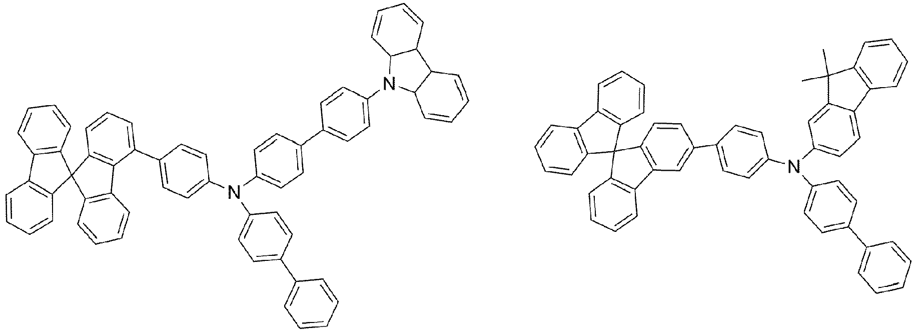

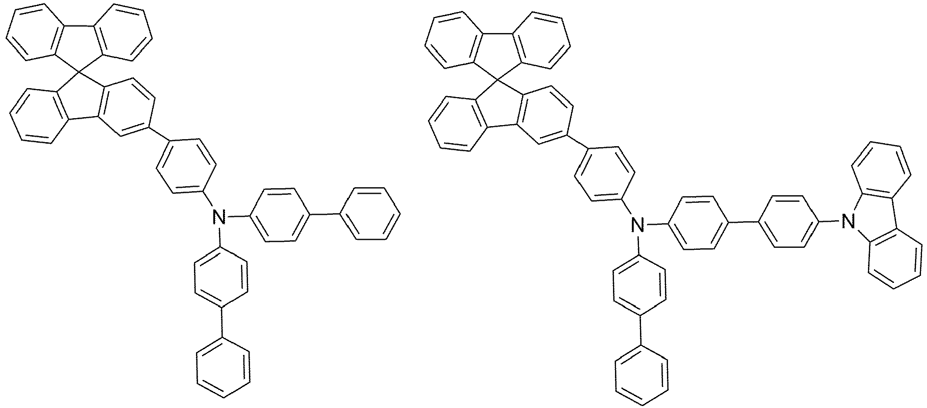

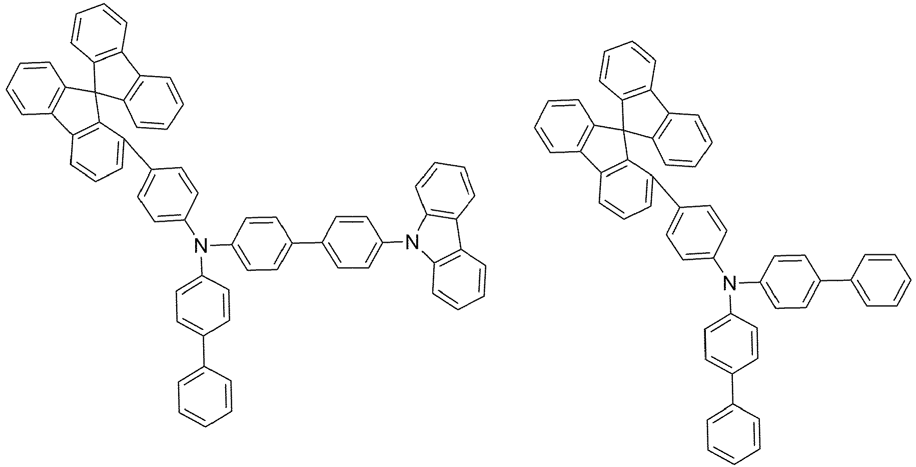

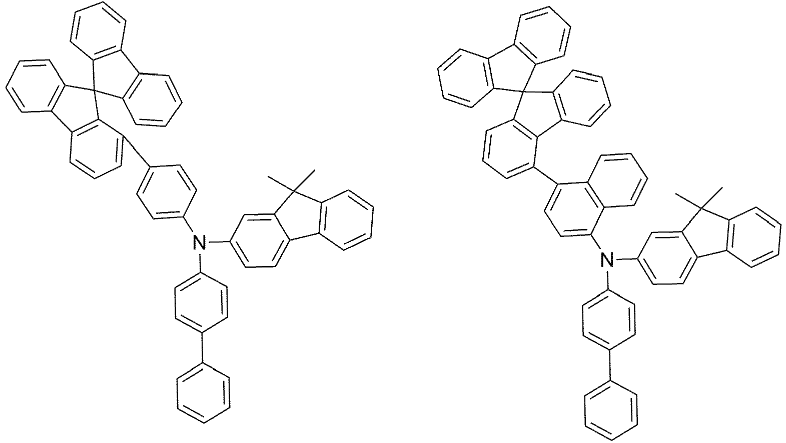

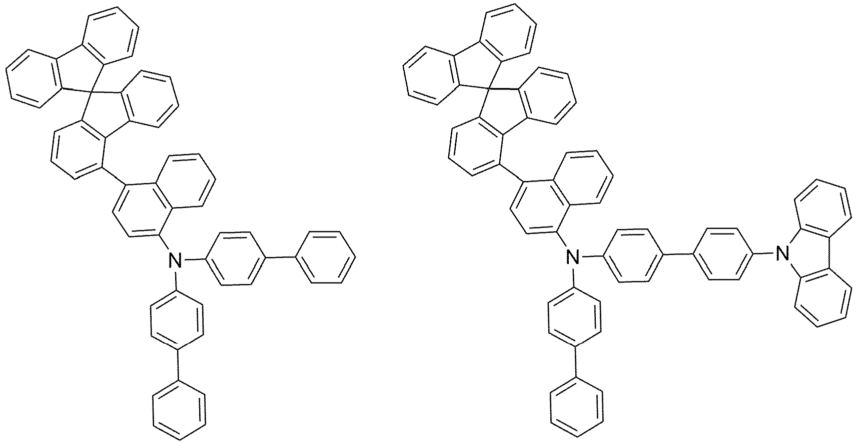

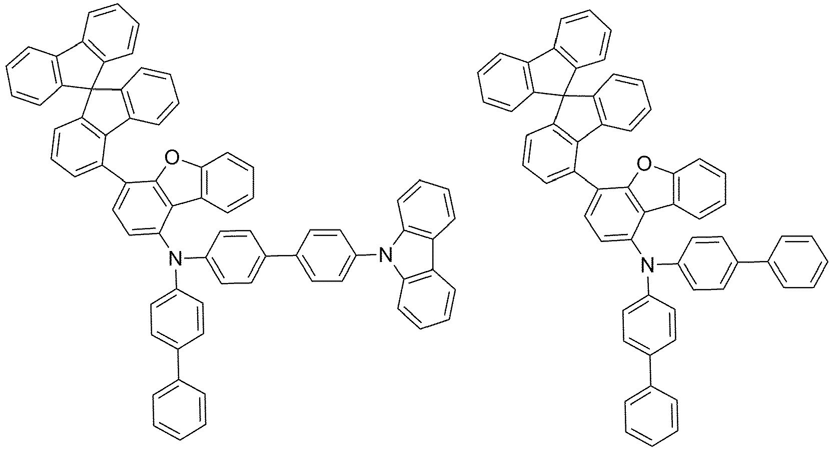

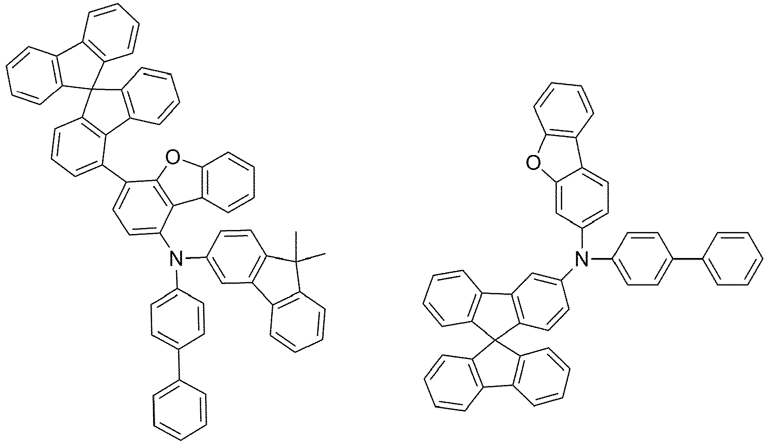

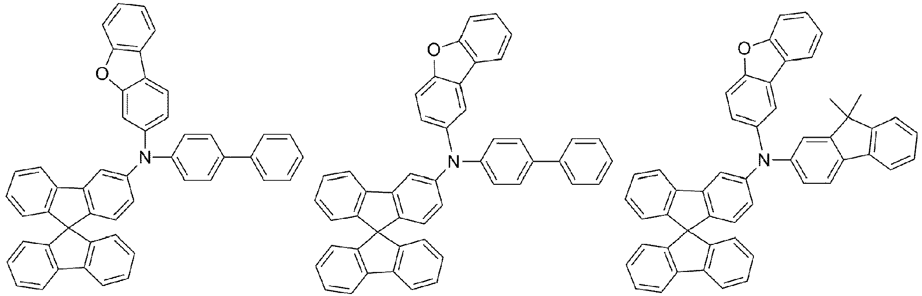

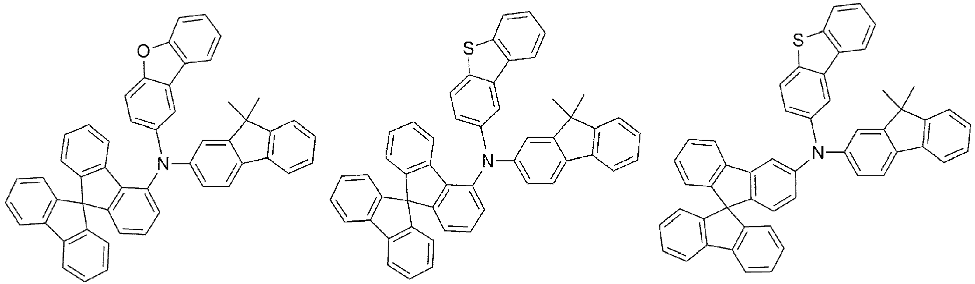

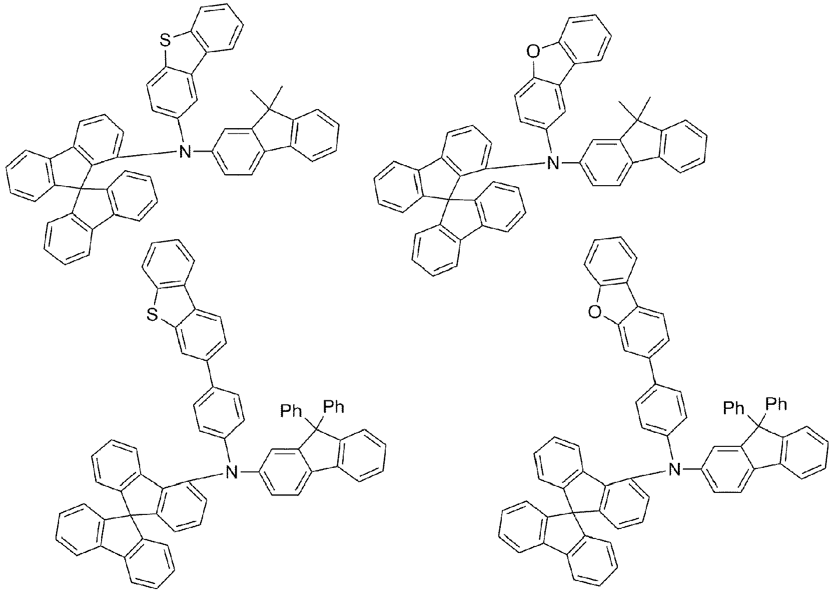

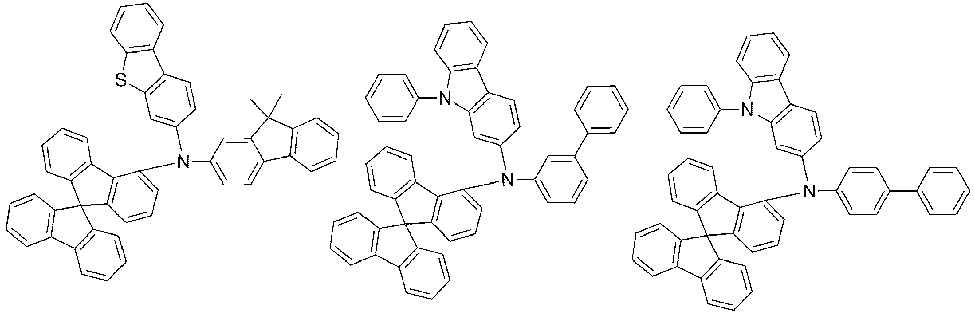

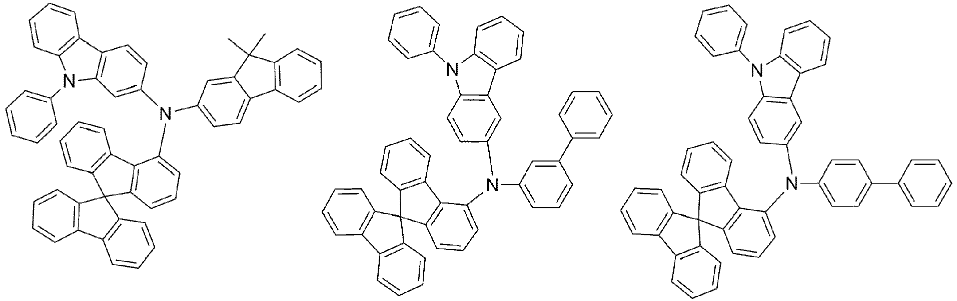

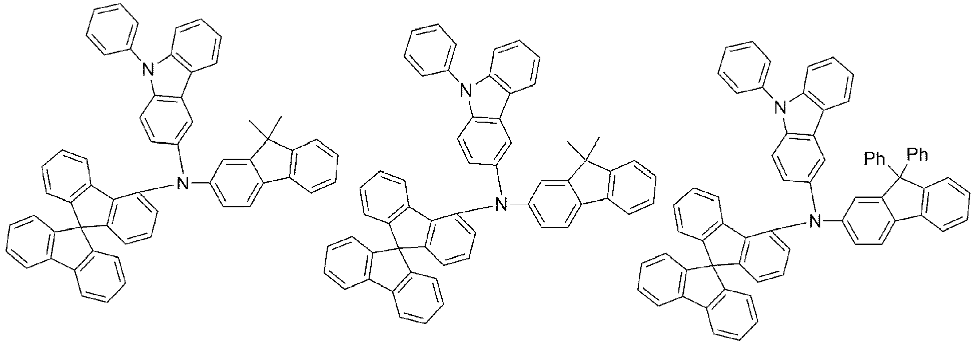

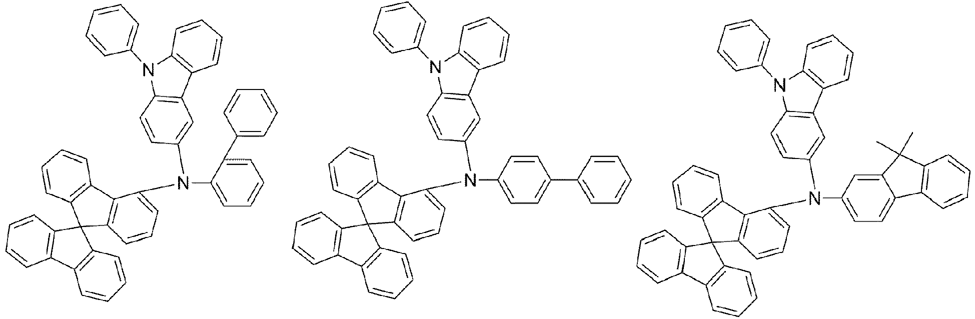

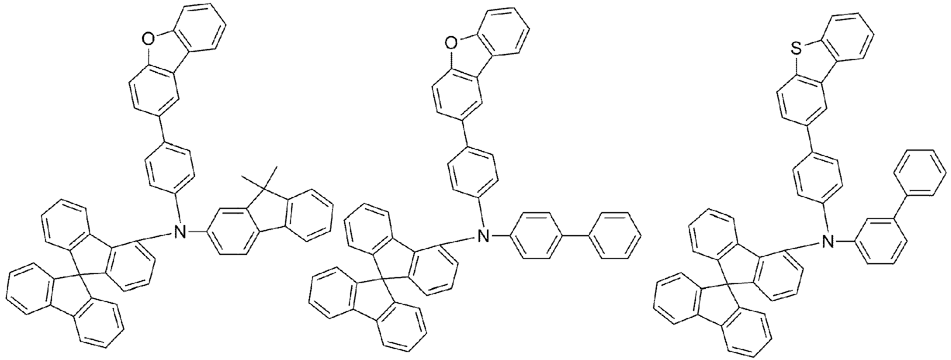

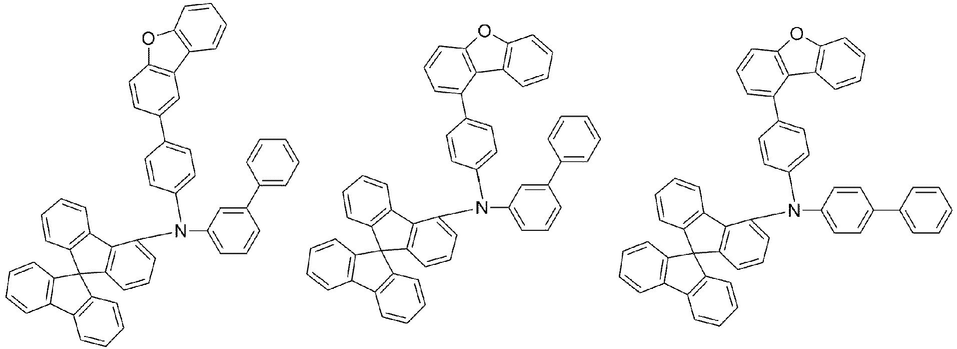

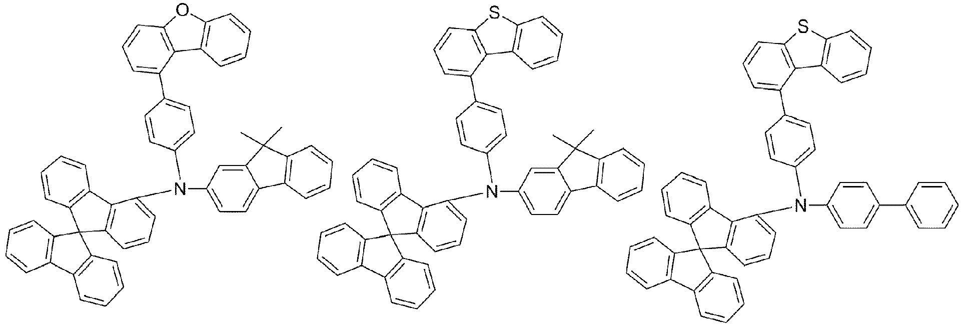

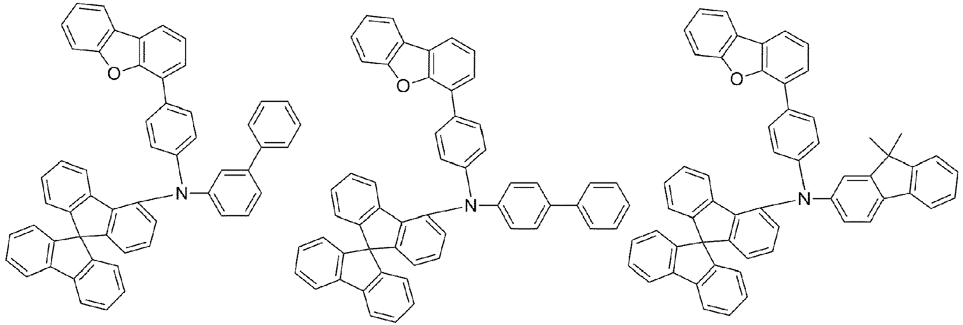

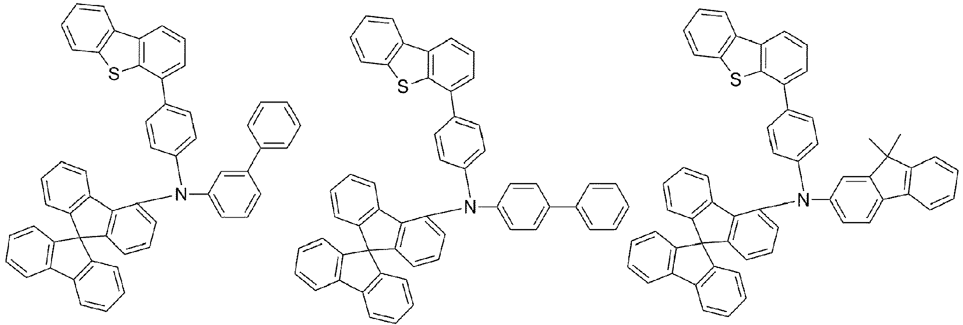

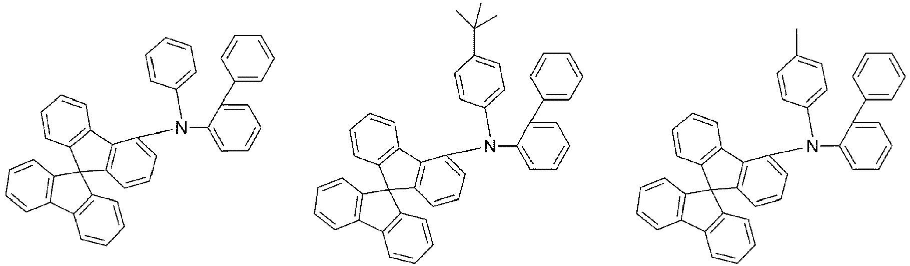

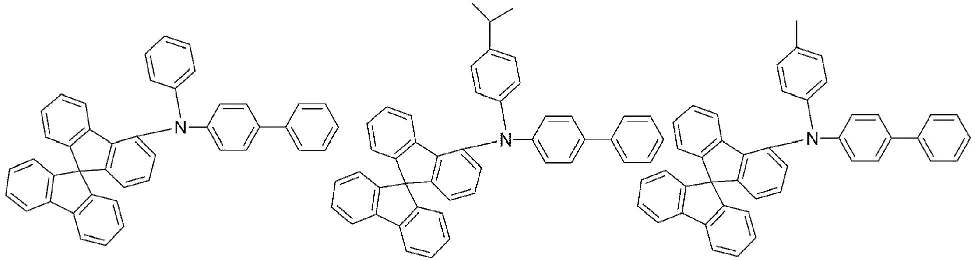

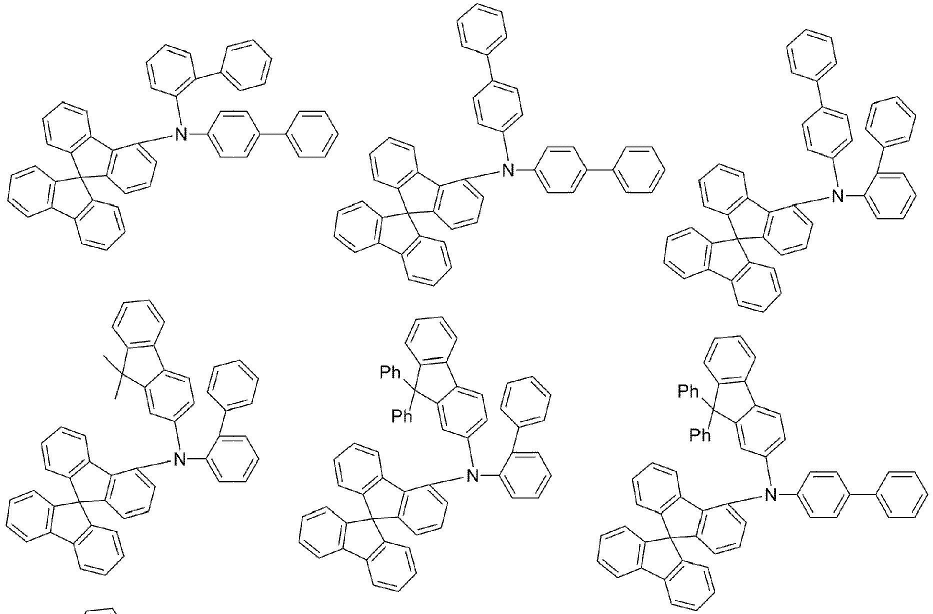

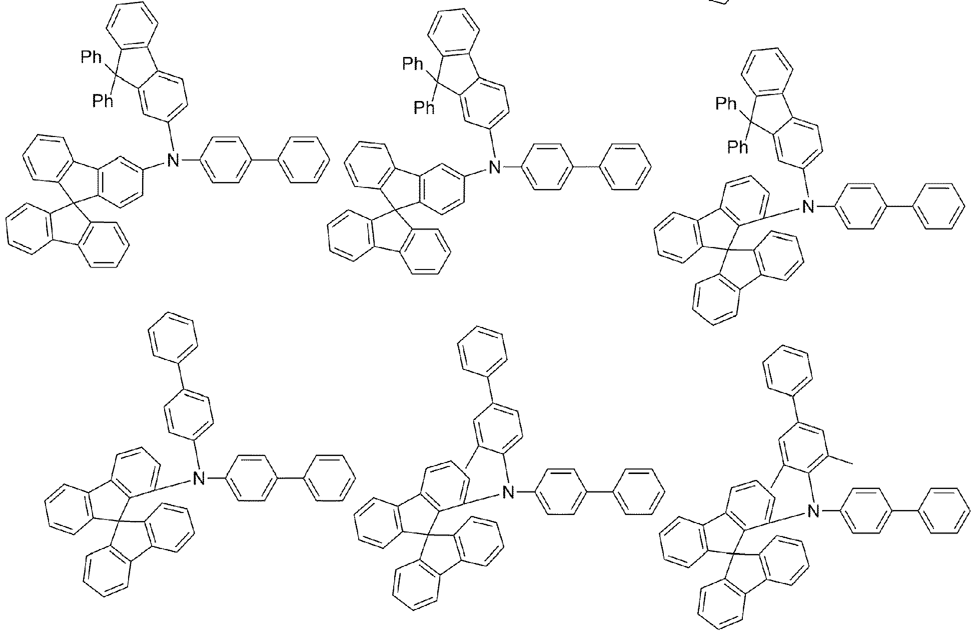

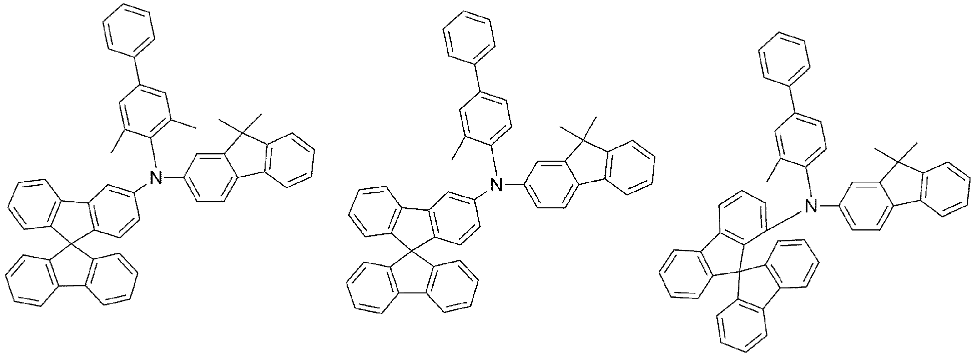

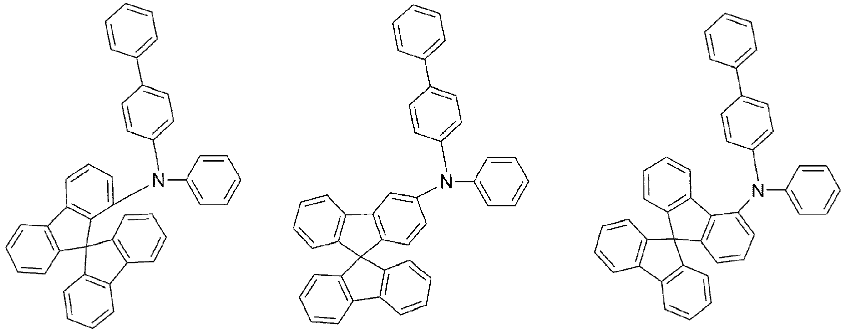

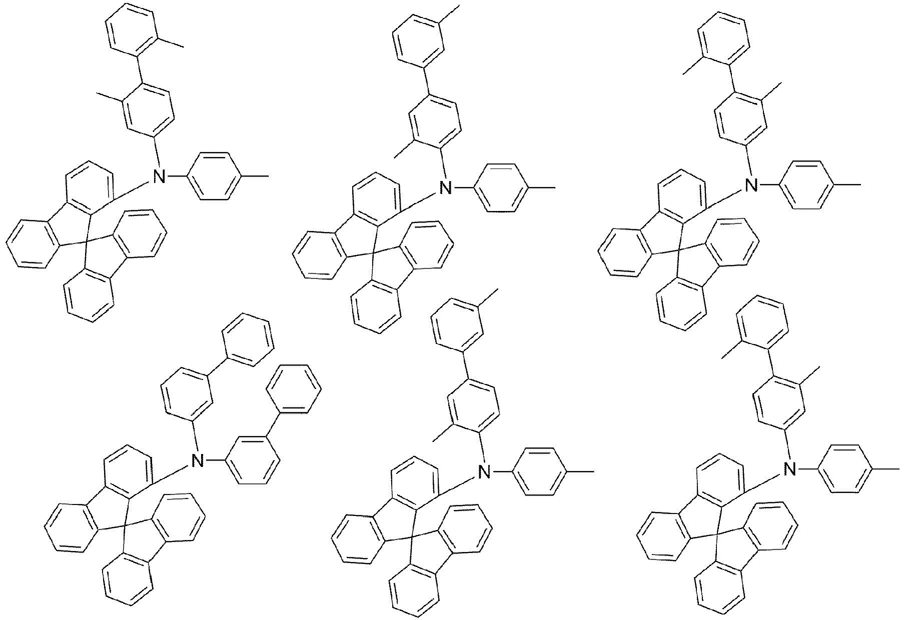

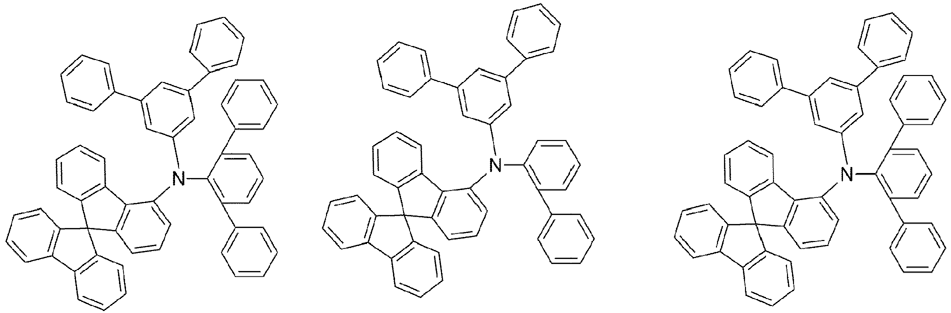

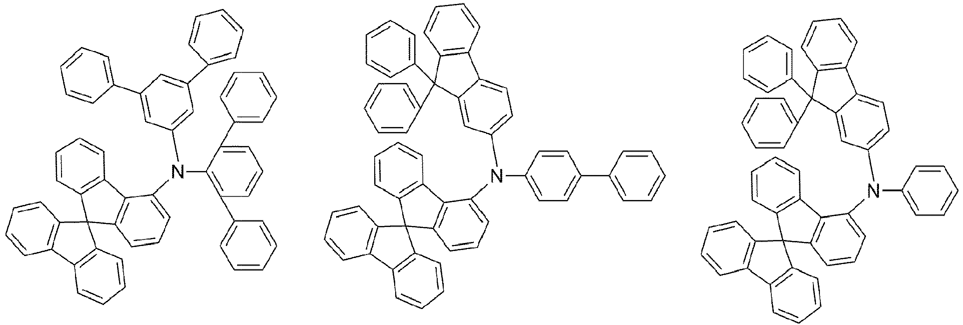

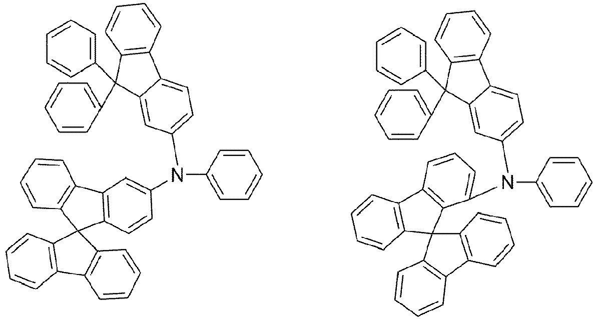

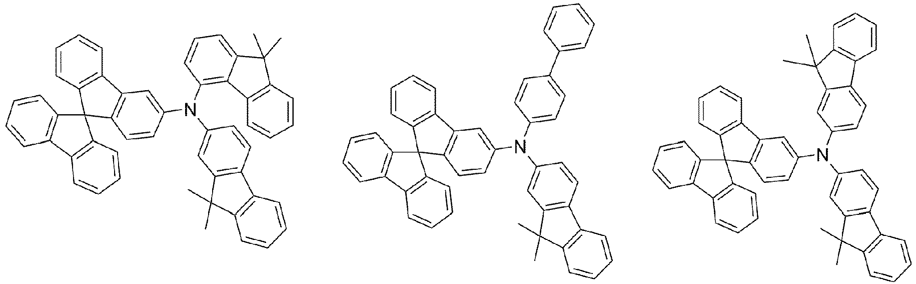

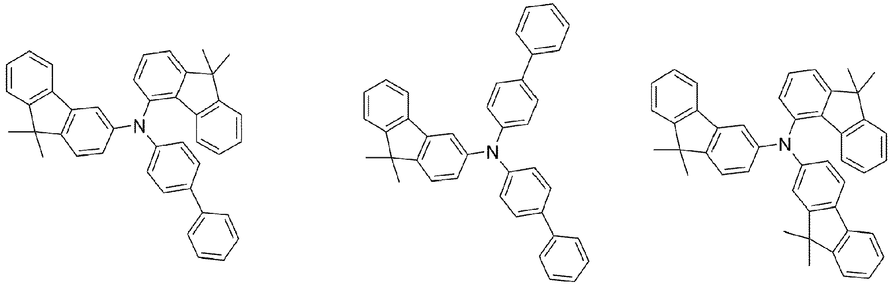

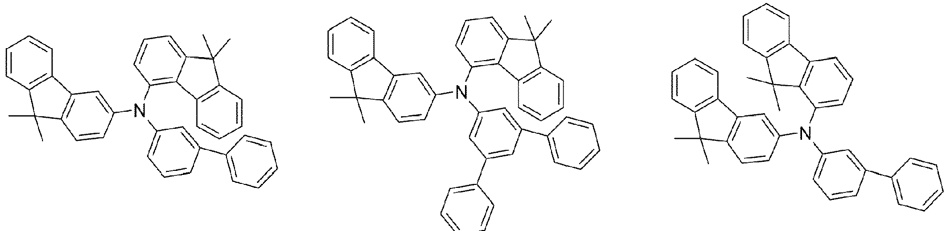

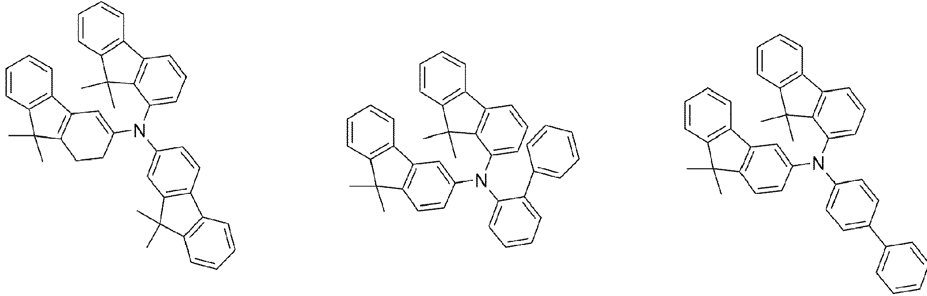

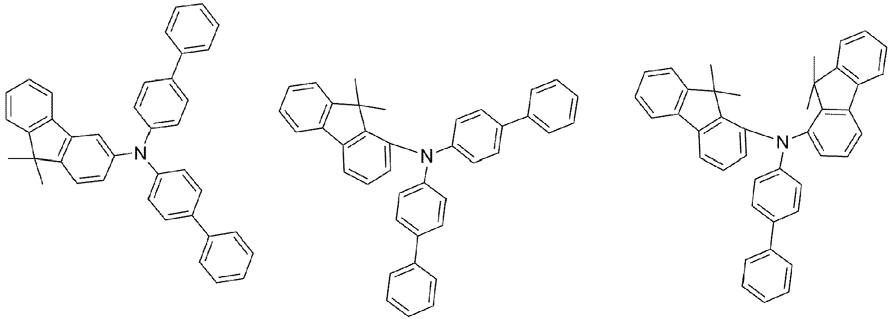

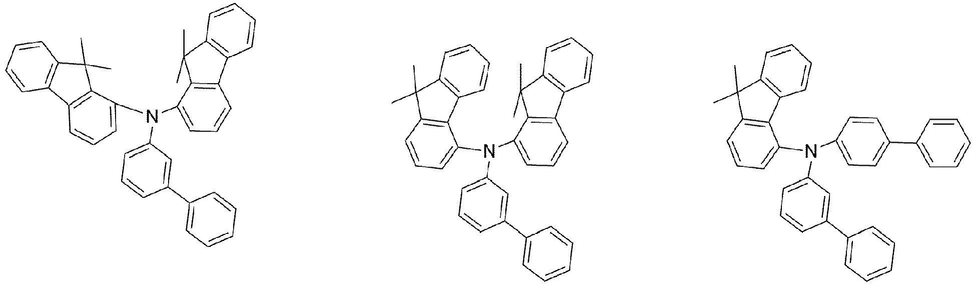

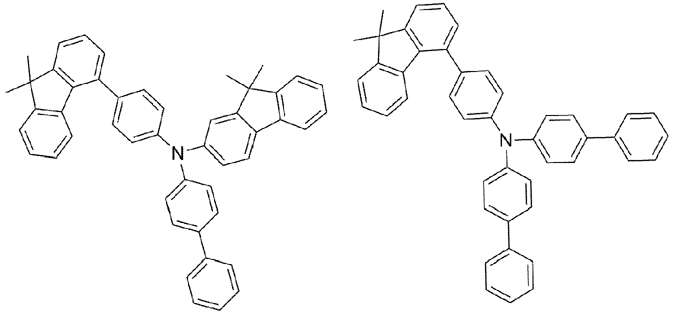

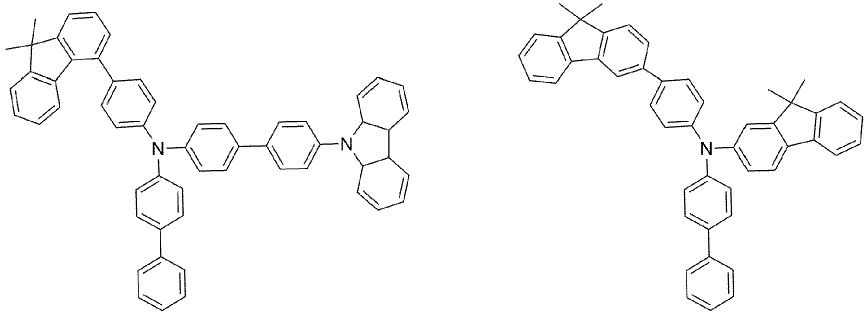

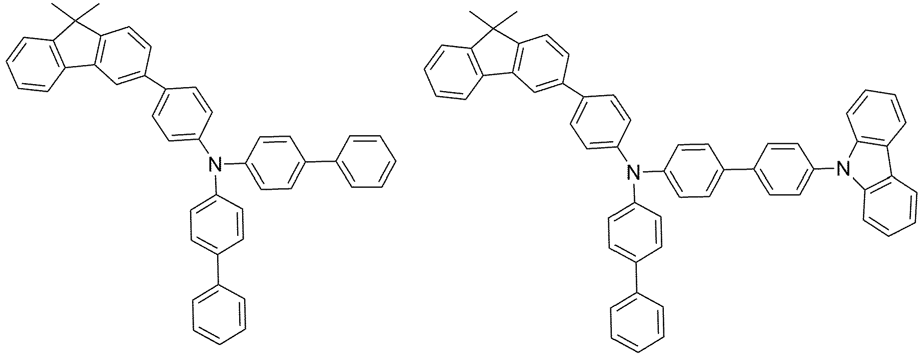

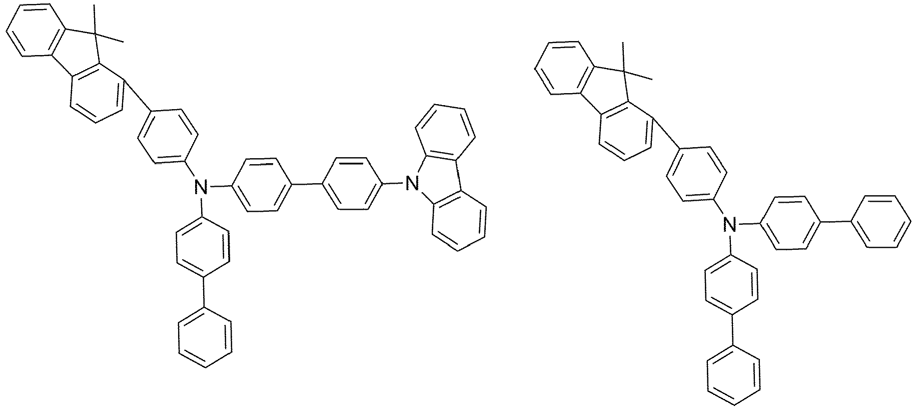

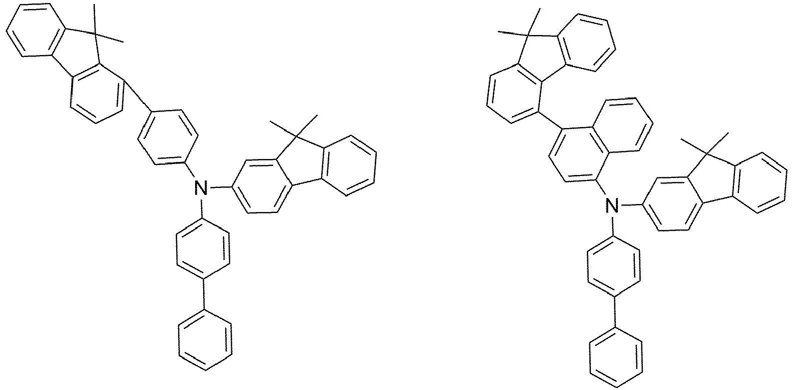

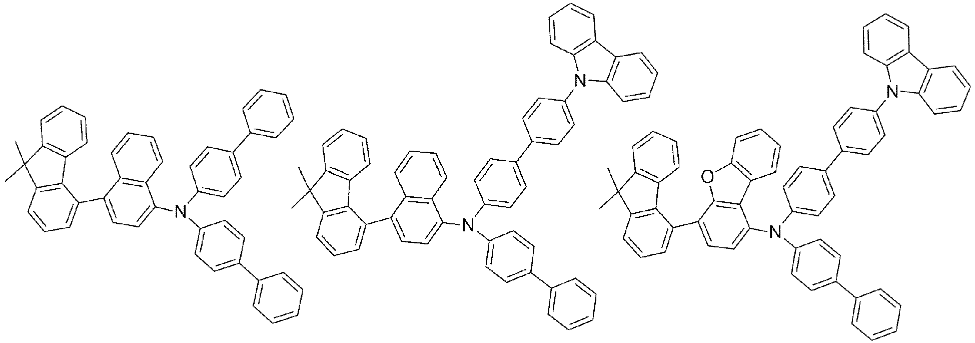

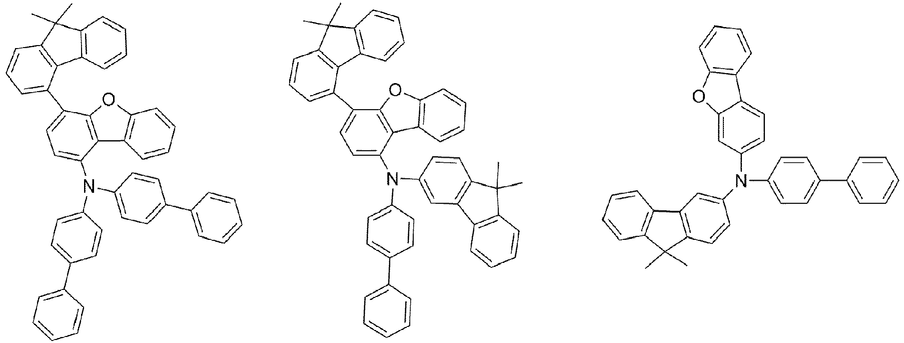

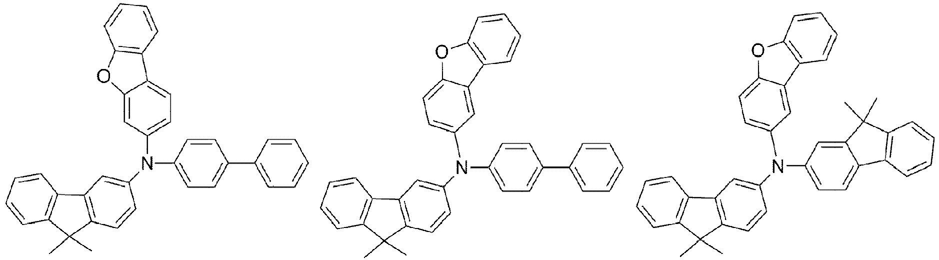

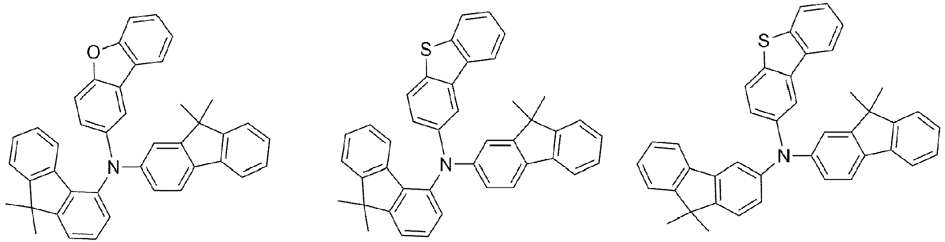

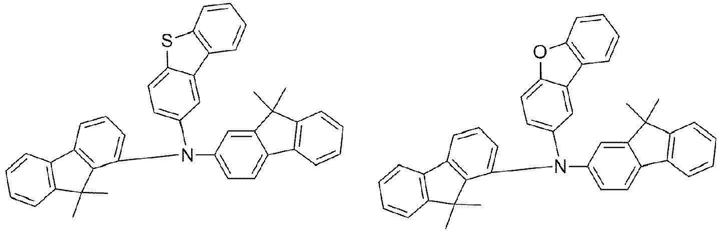

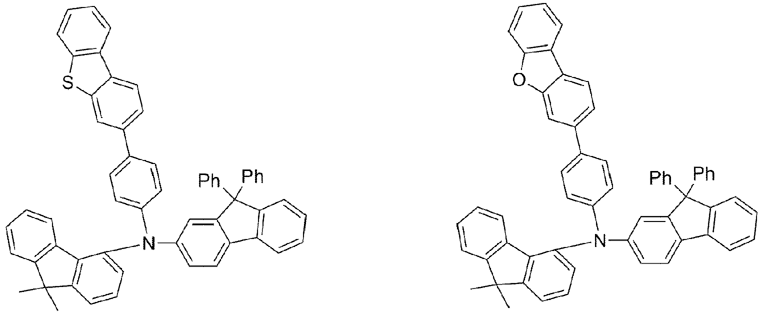

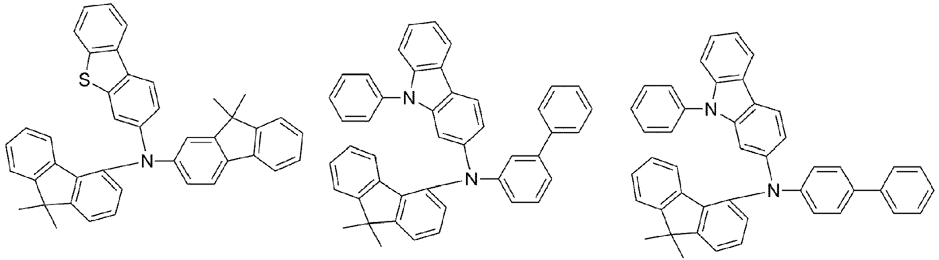

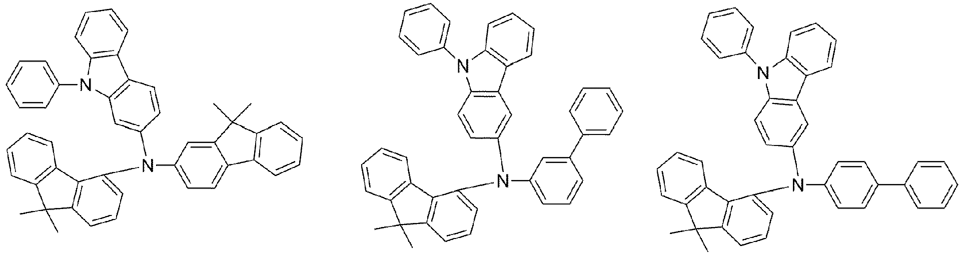

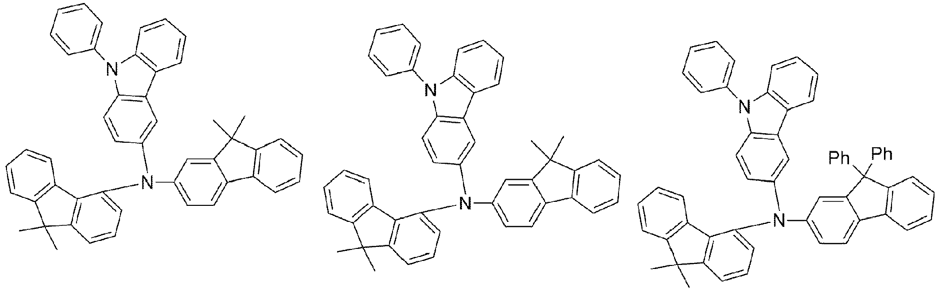

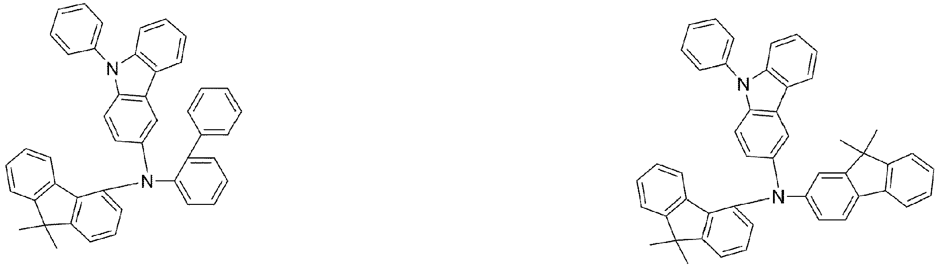

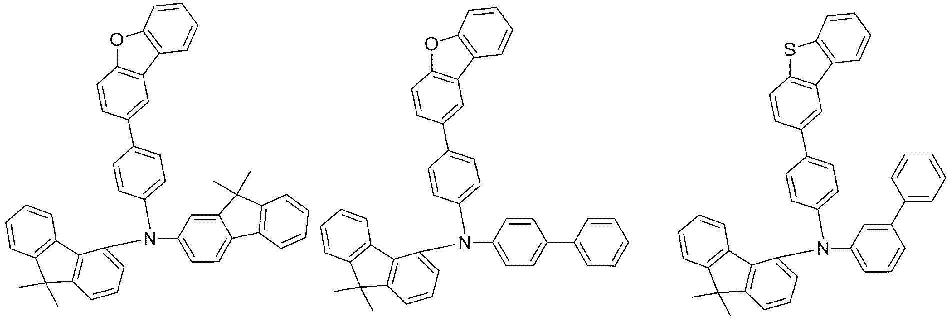

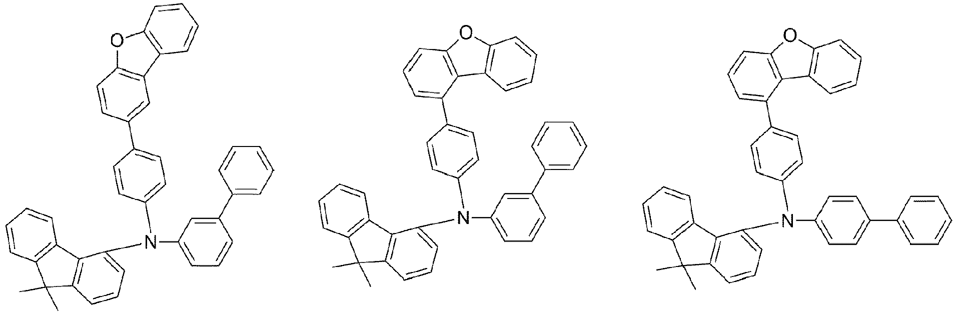

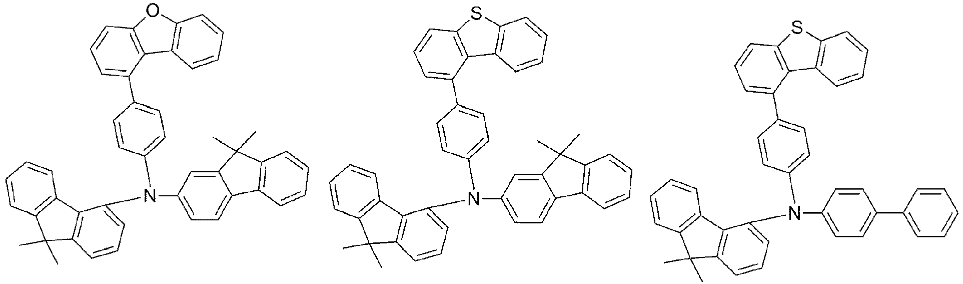

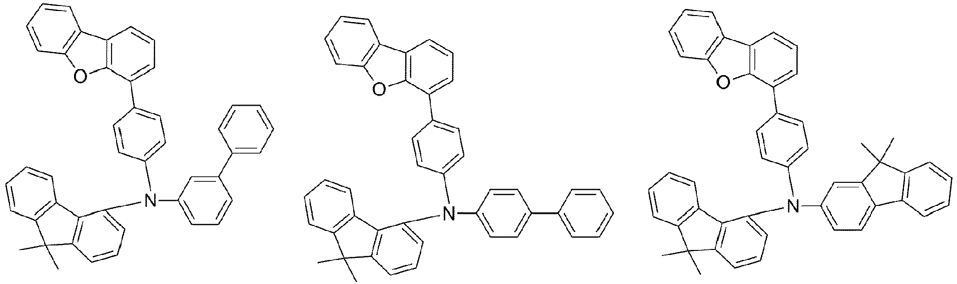

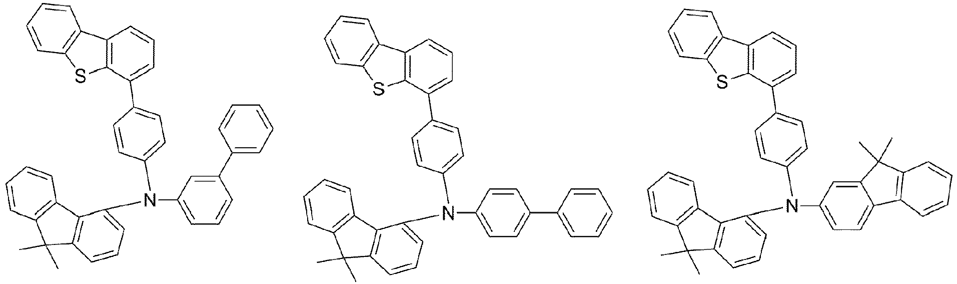

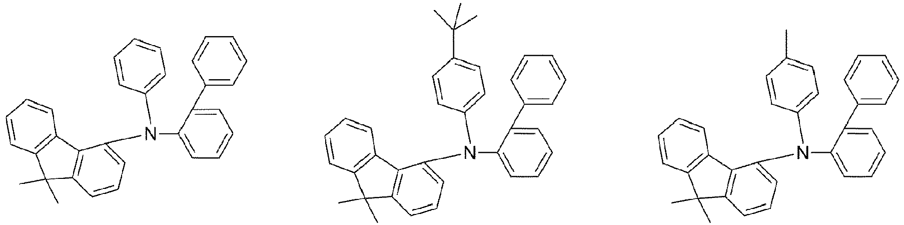

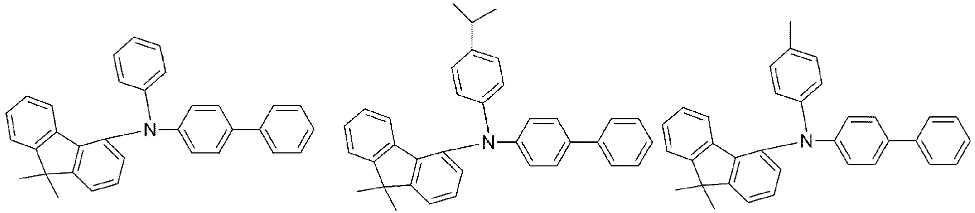

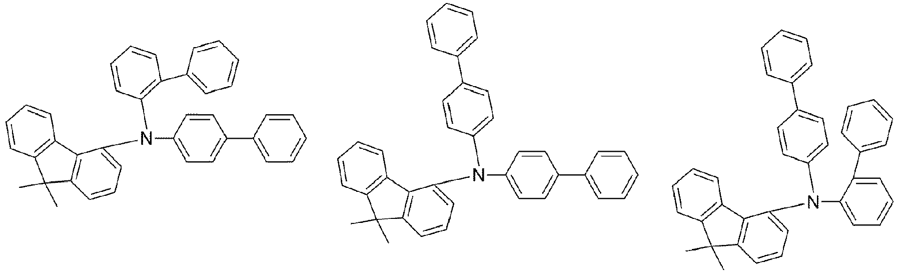

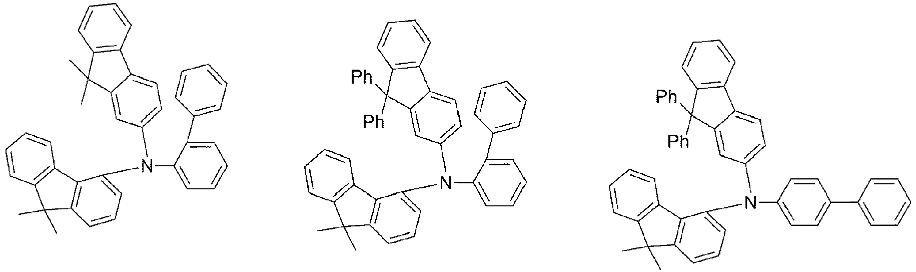

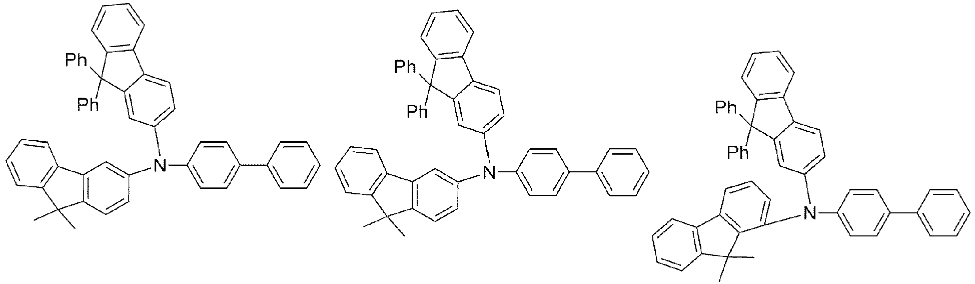

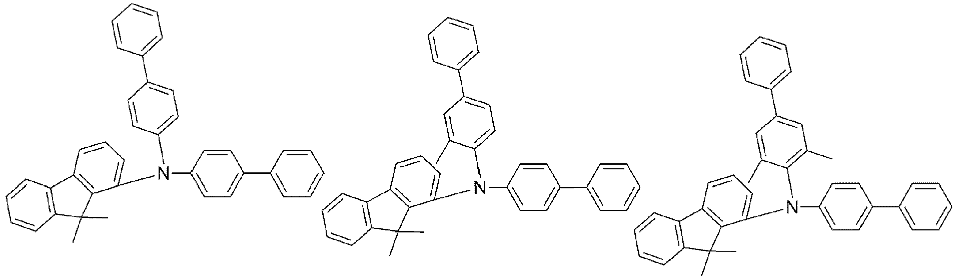

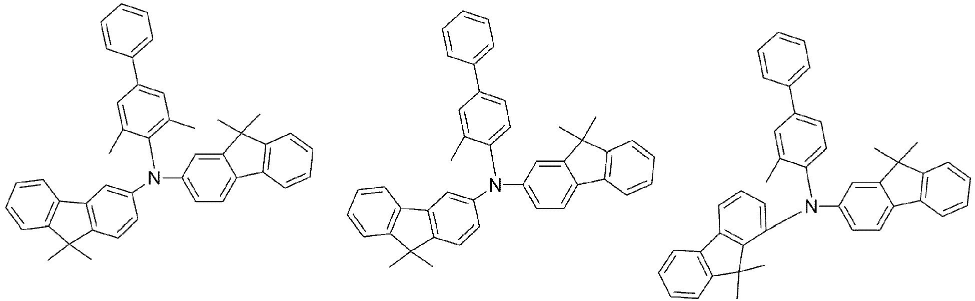

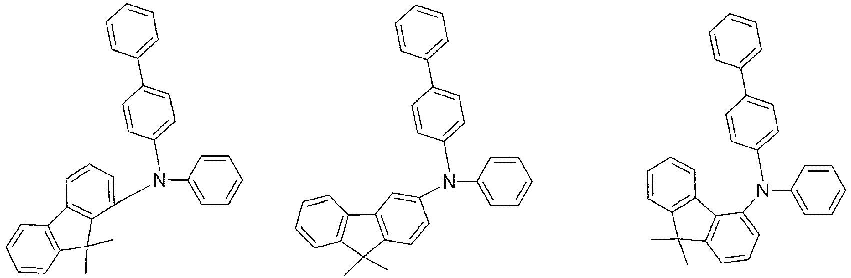

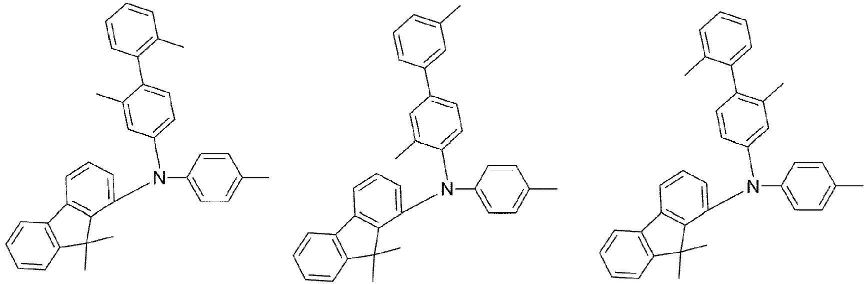

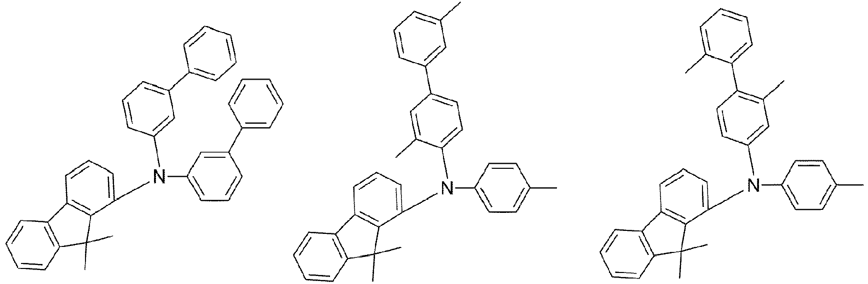

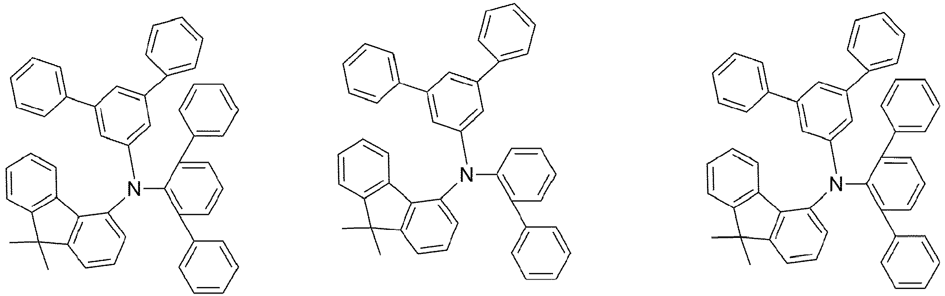

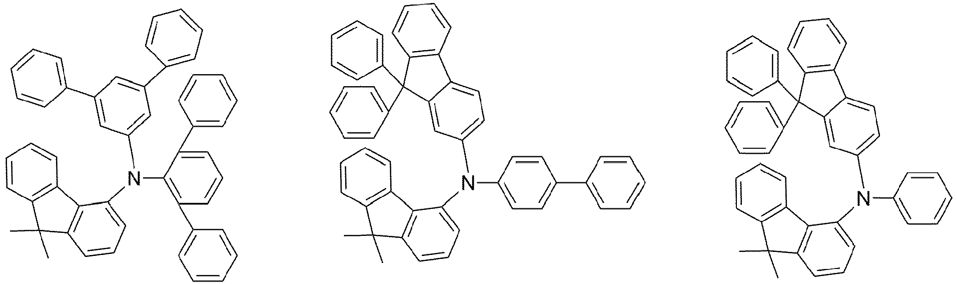

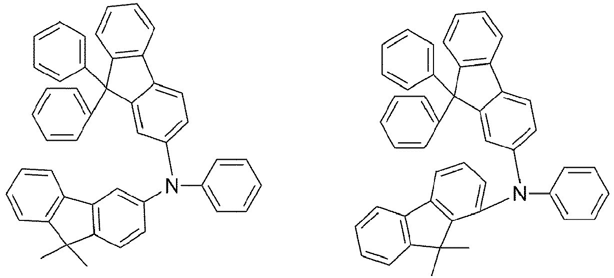

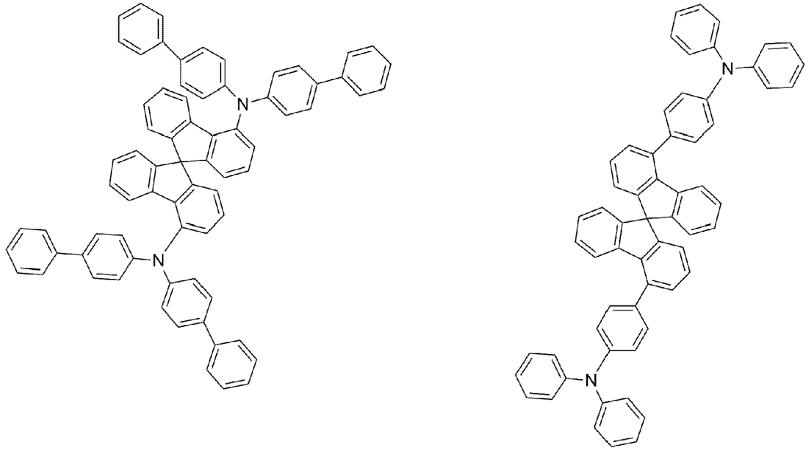

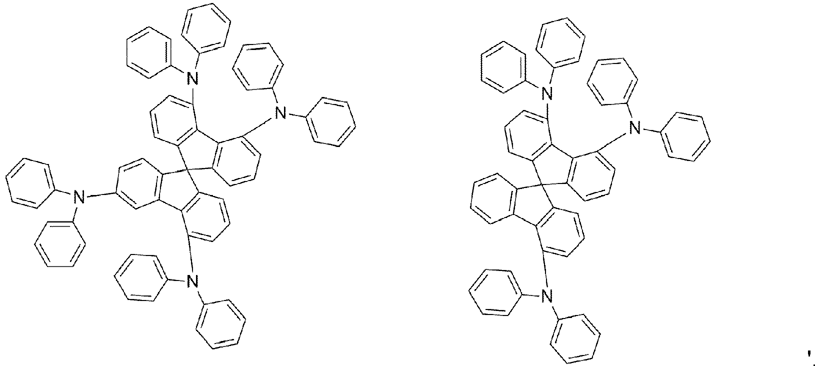

The hole transport region may have a single-layered structure including a single material, a single-layered structure including a plurality of different materials, or a multi-layered structure having a plurality of layers including a plurality of different materials.

For example, the hole transport region includes an auxiliary layer, which may include the amine-based compound. The hole transport region may further include at least one of a hole injection layer, a hole transport layer, and an electron blocking layer, but the structure of the hole transport region is not limited thereto.

In some embodiments, the hole transport region may have a single-layer structure including a plurality of different materials, or may have a structure of hole injection layer/hole transport layer/auxiliary layer, hole injection layer/auxiliary layer or hole transport layer/auxiliary layer, which are sequentially located on the first electrode 110 in this stated order, but the structure of the hole transport region is not limited thereto.

The auxiliary layer may be formed on the hole injection layer or the hole transport layer by using one or more methods selected from vacuum deposition, spin coating casting, a Langmuir-Blodgett (LB) method, ink-jet printing, laser-printing, and laser-induced thermal imaging. When the auxiliary layer is formed by vacuum deposition or spin coating, deposition and coating conditions for the auxiliary layer may be determined by referring to the deposition and coating conditions for the hole injection layer.

A thickness of the auxiliary layer may be in a range of about 1 to about 100 nm (about 10 Å to about 1,000 Å). For example, when an emission layer disposed on the auxiliary layer emits green light, a thickness of the auxiliary layer may be in a range of about 20 to 45 nm (about 200 Å to about 450 Å). In some embodiments, when an emission layer disposed on the auxiliary layer emits red light, a thickness of the auxiliary layer may be in a range of about 50 to about 100 nm (about 500 Å to about 1000 Å). When the thickness of the auxiliary layer is within these ranges, the auxiliary layer may have satisfactory hole transporting ability without a substantial increase in driving voltage. When the thickness of the auxiliary layer is within these ranges, improved efficiency may be provided. When the thickness of the auxiliary layer is within these ranges, the roll-off phenomenon may be improved.

The auxiliary layer may be adjacent to the emission layer.

When the hole transport region includes a hole injection layer, the hole injection layer may be formed on the first electrode 110 by using one or more methods selected from vacuum deposition, spin coating, casting, an LB method, ink-jet printing, laser-printing, and laser-induced thermal imaging.

When the hole injection layer is formed by vacuum deposition, conditions for the vacuum deposition may include, for example, a deposition temperature of about 100 to about 500 °C, a vacuum degree of about 10⁻⁸ to about 10⁻³ torr, and a vacuum speed of about 0,001 to about 10 nm/sec (about 0.01 to about 100Å/sec), and the conditions may be appropriately adjusted by taking into account a compound for forming the hole injection layer and the structure of the hole injection layer to be formed.

When a hole injection layer is formed by spin coating, the spin coating may be performed at a coating rate of about 2,000 rpm to about 5,000 rpm, and at a temperature of about 80°C to 200°C by taking into account a compound for a hole injection layer to be deposited, and the structure of the hole injection layer.

When the hole transport region includes a hole transport layer, the hole transport layer may be formed on the first electrode 110 or the hole injection layer by using one or more methods selected from vacuum deposition, spin coating, casting, an LB method, ink-jet printing, laser-printing, and laser-induced thermal imaging. When the hole transport layer is formed by vacuum deposition or spin coating, deposition and coating conditions for the hole transport layer may be the same as the deposition and coating conditions for the hole injection layer.

The hole transport region may include, in addition to the amine-based compound represented by Formula 2, at least one selected from m-MTDATA, TDATA, 2-TNATA, NPB, β-NPB, TPD, Spiro-TPD, Spiro-NPB, α-NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonicacid (Pani/CSA), (polyaniline)/poly(4-styrenesulfonate) (PANI/PSS), a compound represented by Formula 201 below, and a compound represented by Formula 202 below:

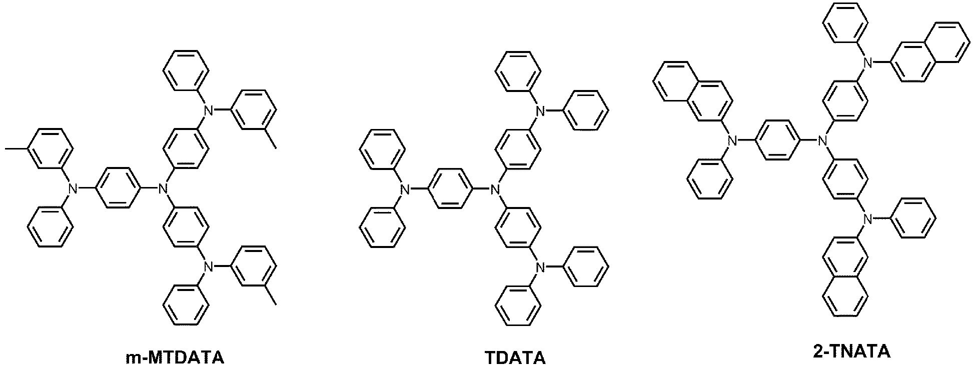

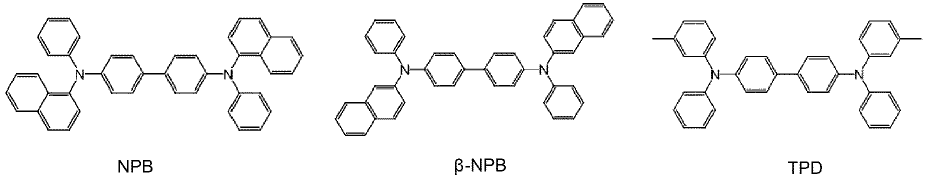

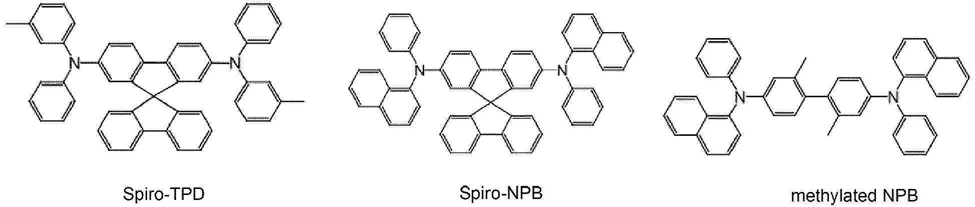

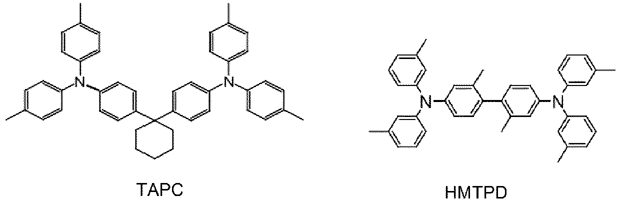

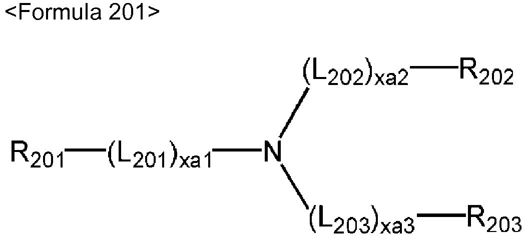

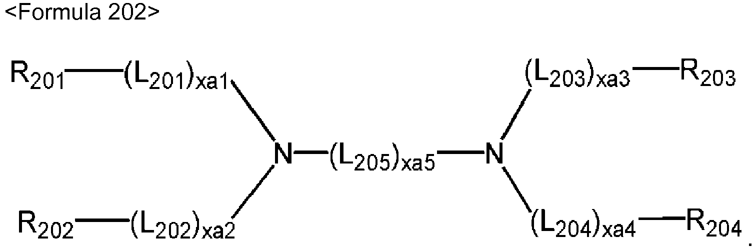

In Formulae 201 and 202,
L₂₀₁ to L₂₀₅ may be each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
at least one of substituents of the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed polycyclic group, and substituted divalent non-aromatic condensed heteropolycyclic group may be selected from
deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₀₁)(Q₂₀₂), -Si(Q₂₀₃)(Q₂₀₄)(Q₂₀₅), and -B(Q₂₀₆)(Q₂₀₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁₁)(Q₂₁₂), - Si(Q₂₁₃)(Q₂₁₄)(Q₂₁₅), and -B(Q₂₁₆)(Q₂₁₇); and
-N(Q₂₂₁)(Q₂₂₂), -Si(Q₂₂₃)(Q₂₂₄)(Q₂₂₅), and -B(Q₂₂₆)(Q₂₂₇),
xa1 to xa4 may be each independently selected from 0, 1, 2, and 3;
xa5 may be selected from 1, 2, 3, 4, and 5;
R₂₀₁ to R₂₀₅ may be each independently selected from
a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₃₁)(Q₂₃₂), -Si(Q₂₃₃)(Q₂₃₄)(Q₂₃₅), and -B(Q₂₃₆)(Q₂₃₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group; and
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₄₁)(Q₂₄₂), - Si(Q₂₄₃)(Q₂₄₄)(Q₂₄₅), and -B(Q₂₄₆)(Q₂₄₇),
wherein Q₂₀₁ to Q₂₀₇, Q₂₁₁ to Q₂₁₇, Q₂₂₁ to Q₂₂₇, Q₂₃₁ to Q₂₃₇, and Q₂₄₁ to Q₂₄₇ are each independently hydrogen, deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group; and
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, in Formulae 201 and 202,
L₂₀₁ to L₂₀₅ may be each independently selected from a phenylene group, a naphthylenylene group, a fluorenylene group, a spiro-fluorenylene group, a benzofluorenylene group, a dibenzofluorenylene group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group; and
a phenylene group, a naphthylenylene group, a fluorenylene group, a spiro-fluorenylene group, a benzofluorenylene group, a dibenzofluorenylene group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, each substituted with at least one selected from deuterium, - F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, an isoindolyl group, a quinolinyl group, an isoquinolinyl group, a quinoxalinyl group, a quinazolinyl group, a carbazolyl group, and a triazinyl group;
xa1 to xa4 may be each independently 0, 1, or 2;
xa5 may be 1, 2, or 3;
R₂₀₁ to R₂₀₅ may be each independently selected from a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, an azulenyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, but they are not limited thereto.

The compound represented by Formula 201 may be represented by Formula 201A:

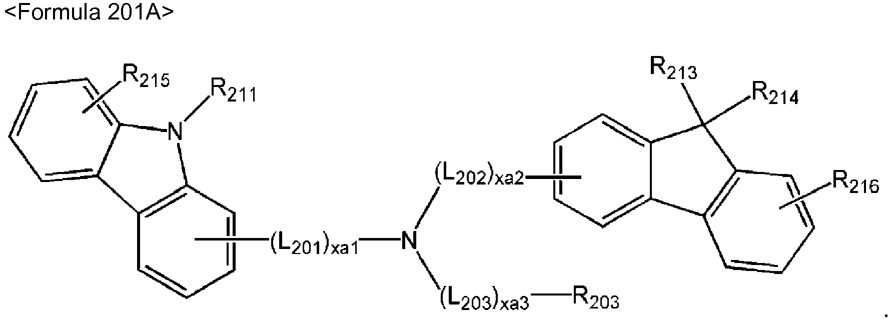

For example, the compound represented by Formula 201 may be represented by Formula 201A-1, but the structure thereof is not limited thereto:

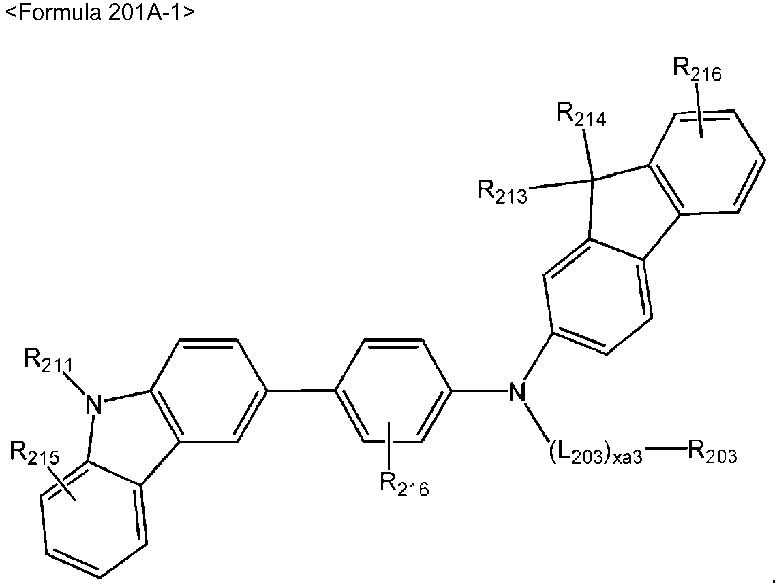

The compound represented by Formula 202 may be represented by Formula 202A, but the structure thereof is not limited thereto: 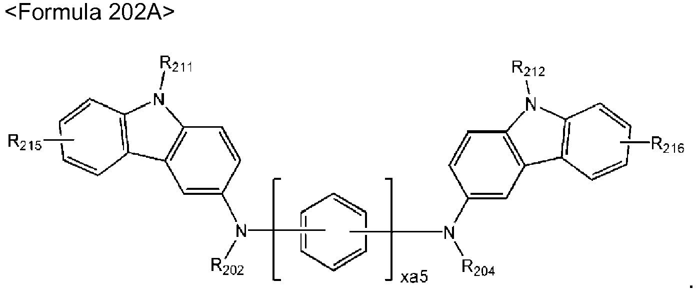 Regarding Formulae 201A, 201A-1, and 202A, L₂₀₁ to L₂₀₃, xa1 to xa3, xa5, and R₂₀₂ to R₂₀₄ are already described above, R₂₁₁ and R₂₁₂ may be understood by referring to descriptions of R₂₀₃ and R₂₁₃ to R₂₁₆ are each independently selected from hydrogen, deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, in Formulae 201A, 201A-1, and 202A,
L₂₀₁ to L₂₀₃ may be each independently selected from a phenylene group, a naphthylenylene group, a fluorenylene group, a spiro-fluorenylene group, a benzofluorenylene group, a dibenzofluorenylene group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group; and
a phenylene group, a naphthylenylene group, a fluorenylene group, a spiro-fluorenylene group, a benzofluorenylene group, a dibenzofluorenylene group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, each substituted with at least one selected from deuterium, - F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
xa1 to xa3 may be each independently 0 or 1;
R₂₀₃, R₂₁₁, and R₂₁₂ may be each independently selected from a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
R₂₁₃ and R₂₁₄ may be each independently selected from
a C₁-C₂₀ alkyl group and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
R₂₁₅ and R₂₁₆ may be each independently selected from hydrogen, deuterium, -F, -CI, -Br, -I, a hydroxyl group, a cyano group, a nitro group, an amino group, an amidino group, a hydrazine group, a hydrazone group, a carboxyl group or a salt thereof, a sulfonic acid or a salt thereof, and a phosphoric acid or a salt thereof,
a C₁-C₂₀ alkyl group and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, and a triazinyl group; and
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
xa5 is 1 or 2.
R₂₁₃ and R₂₁₄ in Formulae 201A and 201A-1 may be linked to each other to form a saturated or unsaturated ring.

The compound represented by Formula 201 and the compound represented by Formula 202 may each be selected from Compounds HT1 to HT20, but they are not limited thereto:

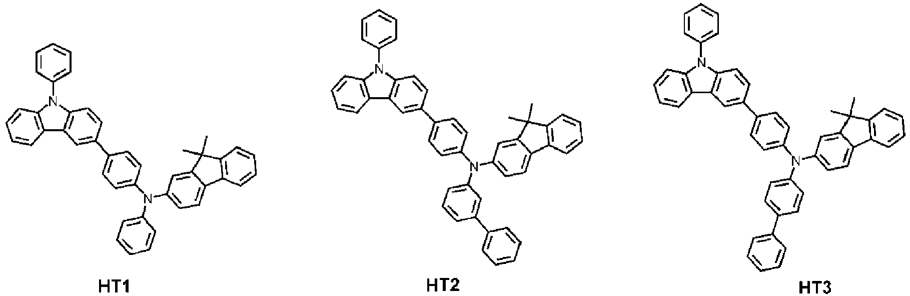

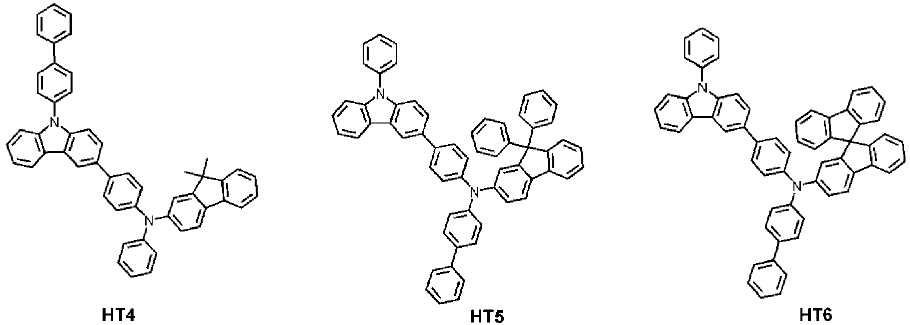

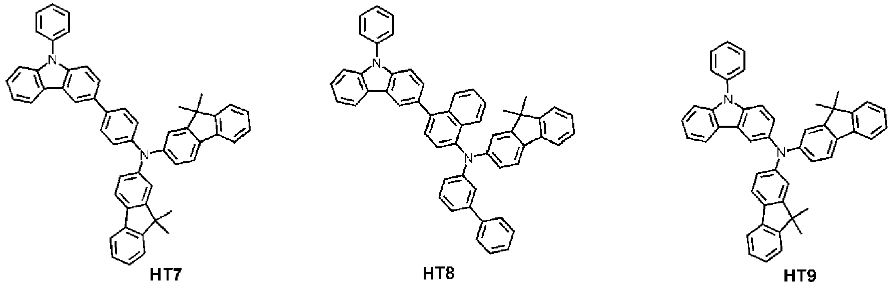

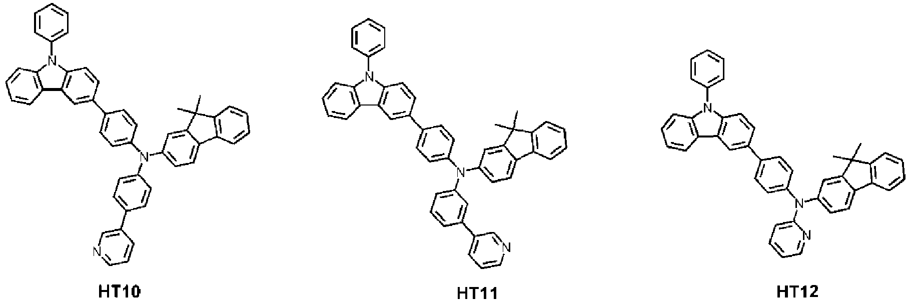

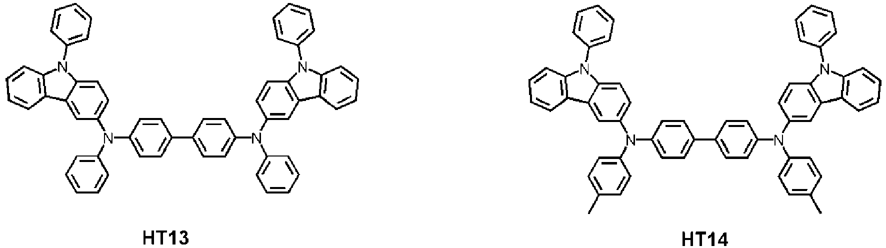

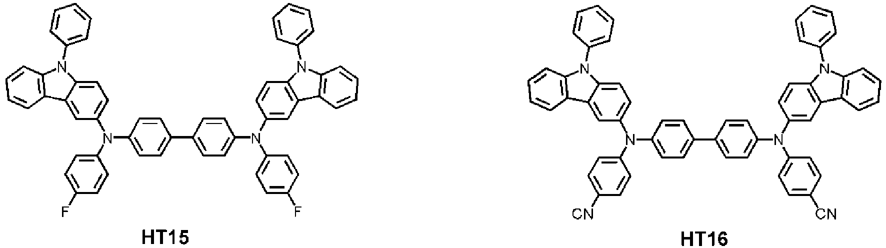

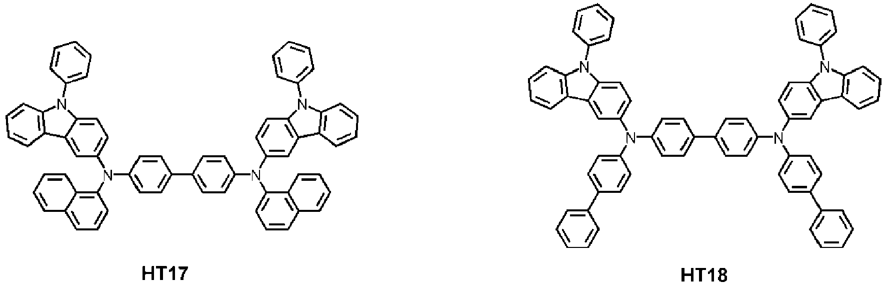

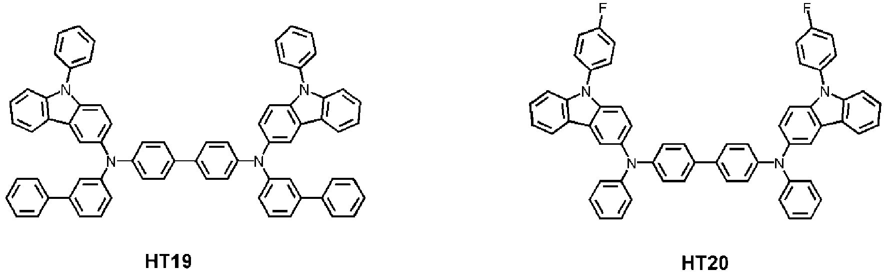

A thickness of the hole transport region may be in a range of about 100 Å to about 10,000 Å, for example, about 100 Å to about 2,000 Å. When the hole transport region includes both a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2000 Å, for example, about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or unhomogeneously dispersed in the hole transport region.

The charge-generation material may be, for example, a p-dopant. The p-dopant may be one selected from a quinone derivative, a metal oxide, and a cyano group-containing compound, but embodiments are not limited thereto. For example, non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenum oxide, and Compound HT-D1 illustrated below, but are not limited thereto.

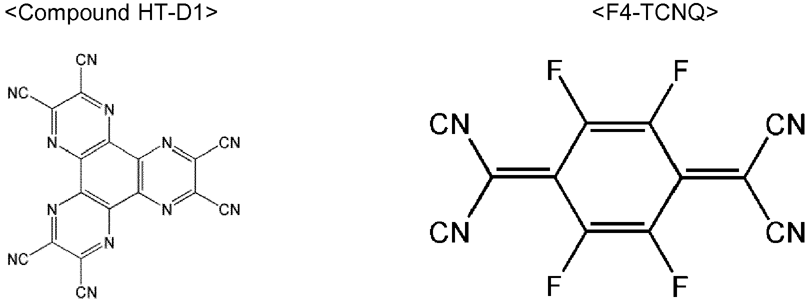

The hole transport region may further include, in addition to the hole injection layer and the hole transport layer, at least one of a buffer layer and an electron blocking layer. Since the buffer layer may compensate for an optical resonance distance according to a wavelength of light emitted from the emission layer, light-emission efficiency of a formed organic light-emitting device may be improved. For use as a material included in the buffer layer, materials that are included in the hole transport region may be used. The electron blocking layer prevents injection of electrons from the electron transport region.

An emission layer is formed on the first electrode 110 or the hole transport region by using one or more methods selected from vacuum deposition, spin coating, casting, an LB method, ink-jet printing, laser-printing, and laser-induced thermal imaging. When an emission layer is formed by vacuum deposition or spin coating, deposition and coating conditions for the emission may be the same as those for the hole injection layer.

When the organic light-emitting device 10 is a full color organic light-emitting device, the emission layer may be patterned into a red emission layer, a green emission layer, or a blue emission layer, according to a sub pixel. In some embodiments, the emission layer may have a stacked structure of a red emission layer, a green emission layer, and a blue emission layer, or may include a red-light emission material, a green-light emission material, and a blue-light emission material, which are mixed with each other in a single layer, to emit white light. In some embodiments, the emission layer may be a white emission layer, and may further include a color converting layer or a color filter to turn white light into light of a desired color.

The emission layer may include a host and a dopant.

The host may include at least one selected from TPBi, TBADN, AND, CBP, CDBP, and TCP:

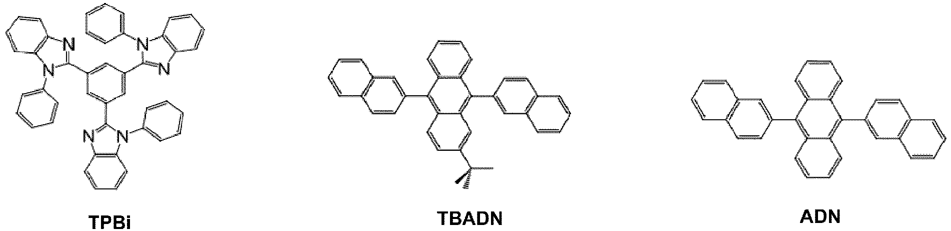

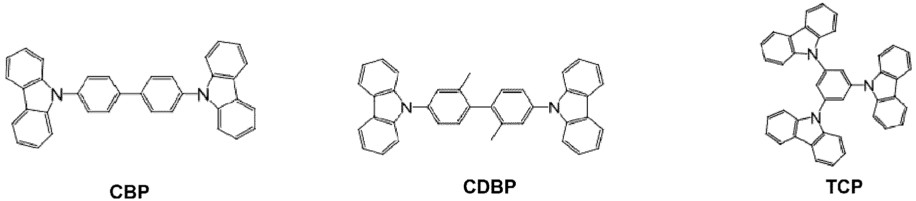

In some embodiments, the host may include a compound represented by one of Formulae 301 to 303:

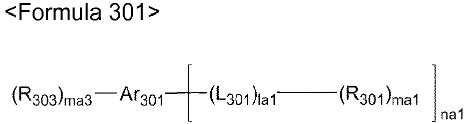

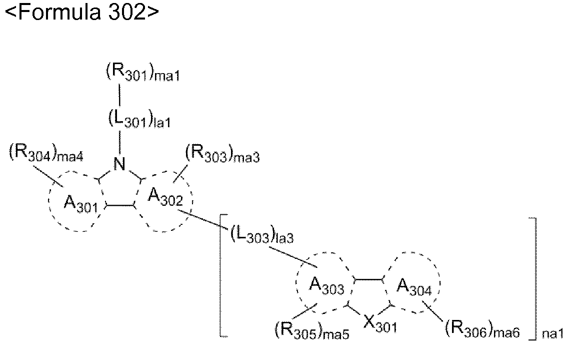

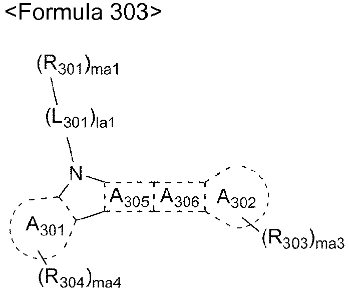

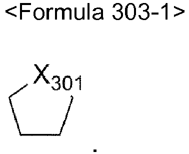

In Formulae 301 to 303 and 303-1,
A₃₀₁ may be selected from a naphthalene, a heptalene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentaphene, and an indenoanthracene;
a naphthalene, a heptalene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentaphene, and an indenoanthracene, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, and -Si(Q₃₀₁)(Q₃₀₂)(Q₃₀₃) (wherein Q₃₀₁ to Q₃₀₃ are each independently selected from hydrogen, a C₁-C₆₀ alkyl group, a C₂-C₆₀ alkenyl group, a C₆-C₆₀ aryl group, and a C₁-C₆₀ heteroaryl group);
A₃₀₁ to A₃₀₄ are each independently selected from a benzene, a naphthalene, a pyridine, a pyrimidine, a pyrazine, a quinoline, an isoquinoline, a 2,6-naphthyridine, a 1,8-naphthyridine, a 1,5-naphthyridine, a 1,6-naphthyridine, a 1,7-naphthyridine, a 2,7-naphthyridine, a quinoxaline, a phthalazine, and a quinazoline;
A₃₀₅ is selected from a benzene and a naphthalene;
A₃₀₆ is represented by one of Formulae 303-1;
X₃₀₁ is selected from N-[(L₃₀₂)ₗₐ₂-(R₃₀₂)ₘₐ₂], an oxygen atom (O), a sulfur atom (S), C(R₃₀₇)(R₃₀₈), Si(R₃₀₇)(R₃₀₈), B(R₃₀₇), P(R₃₀₇), and P(=O)(R₃₀₇);
L₃₀₁ to L₃₀₃ may be each independently understood by referring to the descriptions of L₂₀₁;
R₃₀₁ and R₃₀₂ may be each independently selected from
a C₁-C₂₀ alkyl group and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, and a triazinyl group; and
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
R₃₀₃ to R₃₀₈ may be each independently understood by referring to the descriptions of Q₂₀₁;
la1 to la3 may be each independently selected from 0, 1, 2, and 3;
ma1 to ma6 may be each independently selected from 1, 2, 3, 4, 5, and 6;
na1 may be selected from 1, 2, 3, and 4.

For example, L₃₀₁ to L₃₀₃ in Formula 301 may be each independently selected from a phenylene group, a naphthylene group, a fluorenylene group, a spiro-fluorenylene group, a benzofluorenylene group, a dibenzofluorenylene group, a phenanthrenylene group, an anthracenylene group, a pyrenylene group, and a chrysenylene group; and
a phenylene group, a naphthylene group, a fluorenylene group, a spiro-fluorenylene group, a benzofluorenylene group, a dibenzofluorenylene group, a phenanthrenylene group, an anthracenylene group, a pyrenylene group, and a chrysenylene group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, and a chrysenyl group; and
R₃₀₁ and R₃₀₂ may be each independently selected from
a C₁-C₂₀ alkyl group and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, and a chrysenyl group;
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, and a chrysenyl group; and
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, and a chrysenyl group, each substituted with at least one selected from deuterium, -F, -Cl, -Br, -I, a hydroxyl group, a cyano group, a nitro group, an amino group, an amidino group, a hydrazine group, a hydrazone group, a carboxyl group or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, and a chrysenyl group, but they are not limited thereto.

For example, the host may include a compound represented by one of Formulae 301A, 301B, 301C, 302A, 303A, 303B, 303C, 303D, 303E, 303F, 303G, 303H, 303I, and 303J:

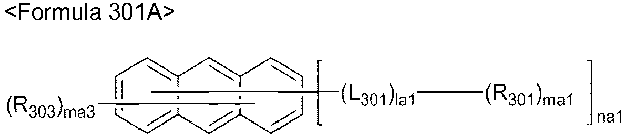

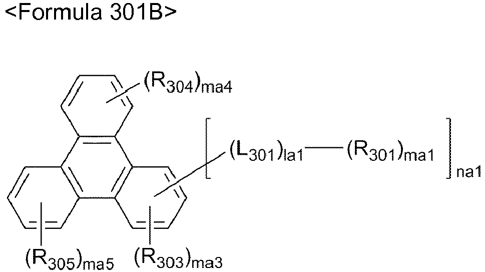

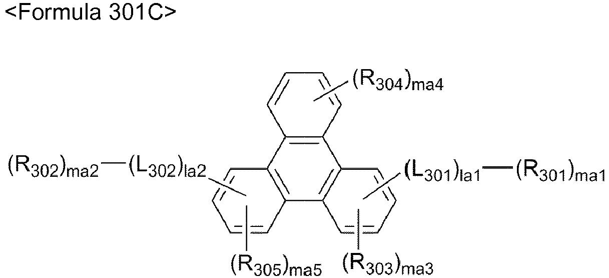

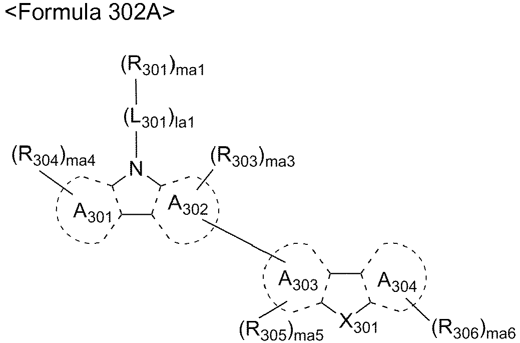

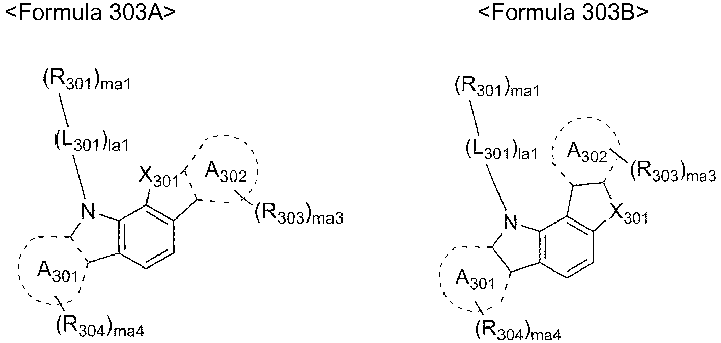

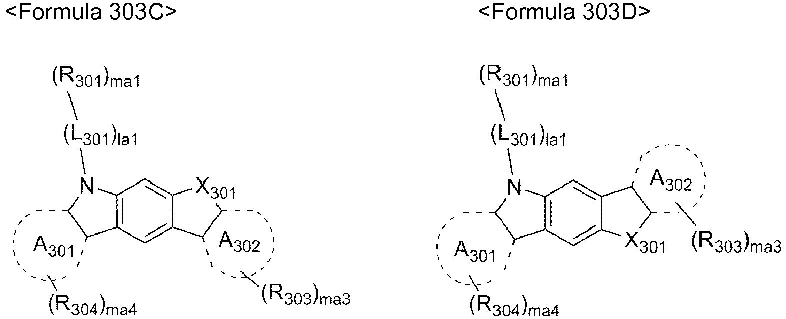

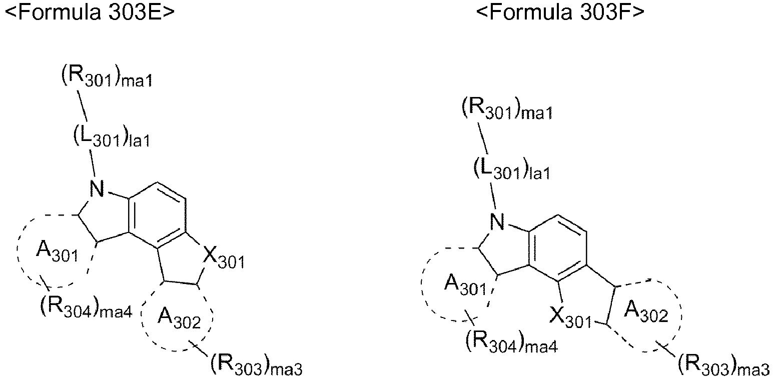

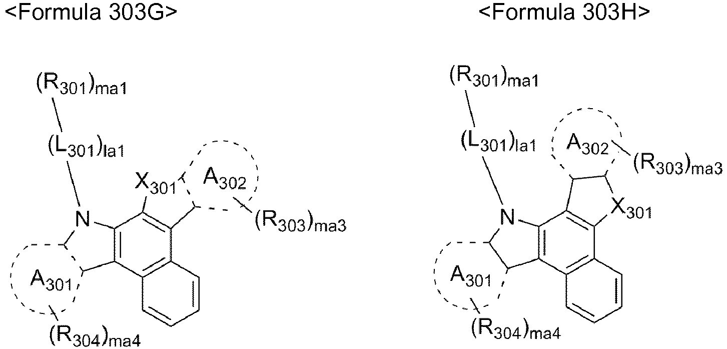

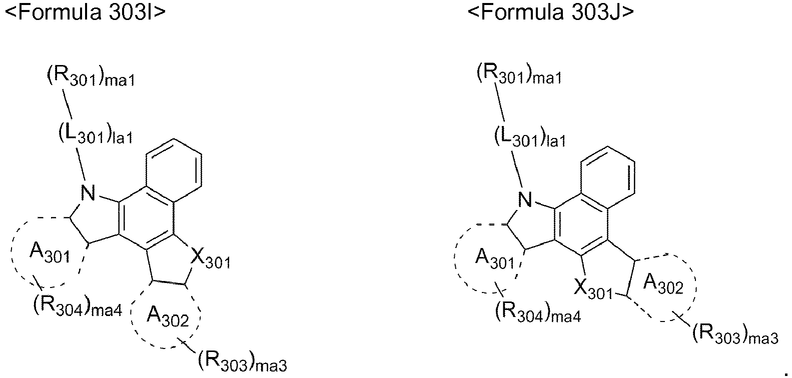

Substituents in Formulae 301A, 301B, 301C, 302A, 303A, 303B, 303C, 303D, 303E, 303F, 303G, 303H, 303I, and 303J may be the same as described above.

A compound represented by one of Formulae 301 to 303 may be represented by one of Compounds H43 to H129, but is not limited thereto:

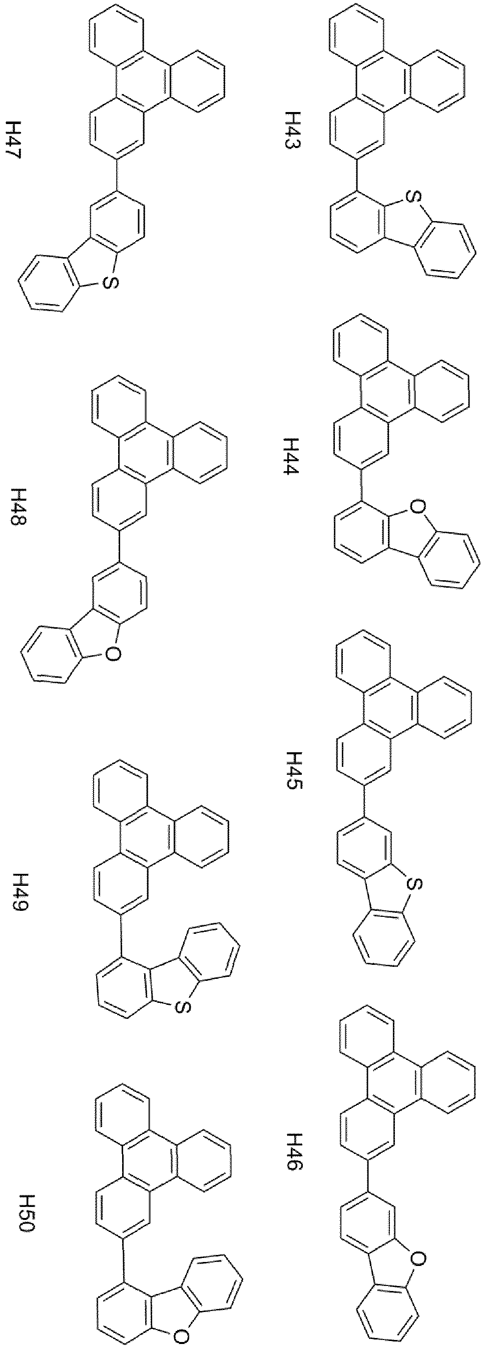

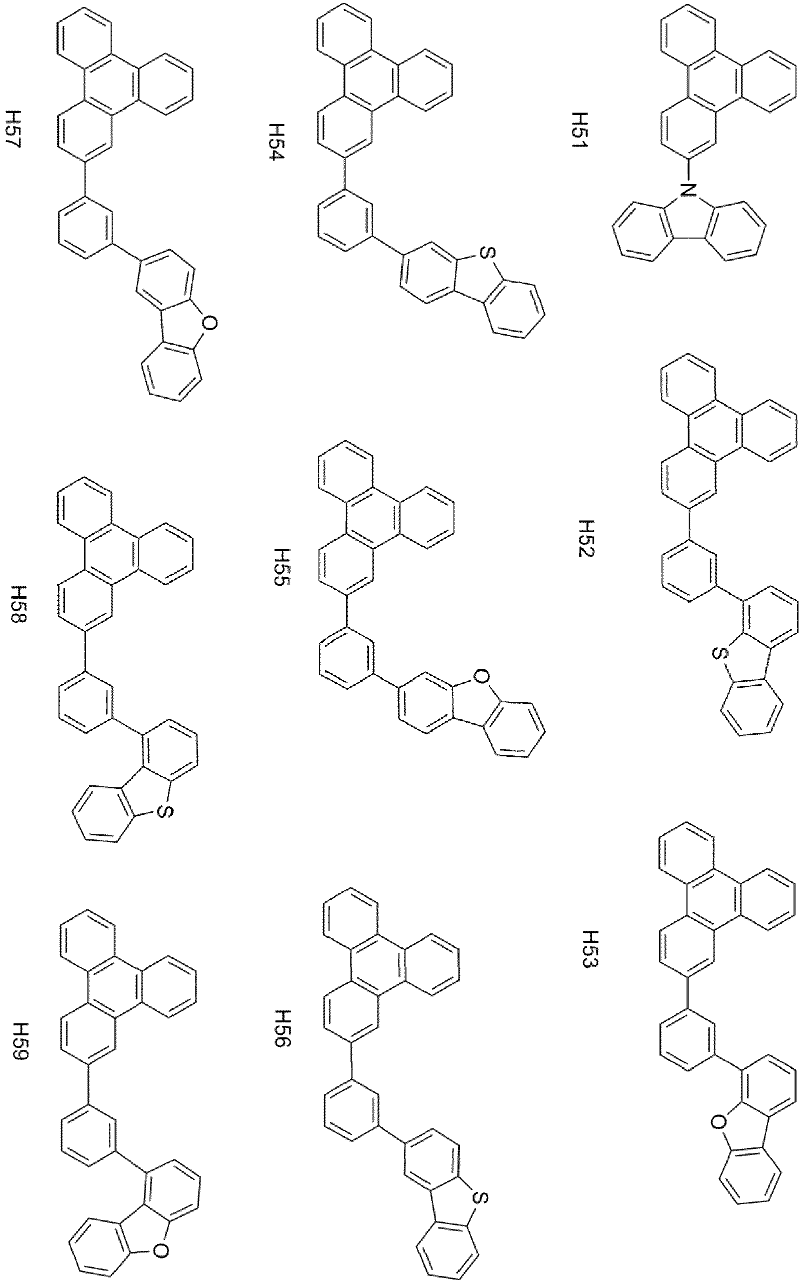

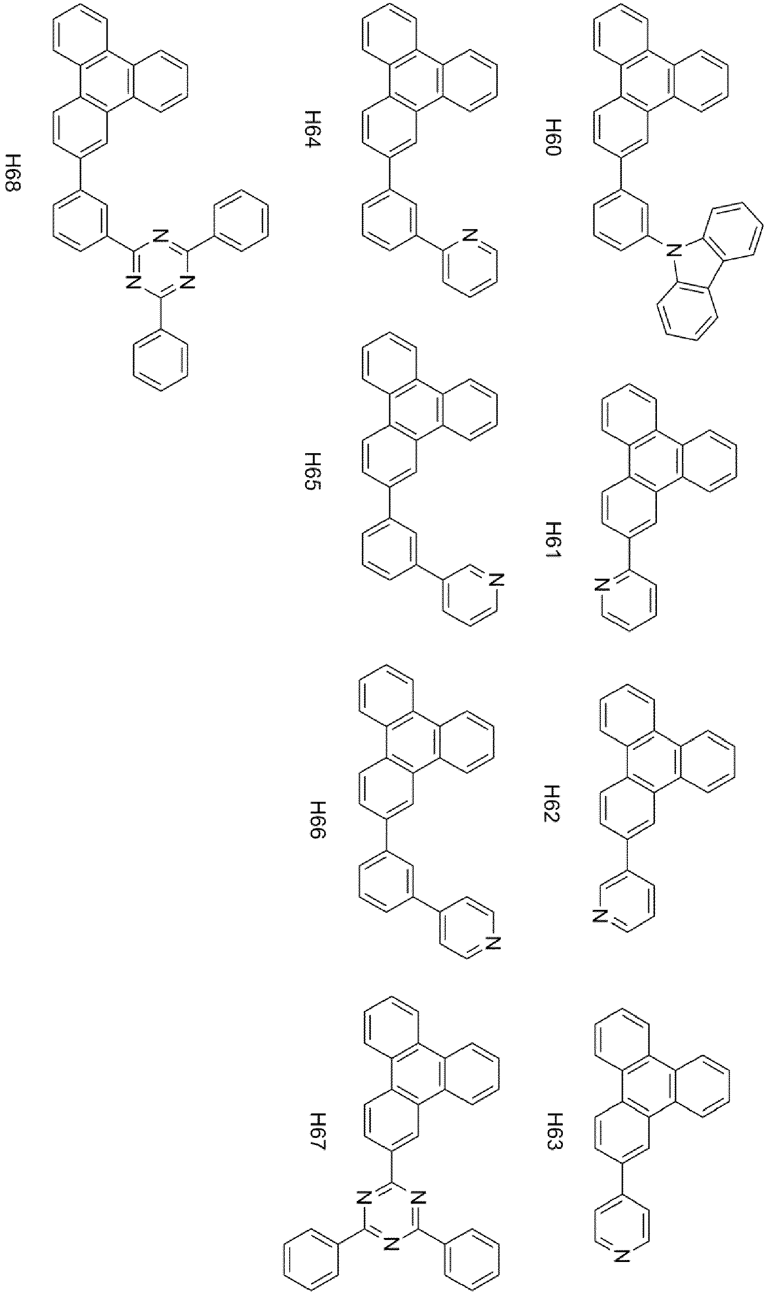

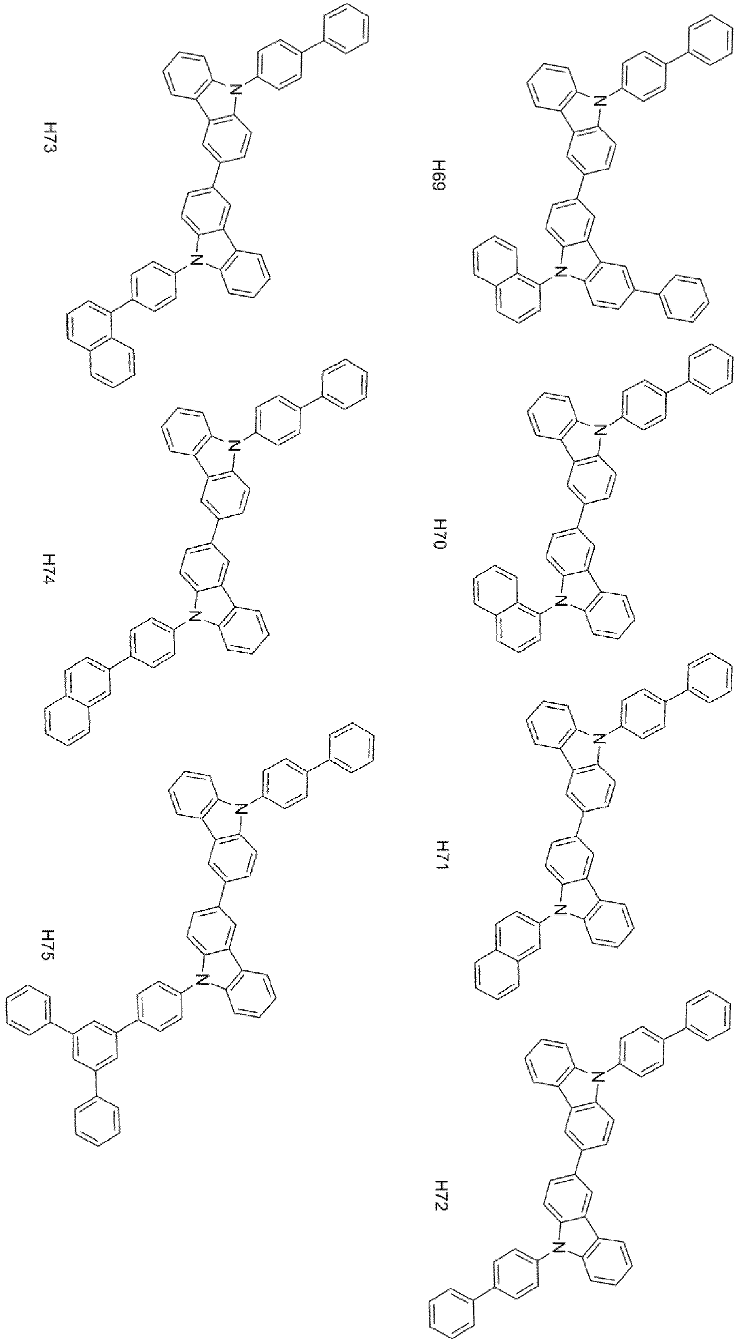

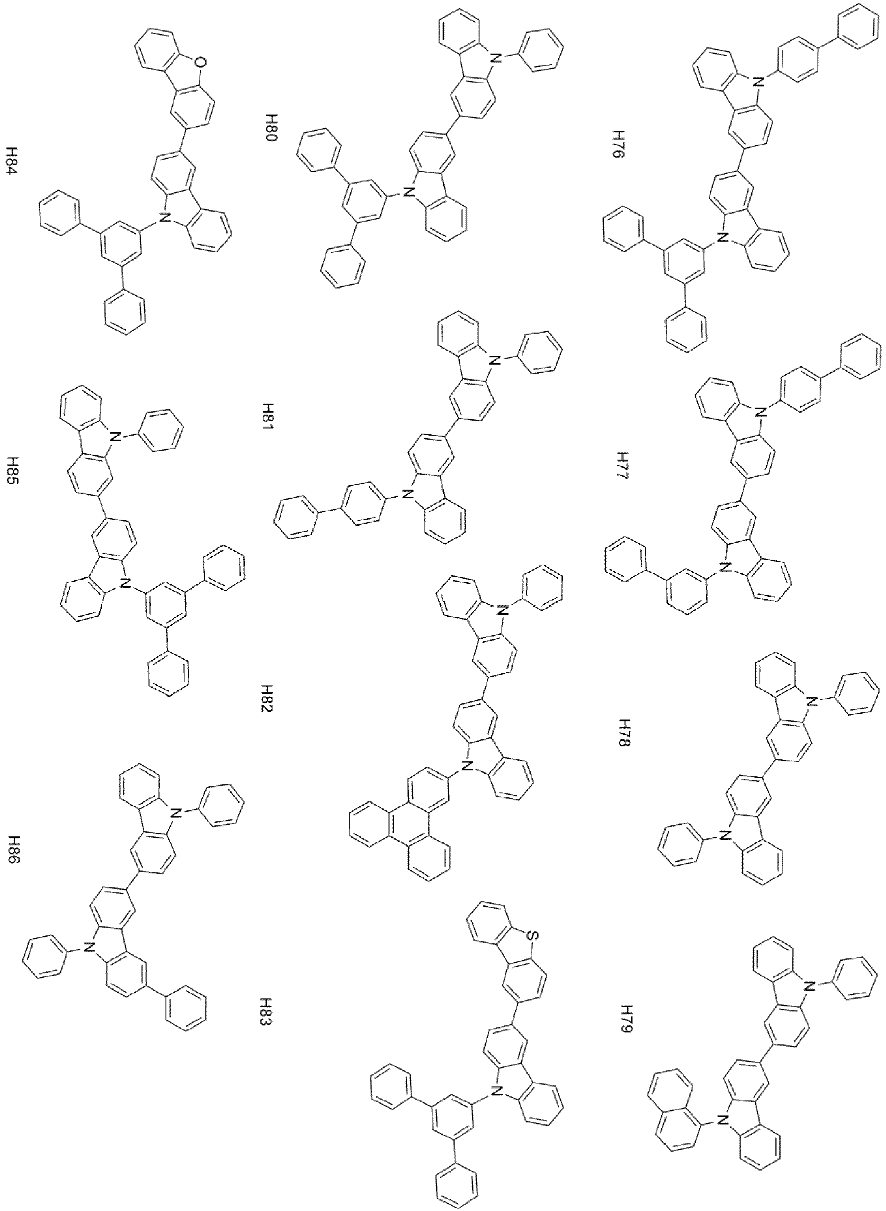

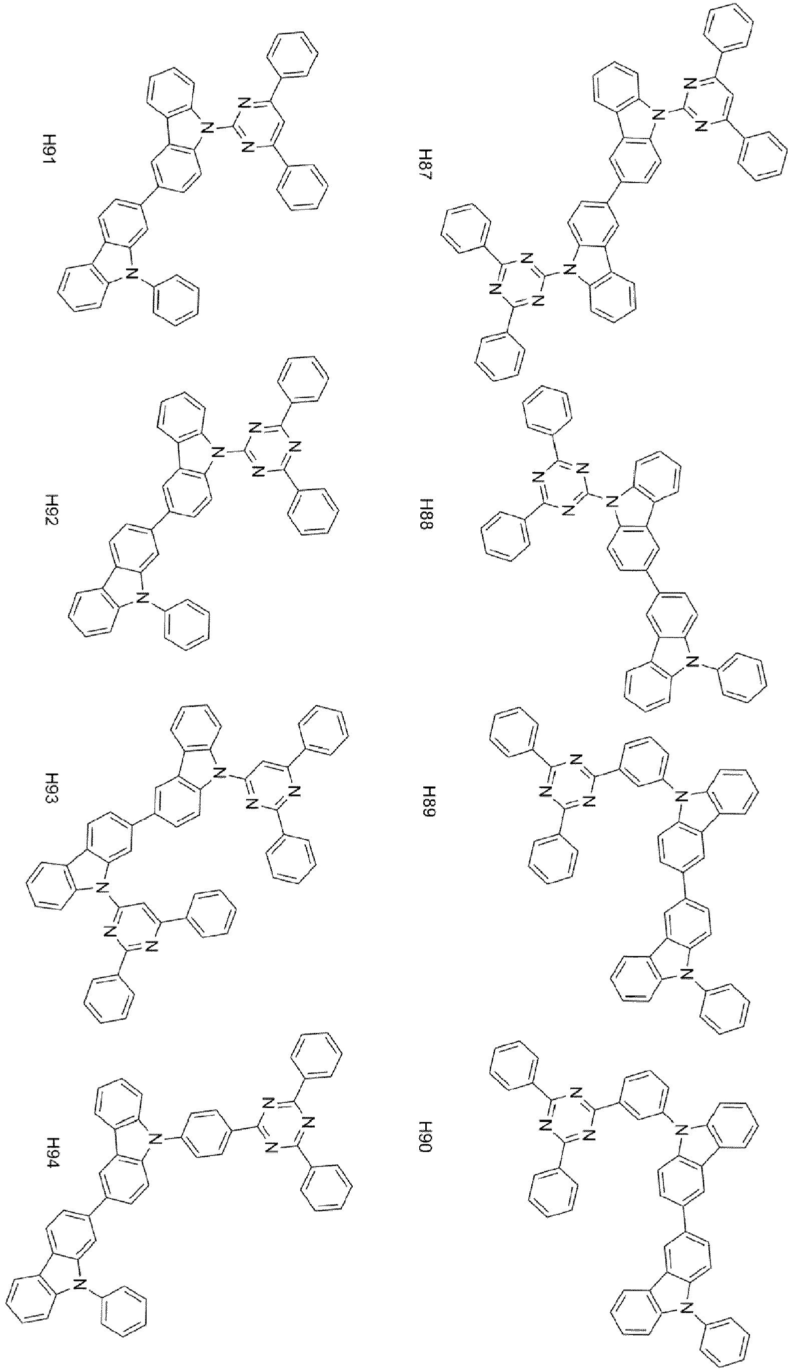

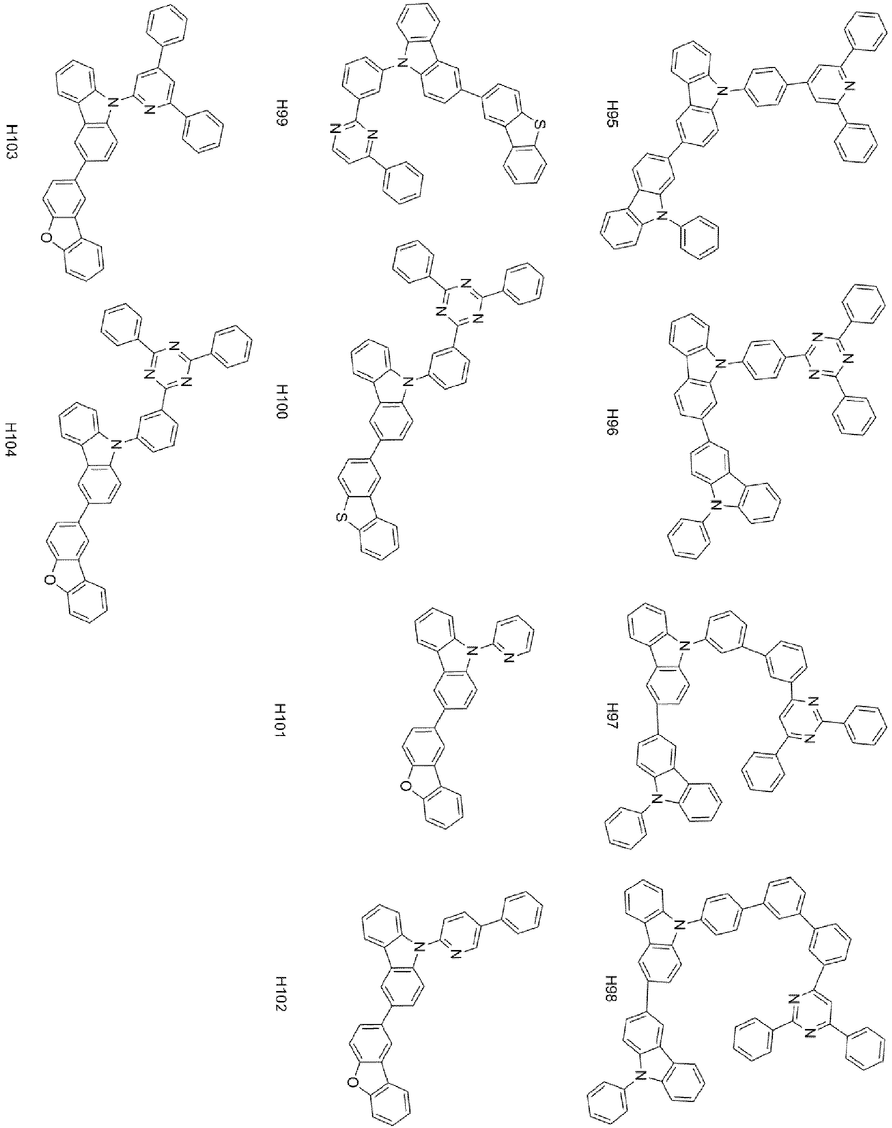

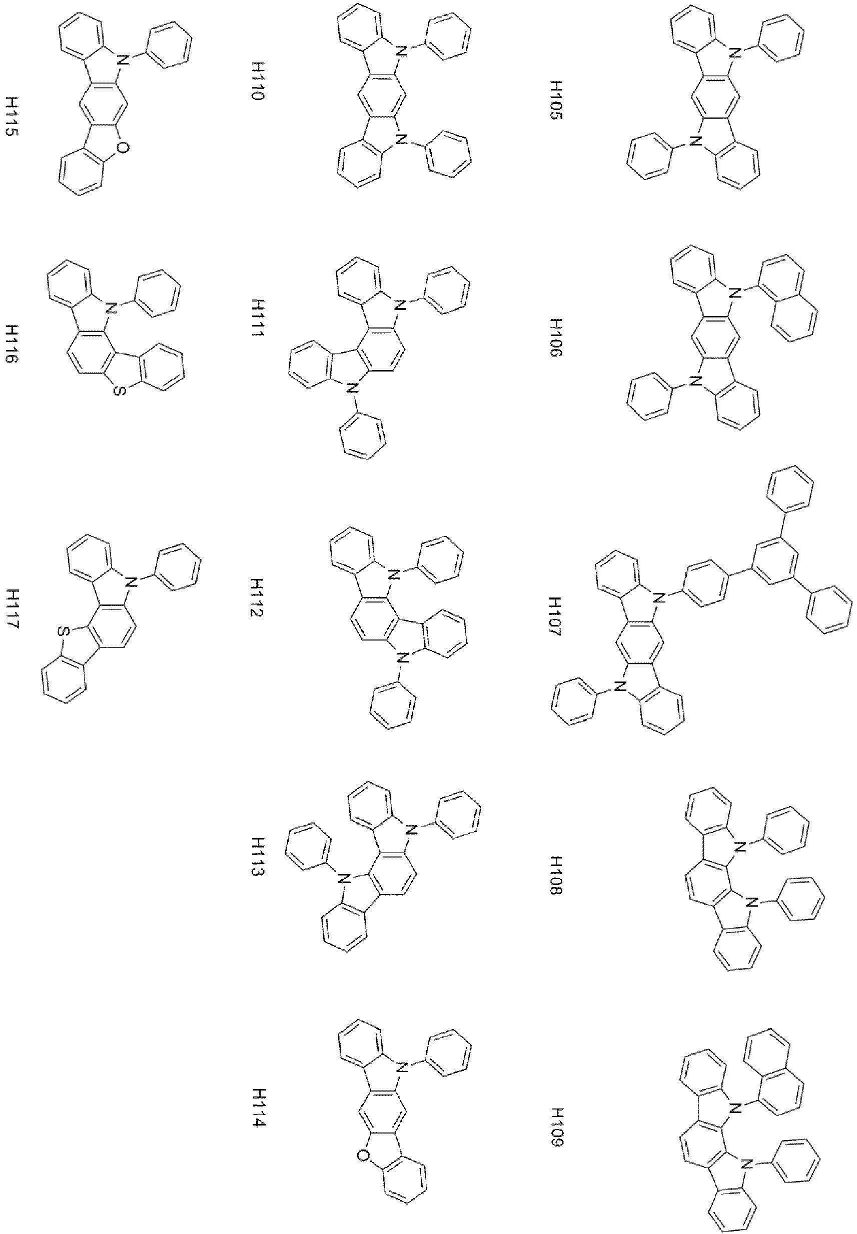

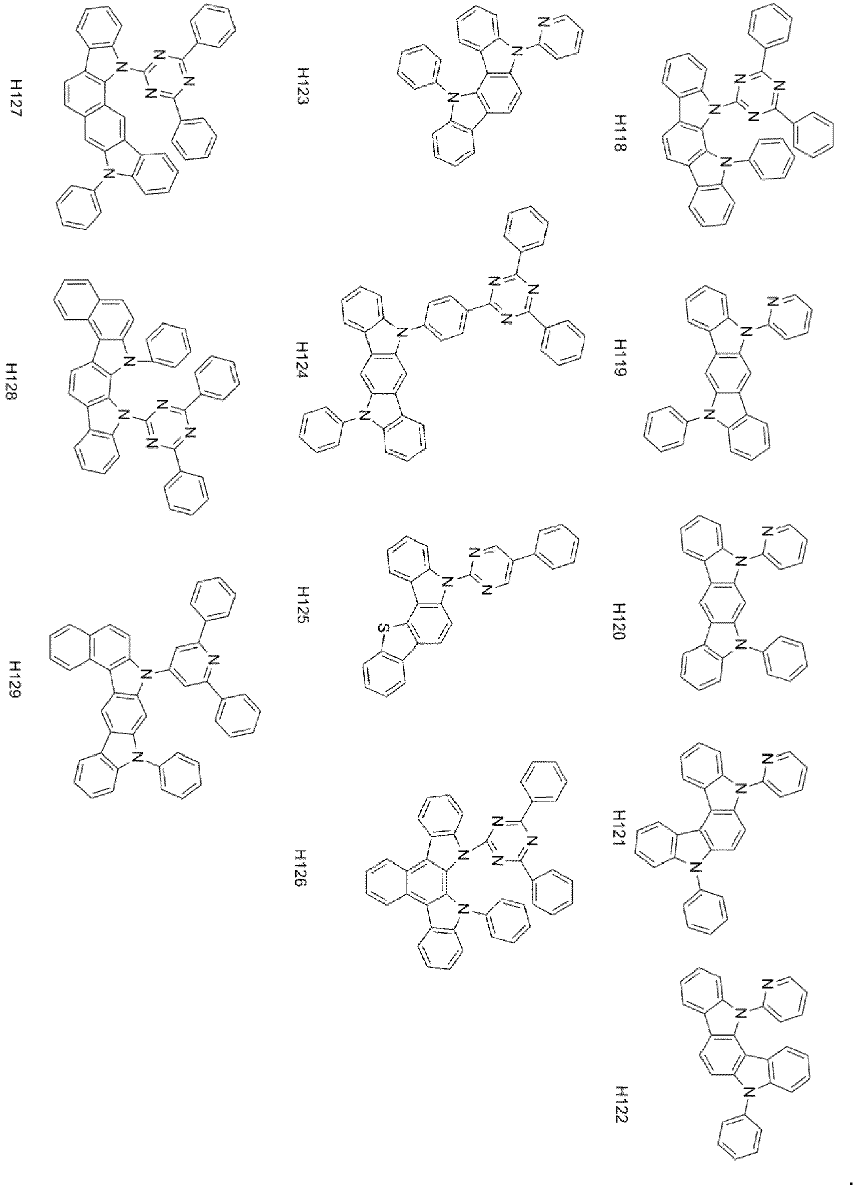

In some embodiments, the host may include at least one selected from Compounds H130 to H132, but is not limited thereto:

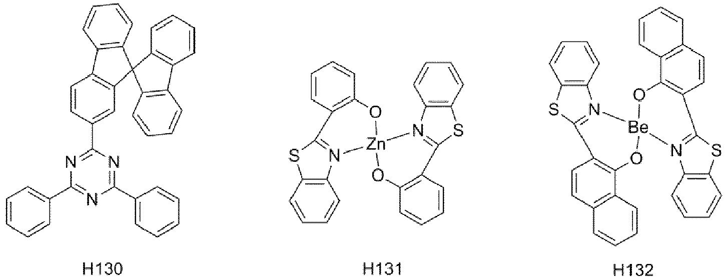

The dopant may include at least one phosphorescent dopant.

The at least one phosphorescent dopant may include the organometallic compound represented by Formula 1:

<Formula 1> M(L₁)ₙ₁(L₂)ₙ₂.

M in Formula 1 is selected from iridium (Ir), platinum (Pt), osmium (Os), titanium (Ti), zirconium (Zr), hafnium (Hf), europium (Eu), terbium (Tb), thulium (Tm), and rhodium (Rh). For example, M in Formula 1 may be selected from Os, Ir, and Pt, but is not limited thereto. In some embodiments, M in Formula 1 may be Ir, but is not limited thereto.
L₁ in Formula 1 is a ligand represented by Formula 1A;
L₂ in Formula 1 is a ligand represented by Formula 1B; and
L₁ and L₂ may be different from each other;

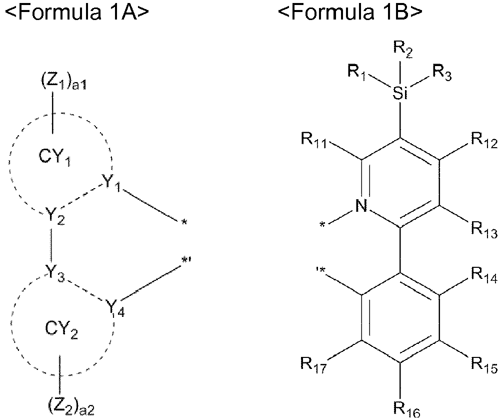

Descriptions of substituents in Formulae 1A and 1B will be provided below.
n1 in Formula 1 indicates the number of L₁(s), and n1 may be 1 or 2. When n1 is 2, two L₁(s) may be identical to or different from each other.
n2 in Formula 1 indicates the number of L₂ (s), and n2 may be 1 or 2. When n2 is 2, two L₂(s) may be identical to or different from each other.

The sum of n1 and n2 in Formula 1 may be 2 or 3. For example, the sum of n1 and n2 in Formula 1 may be 3, but is not limited thereto.

Y₁ to Y₄ are each independently carbon (C) or nitrogen (N), Y₁ and Y₂ are linked to each other via a single bond or a double bond, and Y₃ and Y₄ are linked to each other via a single bond or a double bond,

For example, in Formula 1A, Y₁ may be N and Y₂ to Y₄ may each be C, but they are not limited thereto.

CY₁ and CY₂ in Formula 1A may be each independently selected from a C₅-C₆₀ cyclic group and a C₂-C₆₀ heterocyclic group, and CY₁ and CY₂ may be optionally linked to each other via a single bond or a first linking group.

For example, CY₁ and CY₂ in Formula 1A may be each independently selected from a benzene, a naphthalene, a fluorene, a spiro-fluorene, an indene, a furan, a thiophene, a carbazole, a benzofuran, a benzothiophene, a dibenzofuran, a dibenzothiophene, a pyrrole, an imidazole, a pyrazole, a thiazole, an isothiazole, an oxazole, an isooxazole, a triazole, a pyridine, a pyrazine, a pyrimidine, a quinoline, an isoquinoline, a benzoquinoline, a quinoxaline, a quinazoline, a naphthyridine, an indole, a benzimidazole, a benzoxazole, an isobenzoxazole, an oxadiazole, and a triazine, but they are not limited thereto.

In some embodiments, CY₁ in Formula 1A may be selected from a pyrrole, an imidazole, a pyrazole, a thiazole, an isothiazole, an oxazole, an isooxazole, a triazole, a pyridine, a pyrazine, a pyrimidine, a quinoline, an isoquinoline, a benzoquinoline, a quinoxaline, a quinazoline, a naphthyridine, a benzimidazole, a benzoxazole, an isobenzoxazole, an oxadiazole, and a triazine, but is not limited thereto.

In some embodiments, CY₁ in Formula 1A may be selected from a pyrrole, an imidazole, a pyrazole, a triazole, a pyridine, a pyrimidine, a pyrazine, a quinoline, an isoquinoline, and oxadiazole, and a triazine, but is not limited thereto.

In some embodiments, CY₁ in Formula 1A may be selected from a pyrrole, an imidazole, a pyrazole, a triazole, a pyridine, a pyrimidine, a pyrazine, and a triazine, but is not limited thereto.

In some embodiments, CY₂ in Formula 1A may be selected from a benzene, a naphthalene, a fluorene, a carbazole, a furan, a thiophene, a benzofuran, a benzothiophene, a dibenzofuran, a dibenzothiophene, a pyridine, a pyrazine, a pyrimidine, a quinoline, an isoquinoline, a benzoquinoline, a quinoxaline, a quinazoline, a naphthyridine, an indole, an oxadiazole, and a triazine, but is not limited thereto.

In some embodiments, CY₂ in Formula 1A may be selected from a benzene, a naphthalene, a fluorene, a carbazole, a furan, a thiophene, a benzofuran, a benzothiophene, a dibenzofuran, a dibenzothiophene, an indole, a pyridine, a pyrimidine, a pyrazine, and a triazine, but is not limited thereto.

In some embodiments, CY₂ in Formula 1A may be selected from a benzene, a pyridine, a pyrimidine, a pyrazine, a triazine, a carbazole, a dibenzofuran, and a dibenzothiophene, but is not limited thereto.

In some embodiments, in Formula 1A,
CY₁ may be selected from a pyrrole, an imidazole, a pyrazole, a triazole, a pyridine, a pyrimidine, a pyrazine, a triazine, a quinoline, an isoquinoline, and an oxadiazole; and
CY₂ may be selected from a benzene, a naphthalene, a fluorene, a carbazole, a furan, a thiophene, a benzofuran, a benzothiophene, a dibenzofuran, a dibenzothiophene, an indole, a pyridine, a pyrimidine, a pyrazine, an oxadiazole, and a triazine, but they are not limited thereto.
R₁ to R₃ in Formula 1B may be each independently selected from
a C₁-C₁₀ alkyl group; and
a C₁-C₁₀ alkyl group, substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, and a phosphoric acid or a salt thereof.

For example, R₁ to R₃ in Formula 1B may be each independently selected from
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group; and
a methyl group, an ethyl group, an n-propyl group, an iso-propyl group, an n-butyl group, an iso-butyl group, a sec-butyl group, a tert-butyl group, an n-pentyl group, an iso-pentyl group,
a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, and a phosphoric acid or a salt thereof, but they are not limited thereto.

In some embodiments, R₁ to R₃ in Formula 1B may be each independently selected from
a methyl group, an ethyl group, an n-propyl group, an iso-propyl group, an n-butyl group, an iso-butyl group, a sec-butyl group, a tert-butyl group, an n-pentyl group, an isopentyl group, a sec-pentyl group, and a tert-pentyl group; and
a methyl group, an ethyl group, an n-propyl group, an iso-propyl group, an n-butyl group, an iso-butyl group, a sec-butyl group, a tert-butyl group, an n-pentyl group, an isopentyl group, a sec-pentyl group, and a tert-pentyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, and a phosphoric acid or a salt thereof, but they are not limited thereto.

In some embodiments, R₁ to R₃ in Formula 1B may be each independently selected from a methyl group, an ethyl group, an n-propyl group, an iso-propyl group, an n-butyl group, an iso-butyl group, a sec-butyl group, and a tert-butyl group, but they are not limited thereto.

In some embodiments, R₁ to R₃ in Formula 1B may be identical to each other, but they are not limited thereto.

Z₁, Z₂, and R₁₁ to R₁₇ in Formulae 1A and 1B may be each independently selected from hydrogen, deuterium, a hydroxyl group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), and -B(Q₆)(Q₇), provided that R₁₂ is not hydrogen and two neighboring substituents selected from R₁₄ to R₁₇ may be optionally linked to each other to form a condensed ring; and
at least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and a substituted monovalent non-aromatic condensed heteropolycyclic group may be selected from
deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro
group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇),
wherein Q₁ to Q₇, Q₁₁ to Q₁₇, Q₂₁ to Q₂₇, and Q₃₁ to Q₃₇ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, Z₁, Z₂, and R₁₁ to R₁₇ in Formulae 1A and 1B may be each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or salt thereof, a sulfonic acid or salt thereof, a phosphoric acid or salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, provided that
R₁₂ is not hydrogen.

In some embodiments, Z₁, Z₂, and R₁₁ to R₁₇ in Formulae 1A and 1B may be each independently selected from hydrogen, -F, a cyano group, a nitro group, -SF₅, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a phenyl group, a naphthyl group, a pyridinyl group, and a pyrimidinyl group; and
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a phenyl group, a naphthyl group, a pyridinyl group, and a pyrimidinyl group, each substituted with at least one selected from -F, a cyano group, and a nitro group, provided that
R₁₂ is not hydrogen.

For example, the organometallic compound represented by Formula 1 may be selected from Compounds PD-1 to PD-192 excluded PD-80, but the structure thereof is not limited thereto:

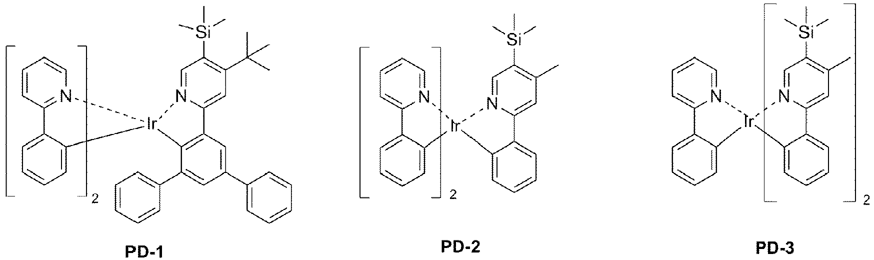

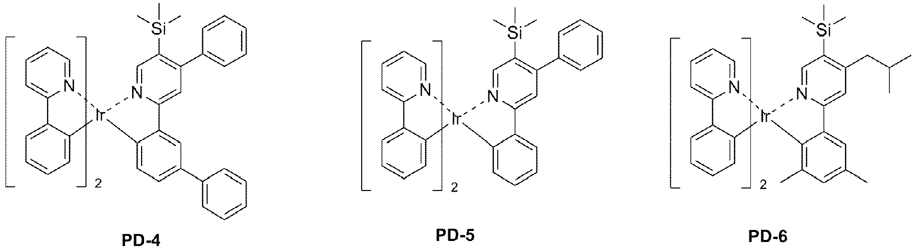

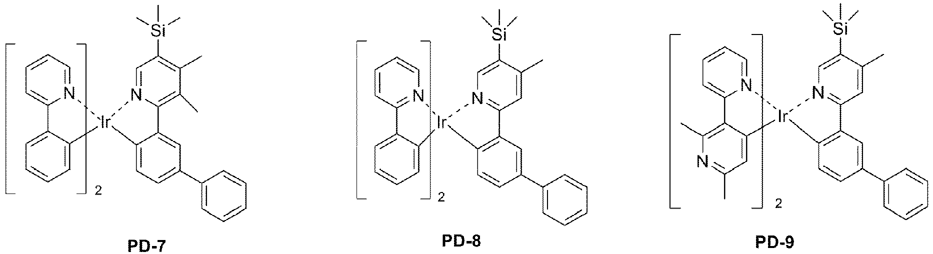

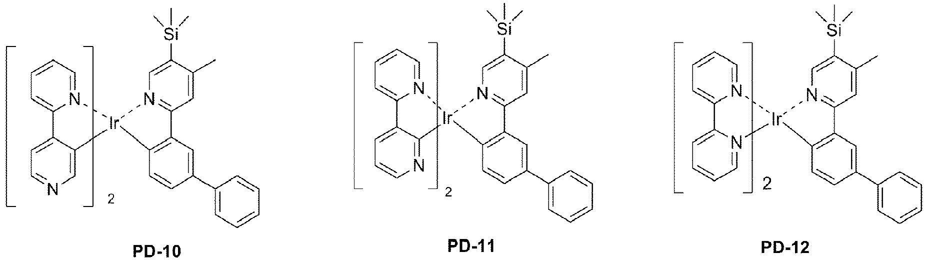

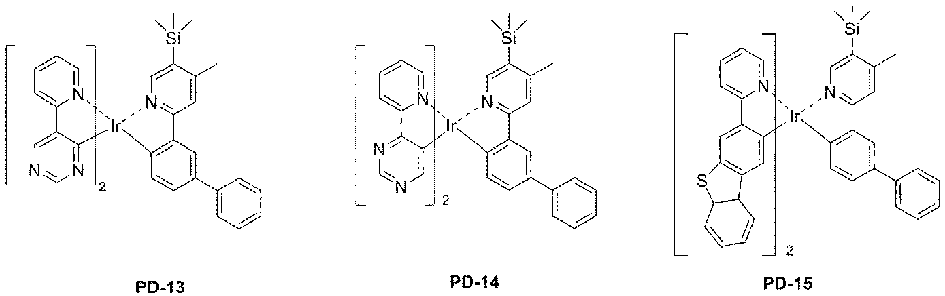

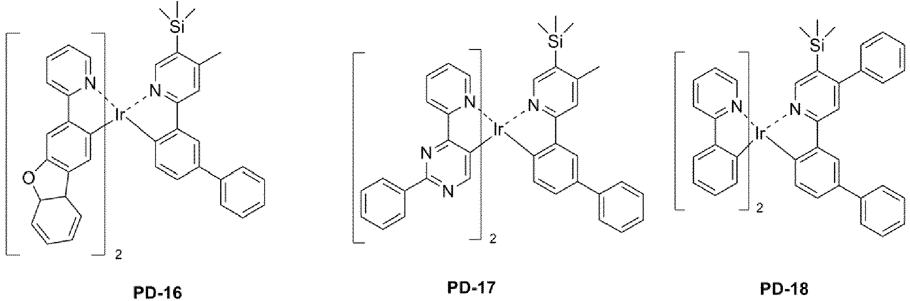

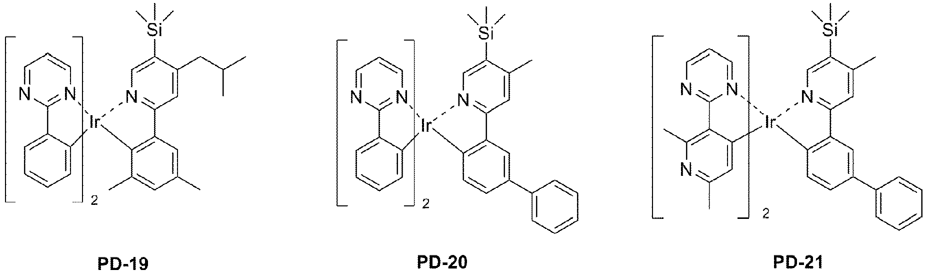

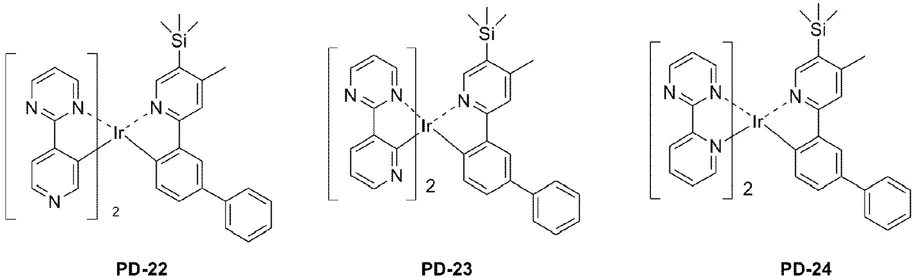

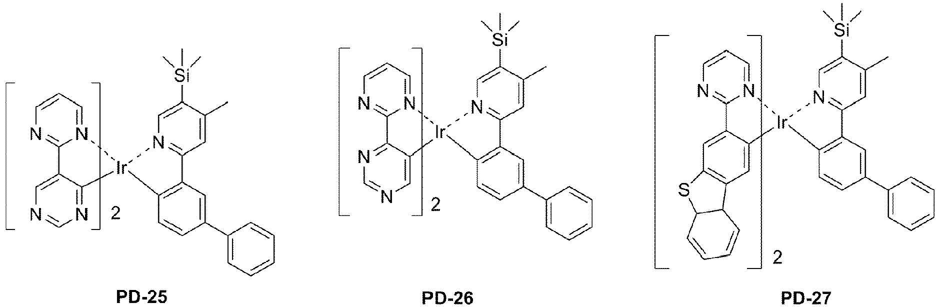

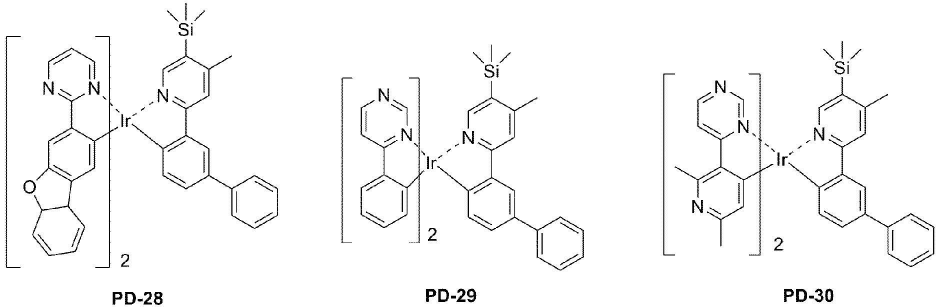

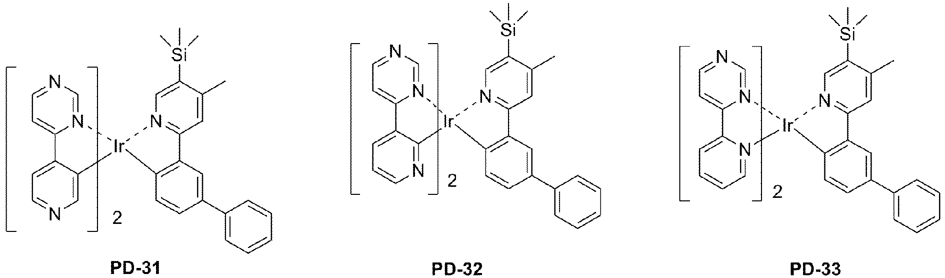

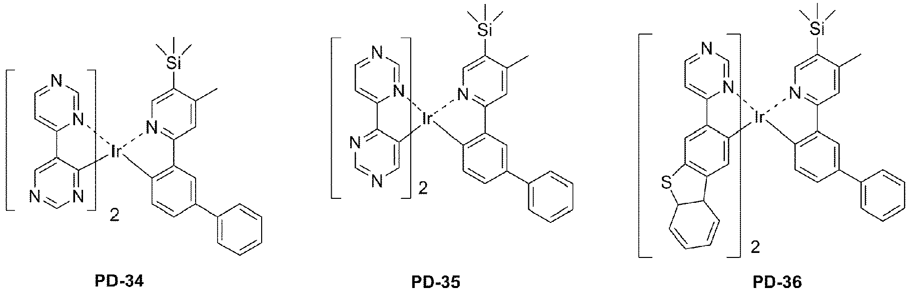

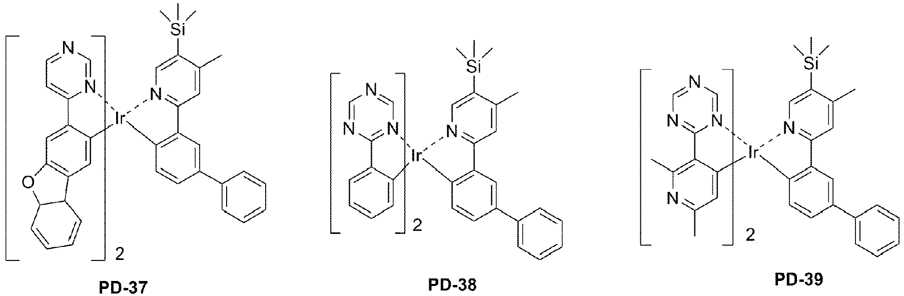

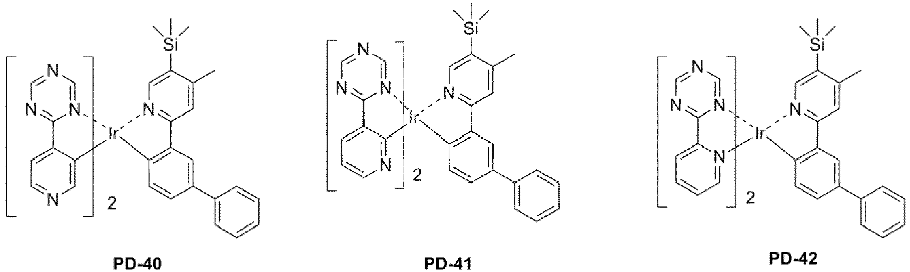

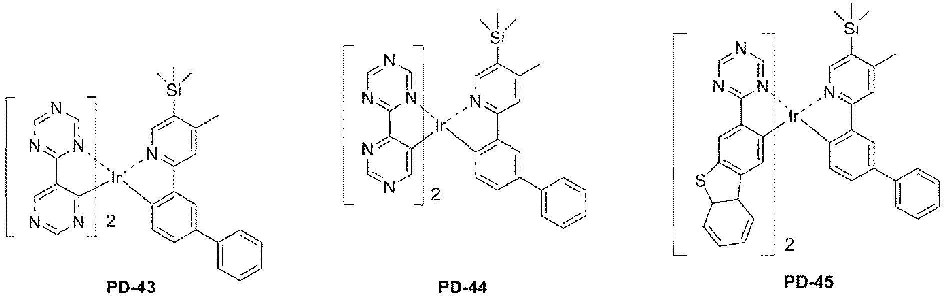

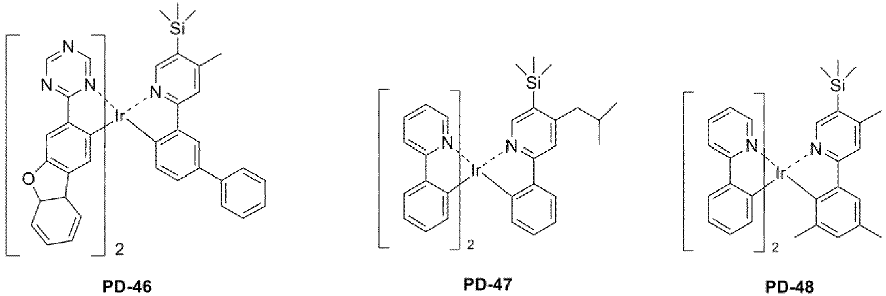

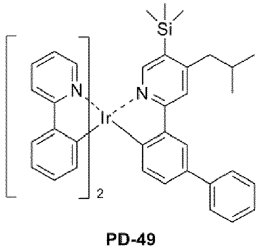

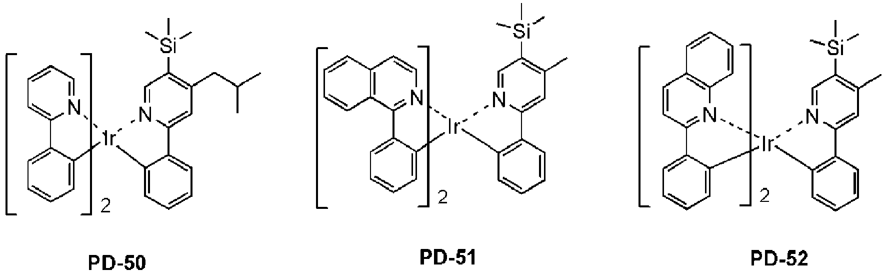

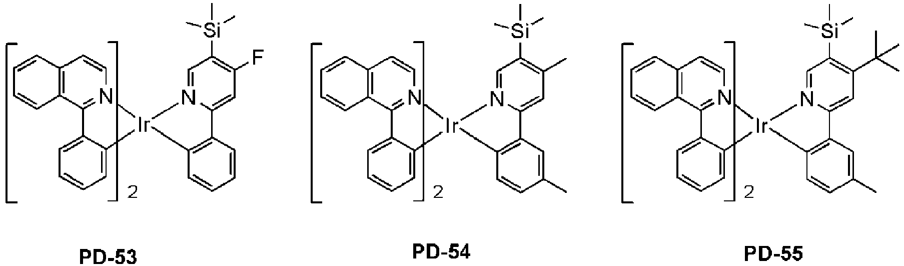

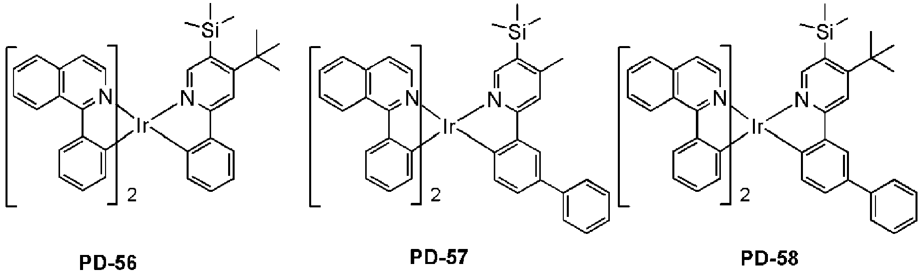

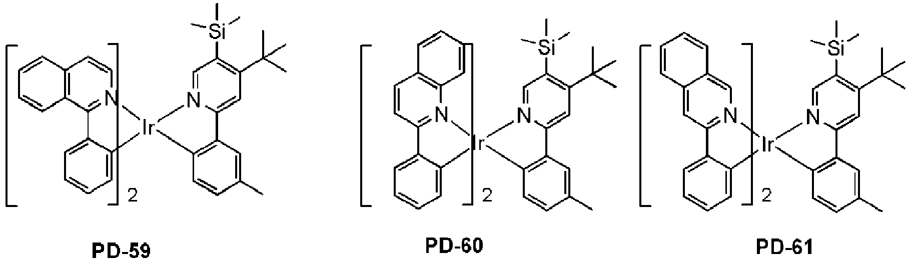

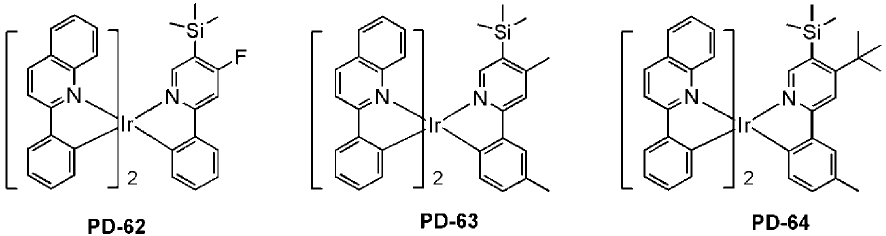

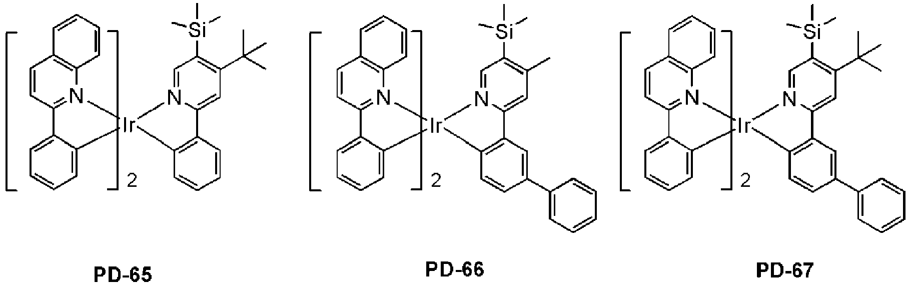

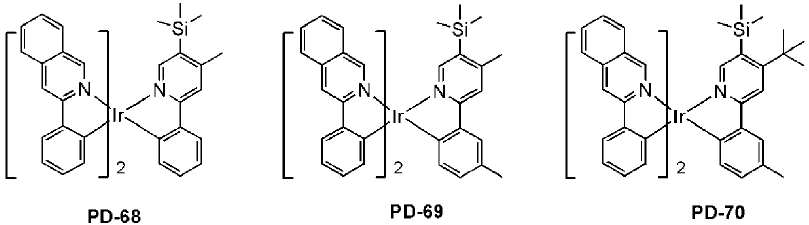

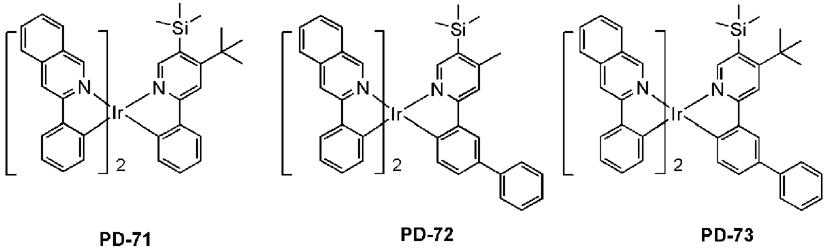

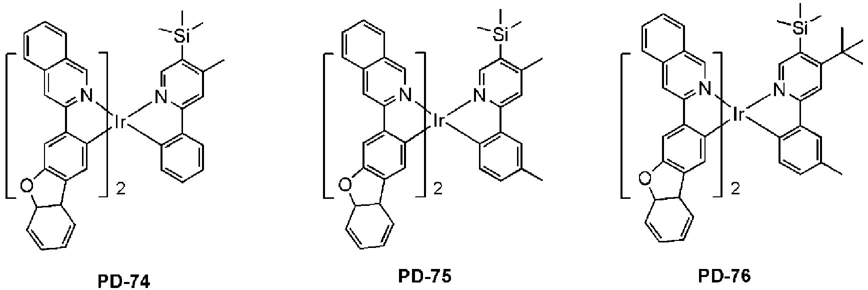

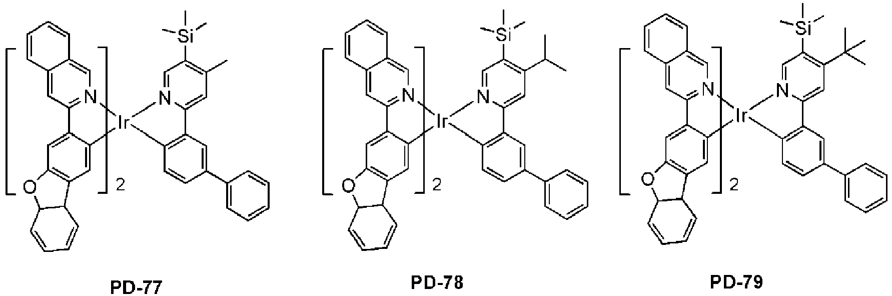

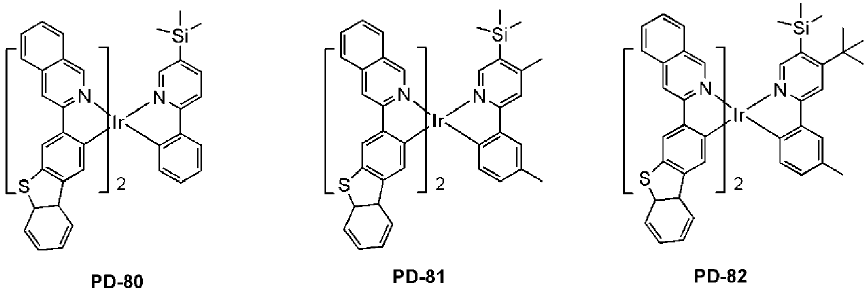

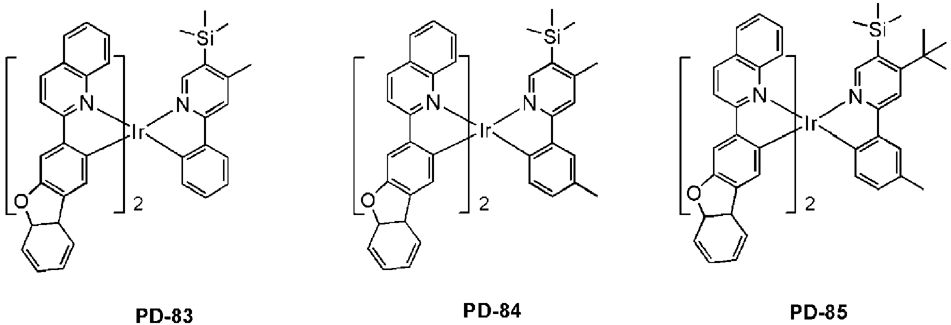

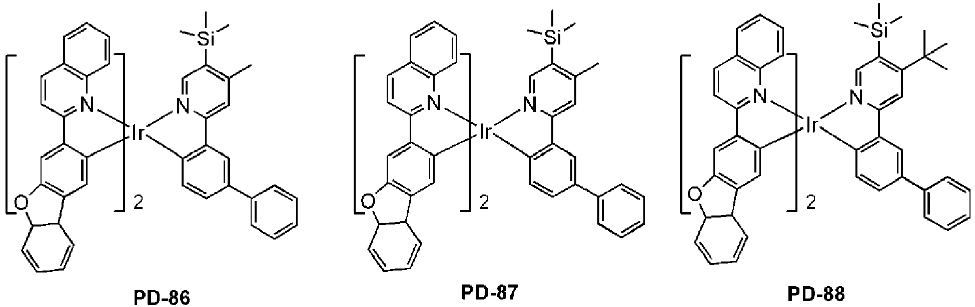

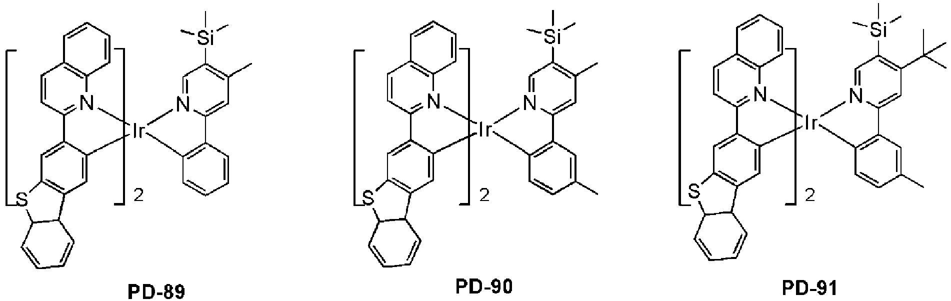

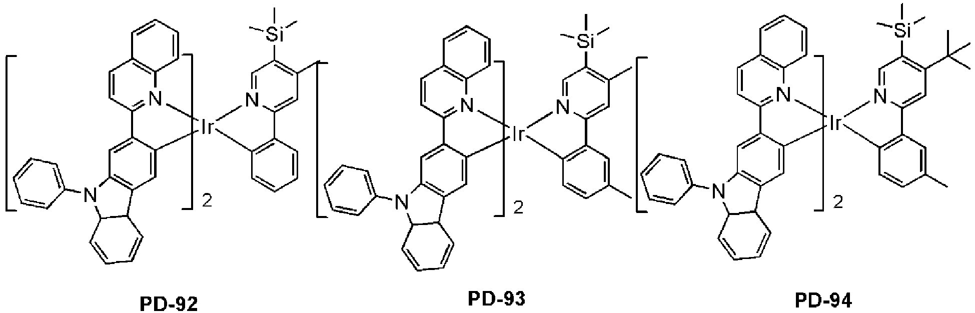

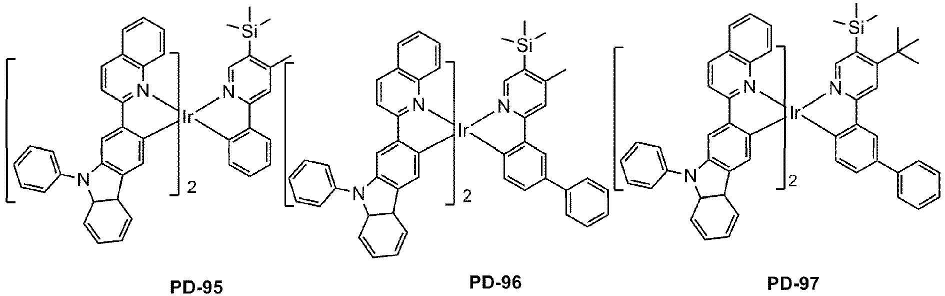

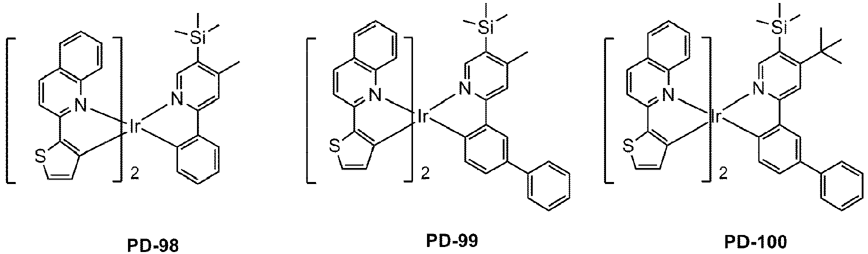

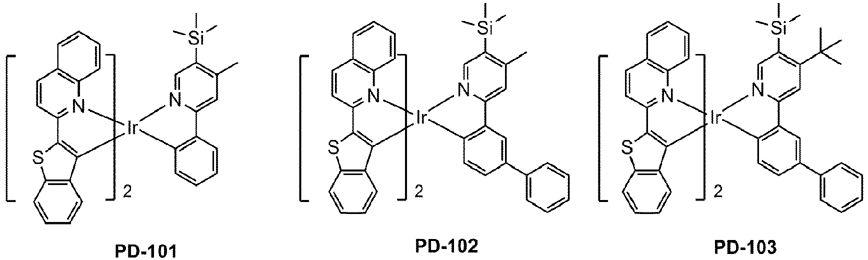

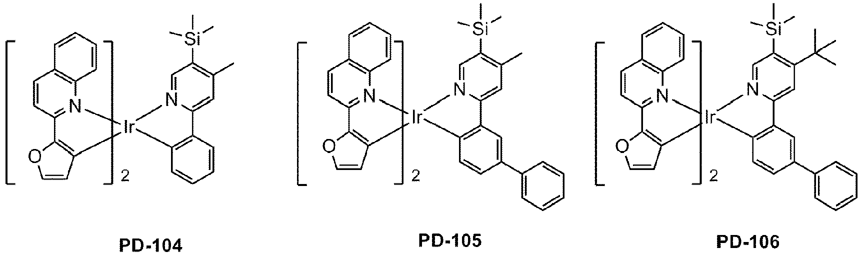

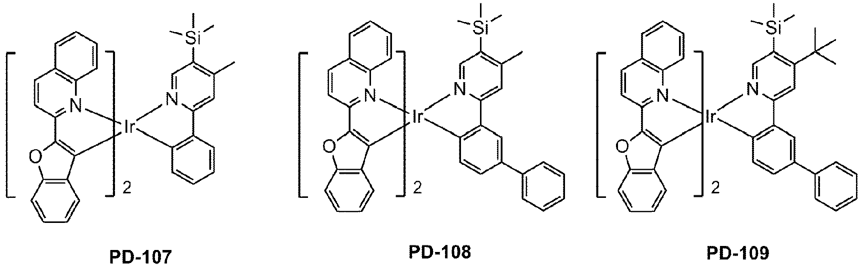

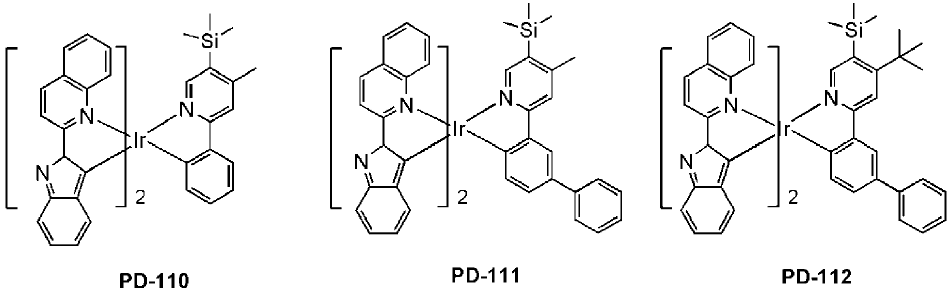

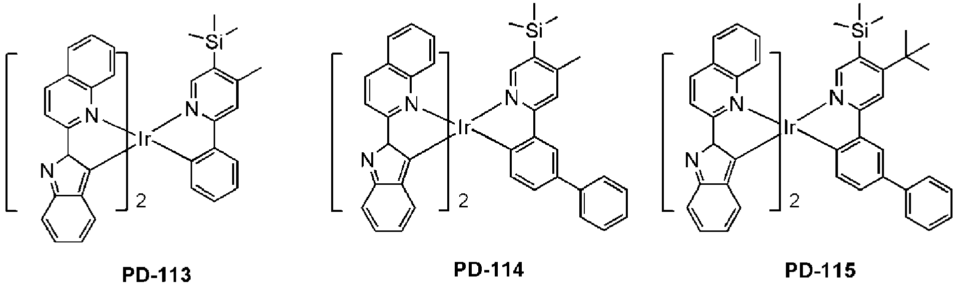

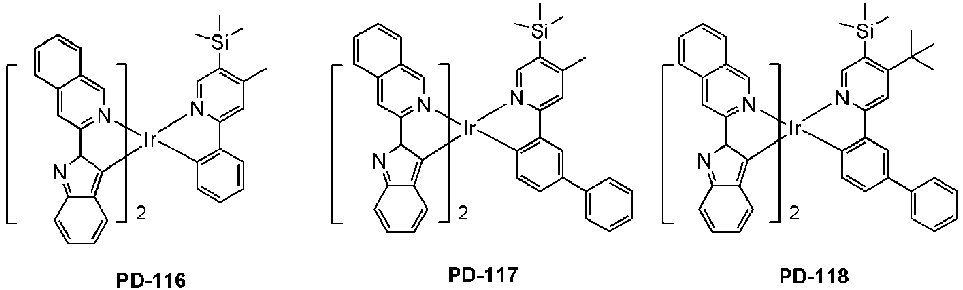

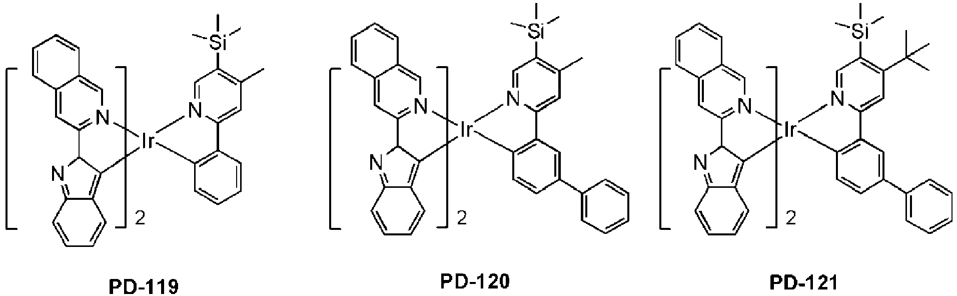

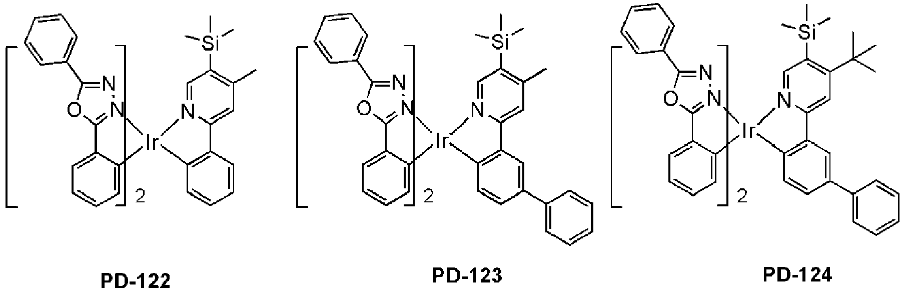

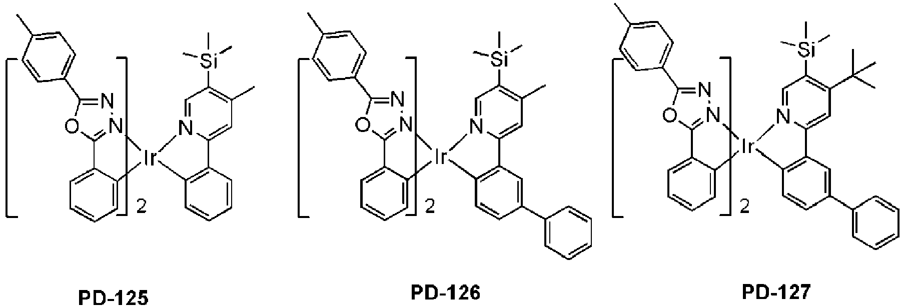

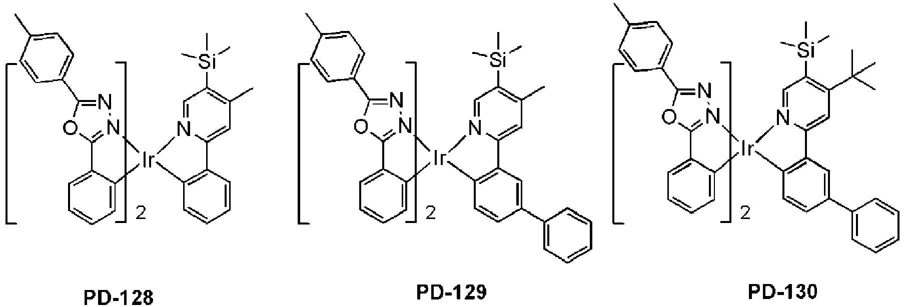

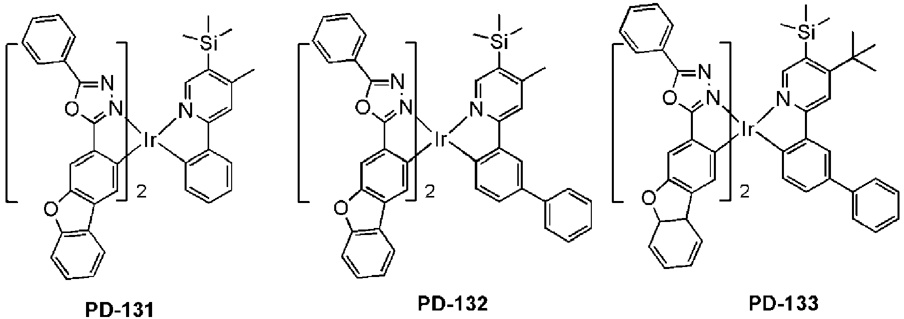

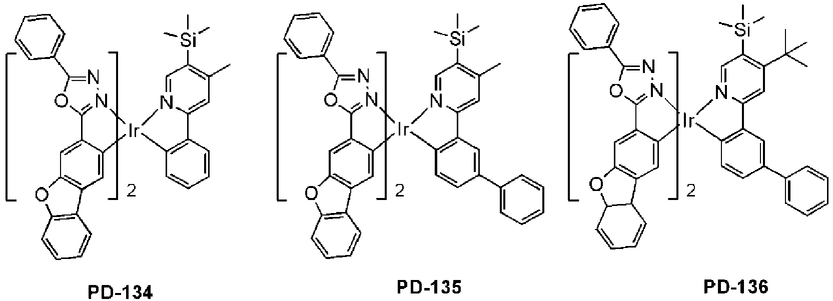

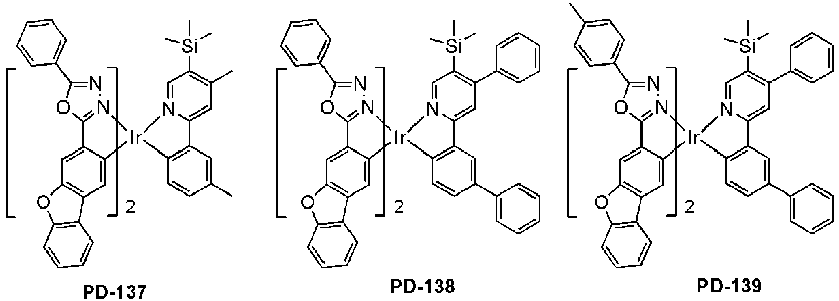

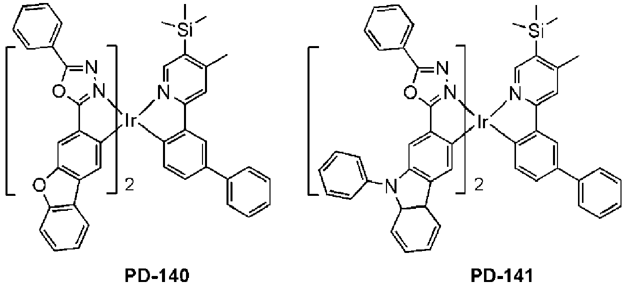

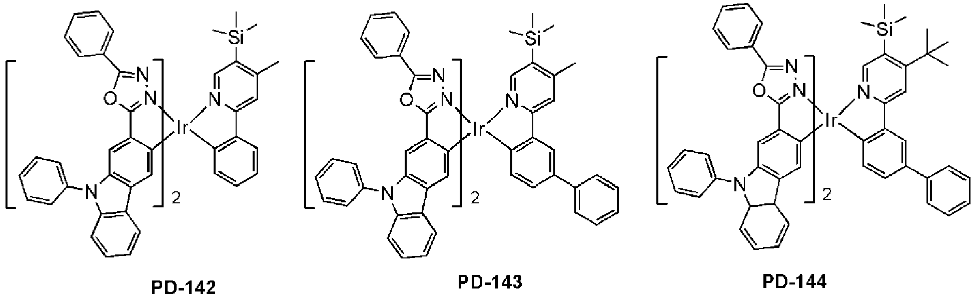

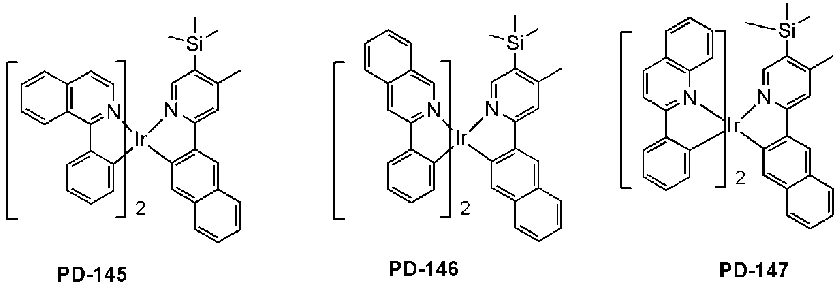

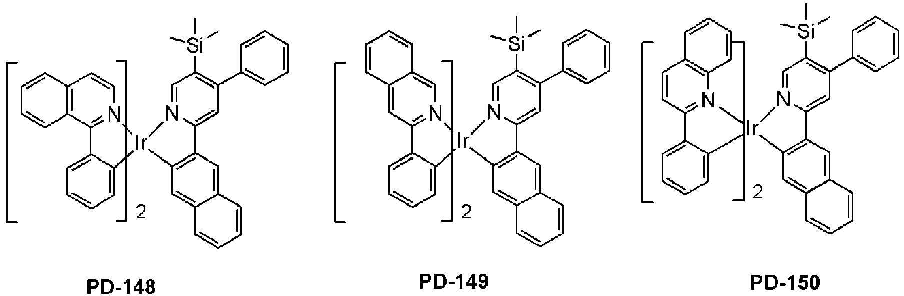

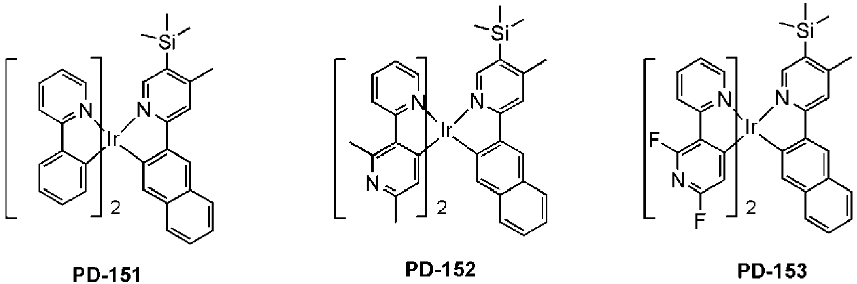

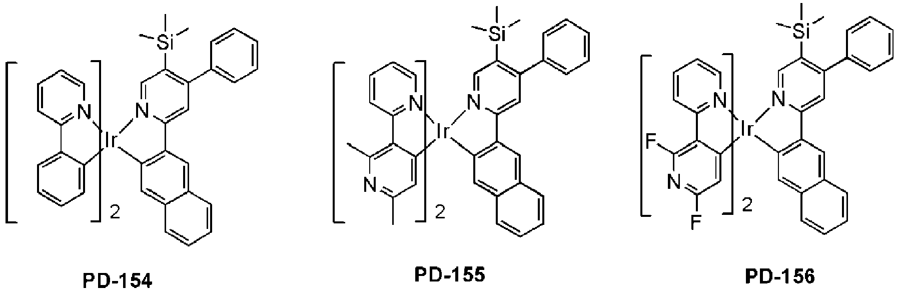

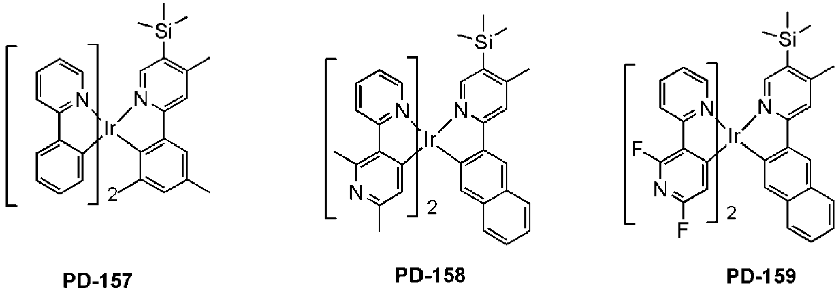

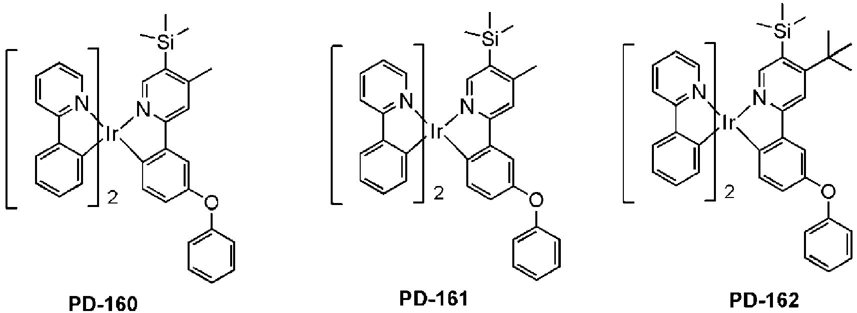

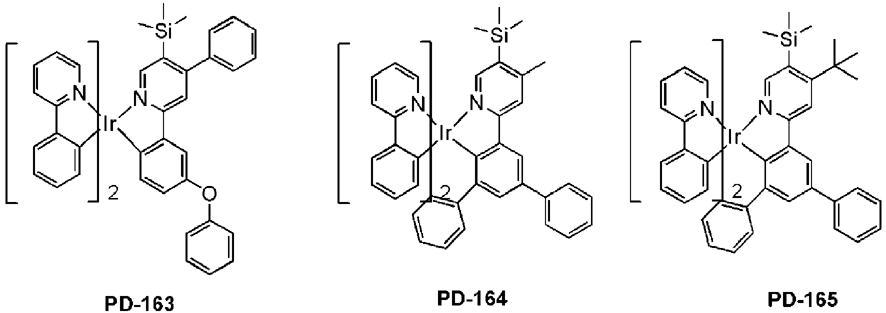

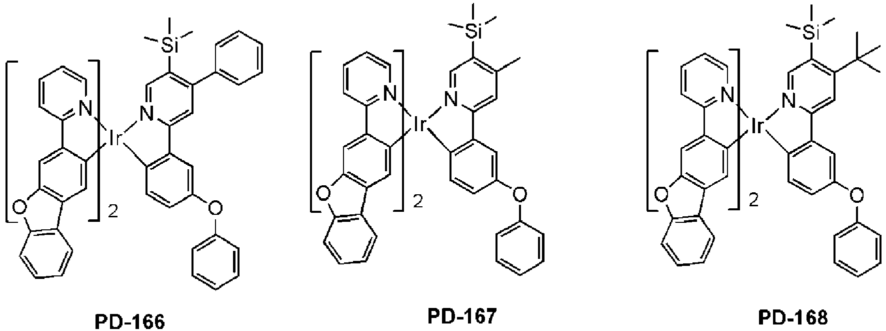

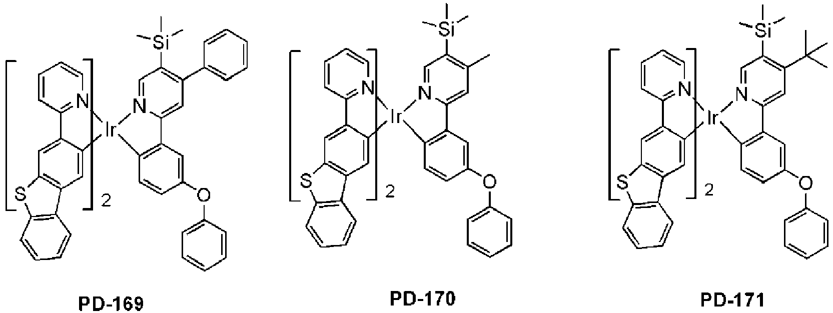

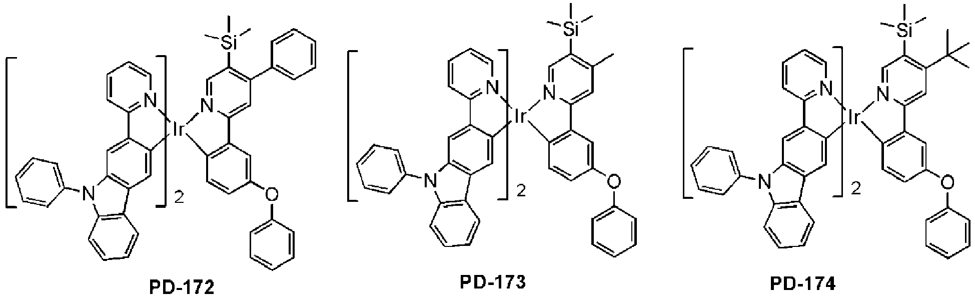

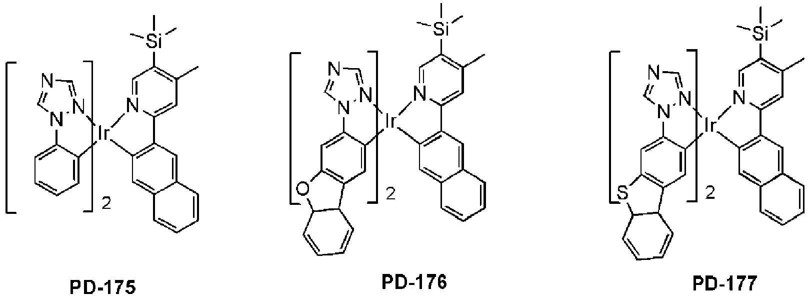

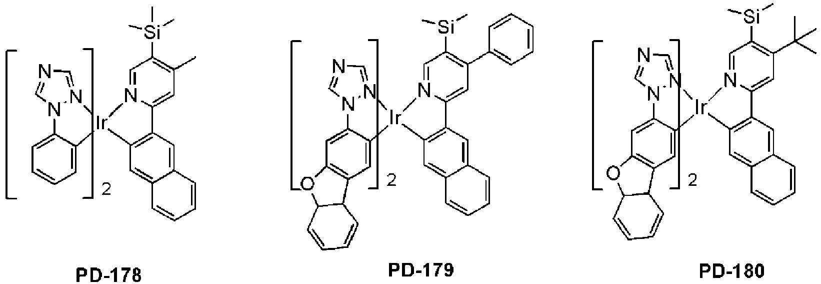

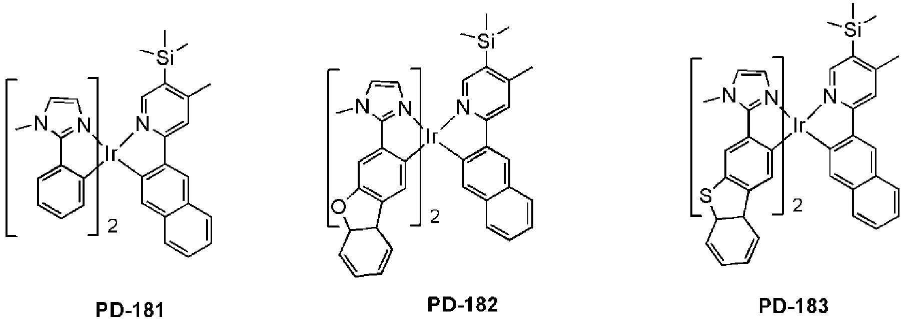

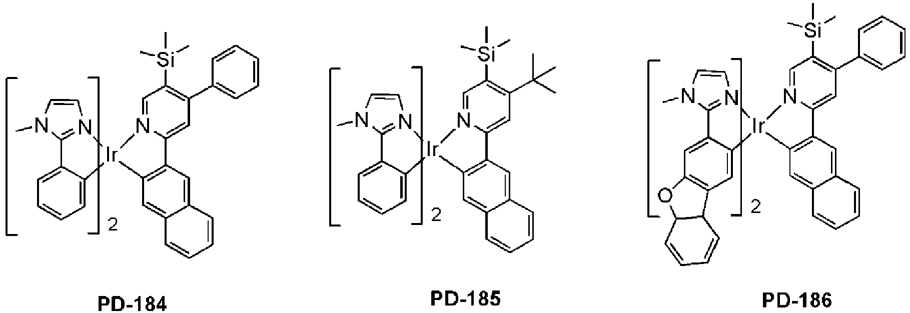

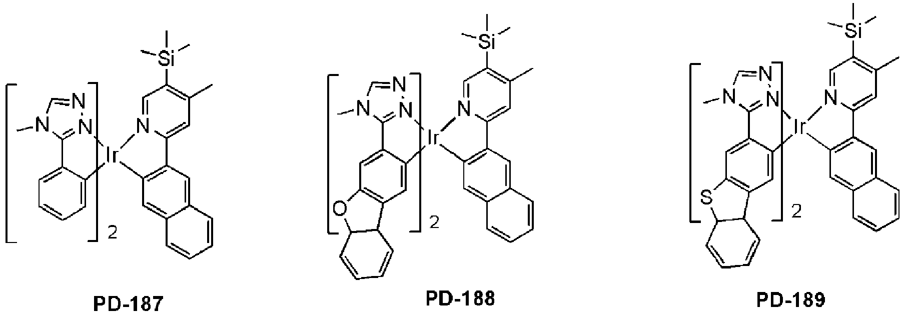

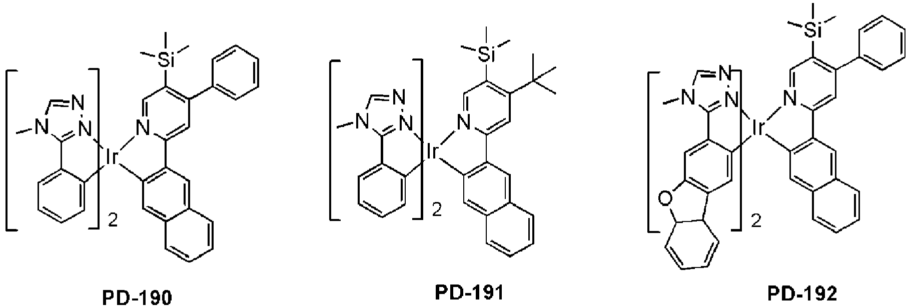

An amount of the dopant in the emission layer may be, in general, in a range of about 0.01 to about 15 parts by weight based on 100 parts by weight of the host, but is not limited thereto.

A thickness of the emission layer may be in a range of about 10 to about 100 nm (about 100

Å to about 1,000 Å), for example, about 20 to about 60 nm (about 200 Å to about 600 Å). When the thickness of the emission layer is within this range, excellent light-emission characteristics may be obtained without a substantial increase in driving voltage.

The phosphorescent dopant may emit green light or red light, but may instead emit other colors of light.

Then, an electron transport region may be disposed on the emission layer.

The electron transport region may include at least one selected from a hole blocking layer, an electron transport layer, and an electron injection layer, but is not limited thereto.

For example, the electron transport region may have a structure of electron transport layer/electron injection layer or a structure of hole blocking layer/electron transport layer/electron injection layer, wherein layers of each structure are sequentially stacked in a direction out of the emission layer in the stated order, but the structure thereof is not limited thereto.

The electron transport region may include a hole blocking layer. The hole blocking layer may be formed, when the emission layer includes a phosphorescent dopant, to prevent diffusion of excitons or holes into an electron transport layer.

When the electron transport region includes a hole blocking layer, the hole blocking layer may be formed on the emission layer by using one or more methods selected from vacuum deposition, spin coating casting, an LB method, ink-jet printing, laser-printing, and laser-induced thermal imaging. When the hole blocking layer is formed by vacuum deposition or spin coating, deposition and coating conditions for the hole blocking layer may be determined by referring to the deposition and coating conditions for the hole injection layer.

The hole blocking layer may include, for example, at least one of BCP and Bphen, but is not limited thereto:

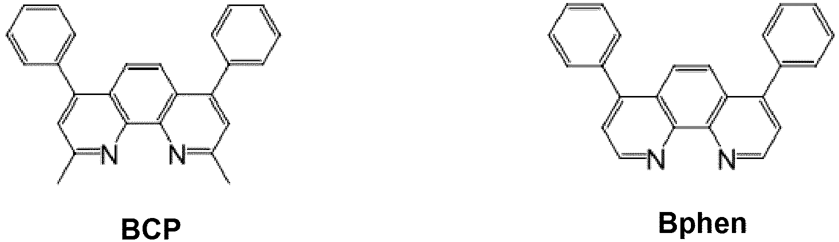

A thickness of the hole blocking layer may be in a range of about 2 to about 100 nm (about 20 Å to about 1,000 Å), for example, about 3 to about 30 nm (about 30 Å to about 300 Å). When the thickness of the hole blocking layer is within these ranges, the hole blocking layer may have excellent hole blocking characteristics without a substantial increase in driving voltage.

The electron transport region may include an electron transport layer. The electron transport layer may be formed on the emission layer or the hole blocking layer by using one or more methods selected from vacuum deposition, spin coating casting, an LB method, ink-jet printing, laser-printing, or laser-induced thermal imaging. When an electron transport layer is formed by vacuum deposition or spin coating, deposition and coating conditions for the electron transport layer may be the same as the deposition and coating conditions for the hole injection layer.

The electron transport layer may further include, in addition to the organometallic compound represented by Formula 1, at least one selected from BCP, Bphen, Alq₃, Balq, TAZ, and NTAZ:

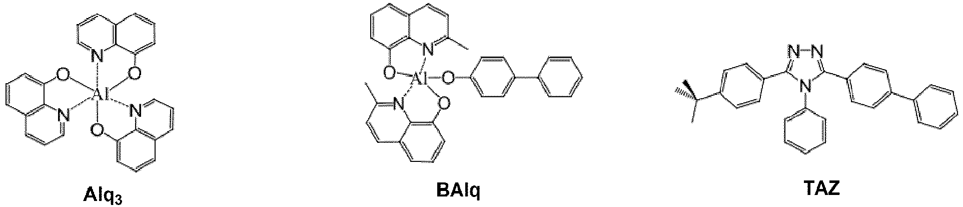

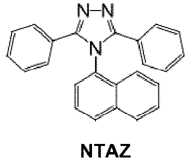

In some embodiments, the electron transport layer may further include at least one of compounds represented by Formula 601 below:

<Formula 601> Ar₆₀₁-[(L₆₀₁)ₓₑ₁-E₆₀₁]ₓₑ₂

Ar₆₀₁ in Formula 601 may be selected from a naphthalene, a heptalene, a fluorenene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentaphene, and an indenoanthracene;
a naphthalene group, a heptalene group, a fluorenene group, a spiro-fluorenene group, a benzofluorenene group, a dibenzofluorenene group, a phenalene group, a phenanthrene group, a anthracene group, a fluoranthene group, a triphenylene group, a pyrene group, a chrysene group, a naphthacene group, a picene group, a perylene group, a pentaphene group, and an indenoanthracene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy, a C₆-C₆₀ arylthio group, a C₁-C₆₀ heteroaryl group, a monovalent non-aromatic condensed polycyclic group, a monovalent non-aromatic condensed heteropolycyclic group, and -Si(Q₃₀₁)(Q₃₀₂)(Q₃₀₃) (wherein Q₃₀₁ to Q₃₀₃ are each independently selected from hydrogen, a C₁-C₆₀ alkyl group, a C₂-C₆₀ alkenyl group, a C₁-C₆₀ aryl group, and a C₁-C₆₀ heteroaryl group);
L₆₀₁ may be the same as explained in connection with L₂₀₁;
E₆₀₁ may be selected from a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group; and
a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each substituted with at least one selected from deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group;
xe1 may be selected from 0, 1, 2, and 3; and
xe2 may be selected from 1, 2, 3, and 4.

In some embodiments, the electron transport layer may further include, the amine-based compound represented by Formula 1, at least one of compounds represented by Formula 602:

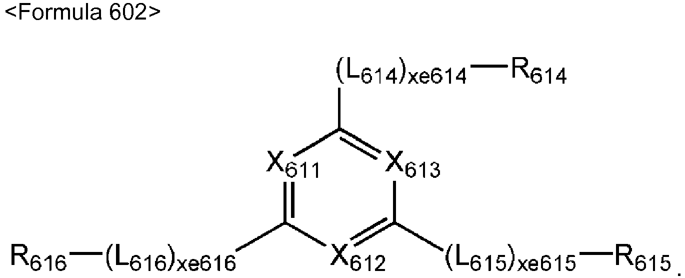

In Formula 602,
X₆₁₁ may be N or C-(L₆₁₁)ₓₑ₆₁₁R₆₁₁, X₆₁₂ may be N or C-(L₆₁₂)ₓₑ₆₁₂-R₆₁₂, X₆₁₃ may be N or C-(L₆₁₃)ₓₑ₆₁₃-R₆₁₃, and at least one of X₆₁₁ to X₆₁₃ may be N;
L₆₁₁ to L₆₁₆ may be the same as explained in connection with L₂₀₁;
R₆₁₁ to R₆₁₆ may be each independently selected from a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an azulenyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
xe611 to xe616 may be each independently selected from 0, 1, 2, and 3.

The compound represented by Formula 601 and the compound represented by Formula 602 may each include at least one of Compounds ET1 to ET15 illustrated below.

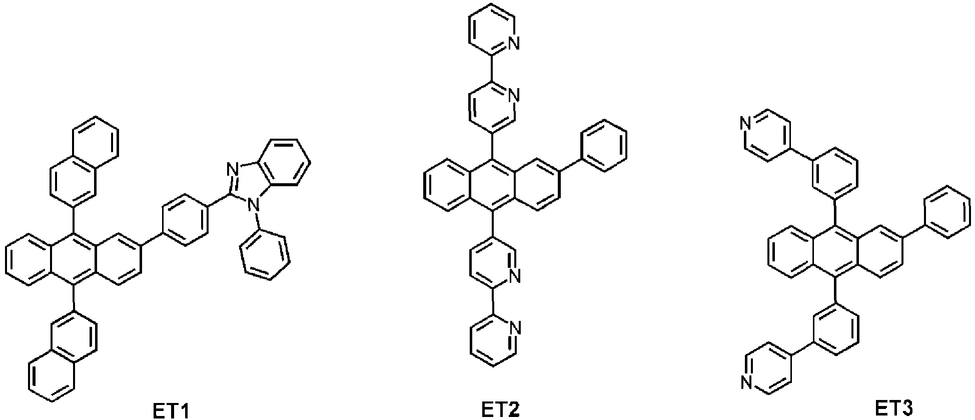

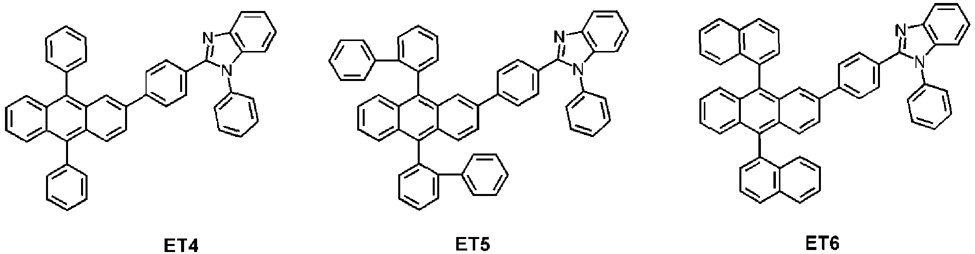

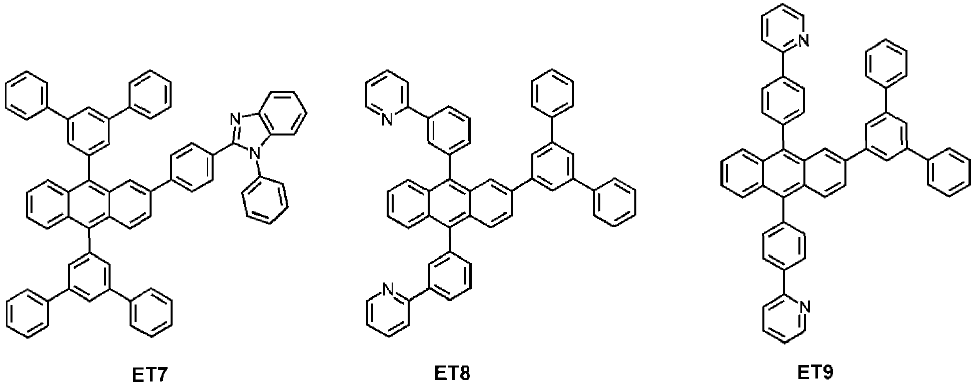

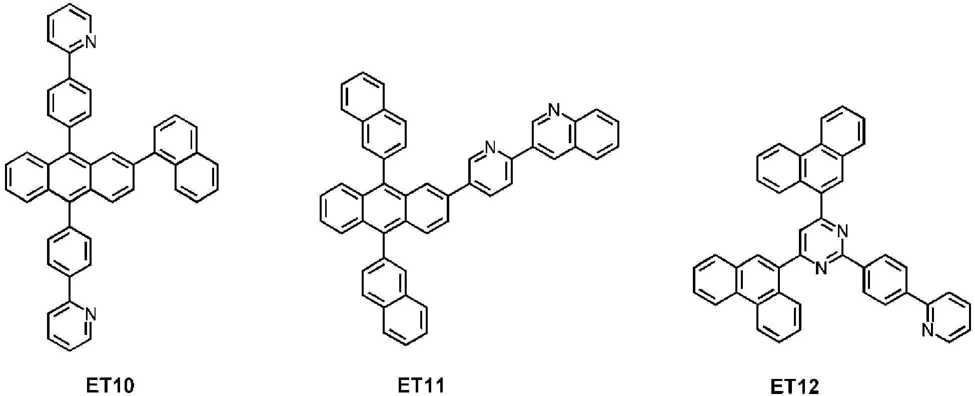

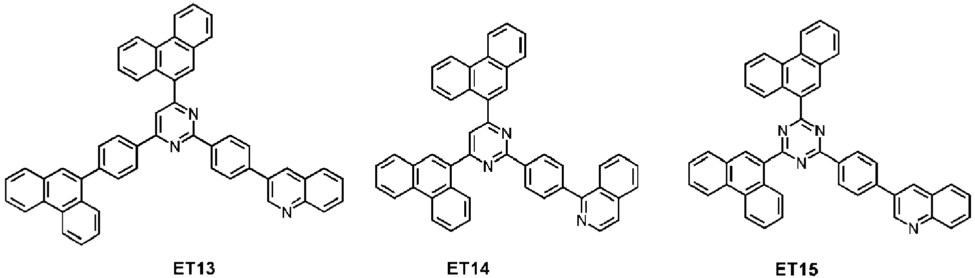

A thickness of the electron transport layer may be in a range of about 10 to about 100 nm (about 100 Å to about 1,000 Å), for example, about 15 to about 50 nm (about 150 Å to about 500 Å). When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium quinolate, LiQ) or ET-D2:

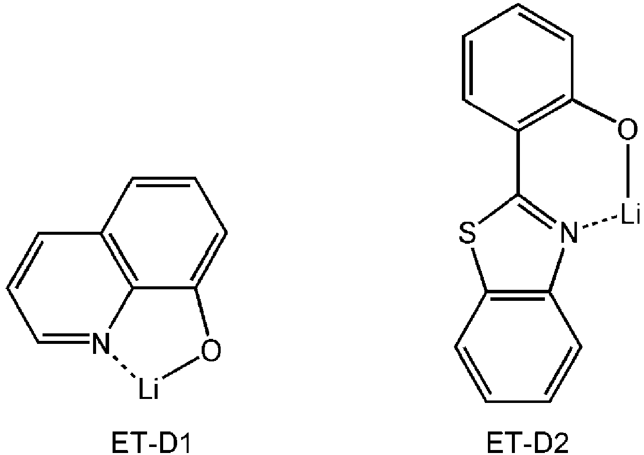

The electron transport region may include an electron injection layer that facilitates the injection of electrons from the second electrode 190.

The electron injection layer may be formed on the electron transport layer by using one or more methods selected from vacuum deposition, spin coating casting, an LB method, ink-jet printing, laser-printing, and laser-induced thermal imaging. When an electron injection layer is formed by vacuum deposition or spin coating, deposition and coating conditions for the electron injection layer may be the same as those for the hole injection layer.

The electron injection layer may include at least one selected from, LiF, NaCl, CsF, Li₂O, BaO, and LiQ.

A thickness of the electron injection layer may be in a range of about 0,1 to about 10 nm (about 1 Å to about 100 Å), for example, about 0,3 to about 90 nm (about 3 Å to about 90 Å). When the thickness of the electron injection layer is within the range described above, the electron injection layer may have satisfactory electron injection characteristics without a substantial increase in driving voltage.

The second electrode 190 may be disposed on the organic layer 150 having such a structure. The second electrode 190 may be a cathode which is an electron injection electrode, and in this regard, a material for the second electrode 190 may be selected from metal, an alloy, an electrically conductive compound, and a mixture thereof, which have a relatively low work function. Detailed examples of the second electrode 190 are lithium (Li), magnesium (Mg), aluminum (Al), aluminum-lithium (Al-Li), calcium (Ca), magnesium-indium (Mg-In), and magnesium-silver (Mg-Ag). In some embodiments, the material for forming the second electrode 190 may be ITO or IZO. The second electrode 190 may be a reflective electrode, a semi-transmissive electrode, or a transmissive electrode.

Hereinbefore, the organic light-emitting device has been described with reference to FIG. 1, but is not limited thereto.

A C₁-C₆₀ alkyl group used herein refers to a linear or branched aliphatic hydrocarbon monovalent group having 1 to 60 carbon atoms, and detailed examples thereof are a methyl group, an ethyl group, an n-propyl group, an iso-propyl group, an n-butyl group, an iso-butyl group, a sec-butyl group, a tert-butyl group, a pentyl group, an iso-amyl group, and a hexyl group. A C₁-C₆₀ alkylene group used herein refers to a divalent group having the same structure as that of the C₁-C₆₀ alkyl group.

A C₁-C₆₀ alkoxy group used herein refers to a monovalent group represented by -OA₁₀₁ (wherein A₁₀₁ is the C₁-C₆₀ alkyl group), and examples thereof are a methoxy group, an ethoxy group, and an isopropyloxy group.

A C₂-C₆₀ alkenyl group used herein refers to a hydrocarbon group having the same structure as that of the C₂-C₆₀ alkyl group, except for at least one carbon double bond in the middle or at the terminal of the C₂-C₆₀ alkyl group, and examples thereof are an ethenyl group, a prophenyl group, and a butenyl group. A C₂-C₆₀ alkenylene group used herein refers to a divalent group having the same structure as that of the C₂-C₆₀ alkenyl group.

A C₂-C₆₀ alkynyl group used herein refers to a hydrocarbon group having the same structure as that of the C₂-C₆₀ alkyl group, except for at least one carbon triple bond in the middle or at the terminal of the C₂-C₆₀ alkyl group, and examples thereof are an ethynyl group and a propynyl group. A C₂-C₆₀ alkynylene group used herein refers to a divalent group having the same structure as that of the C₂-C₆₀ alkynyl group.

A C₃-C₁₀ cycloalkyl group used herein refers to a monovalent saturated hydrocarbon monocyclic group having 3 to 10 carbon atoms, and examples thereof are a cyclopropyl group, a cyclobutyl group, a cyclopentyl group, a cyclohexyl group, and a cycloheptyl group. A C₃-C₁₀ cycloalkylene group used herein refers to a divalent group having the same structure as that of the C₃-C₁₀ cycloalkyl group.

A C₁-C₁₀ heterocycloalkyl group used herein refers to a monovalent monocyclic group having at least one heteroatom selected from N, O, P, and S as a ring-forming atom and 1 to 10 carbon atoms, and examples thereof are a tetrahydrofuranyl group and a tetrahydrothiophenyl group. A C₁-C₁₀ heterocycloalkylene group used herein refers to a divalent group having the same structure as the C₁-C₁₀ heterocycloalkyl group.

A C₃-C₁₀ cycloalkenyl group used herein refers to a monovalent monocyclic group that has 3 to 10 carbon atoms and at least one double bond in the ring thereof and does not have aromaticity, and examples thereof are a cyclopentenyl group, a cyclohexenyl group, and a cycloheptenyl group. A C₃-C₁₀ cycloalkenylene group used herein refers to a divalent group having the same structure as the C₃-C₁₀ cycloalkenyl group.

A C₁-C₁₀ heterocycloalkenyl group used herein refers to a monovalent monocyclic group that has at least one heteroatom selected from N, O, P, and S as a ring-forming atom, 1 to 10 carbon atoms, and at least one double bond in its ring. Examples of the C₁-C₁₀ heterocycloalkenyl group are a 2,3-hydrofuranyl group and a 2,3-hydrothiophenyl group. A C₁-C₁₀ heterocycloalkenylene group used herein refers to a divalent group having the same structure as the C₁-C₁₀ heterocycloalkenyl group.

A C₆-C₆₀ aryl group used herein refers to a monovalent group having a carbocyclic aromatic system having 6 to 60 carbon atoms, and a C₆-C₆₀ arylene group used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

A C₁-C₆₀ heteroaryl group used herein refers to a monovalent group having a carbocyclic aromatic system that has at least one heteroatom selected from N, O, P, and S as a ring-forming atom, and 1 to 60 carbon atoms. A C₁-C₆₀ heteroarylene group used herein refers to a divalent group having a carbocyclic aromatic system that has at least one heteroatom selected from N, O, P, and S as a ring-forming atom, and 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The C₆-C₆₀ aryloxy used herein indicates -OA₁₀₂ (wherein A₁₀₂ is the C₆-C₆₀ aryl group), and the C₆-C₆₀ arylthio indicates -SA₁₀₃ (wherein A₁₀₃ is the C₆-C₆₀ aryl group).

A monovalent non-aromatic condensed polycyclic group used herein refers to a monovalent group that has two or more rings condensed to each other, only carbon atoms as a ring forming atom, and non-aromacity in the entire molecular structure. Detailed examples of the monovalent non-aromatic condensed polycyclic group are a fluorenyl group. A divalent non-aromatic condensed polycyclic group used herein refers to a divalent group having the same structure as the monovalent non-aromatic condensed polycyclic group.

A monovalent non-aromatic condensed heteropolycyclic group used herein refers to a monovalent group that has two or more rings condensed to each other, has a heteroatom selected from N, O P, and S, other than carbon atoms, as a ring forming atom, and has non-aromacity in the entire molecular structure. Detailed examples of the monovalent non-aromatic condensed heteropolycyclic group are a carbazolyl group. A divalent non-aromatic condensed heteropolycyclic group used herein refers to a divalent group having the same structure as the monovalent non-aromatic condensed heteropolycyclic group.

The term "Ph" used herein refers to a phenyl group, the term "Me" used herein refers to a methyl group, the term "Et" used herein refers to an ethyl group, and the term "ter-Bu" or "But" used herein refers to a tert-butyl.

Hereinafter, an organic light-emitting device according to an embodiment will be described in detail with reference to Synthesis Examples and Examples. The wording "B was used instead of A" used in describing Synthesis Examples means that a molar equivalent of A was identical to a molar equivalent of B.

### [Example]

Hereinafter, compounds used in Examples and Comparative Examples will be explained in details.

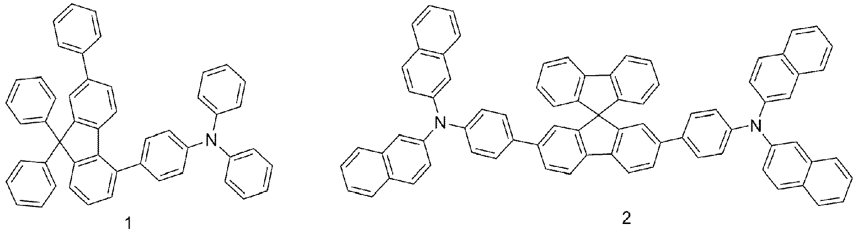

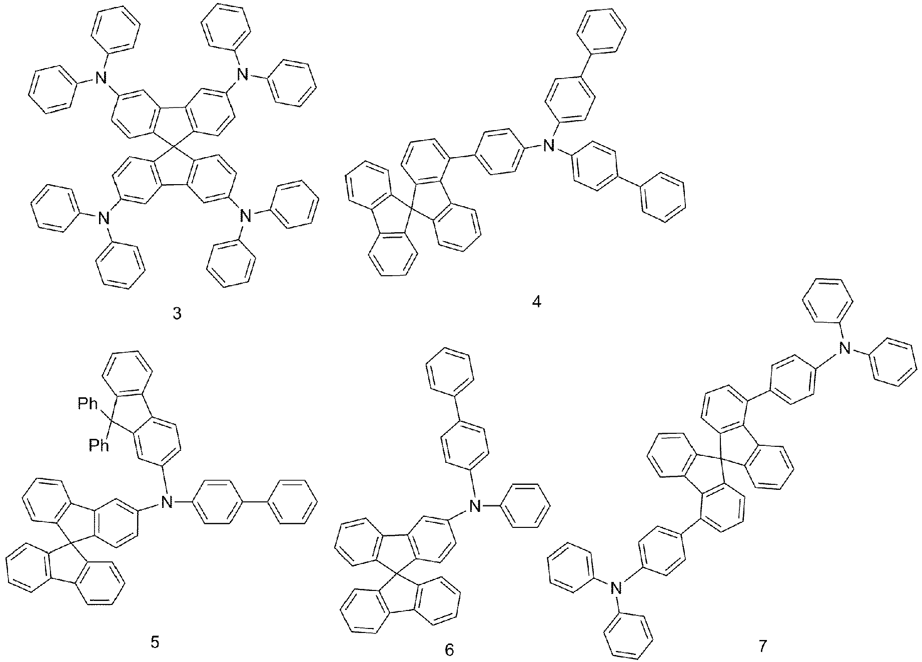

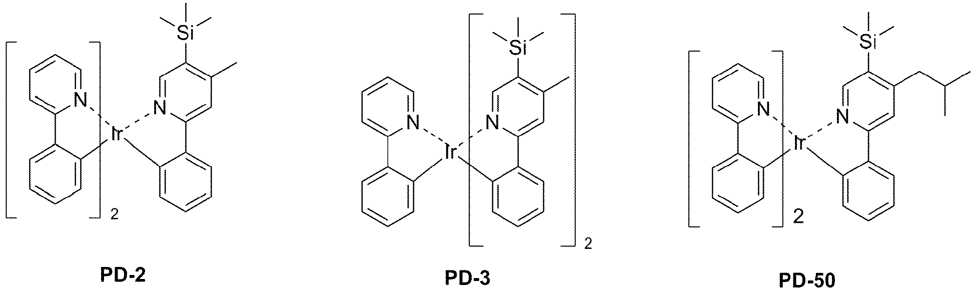

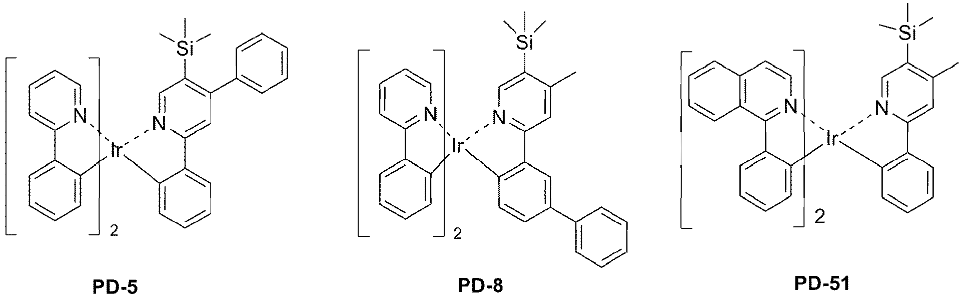

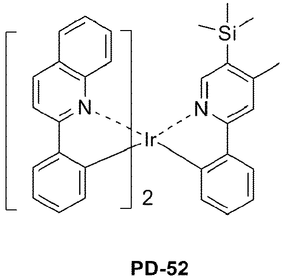

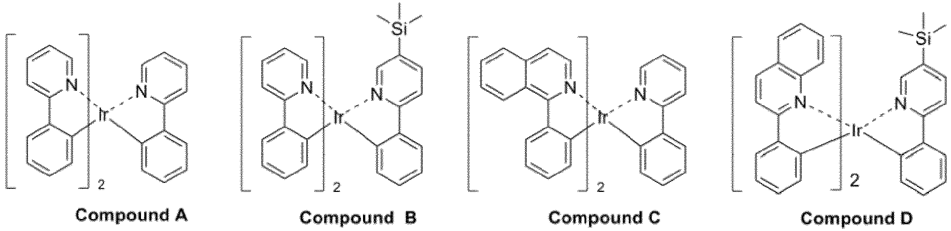

### Example G1

ITO/Ag/ITO glass substrate was sonicated with isopropyl alcohol and pure water, each for 5 minutes, and then, exposed to ultraviolet light for 30 minutes and then ozone to form the structure of an anode on a substrate.
m-MTDATA was vacuum-deposited on the resultant structure to form a hole injection layer having a thickness of 35nm (350 Å), and then, NPB was vacuum-deposited thereon to form a hole transport layer having a thickness of 50nm (500 Å). Then, Compound 1 was deposited thereon to form an auxiliary layer having a thickness of 20nm (200 Å).
mCP(host) and PD-2(dopant) were co-deposited at a weight ratio of 90:10 on the auxiliary layer to form an emission layer having a thickness of 30nm (300 Å).

Alq3 and LiF were co-deposited at a weight ratio of 1: 1 on the emission layer to form an electron transport layer having a thickness of 30nm (300 Å). LiF was vacuum-deposited on the electron transport layer to form an electron injection layer having a thickness of 1nm (10 Å), and MgAl (a weight ratio of 90:10) was vacuum-deposited to form a cathode having a thickness of 15nm (150 Å), thereby completing manufacture of an organic light-emitting device.

### Example G2 to Example G35 and Comparative Example G1 to Comparative Example G14

Organic light-emitting devices were manufactured in the same manner as used to synthesize Example G1, except that the auxiliary layer-forming materials and dopants shown in Table 1 were used.

**[Table 1]**

| | Auxiliary layer | Dopant |
|---|---|---|
| Example G1 | 1 | PD-2 |
| Example G2 | 1 | PD-3 |
| Example G3 | 1 | PD-50 |
| Example G4 | 1 | PD-5 |
| Example G5 | 1 | PD-8 |
| Example G6 | 2 | PD-2 |
| Example G7 | 2 | PD-3 |
| Example G8 | 2 | PD-50 |
| Example G9 | 2 | PD-5 |
| Example G10 | 2 | PD-8 |
| Example G11 | 3 | PD-2 |
| Example G12 | 3 | PD-3 |
| Example G13 | 3 | PD-50 |
| Example G14 | 3 | PD-5 |
| Example G15 | 3 | PD-8 |
| Example G16 | 4 | PD-2 |
| Example G17 | 4 | PD-3 |
| Example G18 | 4 | PD-50 |
| Example G19 | 4 | PD-5 |
| Example G20 | 4 | PD-8 |
| Example G21 | 5 | PD-2 |
| Example G22 | 5 | PD-3 |
| Example G23 | 5 | PD-50 |
| Example G24 | 5 | PD-5 |
| Example G25 | 5 | PD-8 |
| Example G26 | 6 | PD-2 |
| Example G27 | 6 | PD-3 |
| Example G28 | 6 | PD-50 |
| Example G29 | 6 | PD-5 |
| Example G30 | 6 | PD-8 |
| Example G31 | 7 | PD-2 |
| Example G32 | 7 | PD-3 |
| Example G33 | 7 | PD-50 |
| Example G34 | 7 | PD-5 |
| Example G35 | 7 | PD-8 |
| Comparative Example G1 | NPB | PD-2 |
| Comparative Example G2 | NPB | PD-3 |
| Comparative Example G3 | NPB | PD-50 |
| Comparative Example G4 | NPB | Compound A |
| Comparative Example G5 | NPB | Compound B |
| Comparative Example G6 | 1 | Compound A |
| Comparative Example G7 | 1 | Compound B |
| Comparative Example G8 | 2 | Compound A |
| Comparative Example G9 | 2 | Compound B |
| Comparative Example G10 | 3 | Compound B |
| Comparative Example G11 | 4 | Compound B |
| Comparative Example G12 | 5 | Compound B |
| Comparative Example G13 | 6 | Compound B |
| Comparative Example G14 | 7 | Compound B |

### Example R1

ITO/Ag/ITO glass substrate was sonicated with isopropyl alcohol and pure water, each for 5 minutes, and then, exposed to ultraviolet light for 30 minutes and then ozone to form the structure of an anode on a substrate.

m-MTDATA was vacuum-deposited on the resultant structure to form a hole injection layer having a thickness of 35nm (350 Å), and then, NPB was vacuum-deposited thereon to form a hole transport layer having a thickness of 50nm (500 Å). Then, Compound 1 was deposited thereon to form an auxiliary layer having a thickness of 50nm (500 Å).

mCP(host) and PD-51(dopant) were co-deposited at a weight ratio of 90:10 on the auxiliary layer to form an emission layer having a thickness of 30nm (300 Å).

Alq3 and LiF were co-deposited at a weight ratio of 1: 1 on the emission layer to form an electron transport layer having a thickness of 30nm (300 Å). LiF was vacuum-deposited on the electron transport layer to form an electron injection layer having a thickness of 1nm (10 Å), and MgAl (a weight ratio of 90:10) was vacuum-deposited to form a cathode having a thickness of 100nm (1,000 Å), thereby completing manufacture of an organic light-emitting device.

### Example R2 to Example R10 and Comparative Example R1 to Comparative Example R11

Organic light-emitting devices were manufactured in the same manner as used to synthesize Example R1, except that the auxiliary layer-forming materials and dopants shown in Table 2 were used.

**[Table 2]**

| | Auxiliary layer | Dopant |
|---|---|---|
| Example R1 | 1 | PD-51 |
| Example R2 | 1 | PD-52 |
| Example R3 | 2 | PD-51 |
| Example R4 | 2 | PD-52 |
| Example R5 | 3 | PD-51 |
| Example R6 | 3 | PD-52 |
| Example R7 | 4 | PD-51 |
| Example R8 | 4 | PD-52 |
| Example R9 | 5 | PD-51 |
| Example R10 | 5 | PD-52 |
| Comparative Example R1 | NPB | PD-51 |
| Comparative Example R2 | NPB | PD-52 |
| Comparative Example R3 | NPB | Compound C |
| Comparative Example R4 | NPB | Compound D |
| Comparative Example R5 | 1 | Compound C |
| Comparative Example R6 | 1 | Compound D |
| Comparative Example R7 | 2 | Compound C |
| Comparative Example R8 | 2 | Compound D |
| Comparative Example R9 | 3 | Compound D |
| Comparative Example R10 | 4 | Compound D |
| Comparative Example R11 | 5 | Compound D |

### Evaluation Example

Efficiency, lifespan (at the current density of 1000 nit) and CIE color coordinate of the organic light-emitting devices of Examples G1 to G35, R1 to R10 and Comparative Examples G1 to G14 and R1 to R11 were evaluated by using PR650 Spectroscan Source Measurement Unit. (Product of PhotoResearch Company). Results thereof are shown in Tables 3 and 4. In Tables 3 and 4, the efficiency means relative efficiency, and the lifespan means relative lifespan.

**[Table 3]**

| | Auxiliary layer | Dopant | Efficiency | Lifespan | Color coordinate (x/y) |
|---|---|---|---|---|---|
| Example G1 | 1 | PD-2 | 1.3 | 1.2 | 0.23/0.71 |
| Example G2 | 1 | PD-3 | 1.4 | 1.2 | 0.22/0.70 |
| Example G3 | 1 | PD-50 | 1.4 | 1.3 | 0.23/0.69 |
| Example G4 | 1 | PD-5 | 1.3 | 1.2 | 0.22 / 0.69 |
| Example G5 | 1 | PD-8 | 1.4 | 1.2 | 0.23 / 0.70 |
| Example G6 | 2 | PD-2 | 1.4 | 1.2 | 0.22 / 0.70 |
| Example G7 | 2 | PD-3 | 1.4 | 1 | 0.23 / 0.69 |
| Example G8 | 2 | PD-50 | 1.3 | 1.2 | 0.22 / 0.70 |
| Example G9 | 2 | PD-5 | 1.3 | 1 | 0.22 / 0.69 |
| Example G10 | 2 | PD-8 | 1.4 | 1 | 0.22 / 0.70 |
| Example G11 | 3 | PD-2 | 1.3 | 1.3 | 0.23 / 0.70 |
| Example G12 | 3 | PD-3 | 1.4 | 1.2 | 0.22 / 0.71 |
| Example G13 | 3 | PD-50 | 1.4 | 1.1 | 0.23 / 0.70 |
| Example G14 | 3 | PD-5 | 1.4 | 1 | 0.22 / 0.70 |
| Example G15 | 3 | PD-8 | 1.4 | 1 | 0.23 / 0.69 |
| Example G16 | 4 | PD-2 | 1.4 | 1.2 | 0.22 / 0.70 |
| Example G17 | 4 | PD-3 | 1.4 | 1.1 | 0.22 / 0.71 |
| Example G18 | 4 | PD-50 | 1.3 | 1 | 0.23 / 0.69 |
| Example G19 | 4 | PD-5 | 1.3 | 1 | 0.23 / 0.70 |
| Example G20 | 4 | PD-8 | 1.3 | 1.1 | 0.22 / 0.71 |
| Example G21 | 5 | PD-2 | 1.3 | 1.3 | 0.22 / 0.69 |
| Example G22 | 5 | PD-3 | 1.4 | 1.1 | 0.22 / 0.70 |
| Example G23 | 5 | PD-50 | 1.4 | 1.2 | 0.23 / 0.70 |
| Example G24 | 5 | PD-5 | 1.3 | 1 | 0.22 / 0.71 |
| Example G25 | 5 | PD-8 | 1.3 | 1 | 0.23 / 0.70 |
| Example G26 | 6 | PD-2 | 1.4 | 1.2 | 0.23 / 0.70 |
| Example G27 | 6 | PD-3 | 1.3 | 1 | 0.22 / 0.71 |
| Example G28 | 6 | PD-50 | 1.3 | 1 | 0.22 / 0.69 |
| Example G29 | 6 | PD-5 | 1.3 | 1.1 | 0.22 / 0.70 |
| Example G30 | 6 | PD-8 | 1.4 | 1 | 0.23 / 0.70 |
| Example G31 | 7 | PD-2 | 1.4 | 1.3 | 0.23 / 0.69 |
| Example G32 | 7 | PD-3 | 1.3 | 1.1 | 0.23 / 0.70 |
| Example G33 | 7 | PD-50 | 1.3 | 1 | 0.22 / 0.71 |
| Example G34 | 7 | PD-5 | 1.4 | 1 | 0.22 / 0.69 |
| Example G35 | 7 | PD-8 | 1.3 | 1.2 | 0.22 / 0.70 |
| Comparative Example G1 | NPB | PD-2 | 1 | 1.1 | 0.22 / 0.69 |
| Comparative Example G2 | NPB | PD-3 | 1 | 1 | 0.22 / 0.70 |
| Comparative Example G3 | NPB | PD-50 | 1 | 1 | 0.23 / 0.70 |
| Comparative Example G4 | NPB | Compound A | 1 | 1 | 0.27 / 0.67 |
| Comparative Example G5 | NPB | Compound B | 1 | 1.1 | 0.30 / 0.66 |
| Comparative Example G6 | 1 | Compound A | 1.1 | 1 | 0.28 / 0.66 |
| Comparative Example G7 | 1 | Compound B | 1.2 | 1.1 | 0.29 / 0.67 |
| Comparative Example G8 | 2 | Compound A | 1.2 | 1 | 0.27 / 0.67 |
| Comparative Example G9 | 2 | Compound B | 1.2 | 1.1 | 0.30 / 0.66 |
| Comparative Example G10 | 3 | Compound B | 1.1 | 1 | 0.30 / 0.66 |
| Comparative Example G11 | 4 | Compound B | 1.1 | 1 | 0.30 / 0.66 |
| Comparative Example G12 | 5 | Compound B | 1.1 | 1 | 0.30 / 0.66 |
| Comparative Example G13 | 6 | Compound B | 1.1 | 1 | 0.30 / 0.66 |
| Comparative Example G14 | 7 | Compound B | 1.1 | 1 | 0.30 / 0.66 |

**[Table 4]**

| | Auxiliary layer | Dopant | Efficiency | Lifespan | Color coordinate (x / y) |
|---|---|---|---|---|---|
| Example R1 | 1 | PD-51 | 1.2 | 1.1 | 0.66 / 0.34 |
| Example R2 | 1 | PD-52 | 1.3 | 1 | 0.66 / 0.33 |
| Example R3 | 2 | PD-51 | 1.3 | 1.1 | 0.66 / 0.34 |
| Example R4 | 2 | PD-52 | 1.3 | 1 | 0.65 / 0.34 |
| Example R5 | 3 | PD-51 | 1.2 | 1.2 | 0.65 / 0.34 |
| Example R6 | 3 | PD-52 | 1.3 | 1.1 | 0.66 / 0.33 |
| Example R7 | 4 | PD-51 | 1.3 | 1.1 | 0.66 / 0.34 |
| Example R8 | 4 | PD-52 | 1.3 | 1.1 | 0.66 / 0.33 |
| Example R9 | 5 | PD-51 | 1.2 | 1.1 | 0.66 / 0.34 |
| Example R10 | 5 | PD-52 | 1.3 | 1.1 | 0.66 / 0.33 |
| Comparative Example R1 | NPB | PD-51 | 1.1 | 1.1 | 0.66 / 0.34 |
| Comparative Example R2 | NPB | PD-52 | 1 | 1 | 0.66 / 0.33 |
| Comparative Example R3 | NPB | Compound C | 1 | 1 | 0.63 / 0.34 |
| Comparative Example R4 | NPB | Compound D | 1 | 1.1 | 0.62 / 0.35 |
| Comparative Example R5 | 1 | Compound C | 1.1 | 1 | 0.63 / 0.34 |
| Comparative Example R6 | 1 | Compound D | 1.2 | 1 | 0.62 / 0.35 |
| Comparative Example R7 | 2 | Compound C | 1.2 | 1 | 0.63 / 0.34 |
| Comparative Example R8 | 2 | Compound D | 1.2 | 1.1 | 0.62 / 0.35 |
| Comparative Example R9 | 3 | Compound D | 1.1 | 1.1 | 0.62 / 0.35 |
| Comparative Example R10 | 4 | Compound D | 1.2 | 1 | 0.62 / 0.35 |
| Comparative Example R11 | 5 | Compound D | 1 | 1 | 0.62 / 0.35 |

Referring to Tables 3 and 4, it is seen that the organic light-emitting devices of Examples G1 to G35 and R1 to R10 have higher efficiency and longer lifespan than the organic light-emitting devices of Comparative Examples G1 to G14 and R1 to R11.

Organic light-emitting devices according to embodiments of the inventive concept may have high efficiency and long lifespan characteristics.

## Claims

1. An organic light-emitting device (10) comprising: a first electrode (110); a second electrode (190); an emission layer between the first electrode (110) and the second electrode (190); and a hole transport region between the first electrode (110) and the emission layer, wherein the emission layer comprises an organometallic compound represented by Formula 1, and the hole transport region comprises an amine-based compound represented by Formula 2:
<Formula 1> M(L₁)ₙ₁(L₂)ₙ₂ 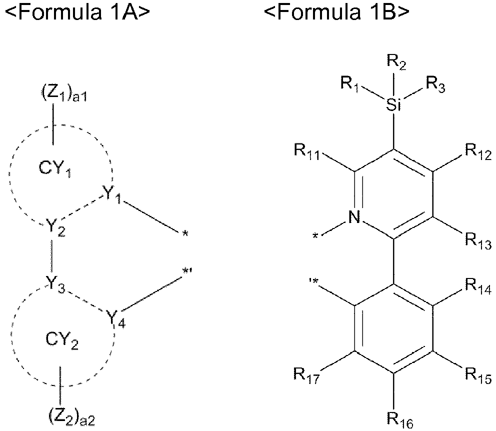 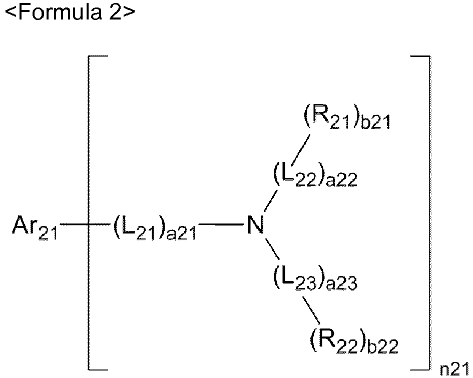 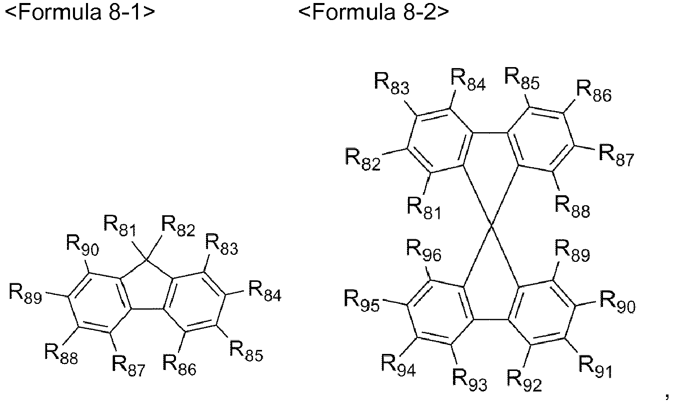
wherein, in Formulae 1, 1A, 1B, 2, 8-1, and 8-2,
M is selected from iridium (Ir), platinum (Pt), osmium (Os), titanium (Ti), zirconium (Zr), hafnium (Hf), europium (Eu), terbium (Tb), thulium (Tm), and rhodium (Rh);
L₁ is a ligand represented by Formula 1A;
L₂ is a ligand represented by Formula 1B;
L₁ to L₂ are different from each other;
n1 and n2 are each independently 1 or 2, and the sum of n1 and n2 is 2 or 3, and when n1 is 2, two of L₁s are identical to or different from each other, and when n2 is 2, two of L₂s are identical to or different from each other;
Y₁ to Y₄ are each independently carbon (C) or nitrogen (N), Y₁ and Y₂ are linked to each other via a single bond or a double bond, and Y₃ and Y₄ are linked to each other via a single bond or a double bond,
CY₁ and CY₂ are each independently selected from a C₅-C₆₀ cyclic group and a C₂-C₆₀ heterocyclic group, and CY₁ and CY₂ are optionally linked to each other via a single bond or a first linking group,
R₁ to R₃ are each independently selected from
a C₁-C₁₀ alkyl group; and
a C₁-C₁₀ alkyl group, substituted with at least one selected from deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, and a phosphoric acid or a salt thereof;
Z₁, Z₂, and R₁₁ to R₁₇ are each independently selected from hydrogen, deuterium, a hydroxyl group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), and -B(Q₆)(Q₇), provided that R₁₂ is not hydrogen, and two neighboring substituents selected from R₁₄ to R₁₇ are optionally linked to each other to form a condensed ring;
a1 and a2 are each independently an integer selected from 1 to 5, when a1 is 2 or more, a plurality of Z₁s are identical to or different from each other, and when a2 is 2 or more, a plurality of Z₂s are identical to or different from each other,
each of * and *' indicates a binding site to M in Formula 1;
Ar₂₁ is represented by one of Formulae 8-1 and 8-2;
L₂₁ to L₂₃ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
a21 to a23 are each independently selected from 0, 1, 2, and 3;
R₂₁ and R₂₂ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group;
b21 and b22 are each independently selected from 1, 2, and 3;
R₈₁ to R₉₆ are each independently selected from 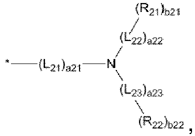 hydrogen, deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group;
n21 is selected from 1, 2, 3, and 4, and when n21 is 2 or more, a plurality of 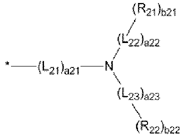 (s) are identical to or different from each other; and at least one of substituents of the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed polycyclic group, substituted divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is selected from
deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇),
wherein Q₁ to Q₇, Q₁₁ to Q₁₇, Q₂₁ to Q₂₇, and Q₃₁ to Q₃₇ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

2. The organic light-emitting device of claim 1, wherein M is Ir.

3. The organic light-emitting device of claim 1, wherein Y₁ is N, and each of Y₂ to Y₄ is C.

4. The organic light-emitting device of claim 1, wherein
CY₁ is selected from a pyrrole, an imidazole, a pyrazole, a triazole, a pyridine, a pyrimidine, a pyrazine, a triazine, a quinoline, an isoquinoline, and an oxadiazole; and
CY₂ is selected from a benzene, a naphthalene, a fluorene, a carbazole, a furan, a thiophene, a benzofuran, a benzothiophene, a dibenzofuran, a dibenzothiophene, an indole, a pyridine, a pyrimidine, a pyrazine, an oxadiazole, and a triazine.

5. The organic light-emitting device of claim 1, wherein
R₁ to R₃ are each independently selected from a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group; and
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, and a phosphoric acid or a salt thereof.

6. The organic light-emitting device of claim 1, wherein
R₁ to R₃ are each independently selected from
a methyl group, an ethyl group, an n-propyl group, an iso-propyl group, an n-butyl group, an iso-butyl group, a sec-butyl group, and a tert-butyl group.

7. The organic light-emitting device of claim 1, wherein
R₁ to R₃ are identical to each other.

8. The organic light-emitting device of claim 1, wherein
Z₁, Z₂, and R₁₁ to R₁₇ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid or salt thereof, a sulfonic acid or salt thereof, a phosphoric acid or salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, provided that
R₁₂ is not hydrogen.

9. The organic light-emitting device of claim 1, wherein
Z₁, Z₂, and R₁₁ to R₁₇ are each independently selected from
hydrogen, -F, a cyano group, a nitro group, -SF₅, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a phenyl group, a naphthyl group, a pyridinyl group, and a pyrimidinyl group; and
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a phenyl group, a naphthyl group, a pyridinyl group, and a pyrimidinyl group, each substituted with at least one selected from -F, a cyano group, and a nitro group, provided that
R₁₂ is not hydrogen.

10. The organic light-emitting device of claim 1, wherein
the organometallic compound is selected from Compounds PD-1 to PD-79 and PD-81 to PD-192:

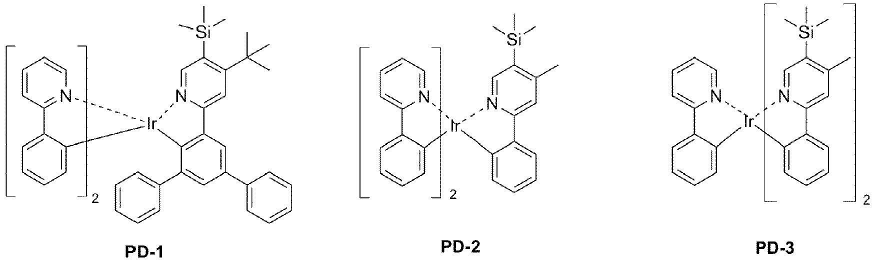

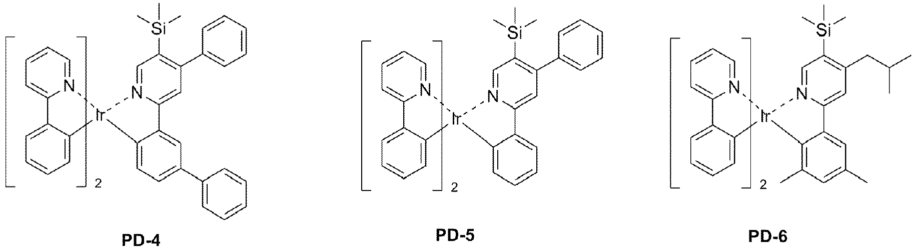

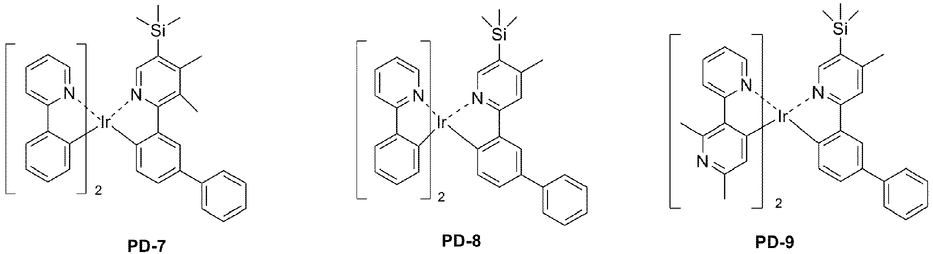

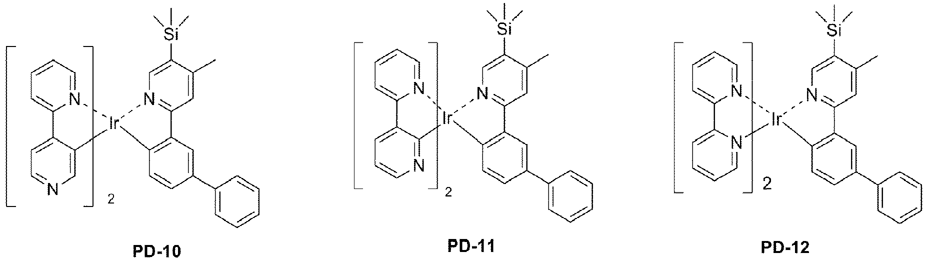

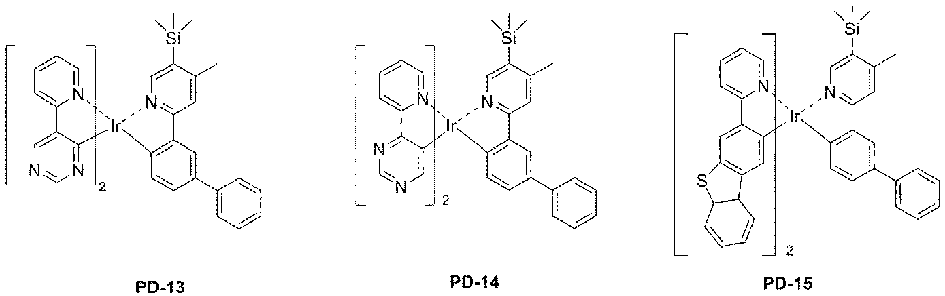

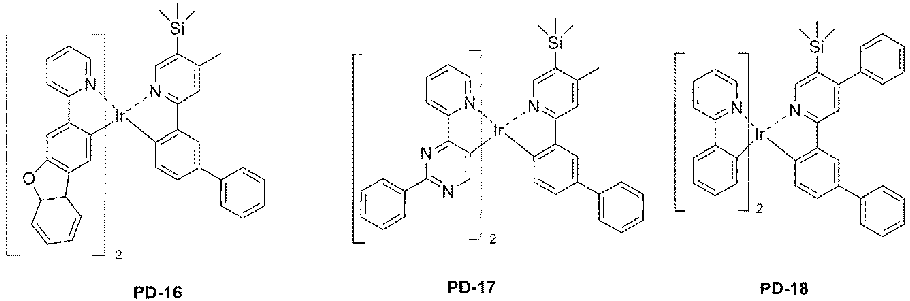

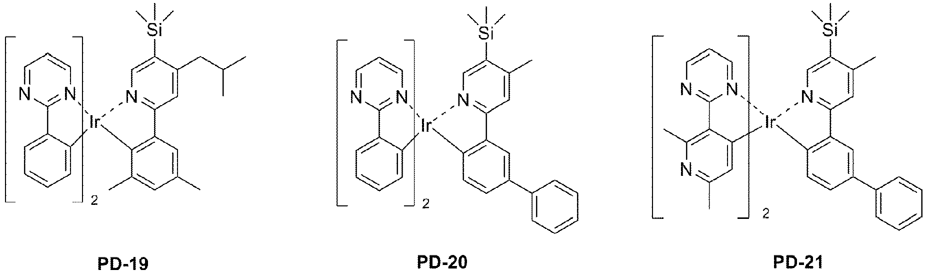

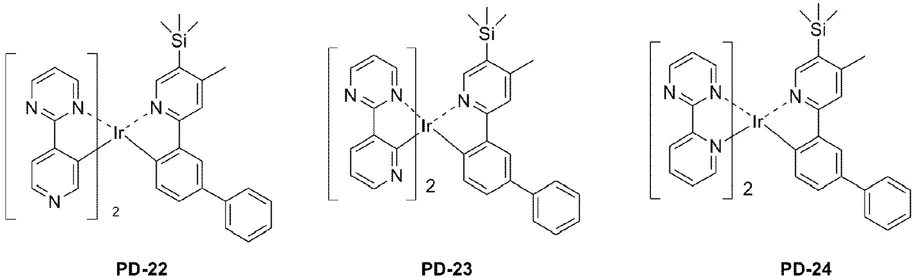

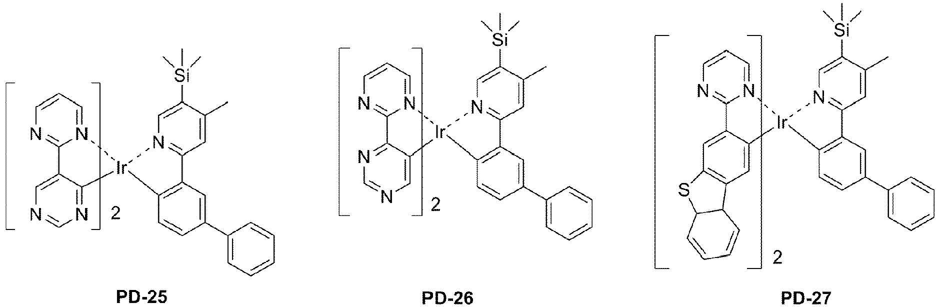

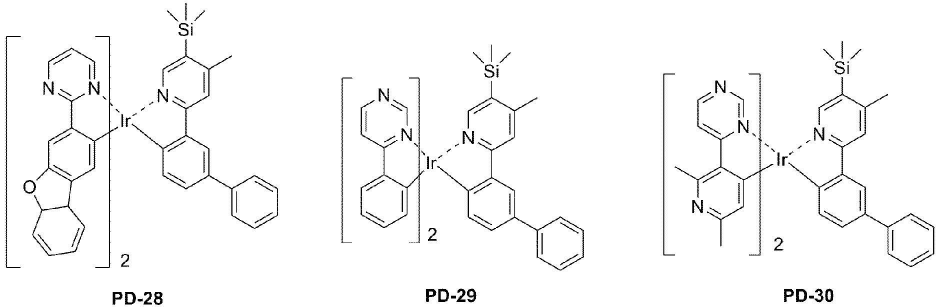

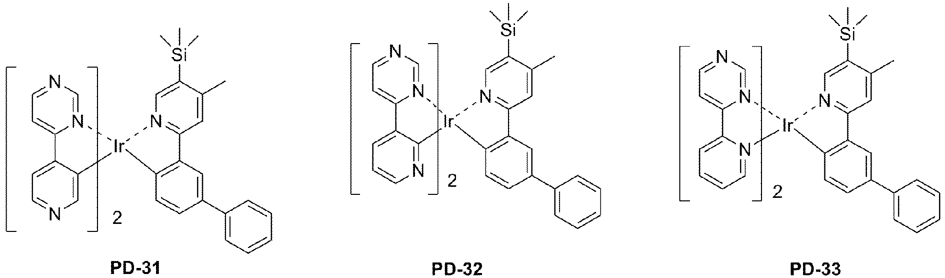

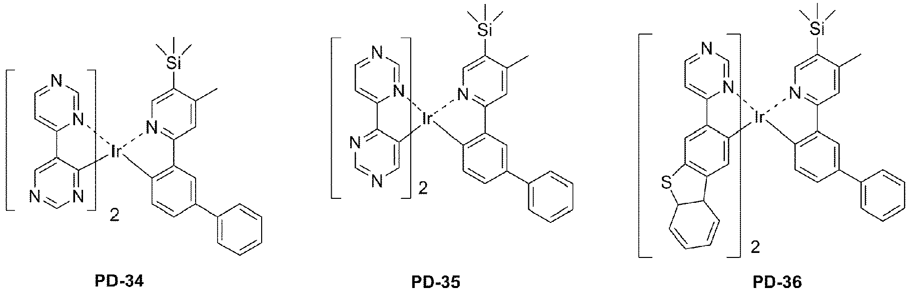

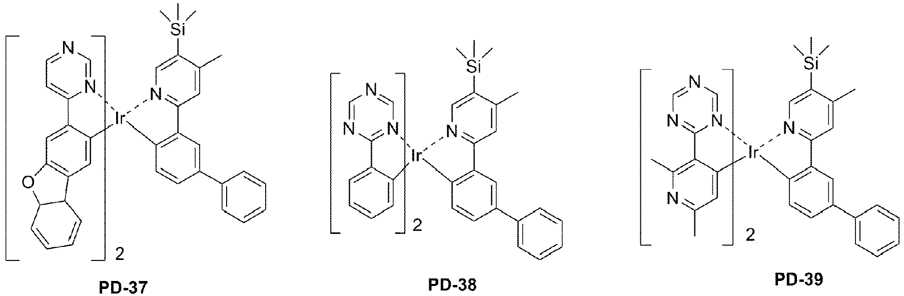

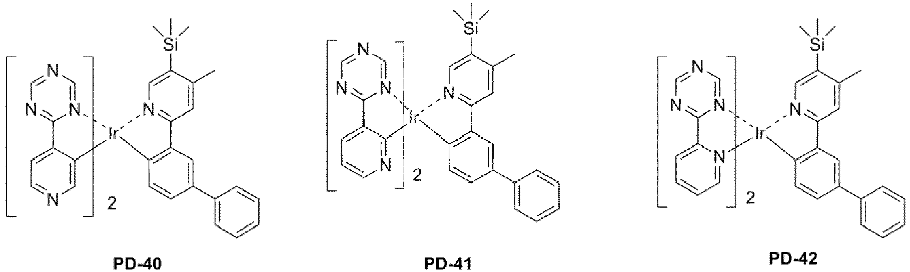

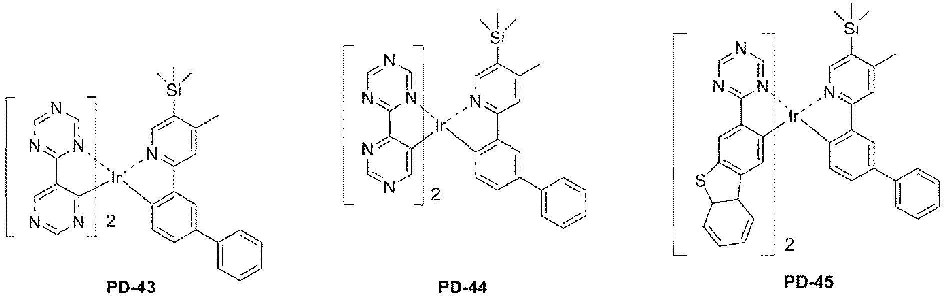

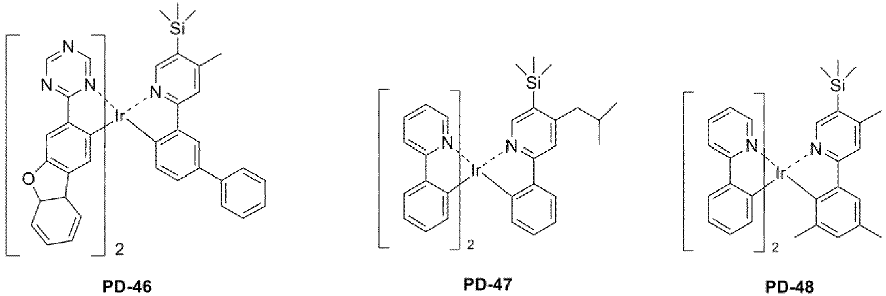

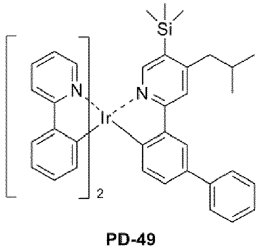

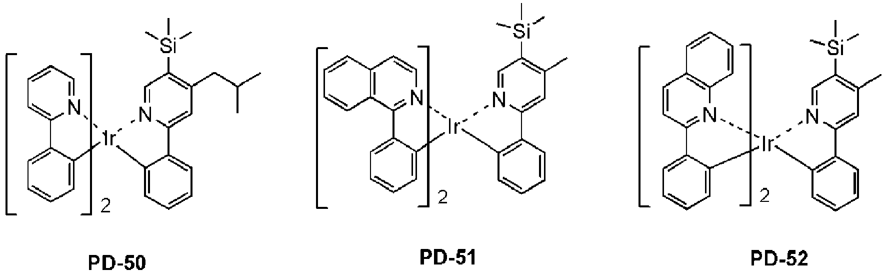

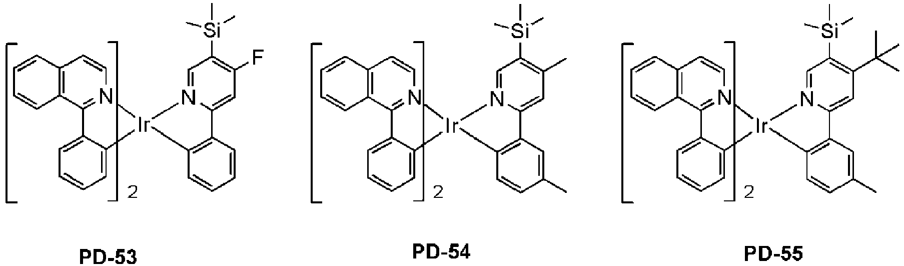

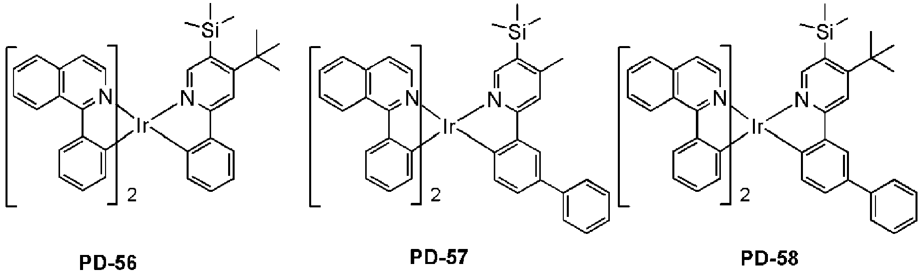

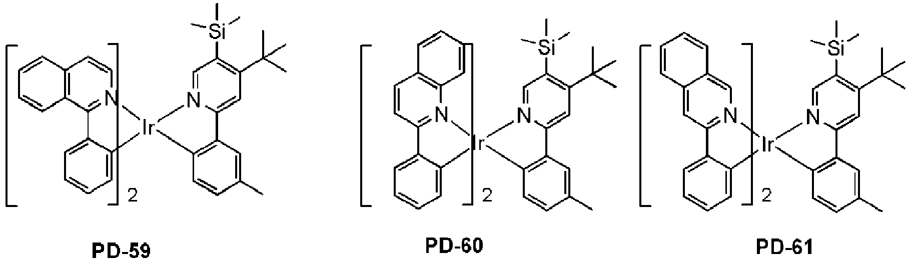

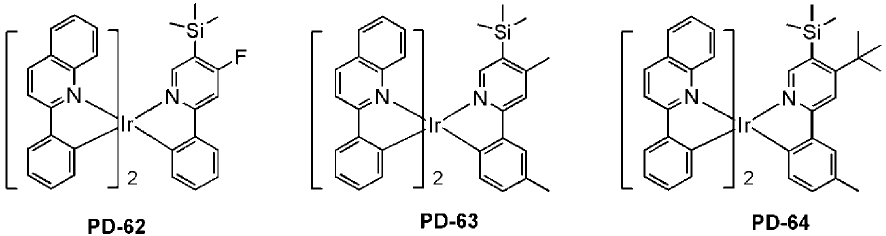

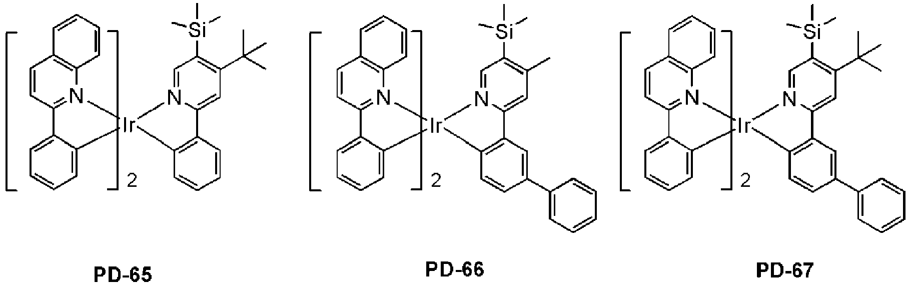

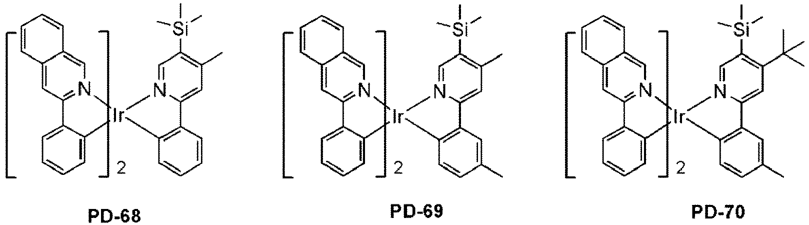

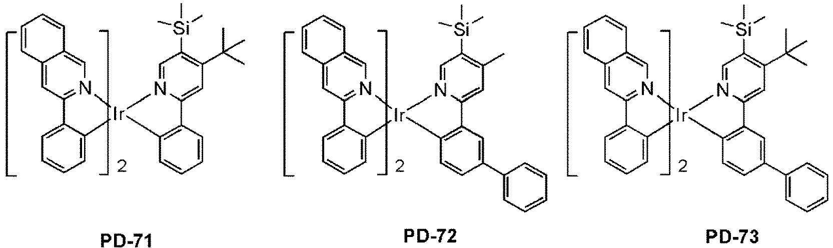

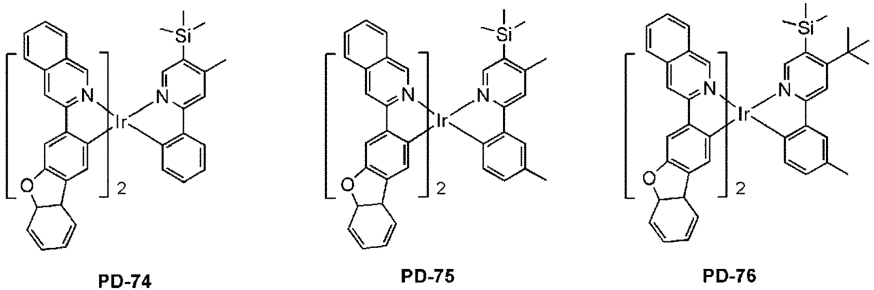

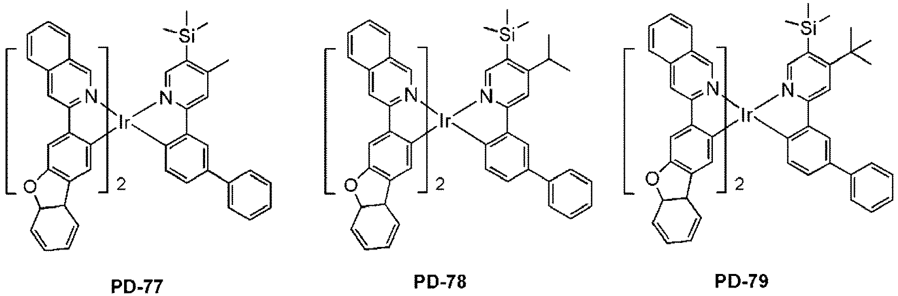

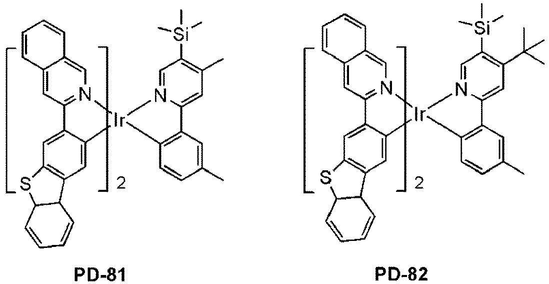

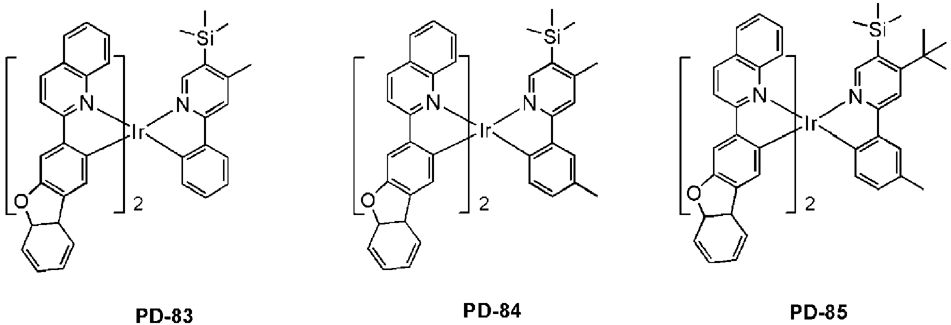

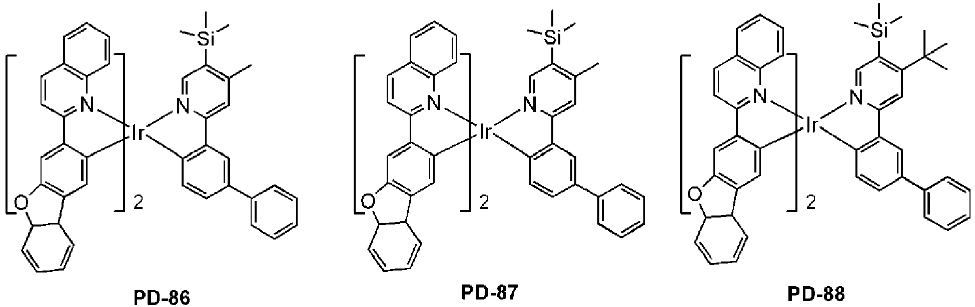

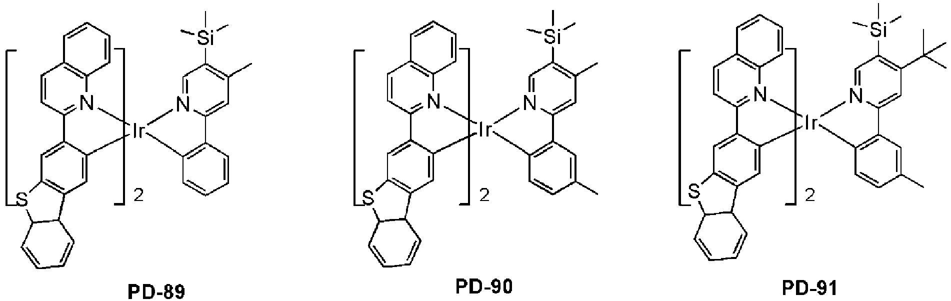

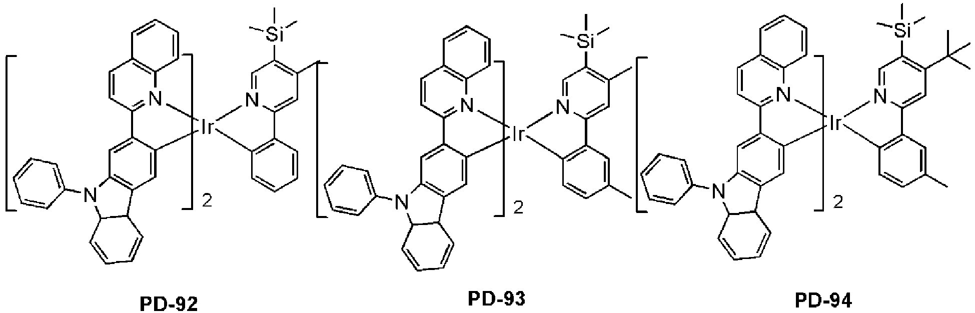

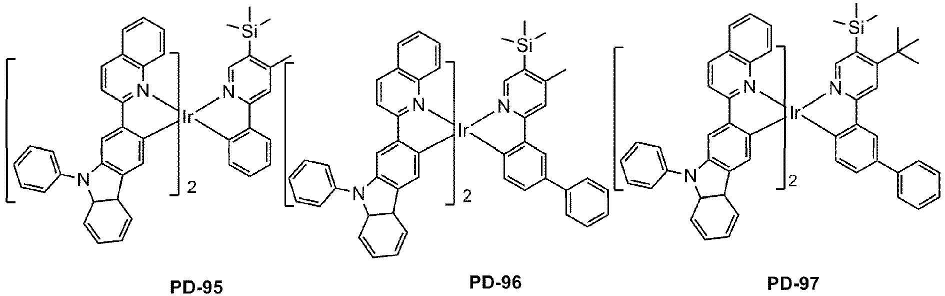

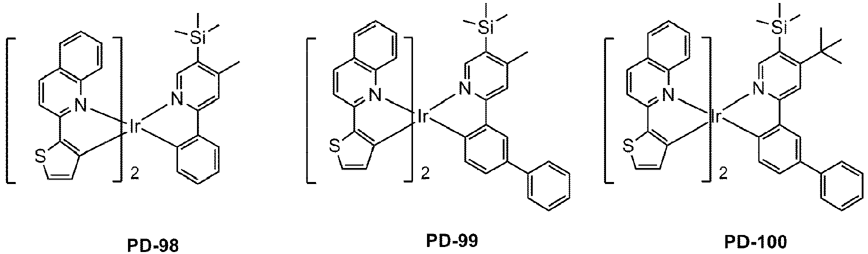

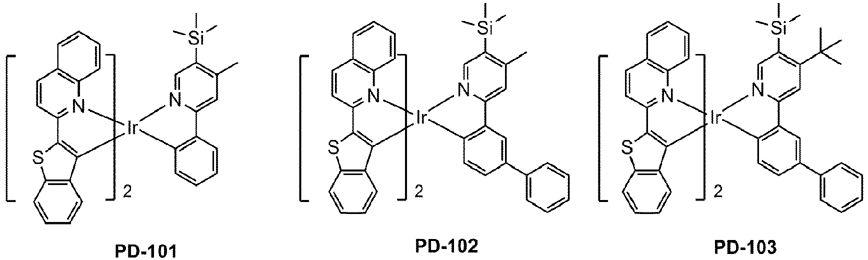

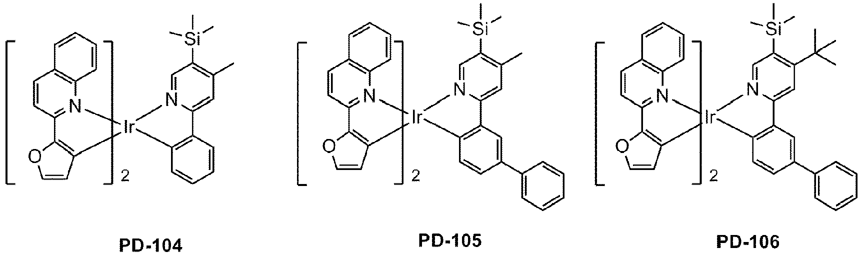

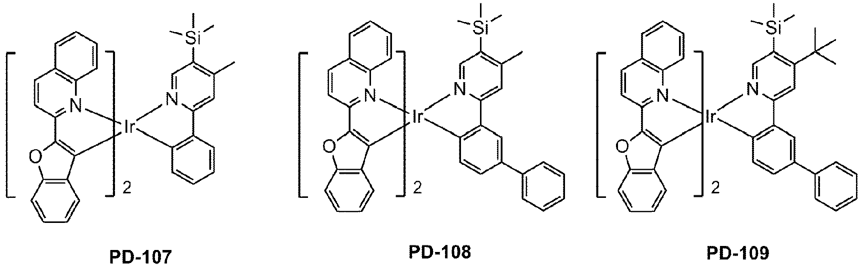

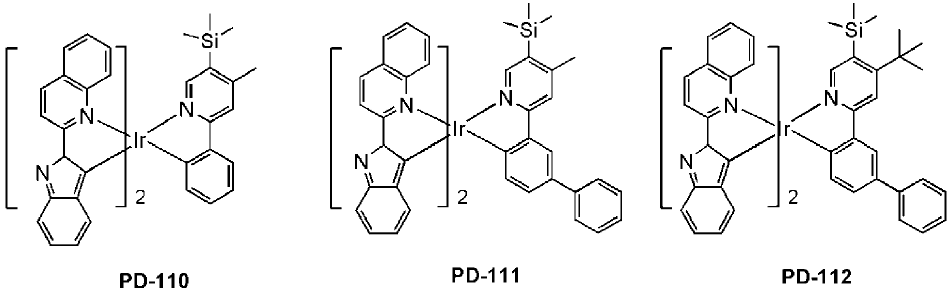

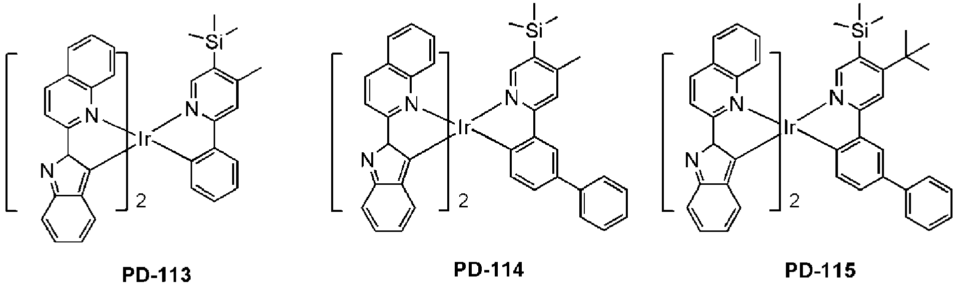

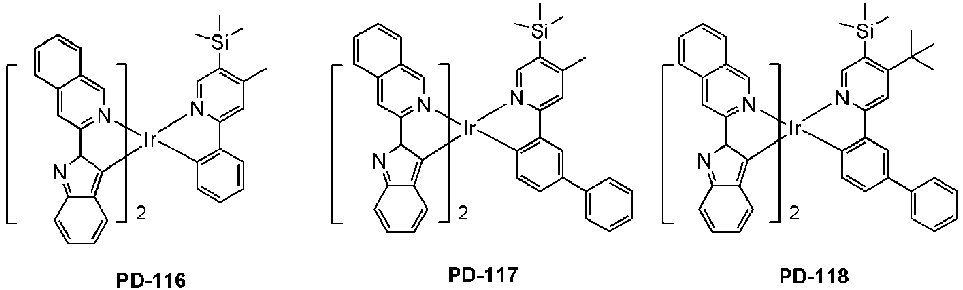

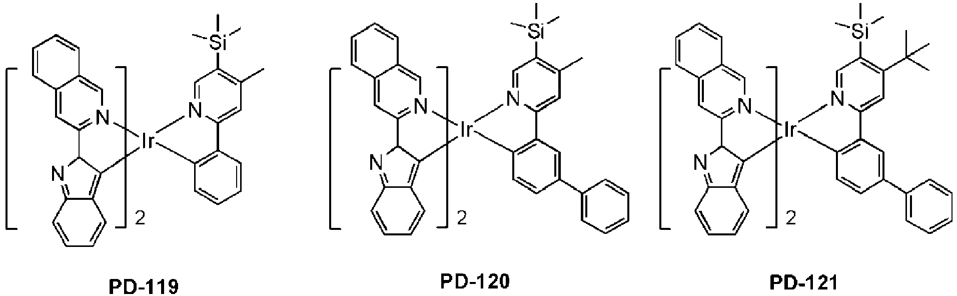

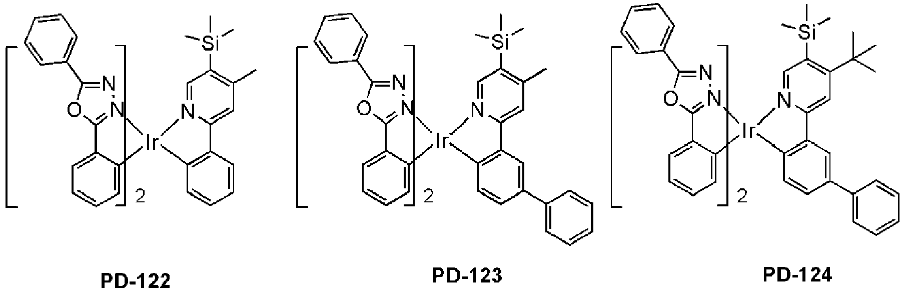

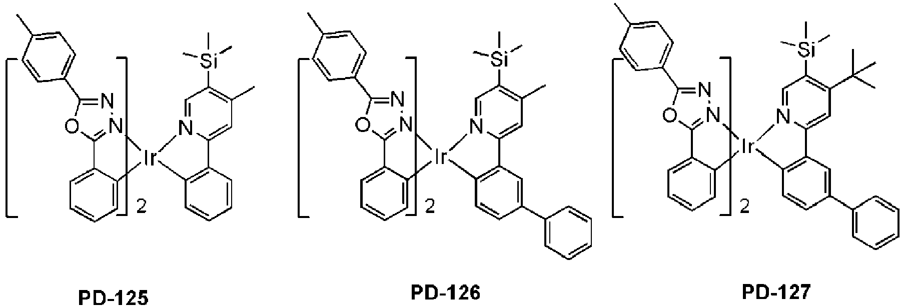

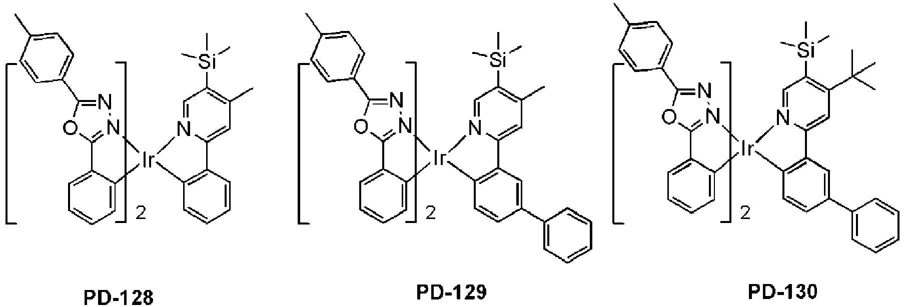

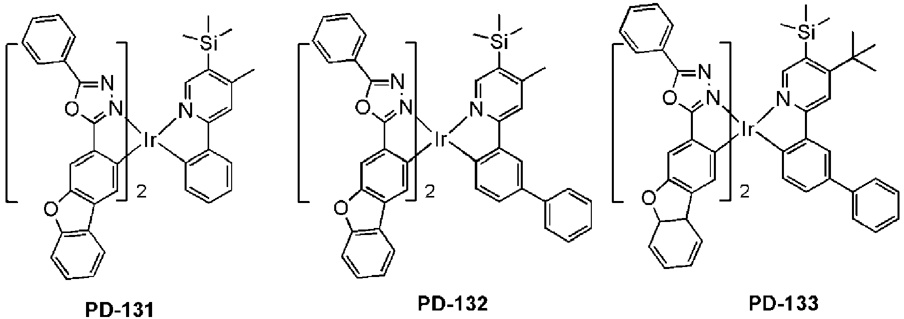

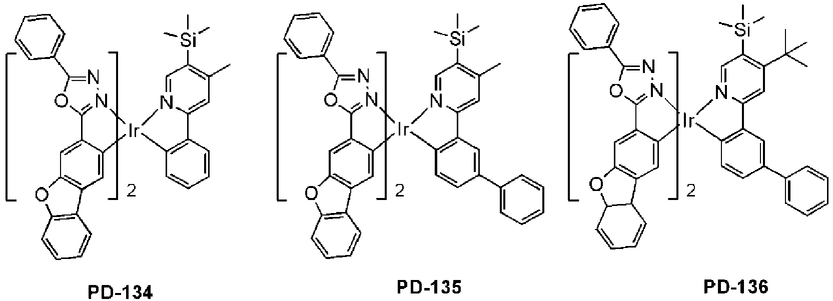

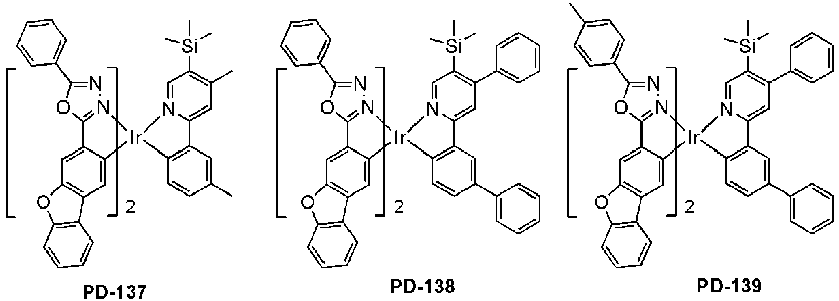

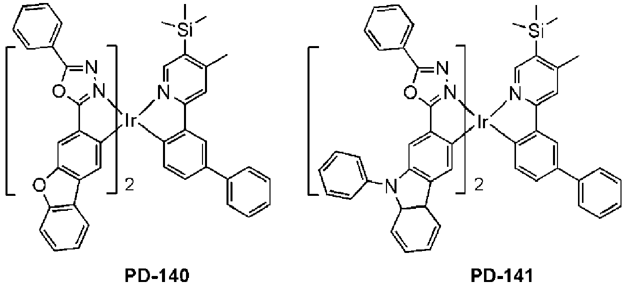

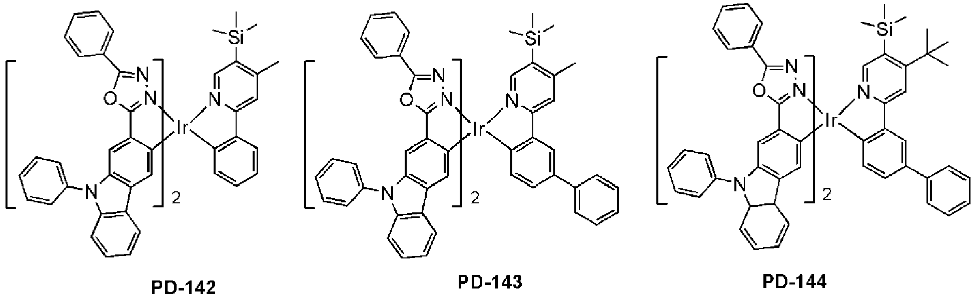

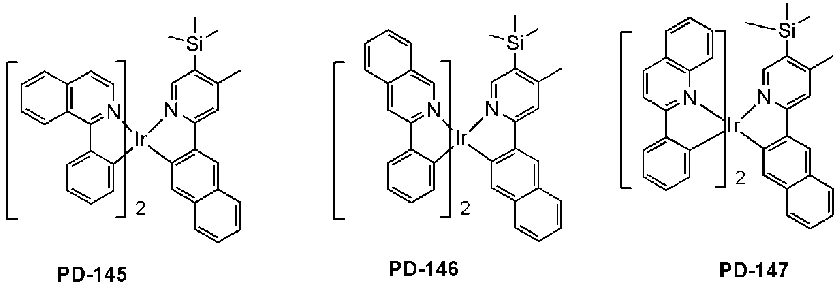

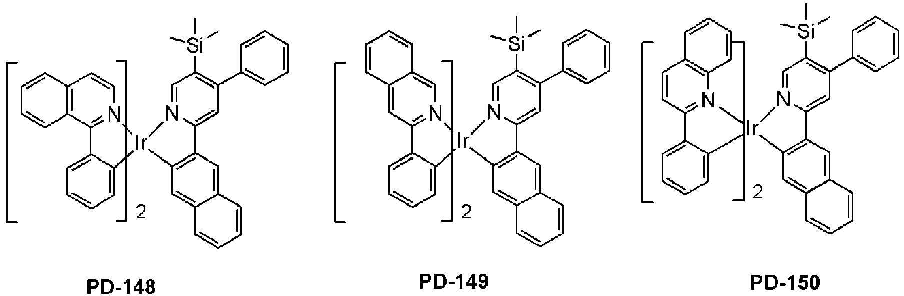

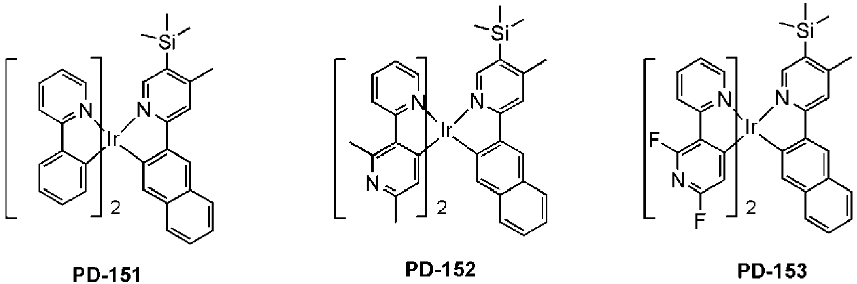

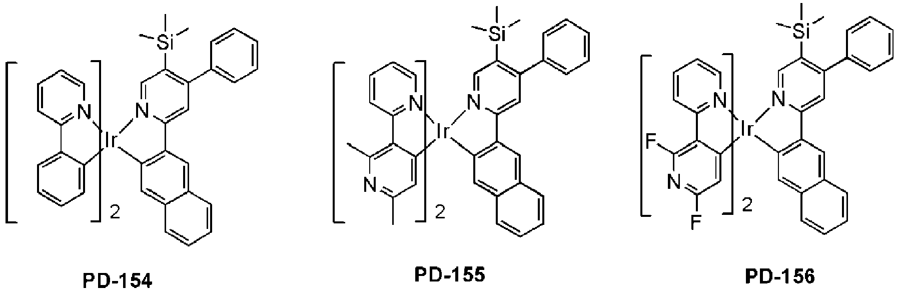

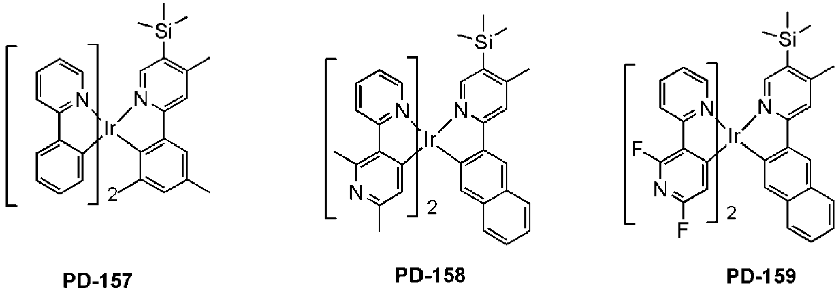

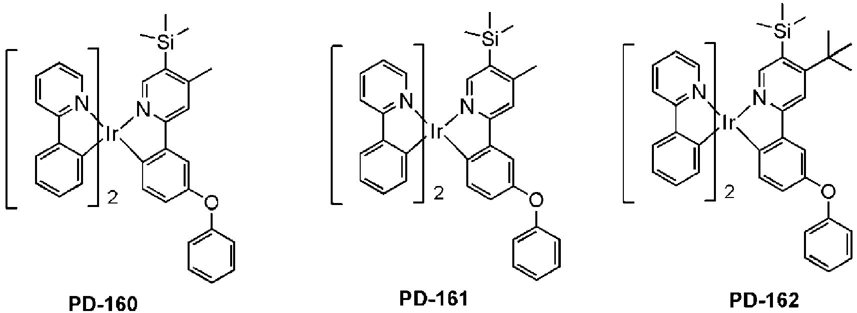

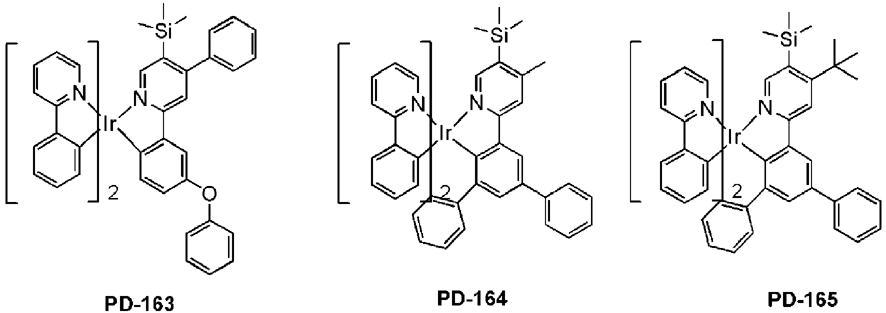

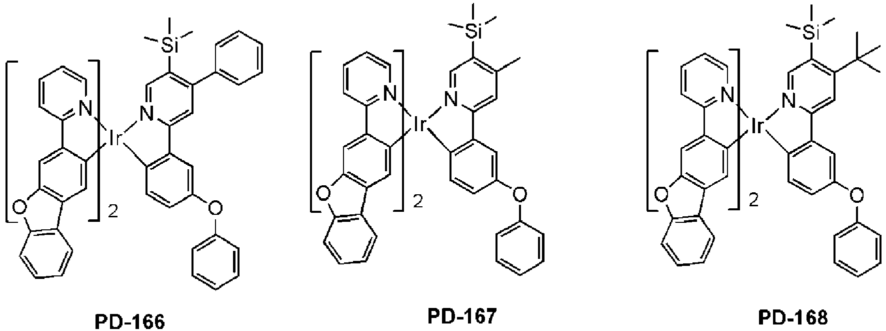

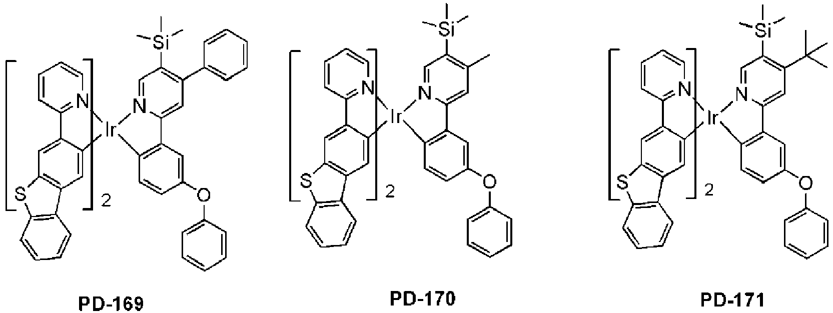

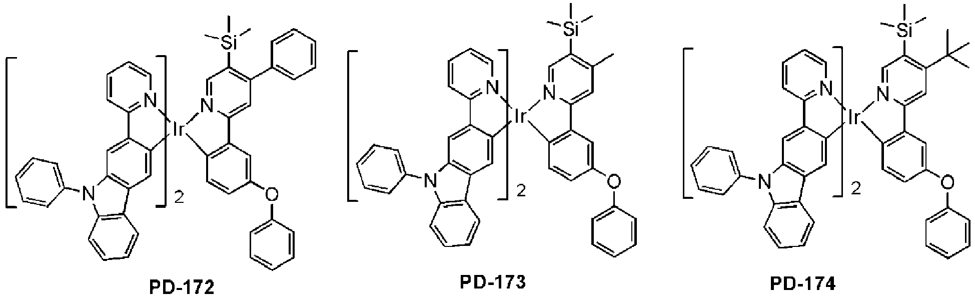

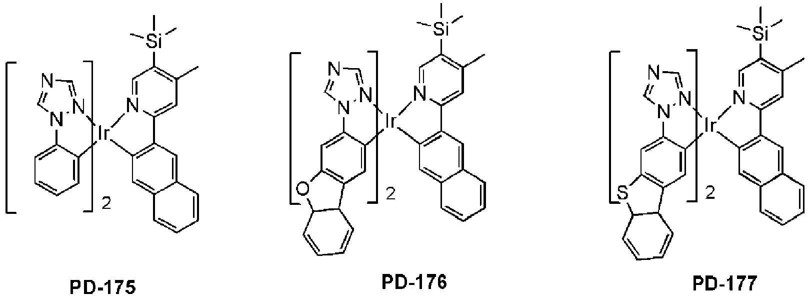

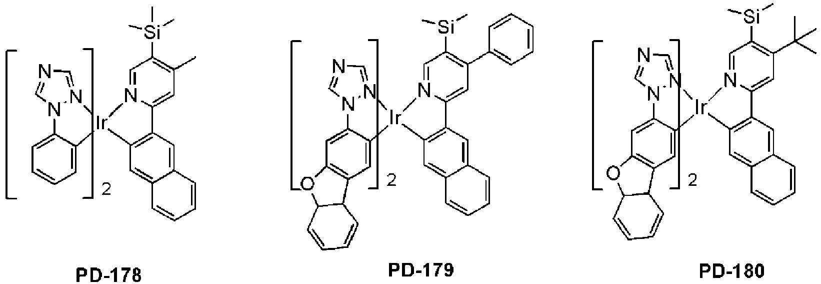

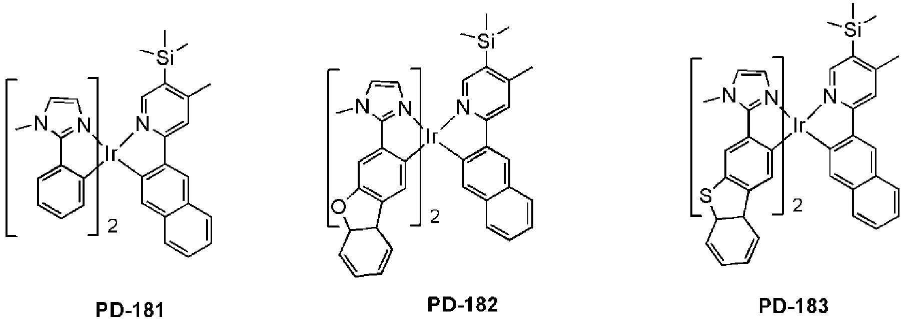

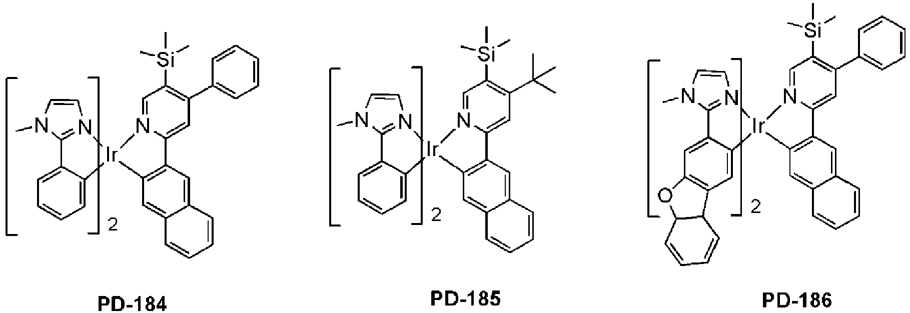

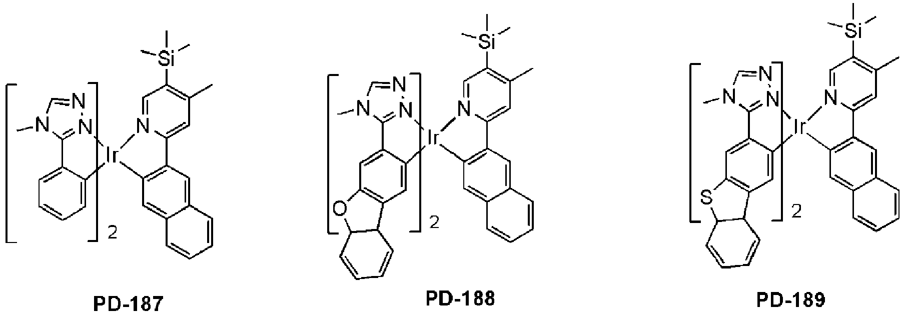

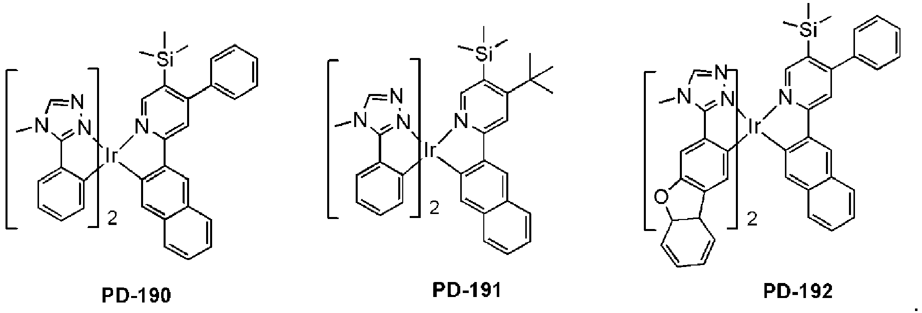

11. The organic light-emitting device of claim 1, wherein
L₂₁ to L₂₃ are each independently selected from a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, an triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group.

12. The organic light-emitting device of claim 1, wherein
L₂₁ to L₂₃ are each independently represented by one of Formulae 3-1 to 3-21: 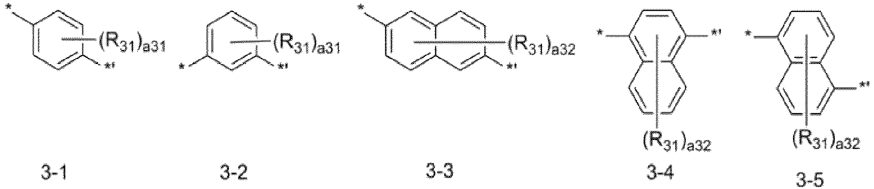 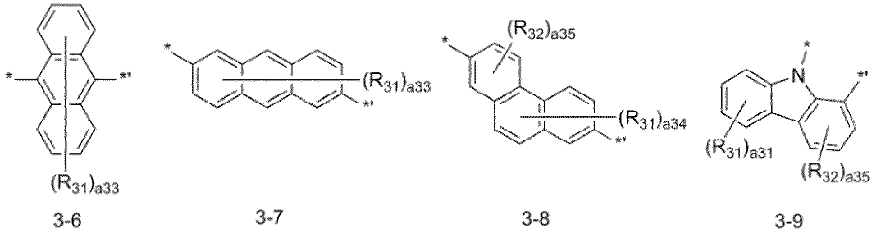 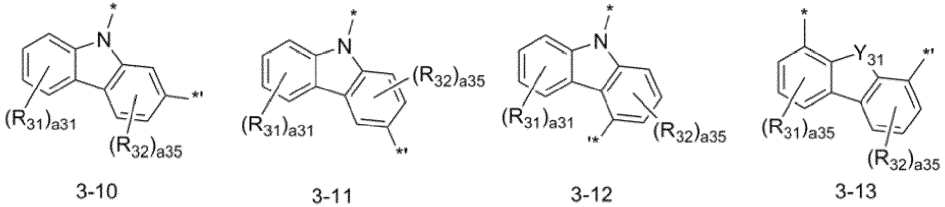 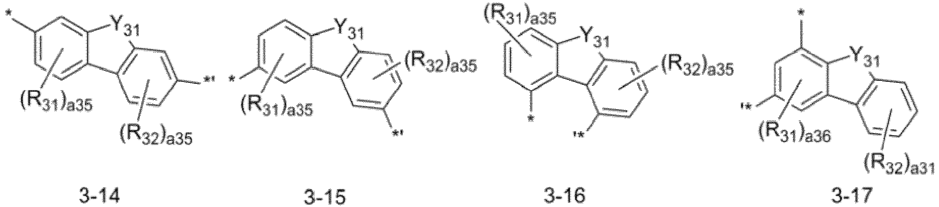 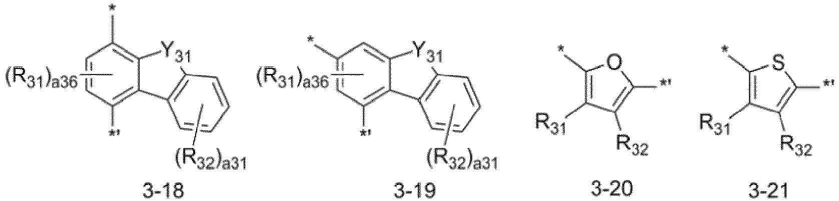 , wherein, in Formulae 3-1 to 3-21,
Y₃₁ is selected from C(R₃₃)(R₃₄), N(R₃₃), O, S, and Si(R₃₃)(R₃₄);
R₃₁ to R₃₄ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
a31 is selected from 1, 2, 3, and 4;
a32 is selected from 1, 2, 3, 4, 5, and 6;
a33 is selected from 1, 2, 3, 4, 5, 6, 7, and 8;
a34 is selected from 1, 2, 3, 4, and 5;
a35 is selected from 1, 2, and 3;
a36 is selected from 1 and 2; and
each of * and *' indicates a binding site to a neighboring site.

13. The organic light-emitting device of claim 1, wherein
R₂₁ and R₂₂ are each independently selected from a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxaliny group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, a thiadiazolyl group, an imidazopyridinyl group, and an imidazopyrimidinyl group; and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxaliny group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, a thiadiazolyl group, an imidazopyridinyl group, and an imidazopyrimidinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a biphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxaliny group, a quinazolinyl group, a benzoquinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, and an imidazopyrimidinyl group.

14. The organic light-emitting device of claim 1, wherein
R₂₁ and R₂₂ are each independently selected from groups represented by Formulae 5-1 to 5-14: 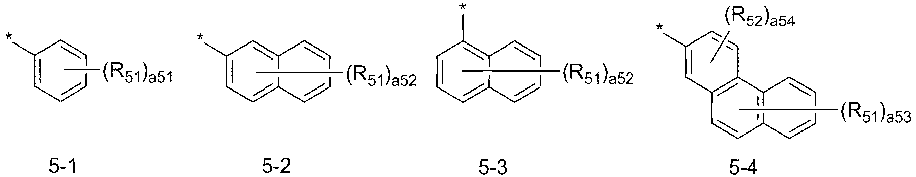 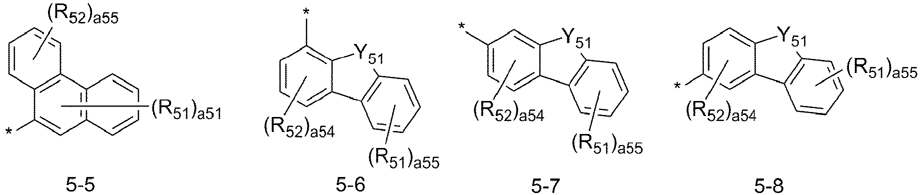 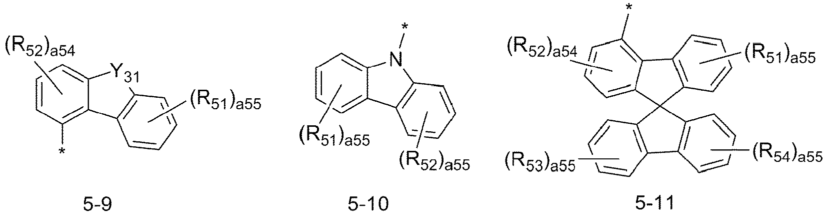 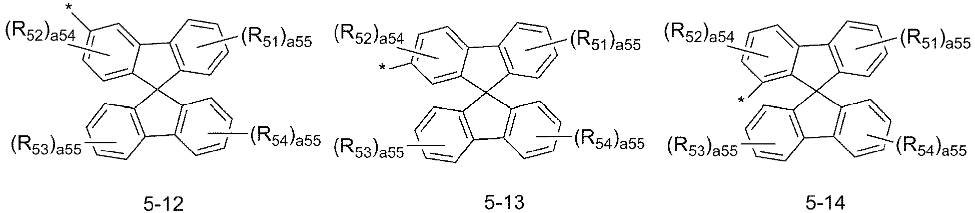 , wherein, in Formulae 5-1 to 5-14,
Y₅₁ is selected from C(R₅₃)(R₅₄), N(R₅₃), O, and S;
R₅₁ to R₅₄ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, -CD₃, -CF₃, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group;
a51 is selected from 1, 2, 3, 4, and 5;
a52 is selected from 1, 2, 3, 4, 5, 6, and 7;
a53 is selected from 1, 2, 3, 4, 5, and 6;
a54 is selected from 1, 2, and 3;
a55 is selected from 1, 2, 3, and 4; and
* indicates a binding site to a neighboring site.

15. The organic light-emitting device of claim 1, wherein
R₂₁ and R₂₂ are each independently selected from groups represented by Formulae 6-1 to 6-55: 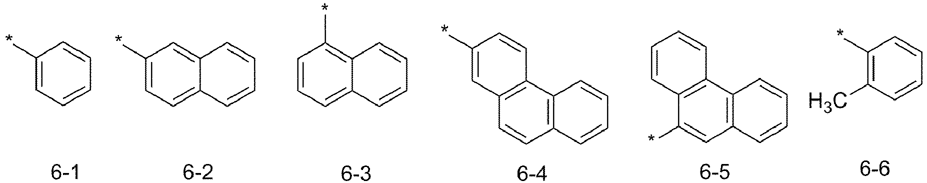 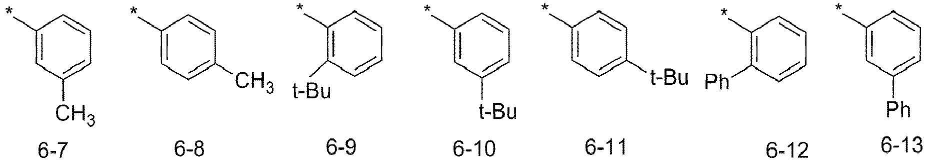 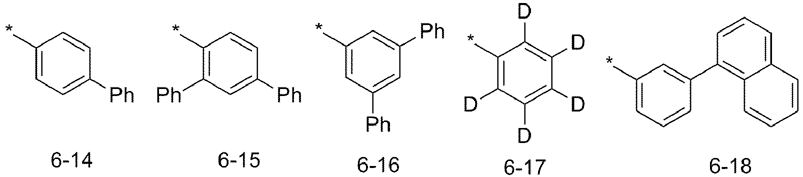 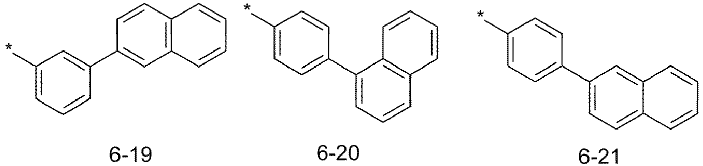 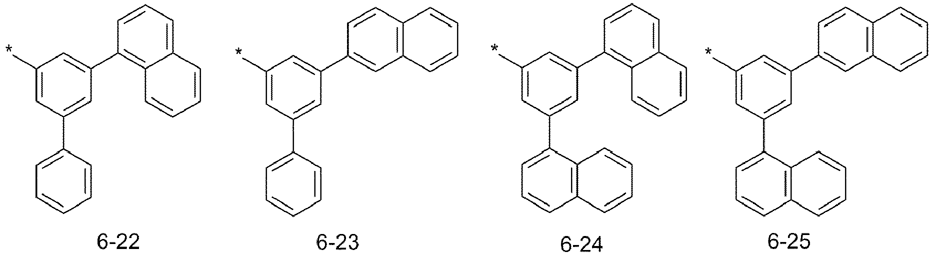 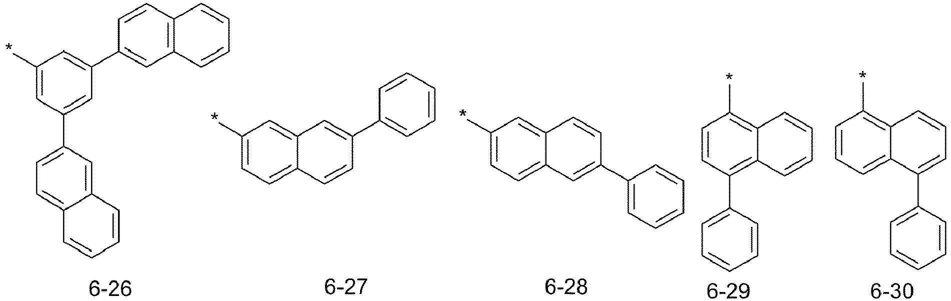 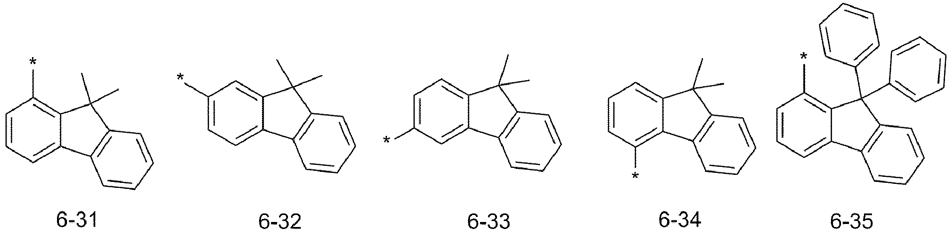 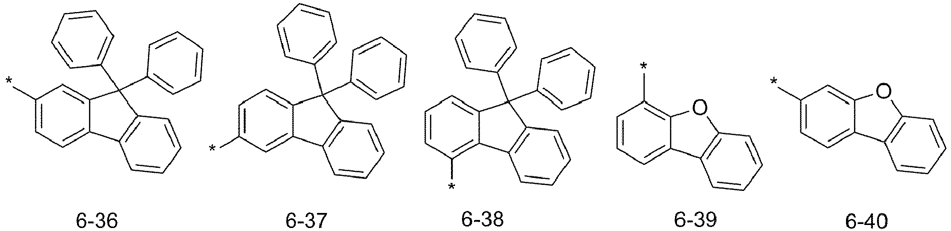 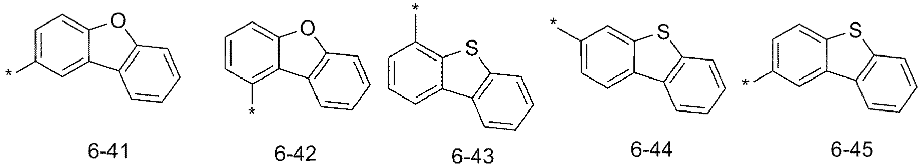 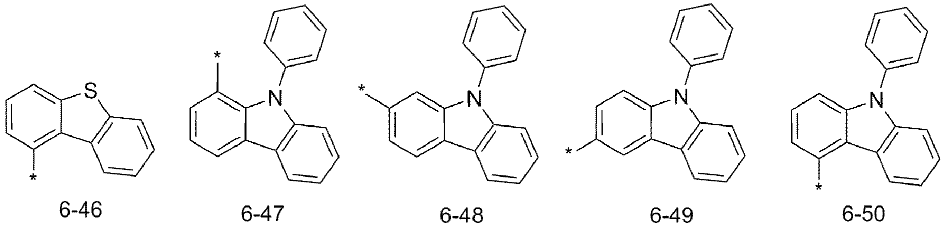 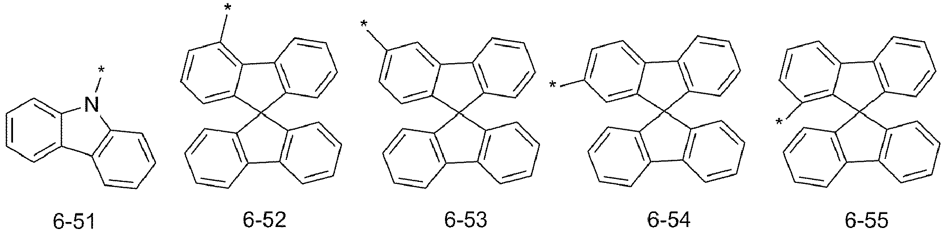 , wherein, in Formulae 6-1 to 6-55,
* indicates a binding site to a neighboring site.

16. The organic light-emitting device of claim 1, wherein
R₈₁ to R₉₆ are each independently selected from 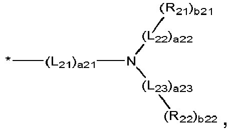 hydrogen, groups represented by Formulae 6-1 to 6-3, and groups represented by Formulae 6-31 to 6-55: 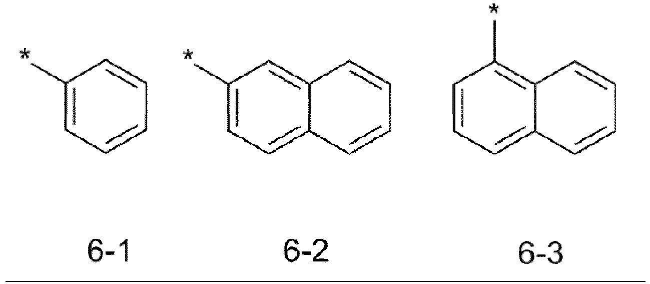 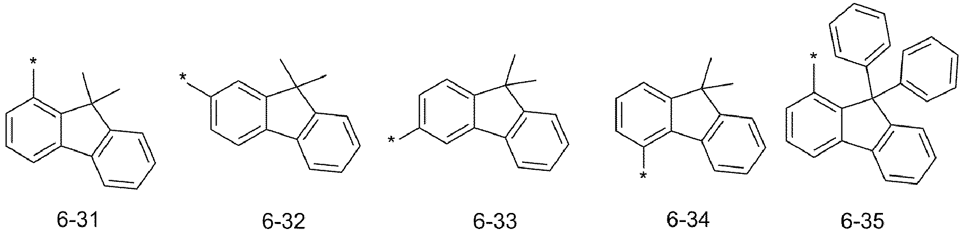 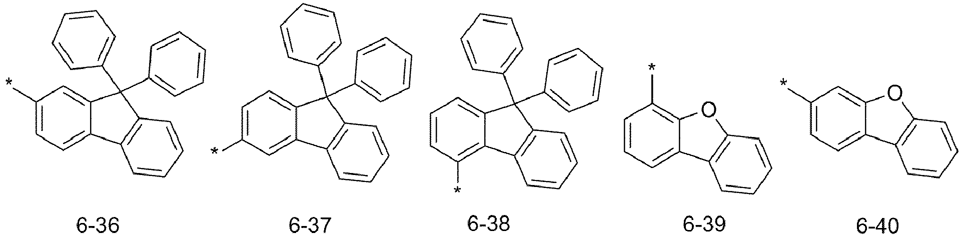 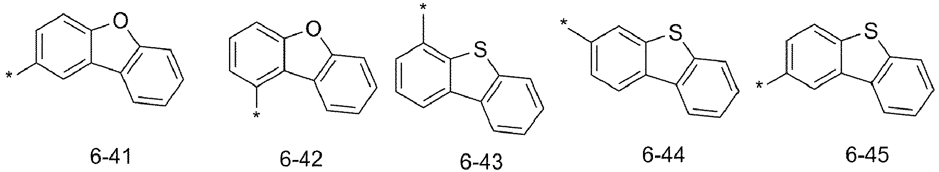 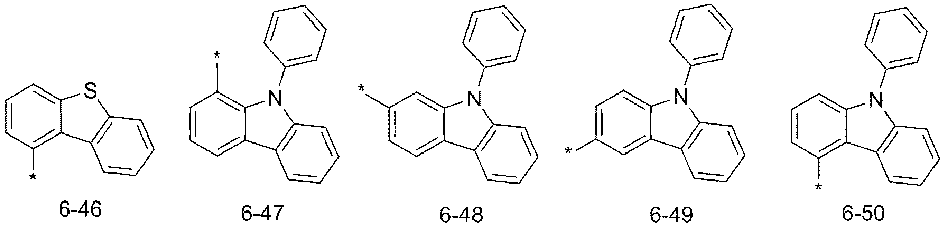 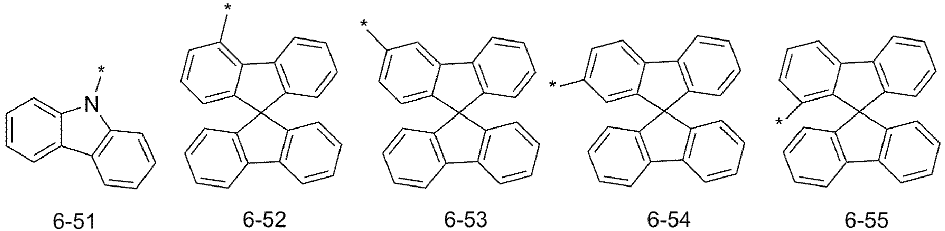 , wherein, in Formulae 6-1 to 6-3 and Formulae 6-31 to 6-55,
* indicates a binding site to a neighboring site.

17. The organic light-emitting device of claim 1, wherein
the amine-based compound is represented by one of Formulae 2-1 to 2-6: 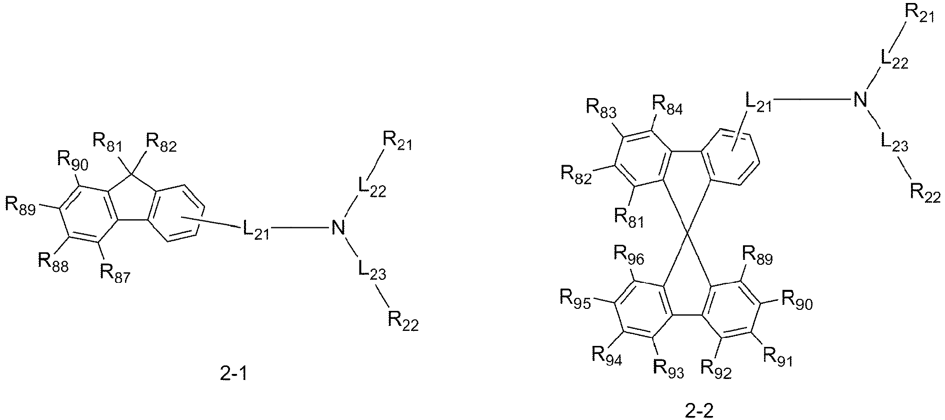 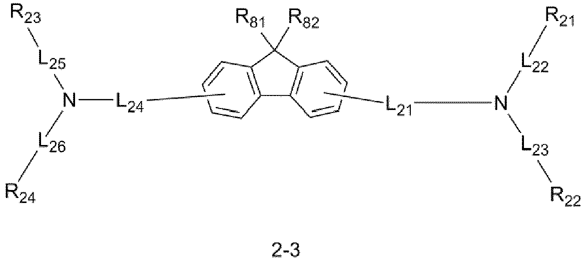 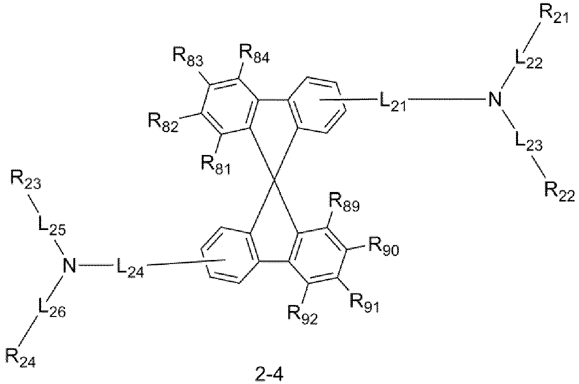 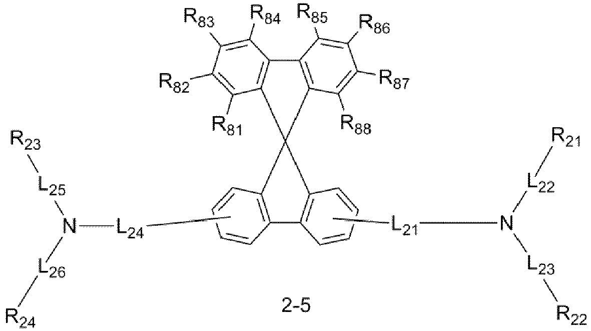 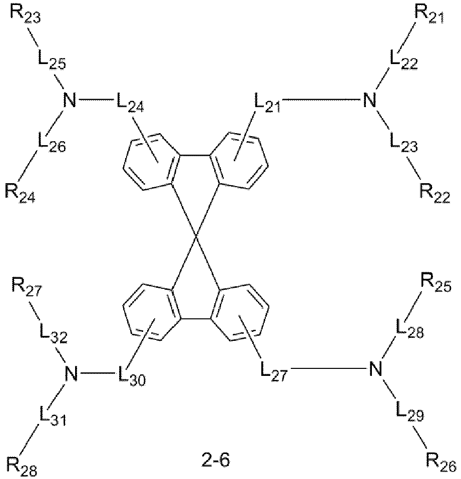 , wherein, in Formulae 2-1 to 2-6,
L₂₁ to L₂₃, R₂₁, R₂₂, and R₈₁ to R₉₆ are the same as described in claim 1;
L₂₄ to L₃₂ are each independently the same as described in connection with L₂₁; and
R₂₃ to R₂₈ are each independently the same as described in connection with R₂₁.

18. The organic light-emitting device of claim 1, wherein
the amine-based compound is selected from compounds illustrated below:

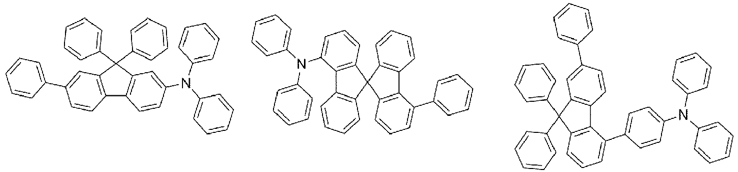

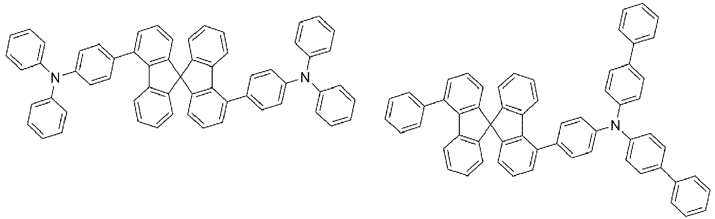

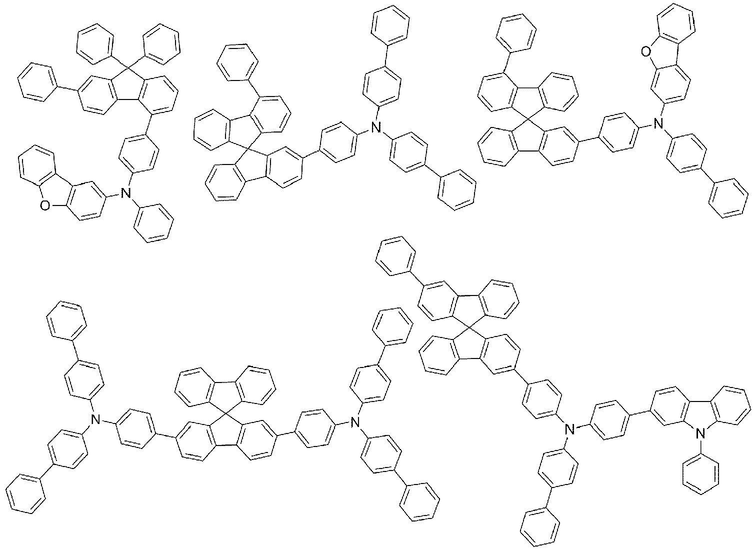

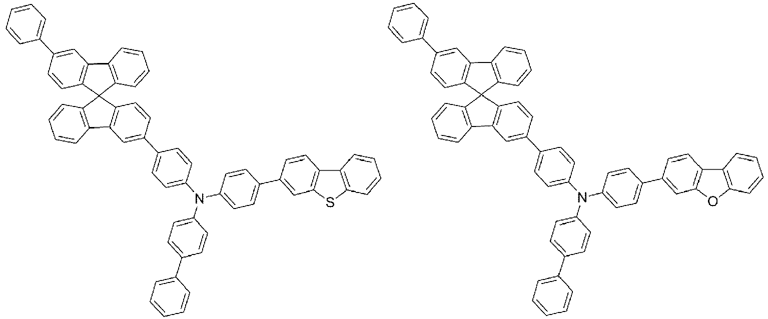

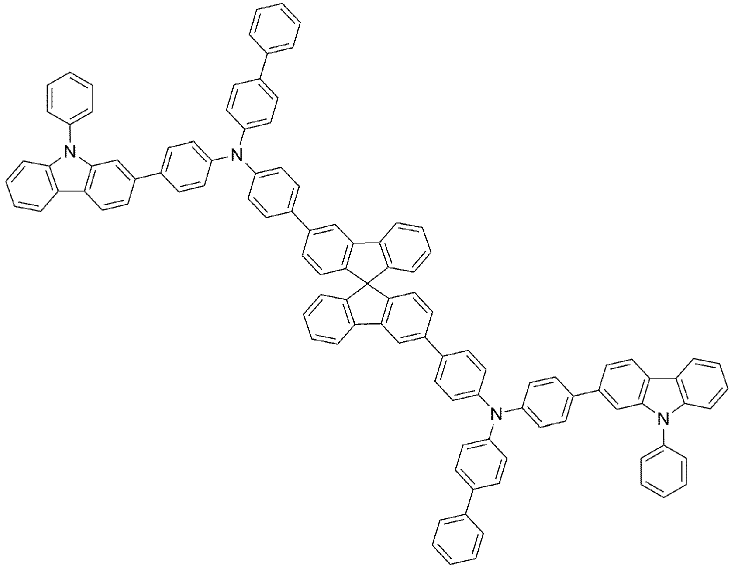

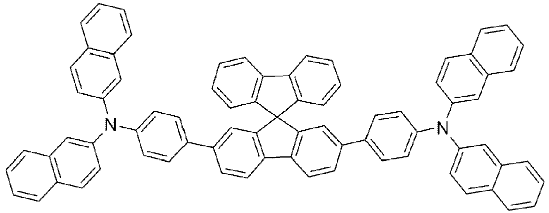

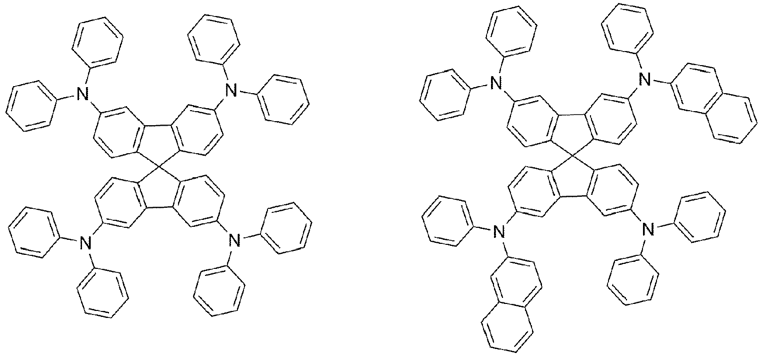

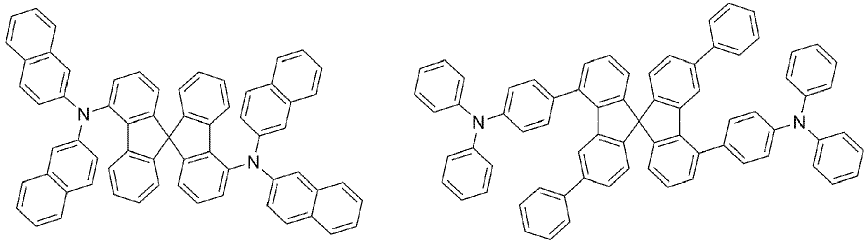

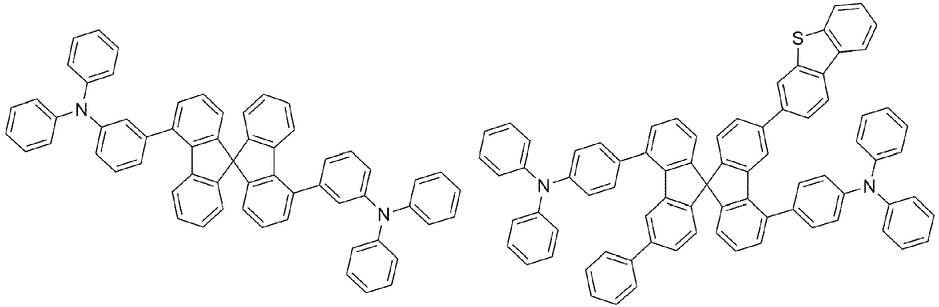

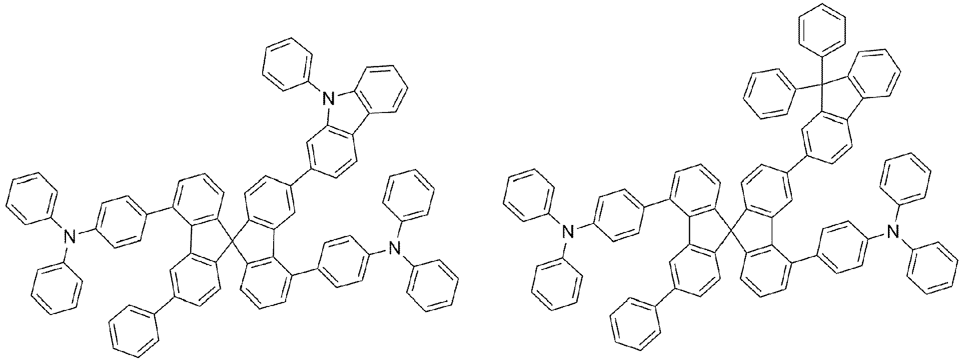

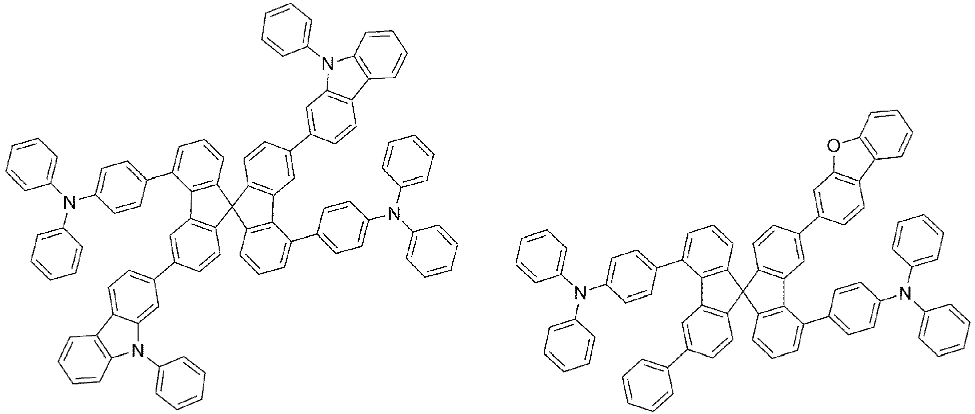

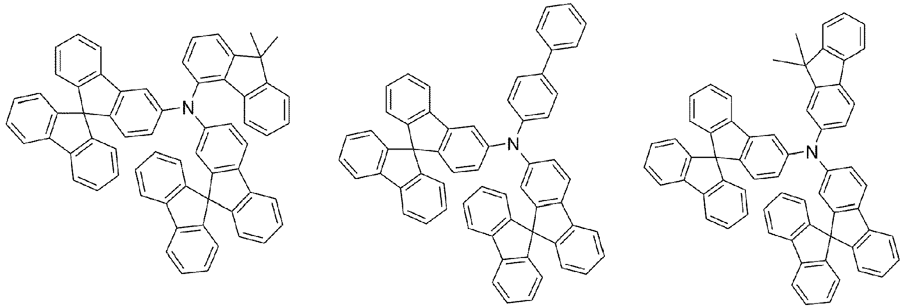

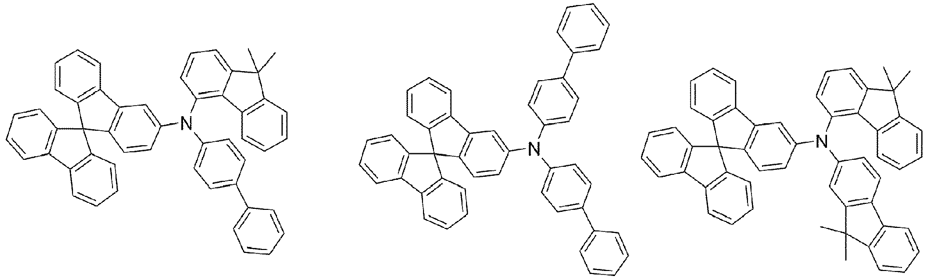

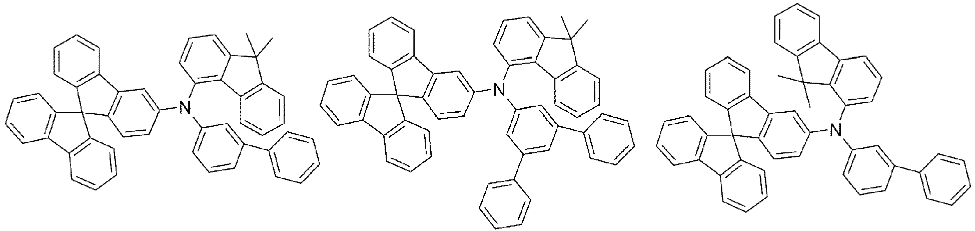

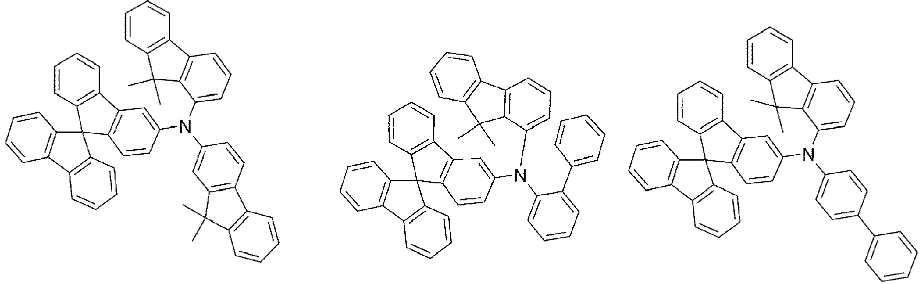

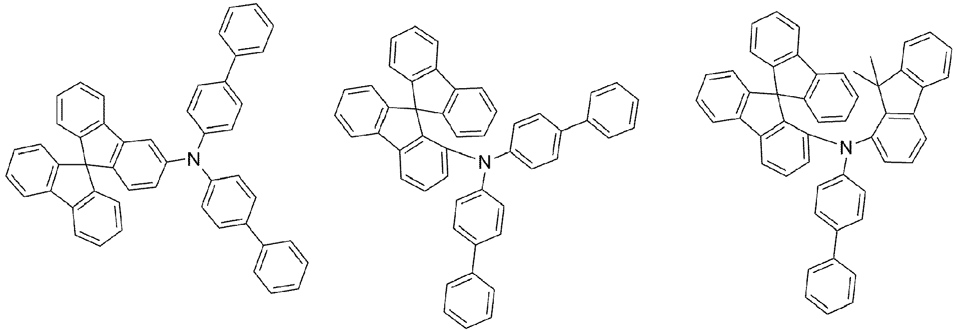

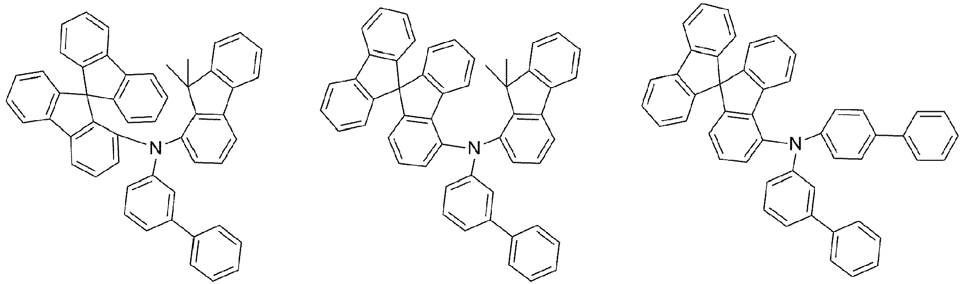

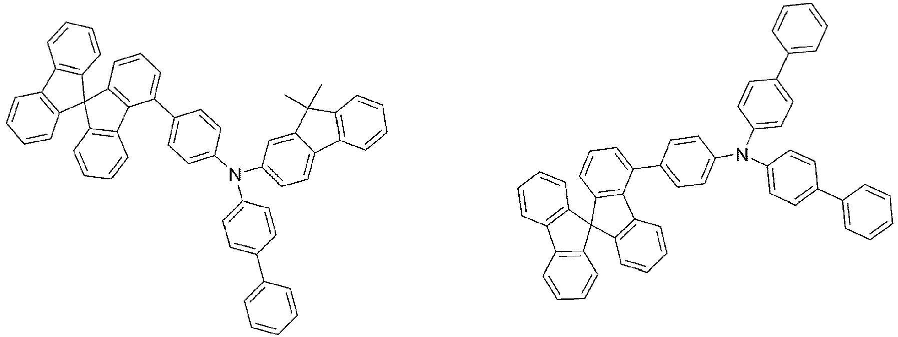

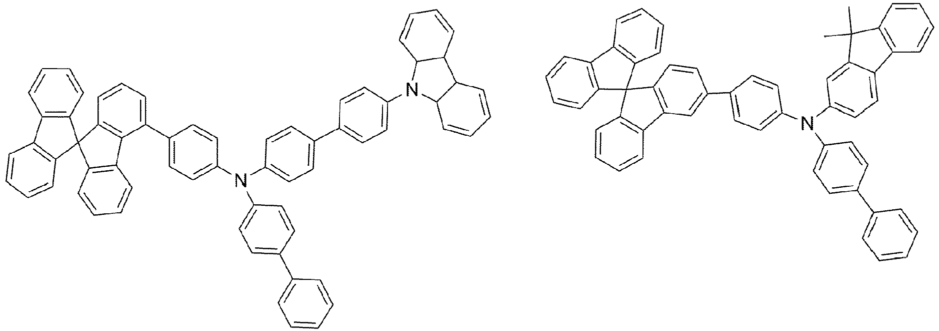

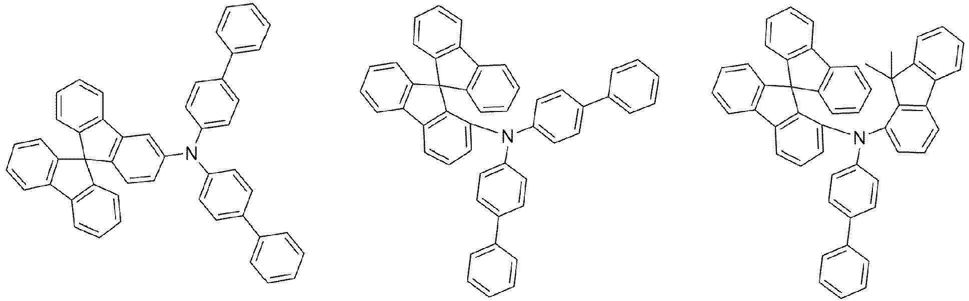

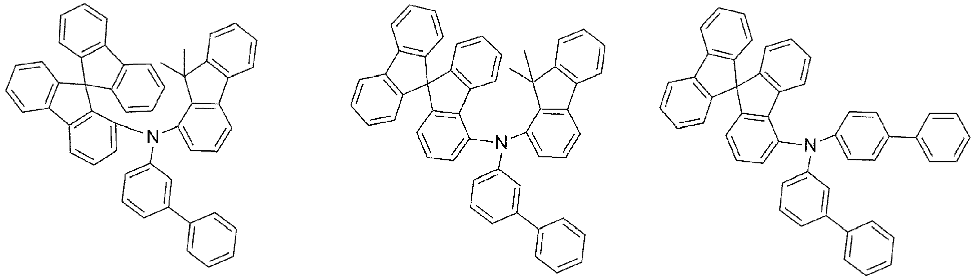

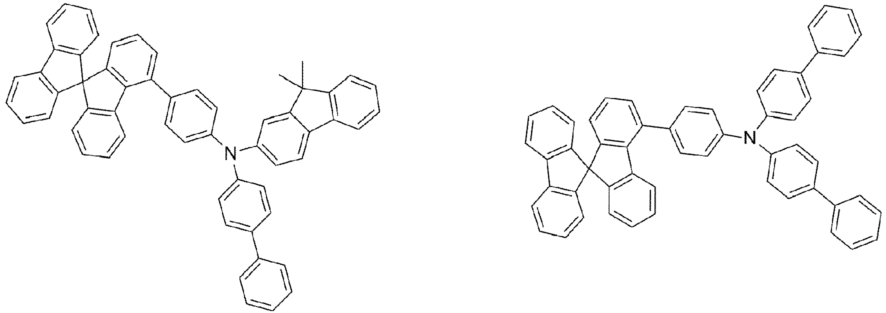

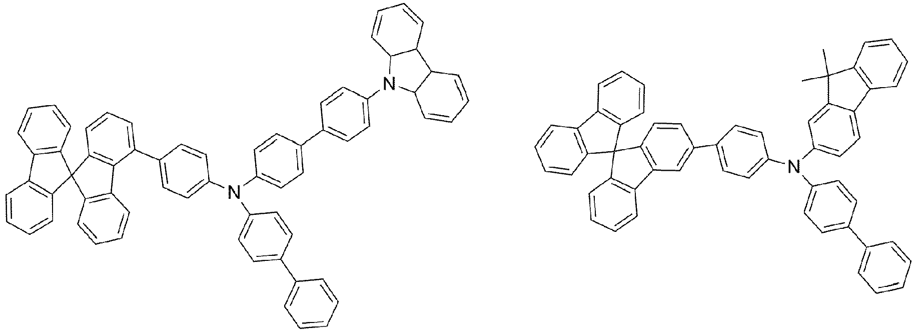

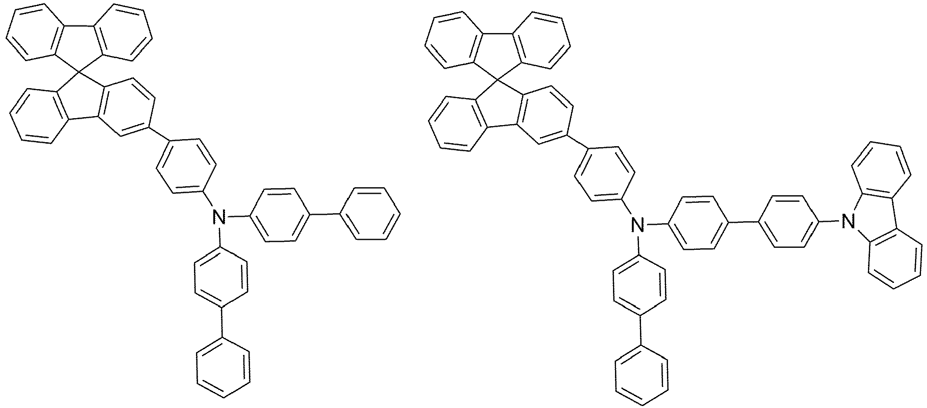

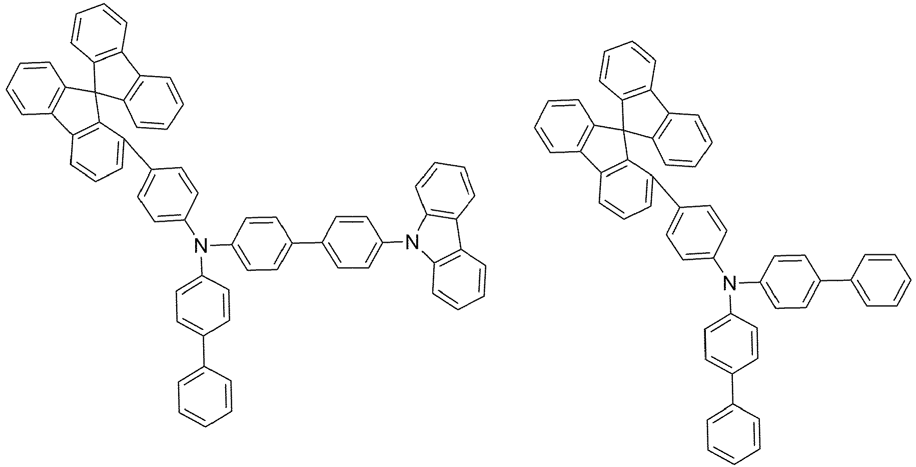

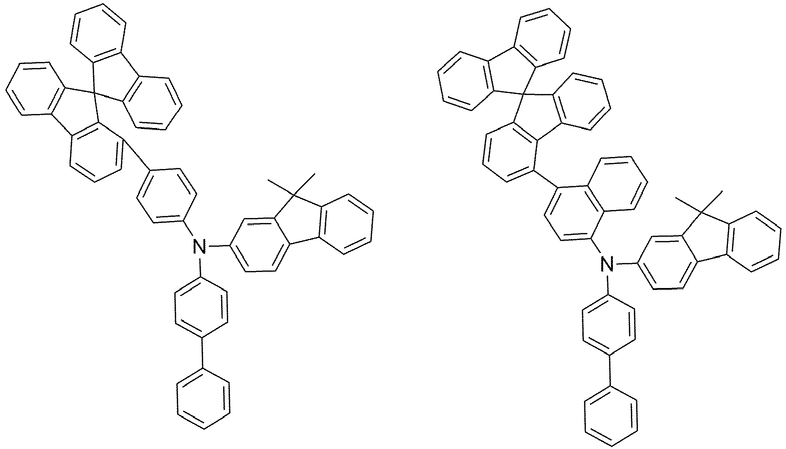

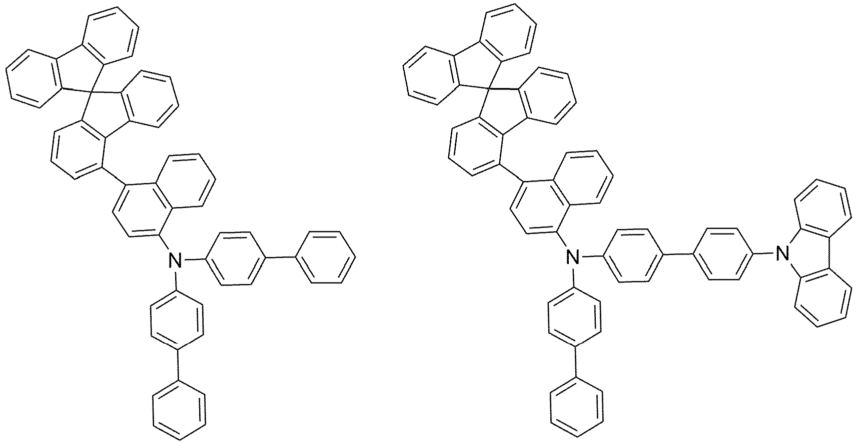

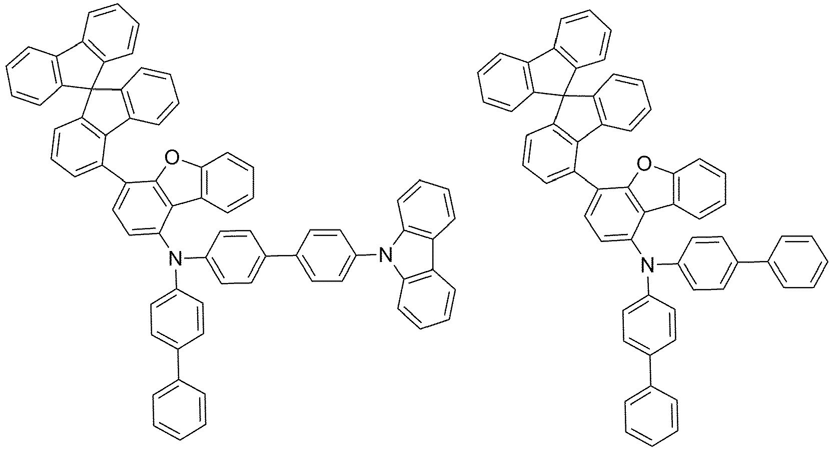

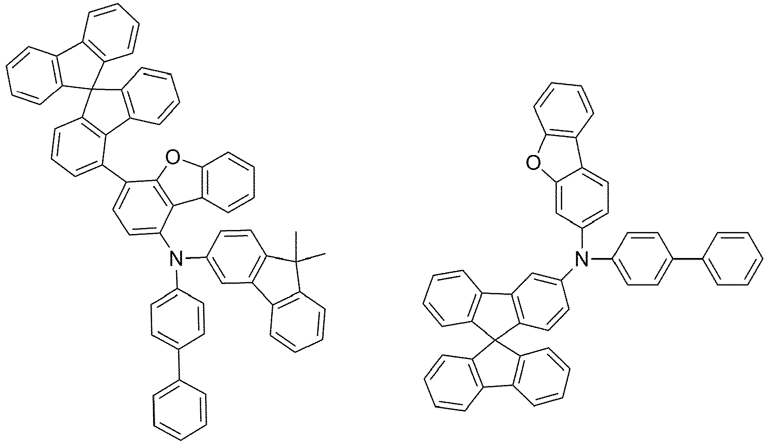

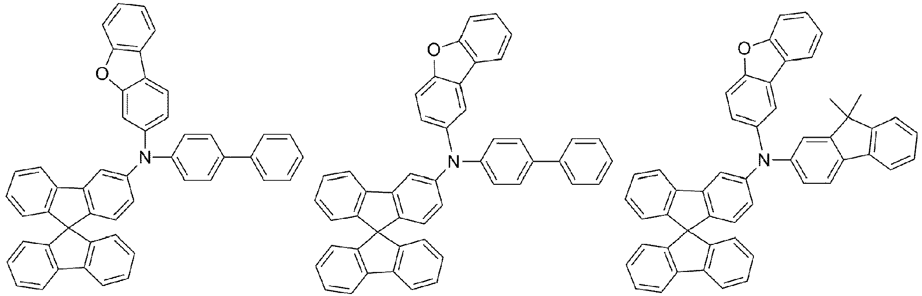

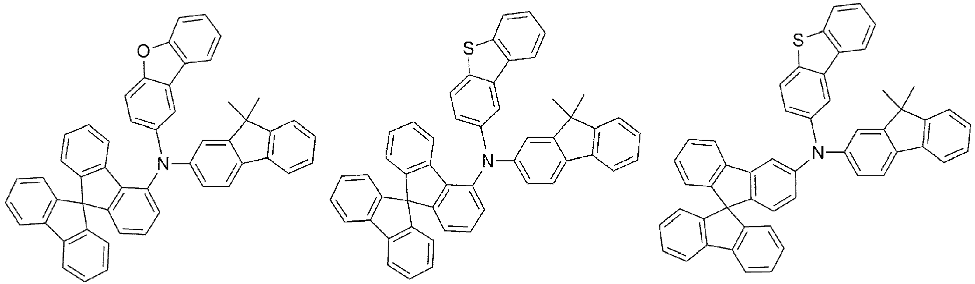

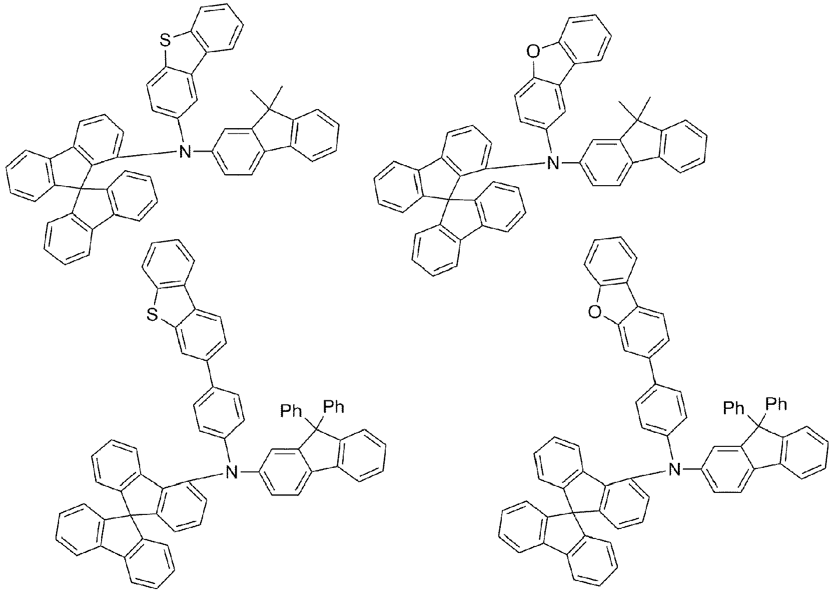

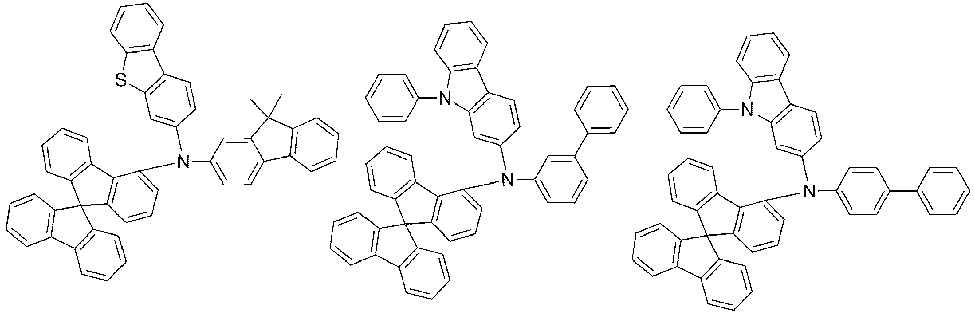

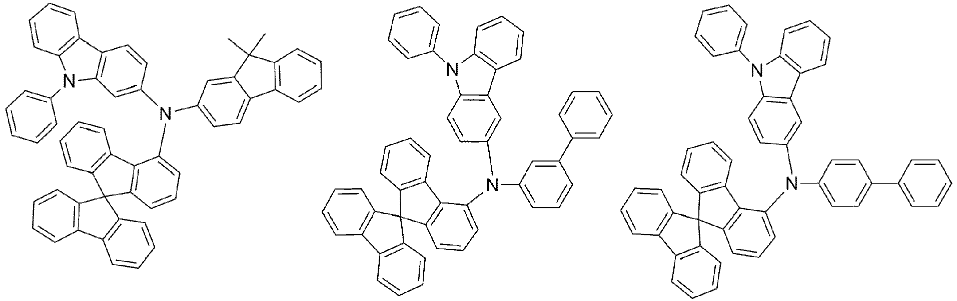

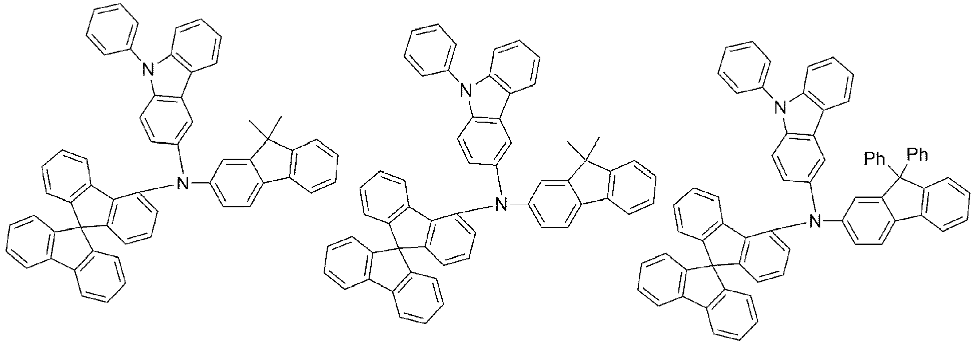

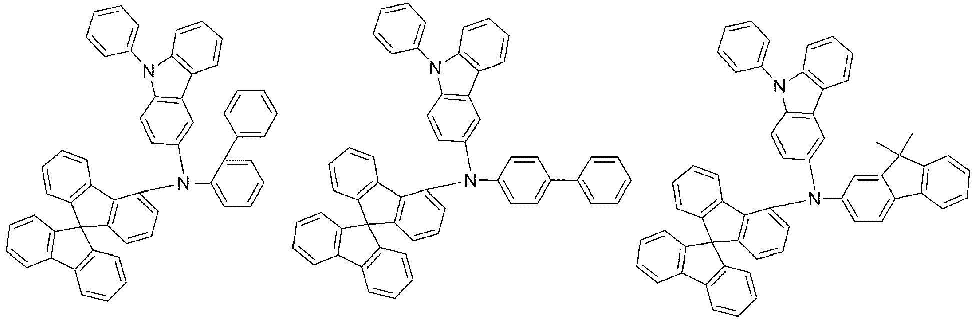

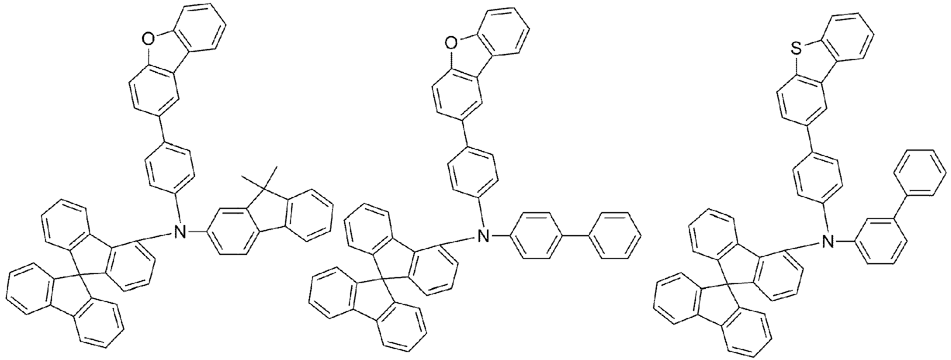

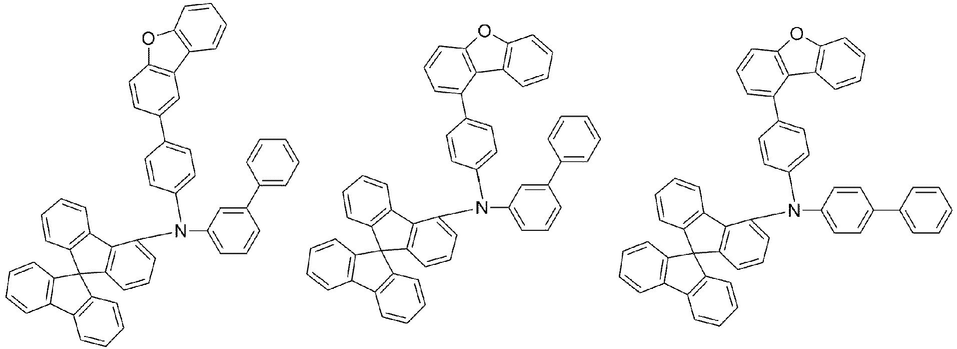

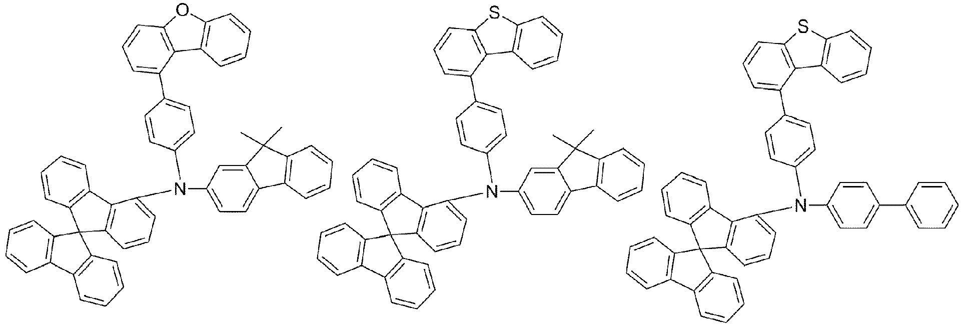

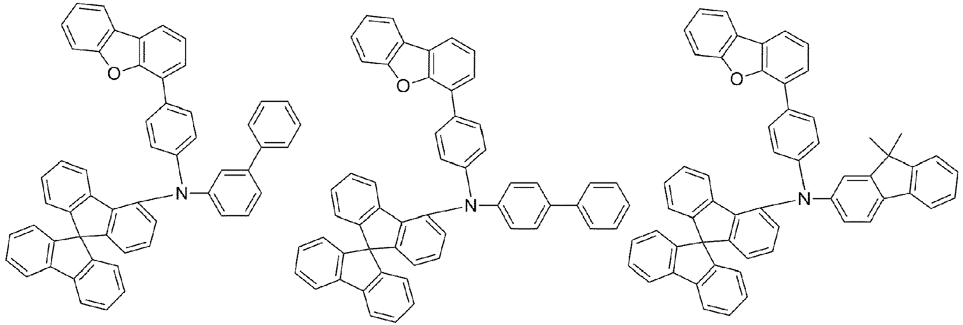

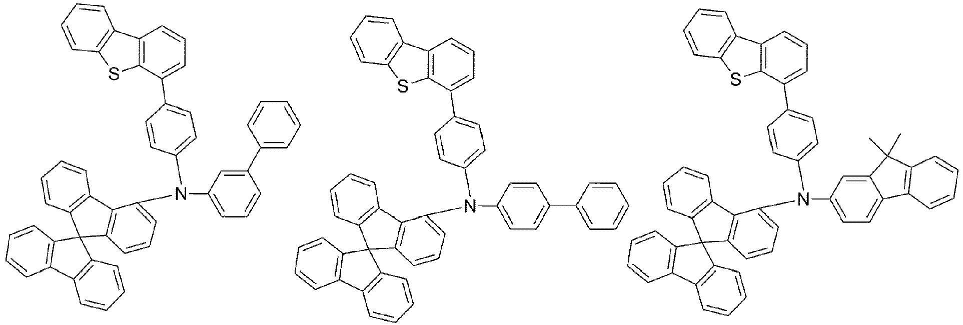

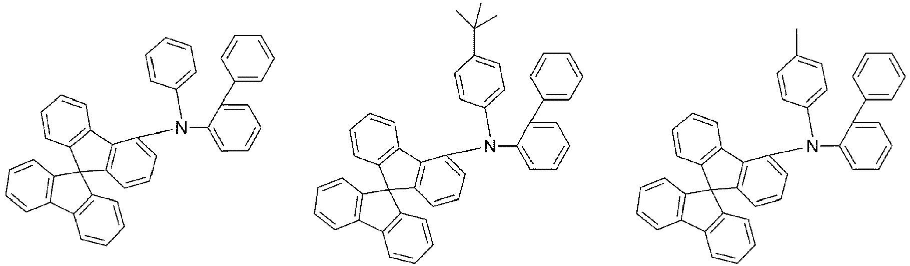

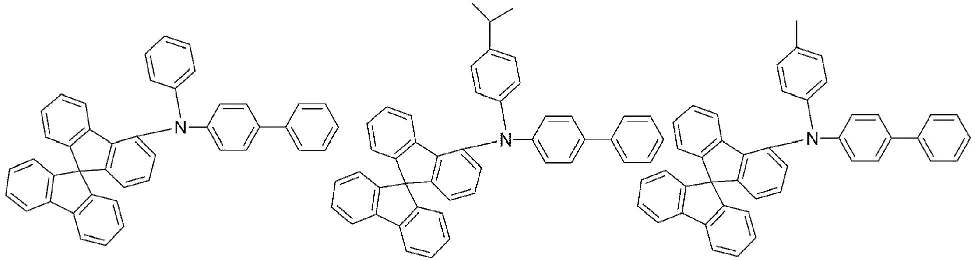

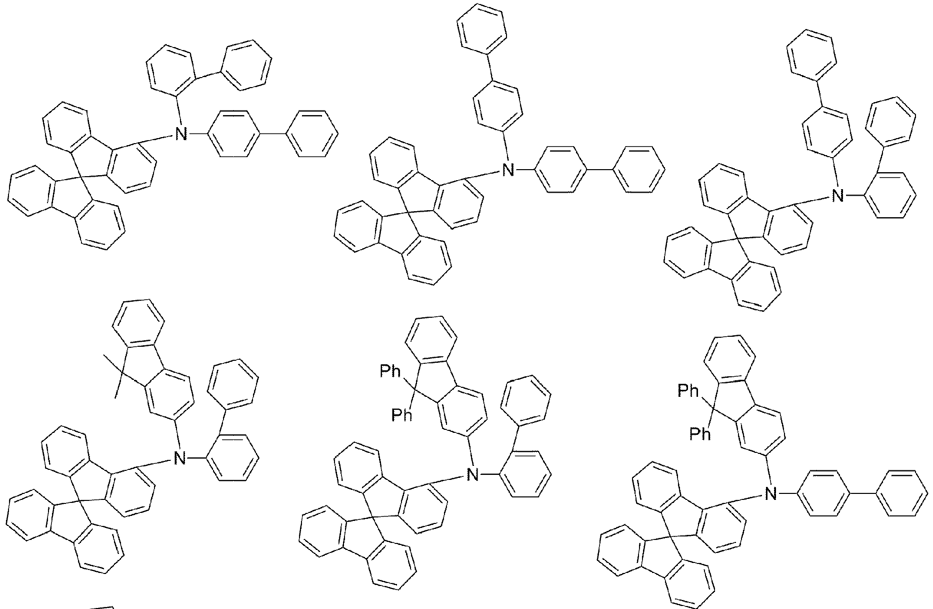

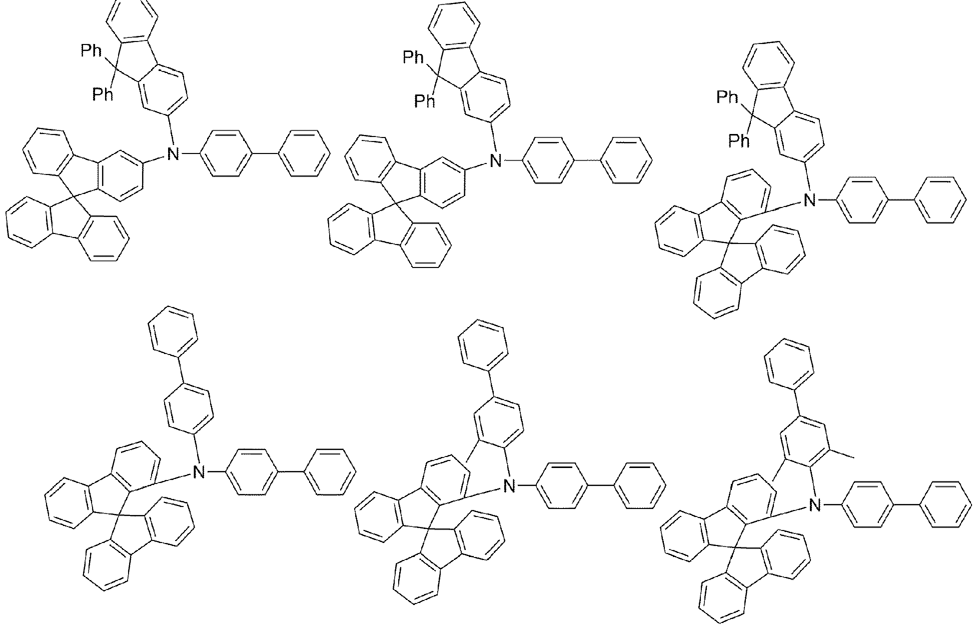

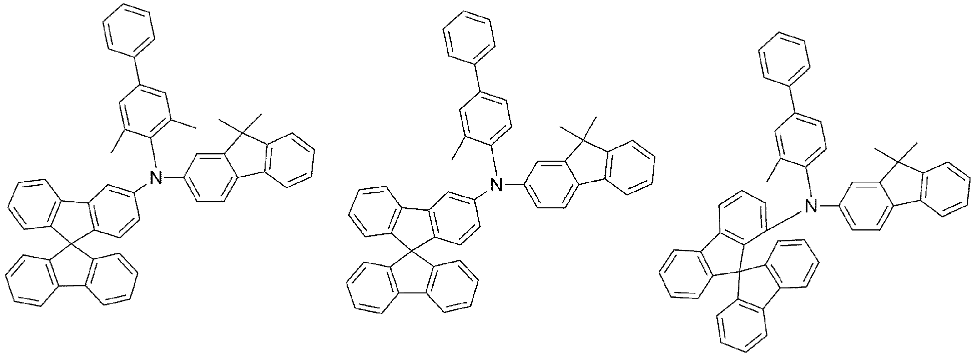

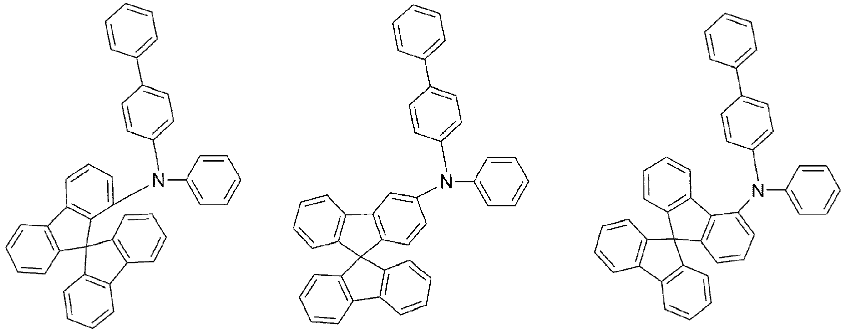

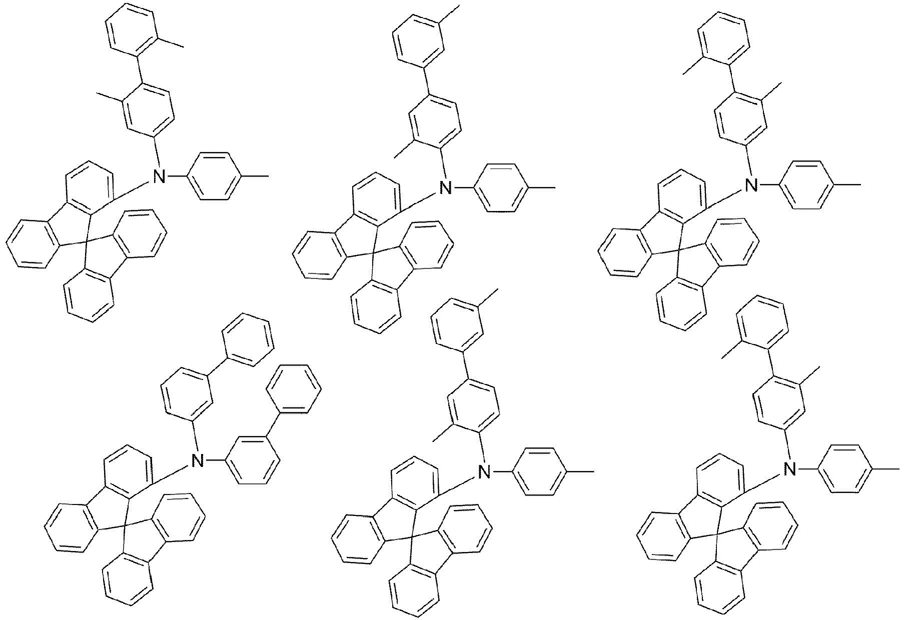

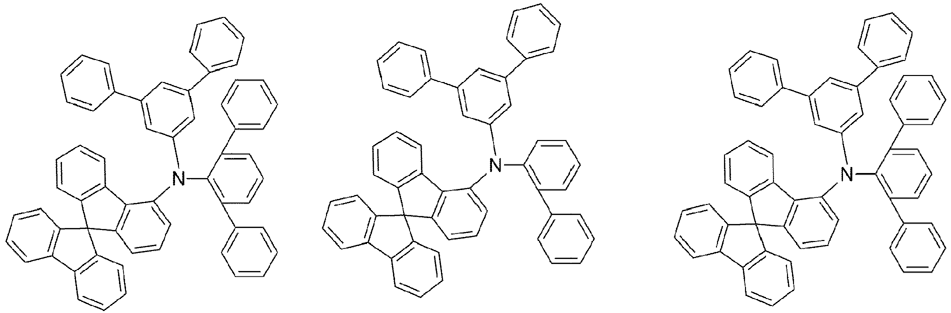

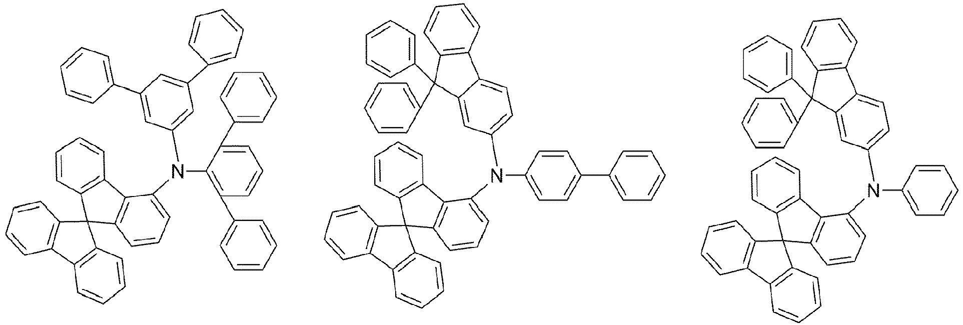

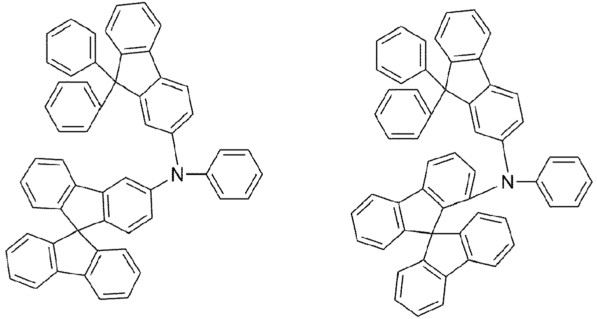

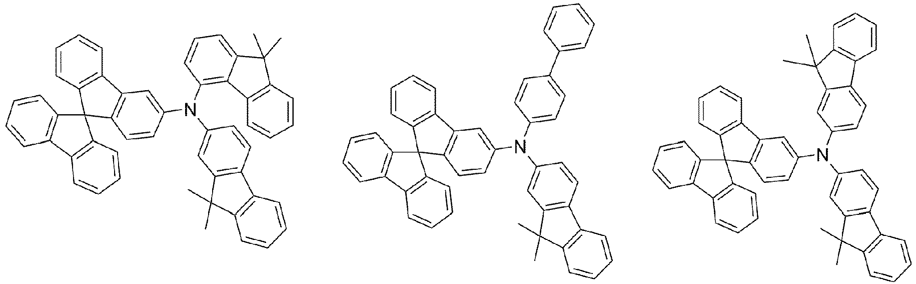

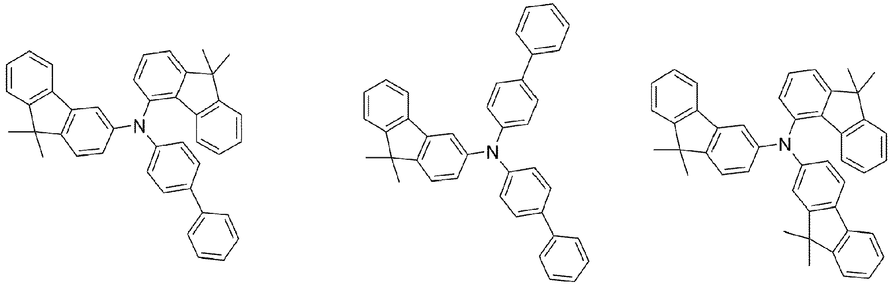

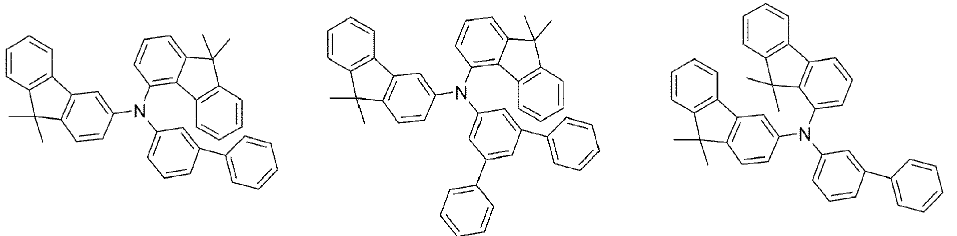

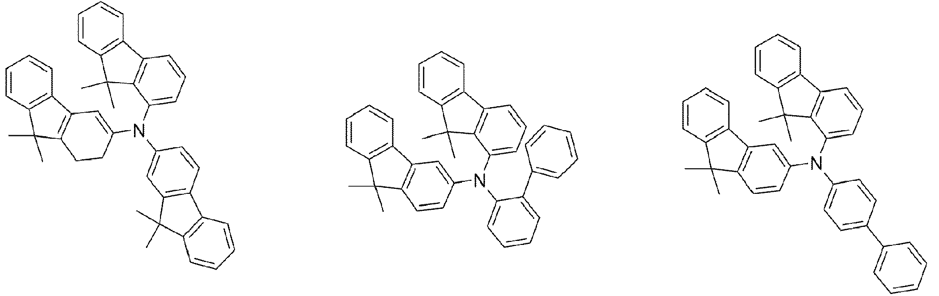

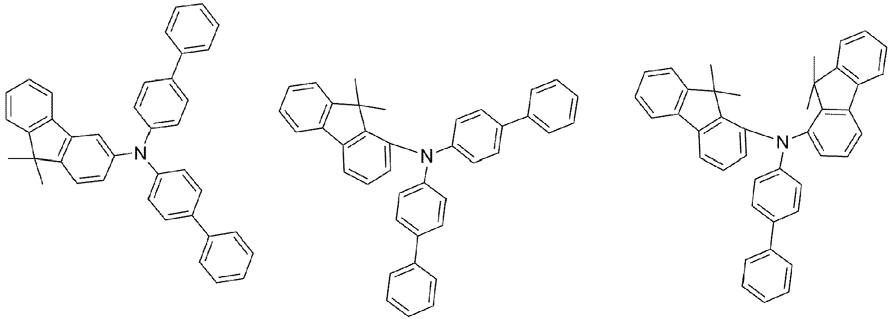

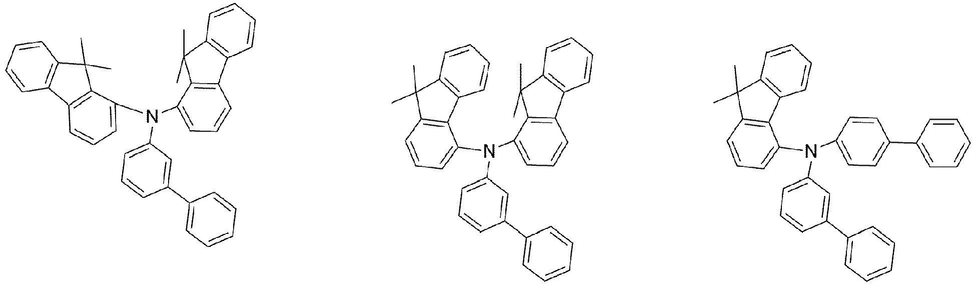

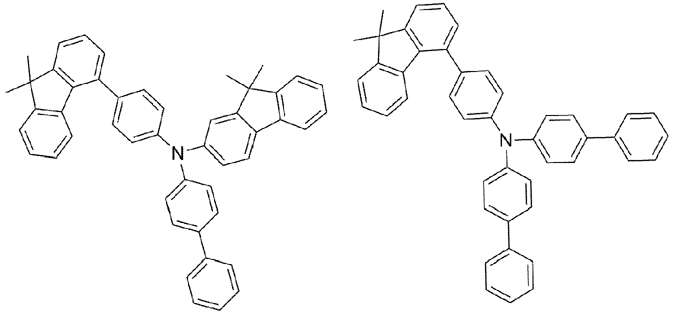

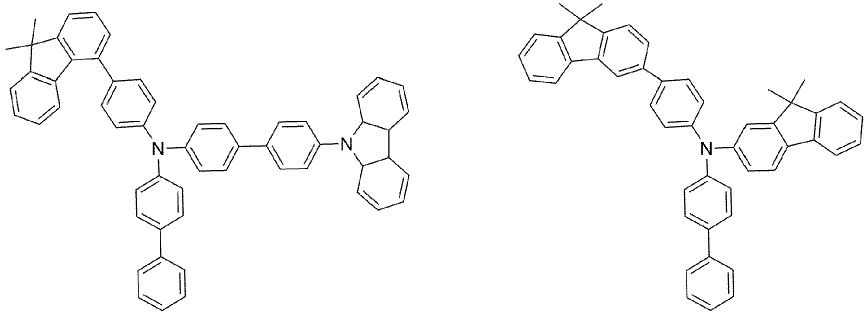

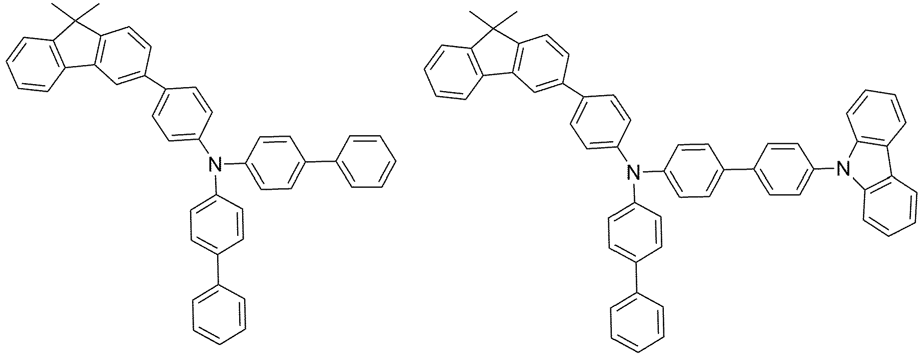

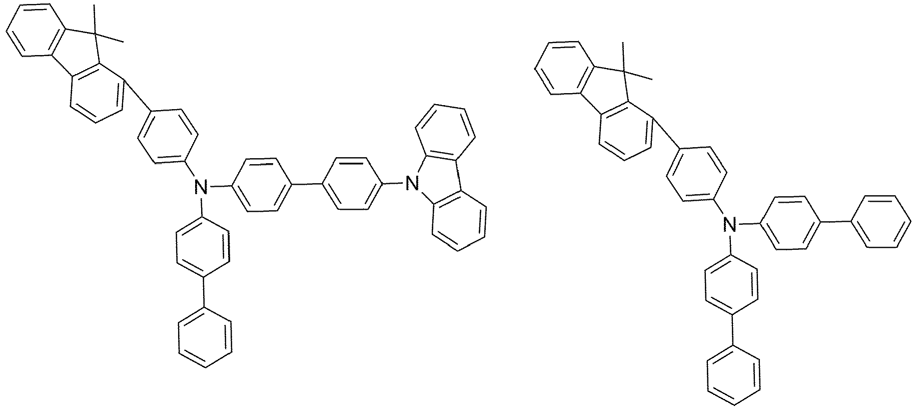

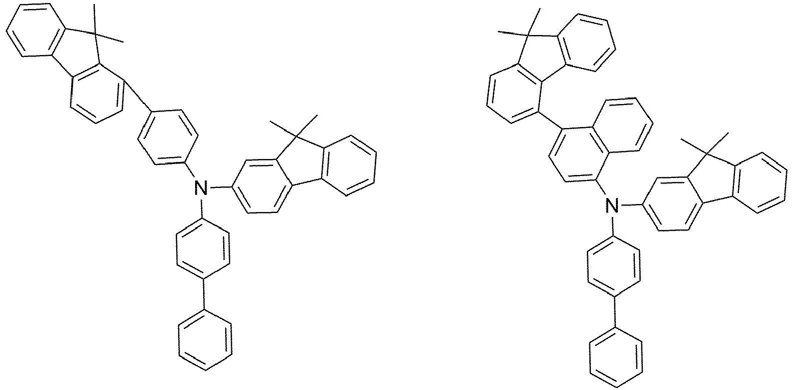

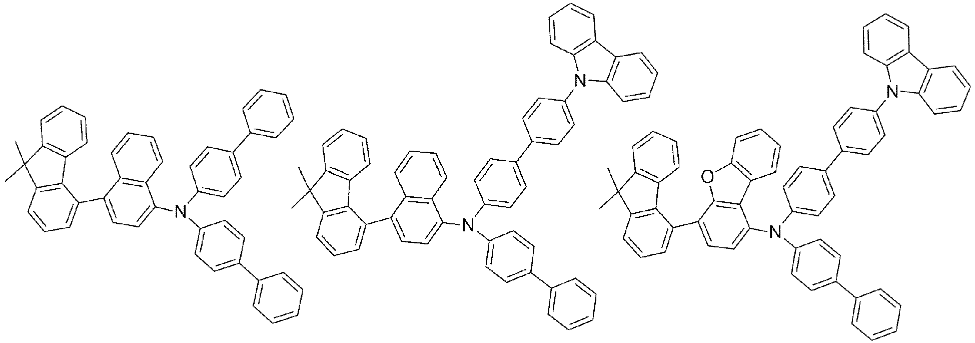

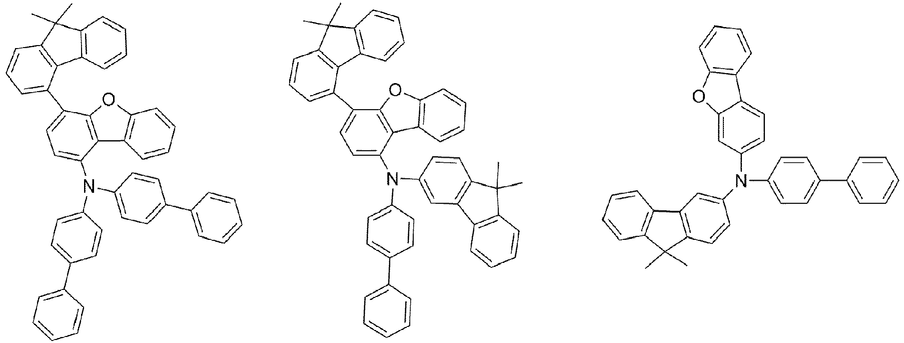

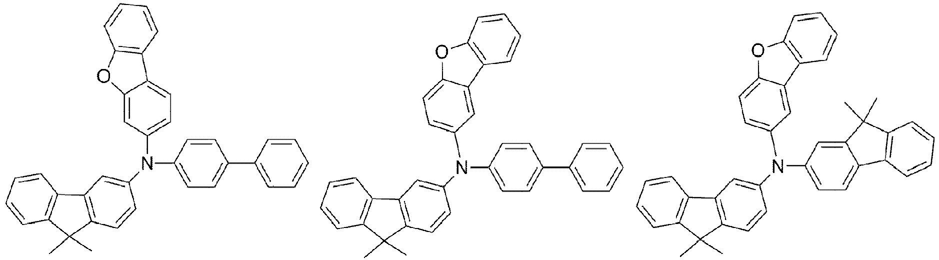

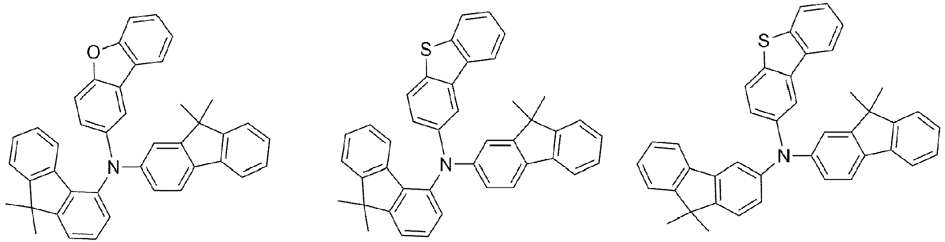

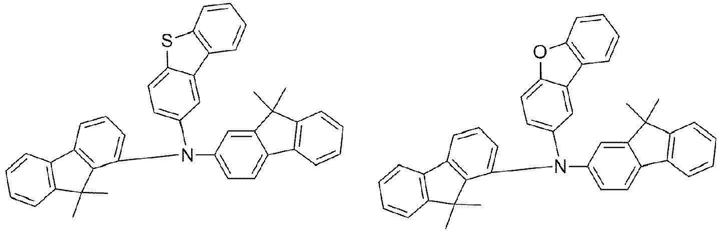

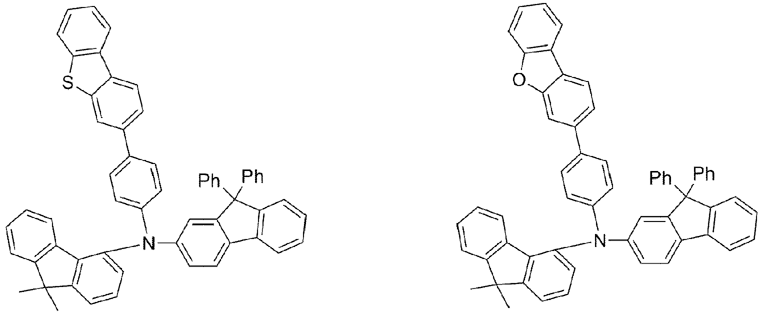

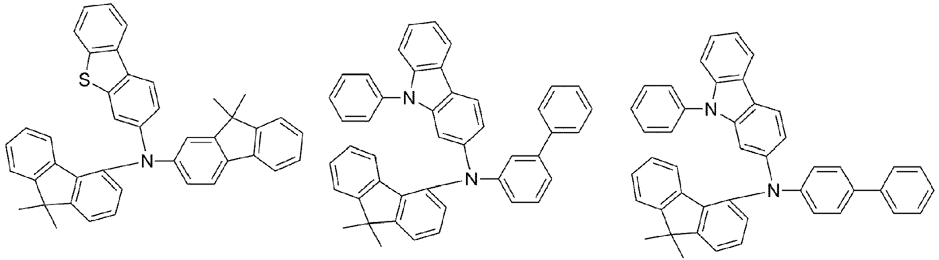

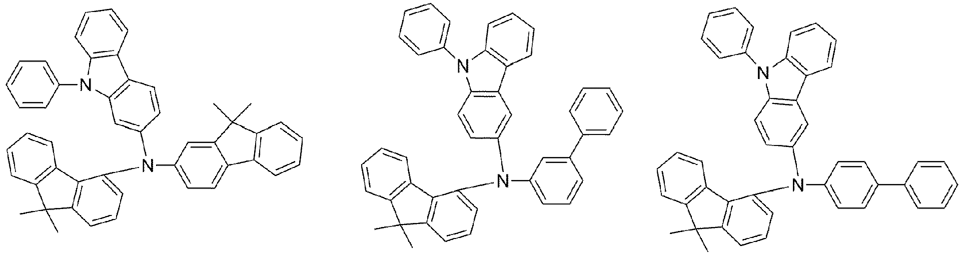

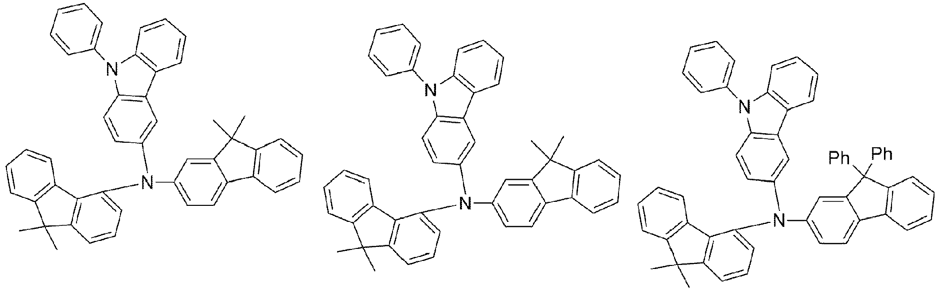

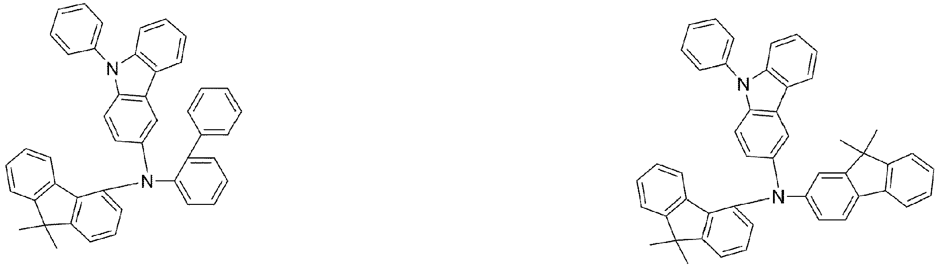

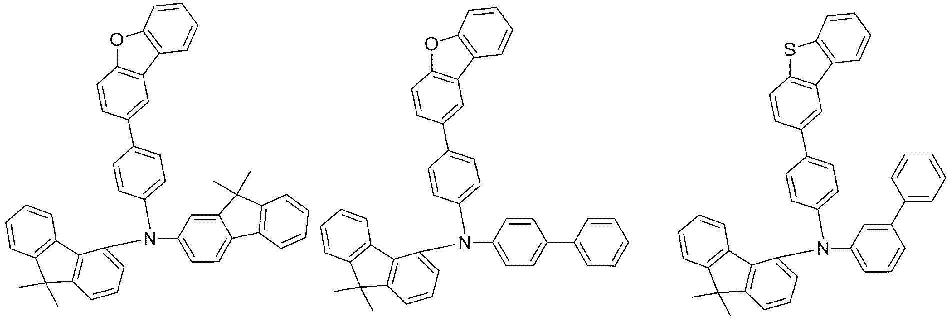

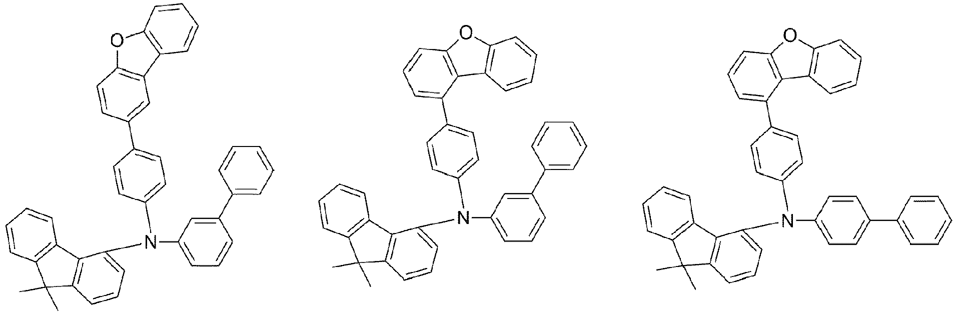

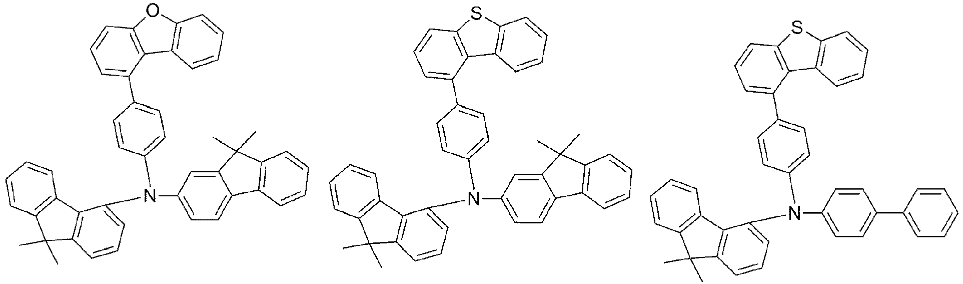

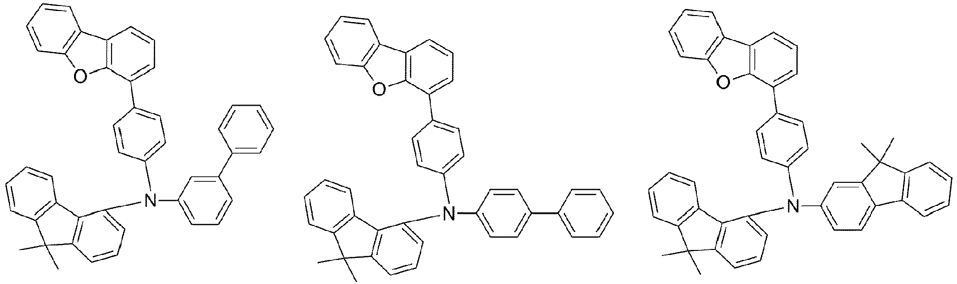

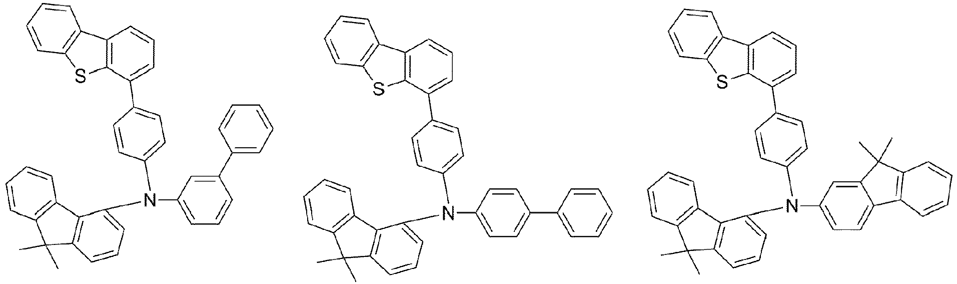

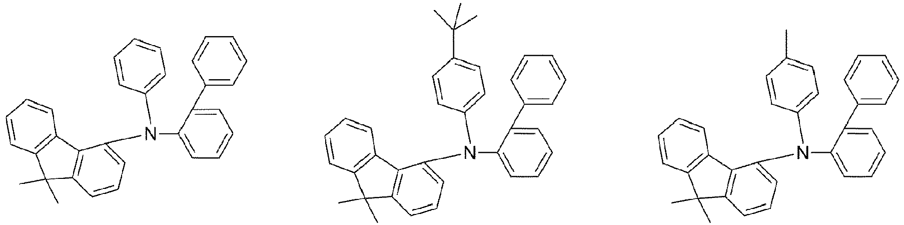

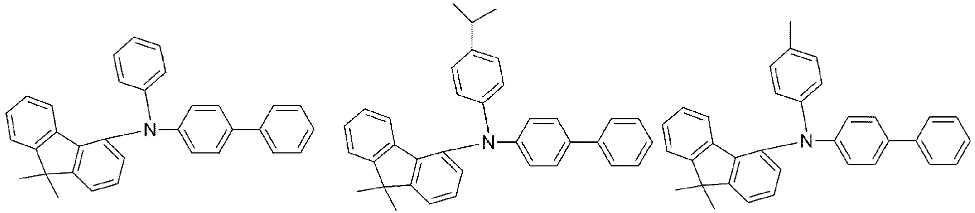

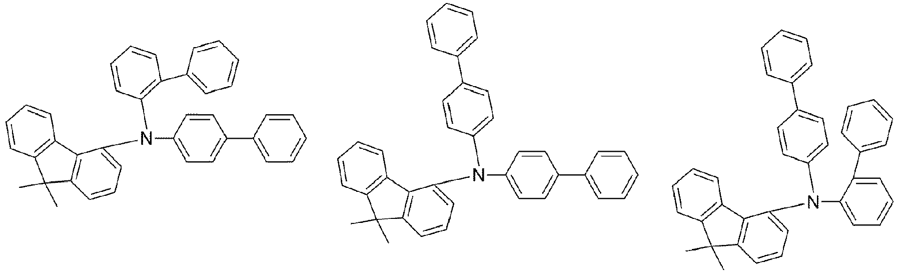

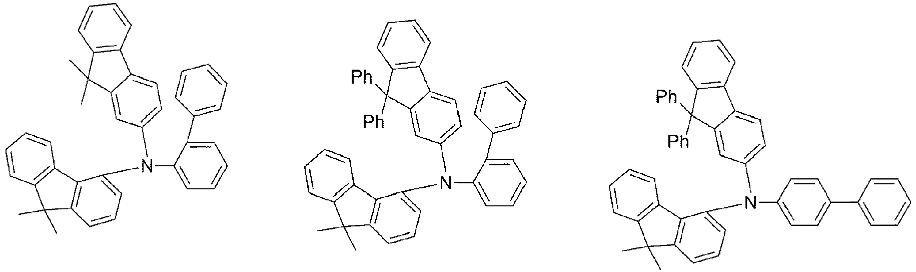

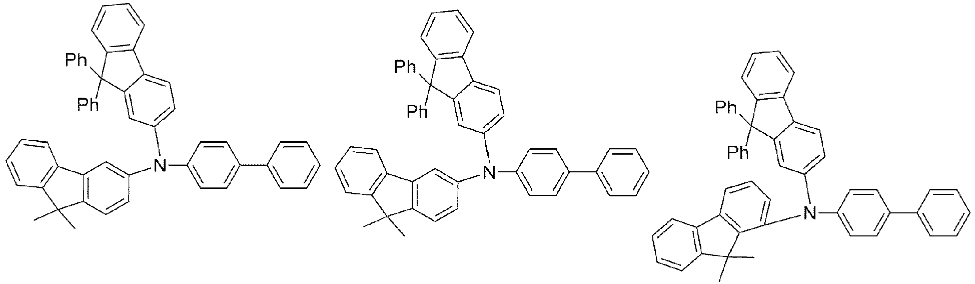

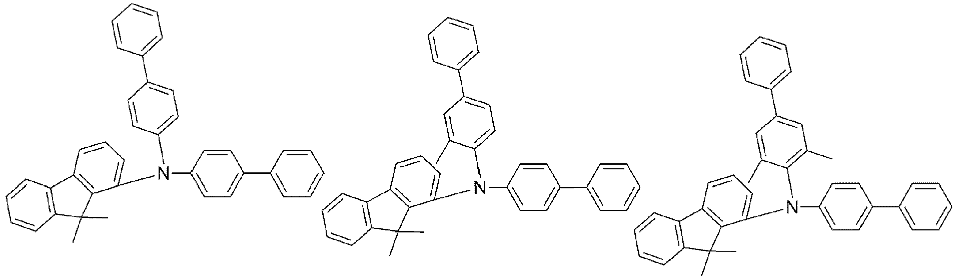

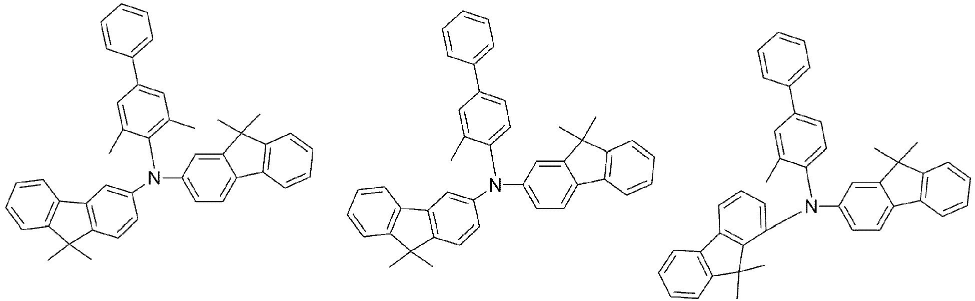

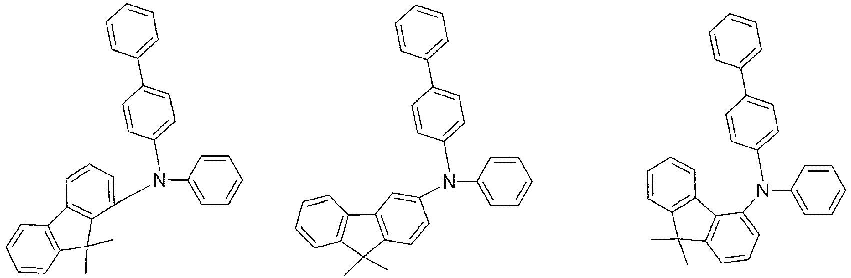

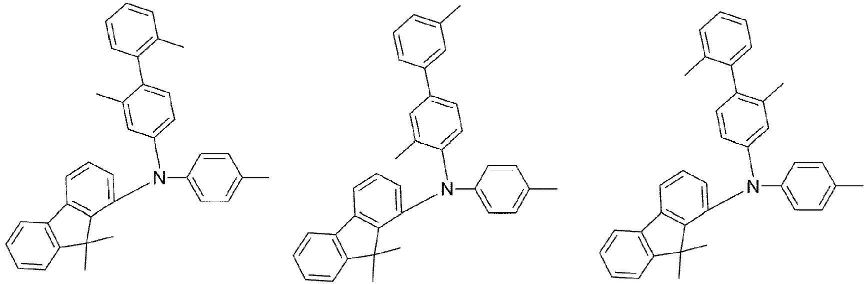

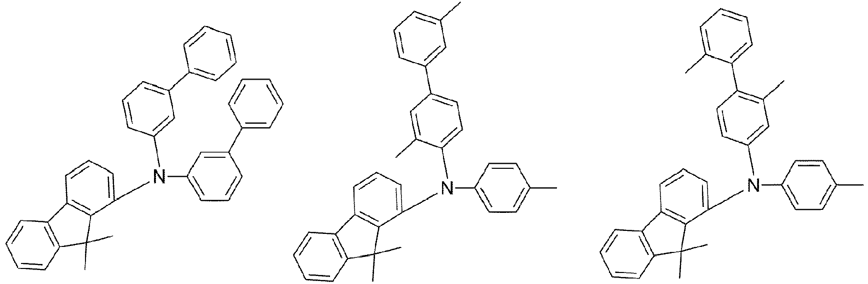

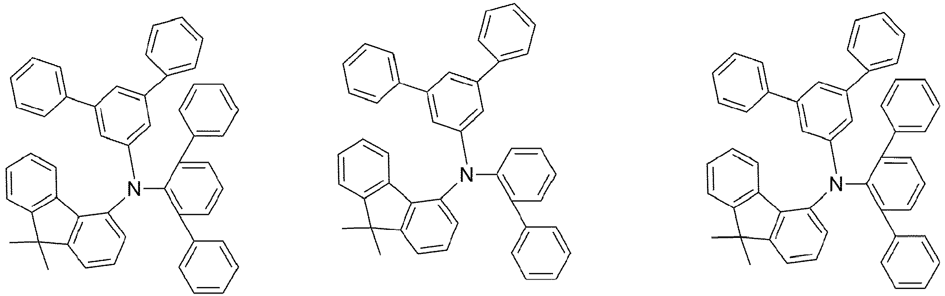

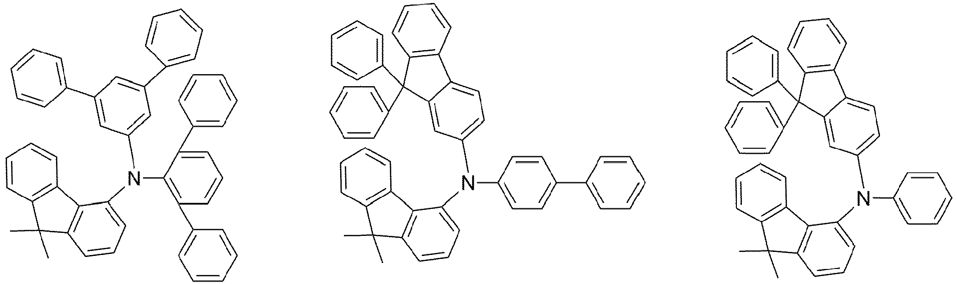

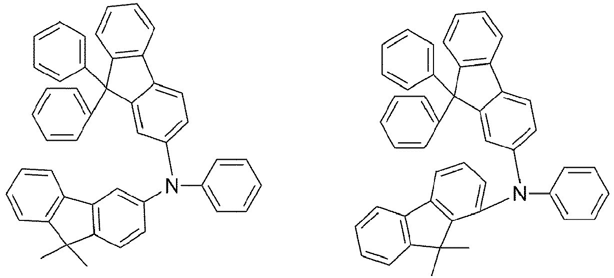

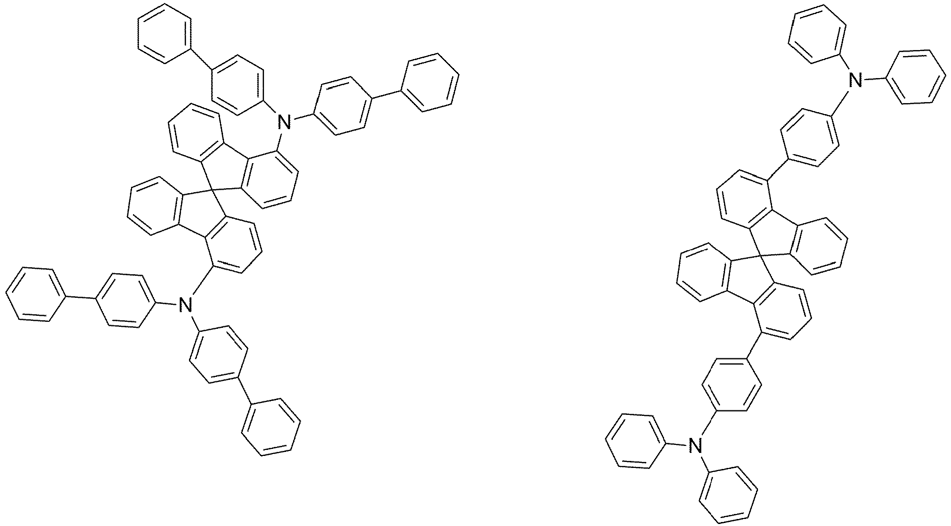

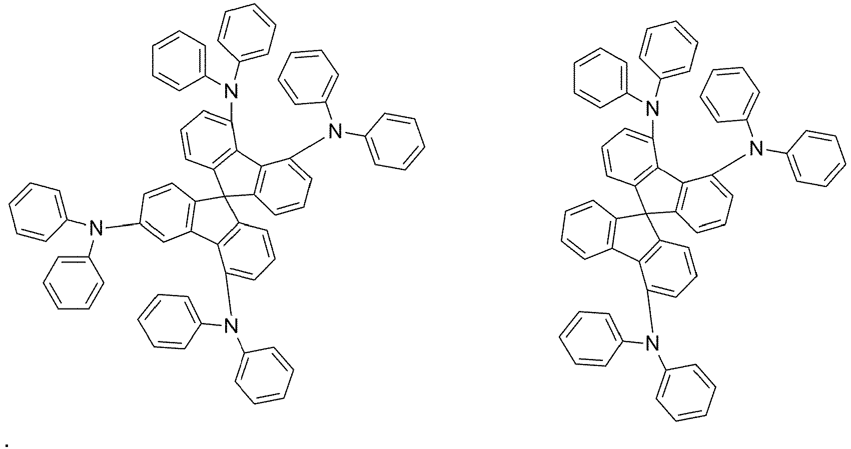

19. The organic light-emitting device of claim 1, wherein
the hole transport region comprises an auxiliary layer that comprises the amine-based compound.

20. The organic light-emitting device of claim 1, wherein
the emission layer is adjacent to the auxiliary layer.

## Patentansprüche

1. Organische lichtemittierende Vorrichtung (10), umfassend: eine erste Elektrode (110); eine zweite Elektrode (190); eine Emissionsschicht zwischen der ersten Elektrode (110) und der zweiten Elektrode (190); und eine Lochtransportregion zwischen der ersten Elektrode (110) und der Emissionsschicht, wobei die Emissionsschicht eine organometallische Verbindung umfasst, die durch Formel 1 dargestellt ist, und die Lochtransportregion eine Verbindung auf Aminbasis umfasst, die durch Formel 2 dargestellt ist:
<Formel 1> M(L₁)ₙ₁(L₂)ₙ₂ 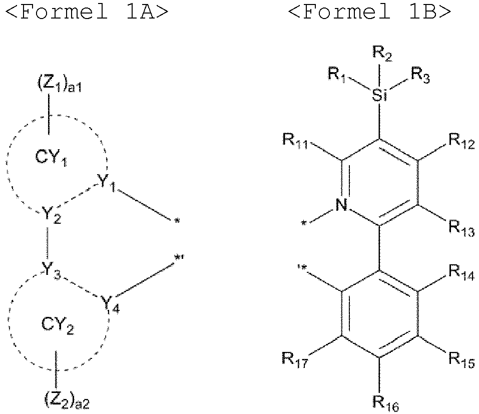 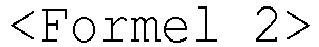 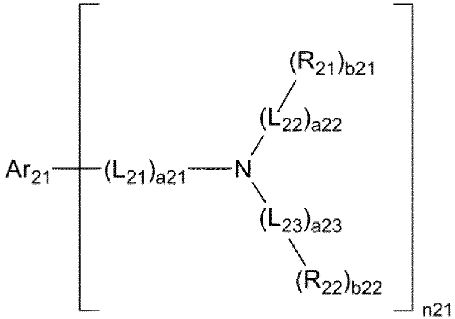 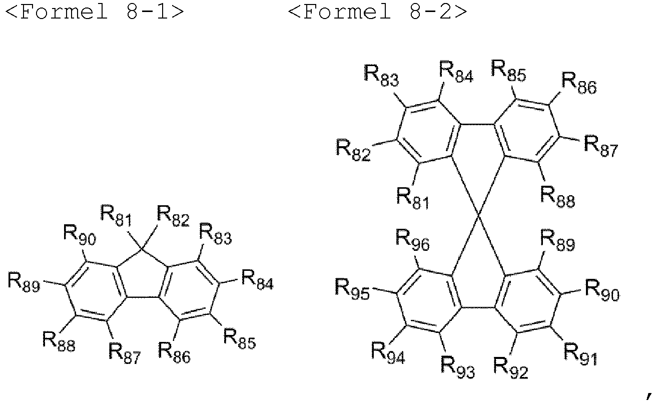
wobei in Formel 1, 1A, 1B, 2, 8-1 und 8-2
M aus Iridium (Ir), Platin (Pt), Osmium (Os), Titan (Ti), Zirkon (Zr), Hafnium (Hf), Europium (Eu), Terbium (Tb), Thulium (Tm) und Rhodium (Rh) ausgewählt ist;
L₁ ein Ligand ist, dargestellt durch Formel 1A;
L₂ ein Ligand ist, dargestellt durch Formel 1B;
L₁ bis L₂ sich voneinander unterscheiden;
n1 und n2 jeweils unabhängig 1 oder 2 sind und die Summe von n1 und n2 2 oder 3 ist und wenn n1 2 ist, zwei von L₁ identisch oder unterschiedlich sind und wenn n2 2 ist, zwei von L₂ identisch oder unterschiedlich sind;
Y₁ bis Y₄ jeweils unabhängig Kohlenstoff (C) oder Stickstoff (N) sind, Y₁ und Y₂ über eine Einzelbindung oder eine Doppelbindung aneinander gebunden sind und Y₃ und Y₄ über eine Einzelbindung oder eine Doppelbindung aneinander gebunden sind,
CY₁ und CY₂ jeweils unabhängig ausgewählt sind aus einer C₅-C₆₀ zyklischen Gruppe und einer C₂-C₆₀ heterozyklischen Gruppe und CY₁ und CY₂ optional über eine Einzelbindung oder eine erste Bindungsgruppe aneinander gebunden sind,
R₁ und R₃ jeweils unabhängig ausgewählt sind aus
einer C₁-C₁₀ Alkylgruppe; und
einer C₁-C₁₀ Alkylgruppe, substituiert mit zumindest einem, ausgewählt aus Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon und einer Phosphorsäure oder einem Salz davon;
Z₁, Z₂ und R₁₁ bis R₁₇ jeweils unabhängig ausgewählt sind aus Wasserstoff, Deuterium, einer Hydroxylgruppe, einer Nitrogruppe, einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer substituierten oder unsubstituierten C₁-C₆₀ Alkylgruppe, einer substituierten oder unsubstituierten C₂-C₆₀ Alkenylgruppe, einer substituierten oder unsubstituierten C₂-C₆₀ Alkinylgruppe, einer substituierten oder unsubstituierten C₁-C₆₀ Alkoxygruppe, einer substituierten oder unsubstituierten C₃-C₁₀ Cykloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₆-C₆₀ Aryloxygruppe, einer substituierten oder unsubstituierten C₆-C₆₀ Arylthiogruppe, einer substituierten oder unsubstituierten C₁-C₆₀ Heteroarylgruppe, einer substituierten oder unsubstituierten, einwertigen, nicht aromatischen, kondensierten, polycyclischen Gruppe, einer substituierten oder unsubstituierten, einwertigen, nicht aromatischen, kondensierten, heteropolycyclischen Gruppe, -N(Q1)(Q₂),-Si(Q₃)(Q₄)(Q₅) und -B(Q₆)(Q₇), vorausgesetzt, dass R₁₂ nicht Wasserstoff ist und zwei benachbarte Substituenten, die aus R₁₄ und R₁₇ ausgewählt sind, optional zur Bildung eines kondensierten Rings aneinander gebunden sind:
a1 und a2 jeweils unabhängig eine ganze Zahl sind, ausgewählt aus 1 bis 5, wenn a1 2 oder mehr ist, eine Vielzahl von Z₁ₛ identisch oder unterschiedlich sind, und wenn a2 2 oder mehr ist, eine Vielzahl von Z₂ₛ identisch oder unterschiedlich sind,
jedes von * und *' eine Bindungsstelle an M in Formel 1 angibt;
Ar₂₁ durch eine von Formeln 8-1 und 8-2 dargestellt ist;
L₂₁ bis L₂₃ jeweils unabhängig ausgewählt sind aus einer substituierten oder unsubstituierten C₃-C₁₀ Cycloalkylengruppe, einer substituierten oder unsubstituierten C₁-C₁₀ Heterocycloalkylengruppe, einer substituierten oder unsubstituierten C₃-C₁₀ Cycloalkenylengruppe, einer substituierten oder unsubstituierten C₁-C₁₀ Heterocycloalkenylengruppe, einer substituierten oder unsubstituierten C₆-C₆₀ Arylengruppe, einer substituierten oder unsubstituierten C₁-C₆₀ Heteroarylengruppe, einer substituierten oder unsubstituierten, zweiwertigen, nicht aromatischen, kondensierten, polycyclischen Gruppe und einer substituierten oder unsubstituierten, zweiwertigen, nicht aromatischen, kondensierten, heteropolycyclischen Gruppe;
a21 bis a23 jeweils unabhängig ausgewählt sind aus 0, 1, 2 und 3;
R₂₁ und R₂₂ jeweils unabhängig ausgewählt sind aus einer substituierten oder unsubstituierten C₃-C₁₀ Cycloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₁-C₆₀ Heteroarylgruppe, einer substituierten oder unsubstituierten, einwertigen, nicht aromatischen, kondensierten, polycyclischen Gruppe und einer substituierten oder unsubstituierten, einwertigen, nicht aromatischen, kondensierten, heteropolycyclischen Gruppe;
b21 und b22 jeweils unabhängig ausgewählt sind aus 1, 2 und 3;
R₈₁ bis R₉₆ jeweils unabhängig ausgewählt sind aus 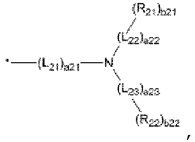 Wasserstoff, Deuterium, -F, -Cl, -Br, - I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer substituierten oder unsubstituierten C₁-C₆₀ Alkylgruppe, einer substituierten oder unsubstituierten C₂-C₆₀ Alkenylgruppe, einer substituierten oder unsubstituierten C₂-C₆₀ Alkinylgruppe, einer substituierten oder unsubstituierten C₁-C₆₀ Alkoxygruppe, einer substituierten oder unsubstituierten C₃-C₁₀ Cykloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₆-C₆₀ Aryloxygruppe, einer substituierten oder unsubstituierten C₆-C₆₀ Arylthiogruppe, einer substituierten oder unsubstituierten C₁-C₆₀ Heteroarylgruppe, einer substituierten oder unsubstituierten, einwertigen, nicht aromatischen, kondensierten, polycyclischen Gruppe und einer substituierten oder unsubstituierten, einwertigen, nicht aromatischen, kondensierten, heteropolycyclischen Gruppe;
n21 ausgewählt ist aus 1, 2, 3 und 4 und, wenn n21 2 oder mehr ist, eine Vielzahl von 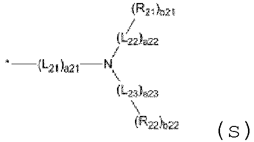 identisch oder unterschiedlich ist; und
zumindest einer von Substituenten der substituierten C₁-C₁₀ Cycloalkenylgruppe, substituierten C₁-C₁₀ Heterocycloalkenylgruppe, substituierten C₃-C₁₀ Cycloalkenylengruppe, substituierten C₁-C₁₀ Heterocycloalkenylengruppe, substituierten C₆-C₆₀ Arylengruppe, substituierten C₁-C₆₀ Heteroarylengruppe, substituierten zweiwertigen, nicht aromatischen, kondensierten, polycyclischen Gruppe, substituierten zweiwertigen, nicht aromatischen, kondensierten, heteropolycyclischen Gruppe, substituierten C₁-C₆₀ Alkylgruppe, substituierten C₂-C₆₀ Alkenylgruppe, substituierten C₂-C₆₀Alkinylgruppe, substituierten C₁-C₆₀ Alkoxygruppe, substituierten C₃-C₁₀ Cycloalkylgruppe, substituierten C₁-C₁₀ Heterocycloalkylgruppe, substituierten C₃-C₁₀ Cycloalkenylgruppe, substituierten C₁-C₁₀ Heterocycloalkenylgruppe, substituierten C₆-C₆₀ Arylgruppe, substituierten C₆-C₆₀ Aryloxygruppe, substituierten C₆-C₆₀ Arylthiogruppe, substituierten C₁-C₆₀ Heteroarylgruppe, substituierten, einwertigen, nicht aromatischen, kondensierten, polycyclischen Gruppe und substituierten, einwertigen, nicht aromatischen, kondensierten, heteropolycyclischen Gruppe ausgewählt ist aus
Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₆₀ Alkylgruppe, einer C₂-C₆₀ Alkenylgruppe, einer C₂-C₆₀ Alkinylgruppe und einer C₁-C₆₀ Alkoxygruppe;
einer C₁-C₆₀ Alkylgruppe, einer C₂-C₆₀ Alkenylgruppe, einer C₂-C₆₀ Alkinylgruppe und einer C₁-C₆₀ Alkoxygruppe, jeweils substituiert mit zumindest einem ausgewählt aus Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer einwertigen, nicht aromatischen, kondensierten, polycyclischen Gruppe, einer einwertigen, nicht aromatischen, kondensierten, heteropolycyclischen Gruppe, -N(Q₁₁)(Q₁₂), - Si(Q₁₃)(Q₁₄)(Q₁₅) und -B(Q₁₆)(Q₁₇);
einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer einwertigen, nicht aromatischen, kondensierten, polycyclischen Gruppe und einer einwertigen, nicht aromatischen, kondensierten, heteropolycyclischen Gruppe; einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer einwertigen, nicht aromatischen, kondensierten, polycyclischen Gruppe und einer einwertigen, nicht aromatischen, kondensierten, heteropolycyclischen Gruppe, jeweils substituiert mit zumindest einem ausgewählt aus Deuterium, -F, -Cl,-Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₆₀ Alkylgruppe, einer C₂-C₆₀ Alkenylgruppe, einer C₂-C₆₀ Alkinylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer einwertigen, nicht aromatischen, kondensierten, polycyclischen Gruppe, einer einwertigen, nicht aromatischen, kondensierten, heteropolycyclischen Gruppe, -N(Q₂₁)(Q₂₂),-Si(Q₂₃)(Q₂₄)(Q₂₅) und -B(Q₂₆)(Q₂₇); und
-N(Q₃₁)(Q₃₂), -Si(Q₃₃)(Q₃₄)(Q₃₅) und -B(Q₃₆)(Q₃₇);
wobei Q₁ bis Q₇, Q₁₁ bis Q₁₇, Q₂₁ bis Q₂₇ und Q₃₁ bis Q₃₇ jeweils unabhängig ausgewählt sind aus Wasserstoff, Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₆₀ Alkylgruppe, einer C₂-C₆₀ Alkenylgruppe, einer C₂-C₆₀ Alkinylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer einwertigen, nicht aromatischen, kondensierten, polycyclischen Gruppe und einer einwertigen, nicht aromatischen, kondensierten, heteropolycyclischen Gruppe.

2. Organische lichtemittierende Vorrichtung nach Anspruch 1, wobei M IR ist.

3. Organische lichtemittierende Vorrichtung nach Anspruch 1, wobei Y₁ N ist und jedes von Y₂ bis Y₄ C ist.

4. Organische lichtemittierende Vorrichtung nach Anspruch 1, wobei
CY₁ ausgewählt ist aus einem Imidazol, einem Pyrzol, eine Triazol, einem Pyridin, einem Pyrimidin, einem Pyrazin, einem Triazin, einem Chinolin, einem Isochinolin und einem Oxadiazol; und
CY₂ ausgewählt ist aus einem Benzol, einem Naphthalin, einem Fluoren, einem Carbazol, einem Furan, einem Thiophen, einem Bezofuran, einem Bezothipphen, einem Dibezofuran, einem Dibenzothiophen, einem Indol, einem Pyridin, einem Pyrimidin, einem Pyrazin, einem Oxadiazol und einem Triazin.

5. Organische lichtemittierende Vorrichtung nach Anspruch 1, wobei
R₁ bis R₃ jeweils unabhängig ausgewählt sind aus
einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decylgruppe, einer iso-Decylgruppe, einer sec-Decylgruppe und einer tert-Decylgruppe; und
einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decylgruppe, einer iso-Decylgruppe, einer sec-Decylgruppe und einer tert-Decylgruppe, jeweils substituiert mit zumindest einem, ausgewählt aus Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon und einer Phosphorsäure oder einem Salz davon.

6. Organische lichtemittierende Vorrichtung nach Anspruch 1, wobei
R₁ bis R₃ jeweils unabhängig ausgewählt sind aus
einer Methylgruppe, einer Ethylgruppe, einer n-Propylgruppe, einer iso-Propylgruppe, einer n-Butylgruppe, einer iso-Butylgruppe, einer sec-Butylgruppe und einer tert-Butylgruppe.

7. Organische lichtemittierende Vorrichtung nach Anspruch 1, wobei
R₁ bis R₃ identisch sind.

8. Organische lichtemittierende Vorrichtung nach Anspruch 1, wobei
Z₁, Z₂ und R₁₁ bis R₁₇ jeweils unabhängig ausgewählt sind aus Wasserstoff, Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, -SF₅, einer C₁-C₂₀ Alkylgruppe und einer C₁-C₂₀ Alkoxygruppe;
einer C₁-C₂₀ Alkylgruppe und einer C₁-C₂₀ Alkoxygruppe, jeweils substituiert mit zumindest einem, ausgewählt aus Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer Phenylgruppe, einer Naphthylgruppe, einer Pyridinylgruppe und einer Pyrimidinylgruppe;
einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiozolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; und
einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiozolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit zumindest einem, ausgewählt aus Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₂₀ Alkylgruppe, einer C₁-C₂₀ Alkoxygruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiozolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, vorausgesetzt, dass R₁₂ nicht Wasserstoff ist.

9. Organische lichtemittierende Vorrichtung nach Anspruch 1, wobei
Z₁, Z₂ und R₁₁ bis R₁₇ jeweils unabhängig ausgewählt sind aus
Wasserstoff, -F, einer Cyanogruppe, einer Nitrogruppe, -SF₅, einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decylgruppe, einer iso-Decylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Phenylgruppe, einer Naphthylgruppe, einer Pyridinylgruppe und einer Pyrimidinylgruppe; und
einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decylgruppe, einer iso-Decylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Phenylgruppe, einer Naphthylgruppe, einer Pyridinylgruppe und einer Pyrimidinylgruppe, jeweils substituiert mit zumindest einem, ausgewählt aus -F, einer Cyanogruppe und einer Nitrogruppe, vorausgesetzt, dass
R₁₂ nicht Wasserstoff ist.

10. Organische lichtemittierende Vorrichtung nach Anspruch 1, wobei
die organometallische Verbindung ausgewählt ist aus Verbindungen PD-1 bis PD-79 und PD-81 bis PD-192:

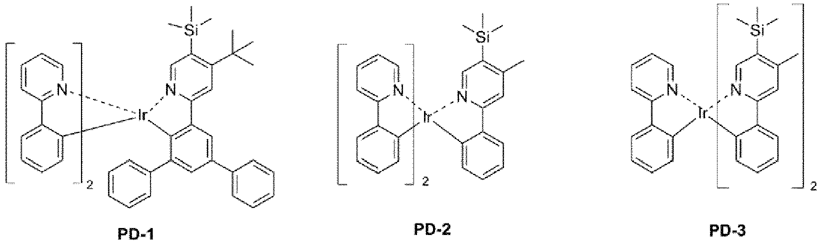

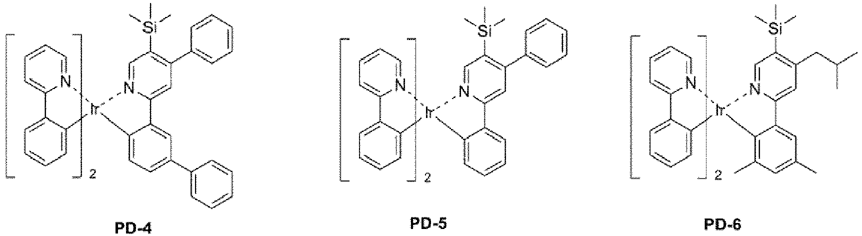

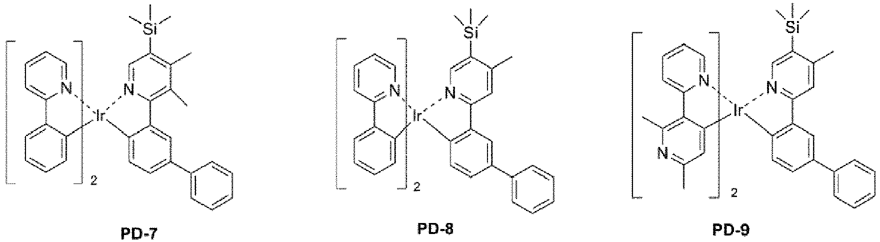

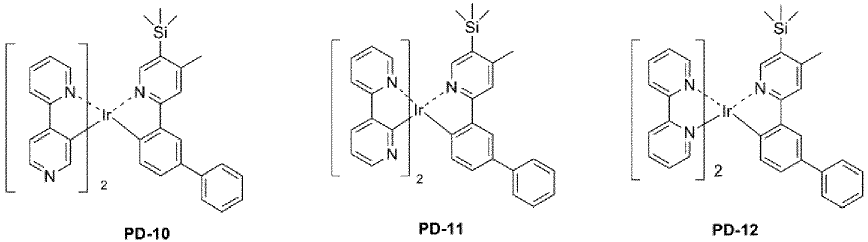

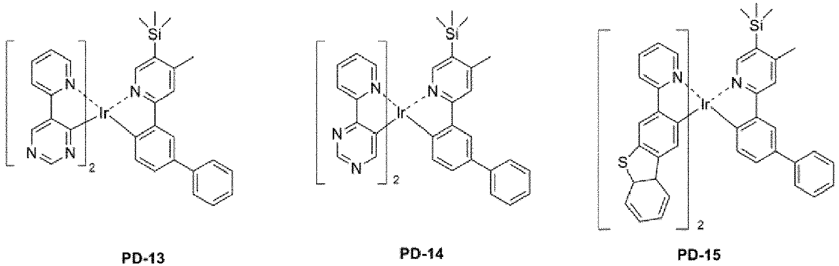

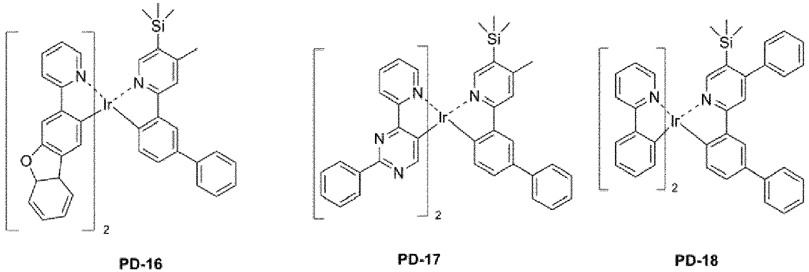

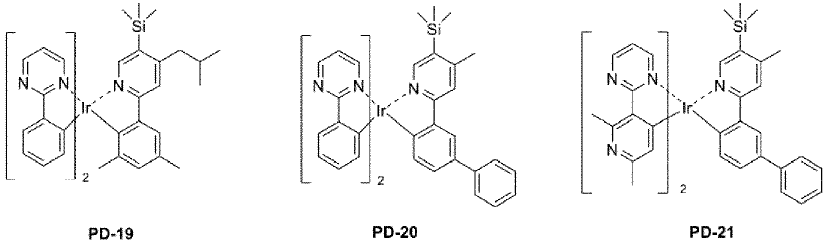

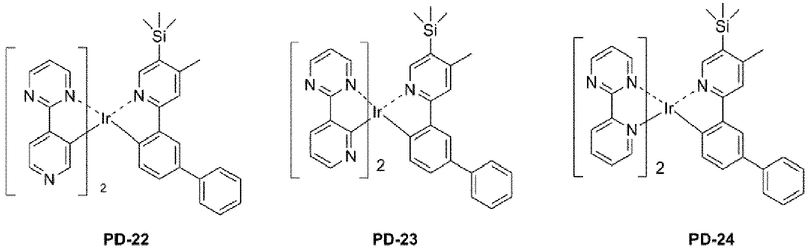

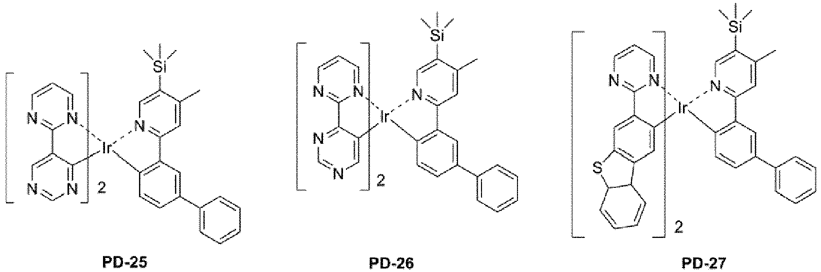

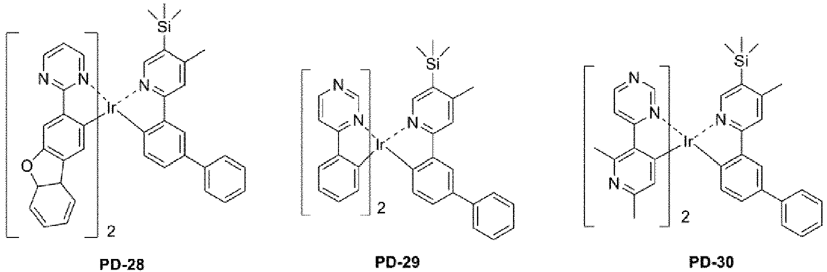

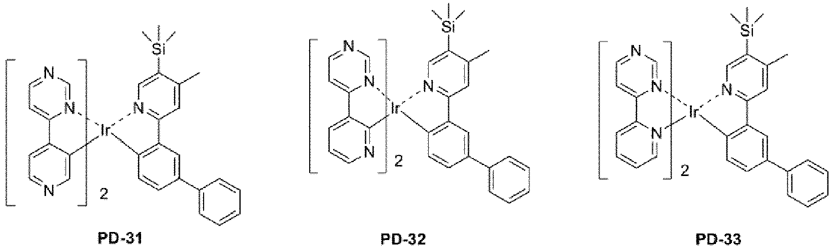

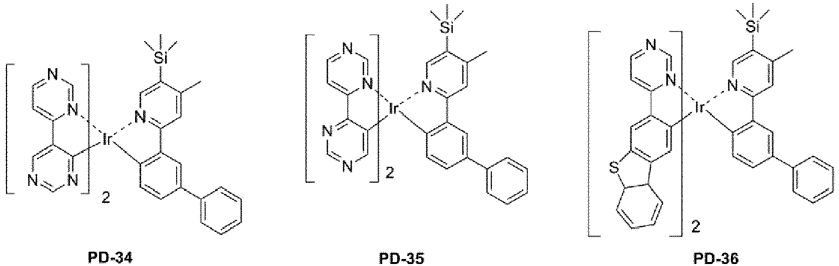

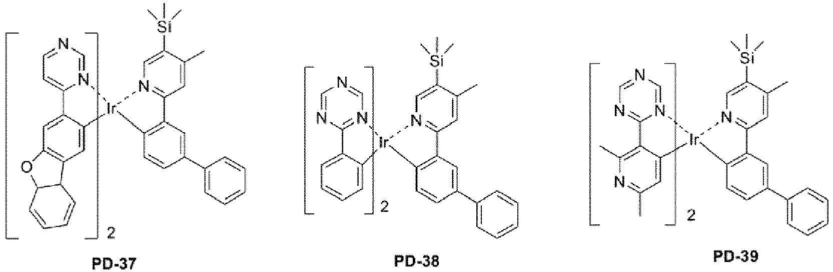

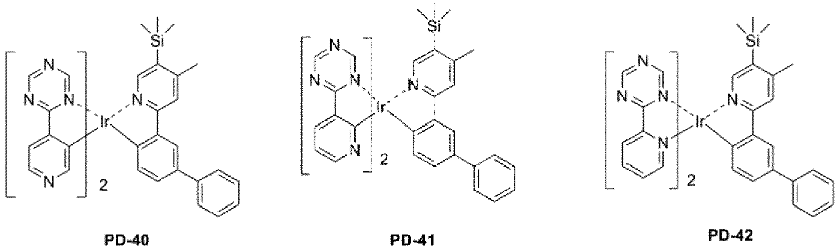

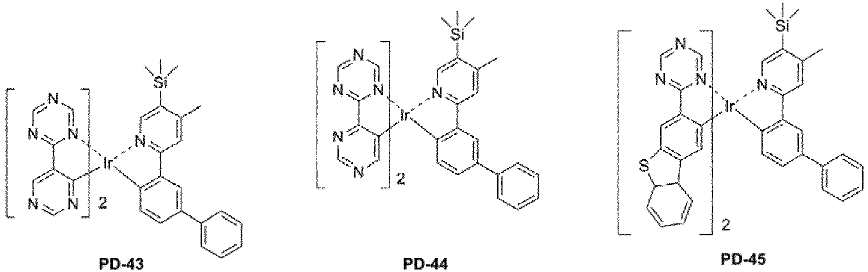

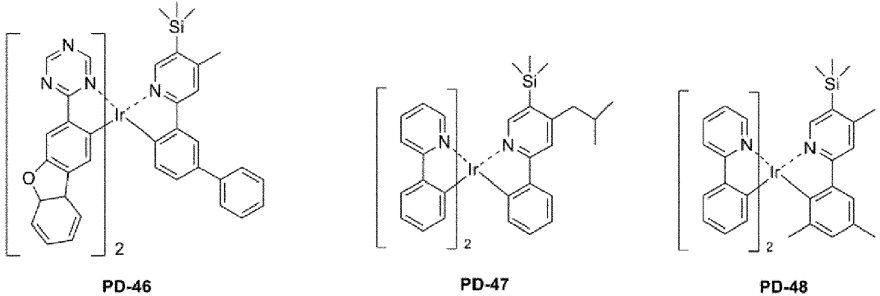

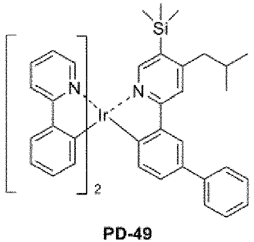

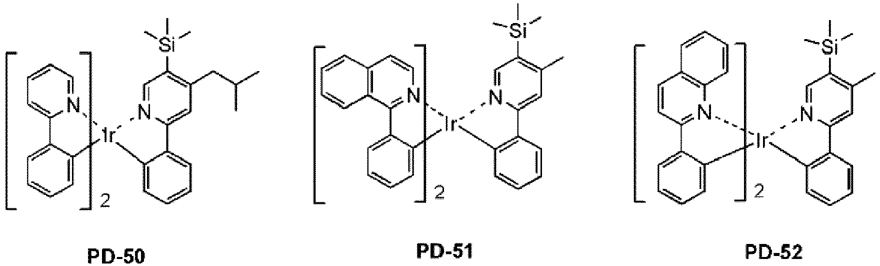

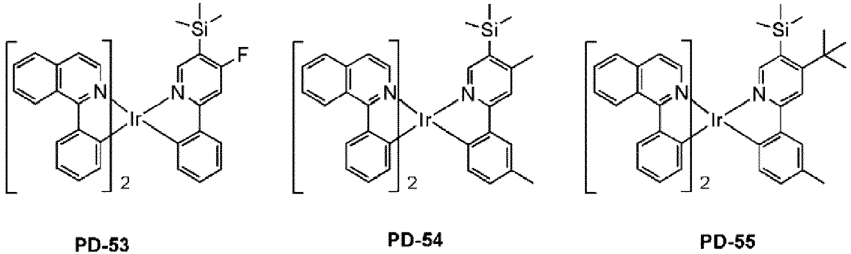

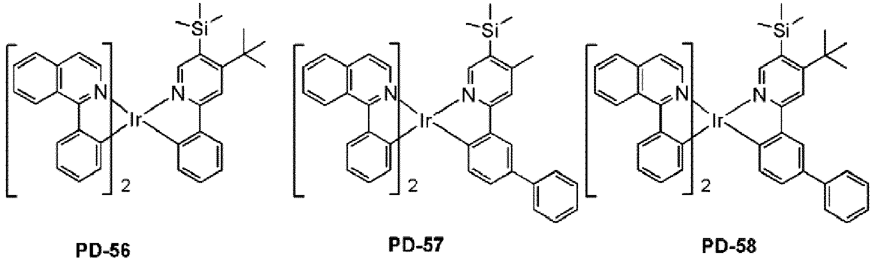

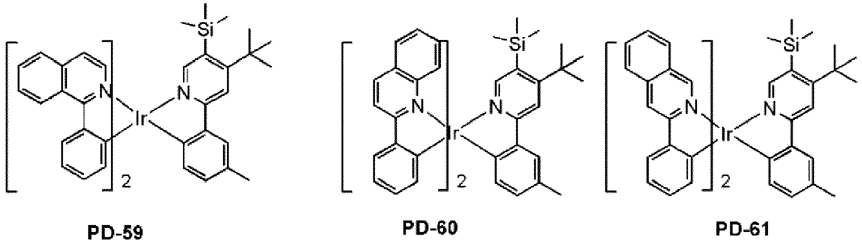

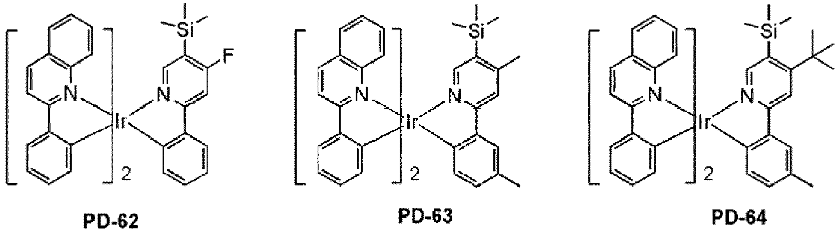

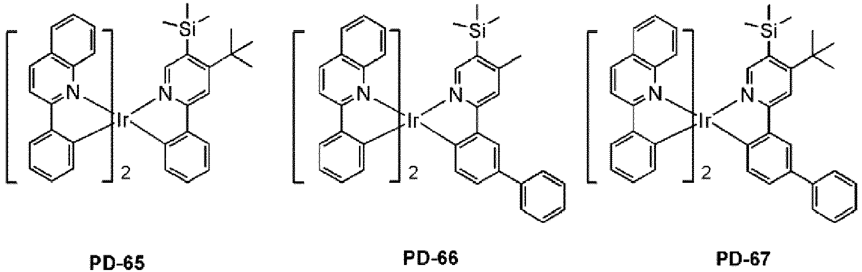

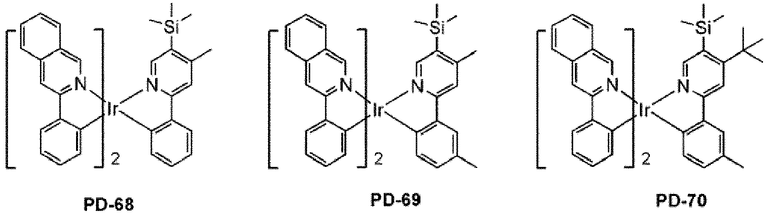

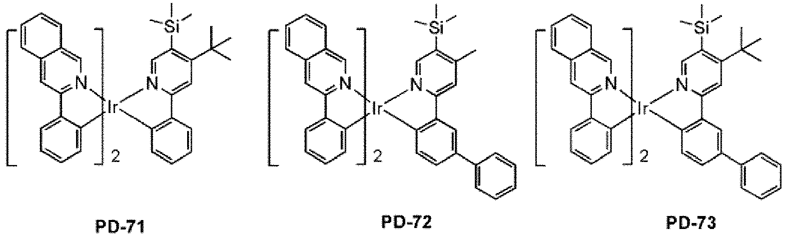

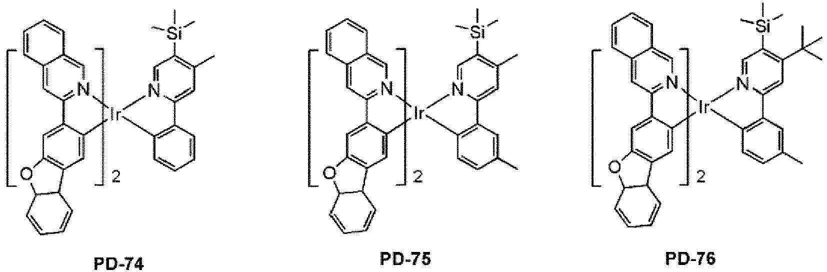

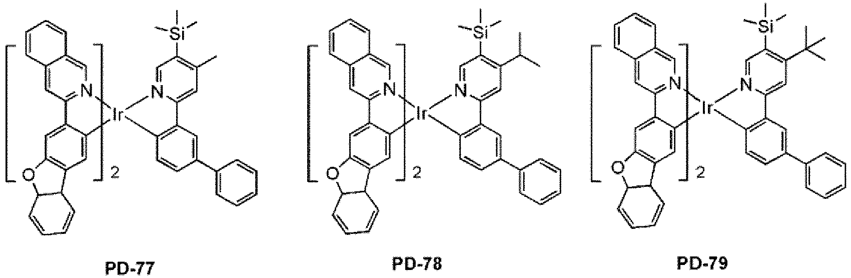

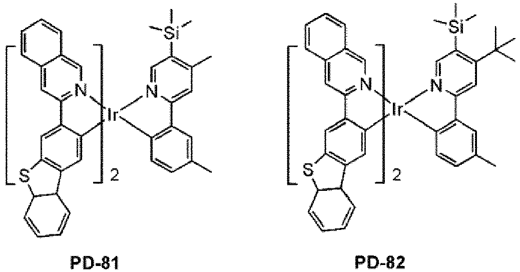

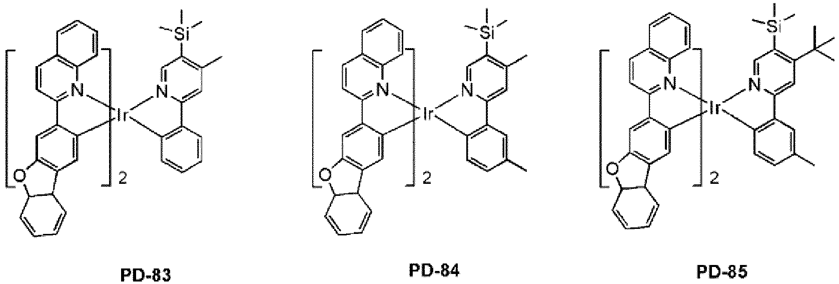

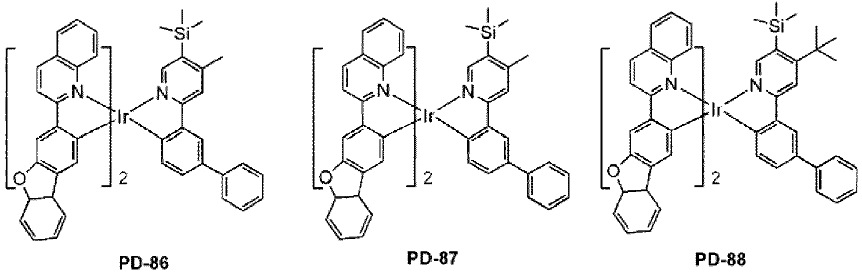

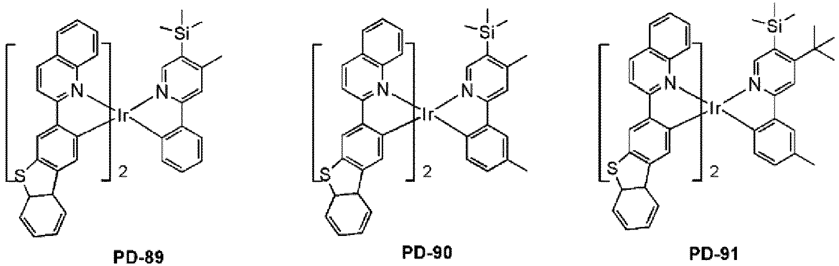

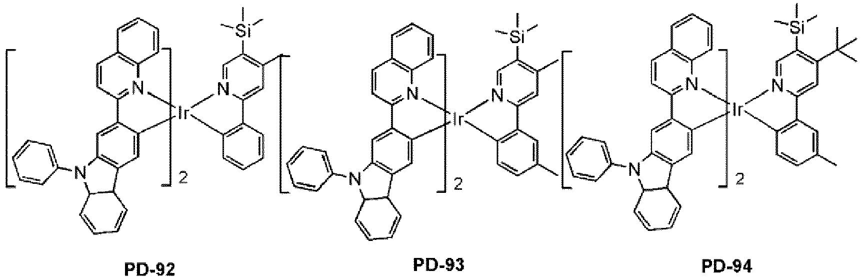

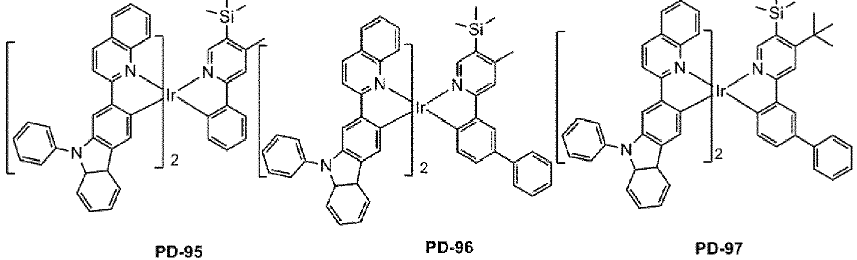

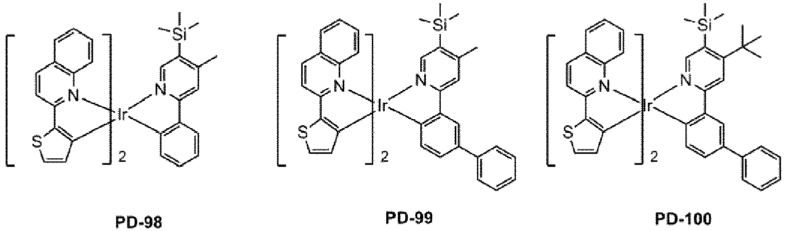

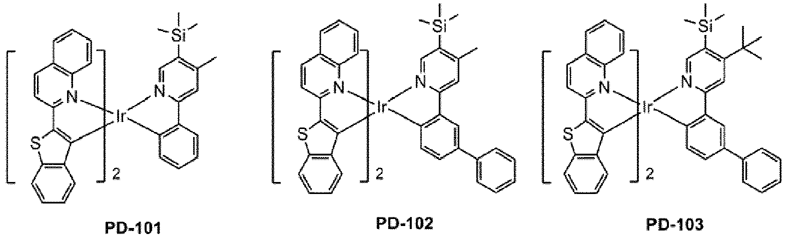

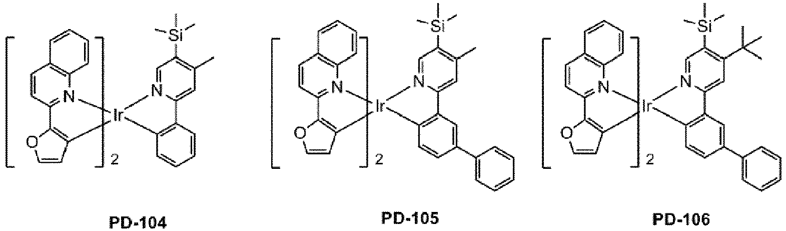

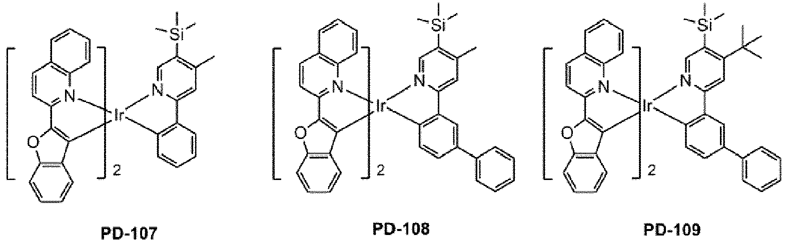

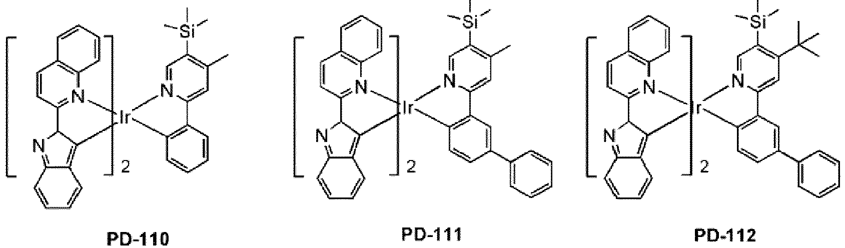

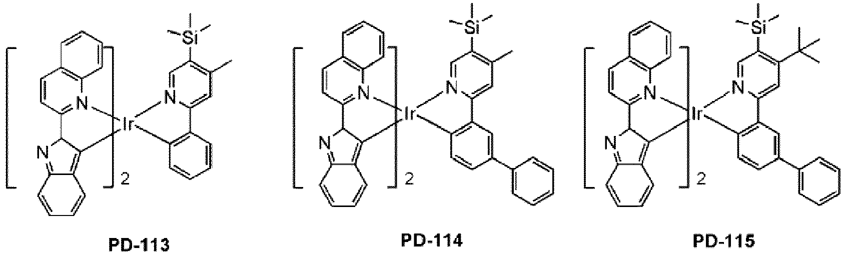

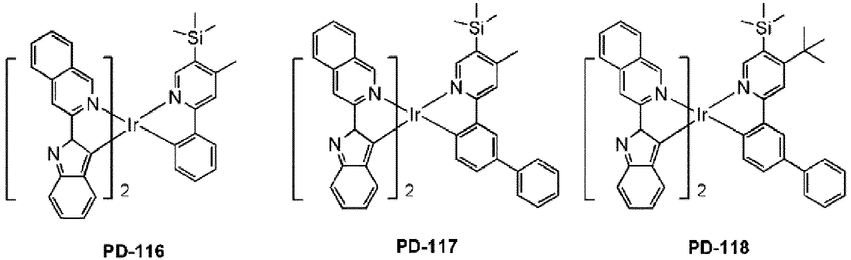

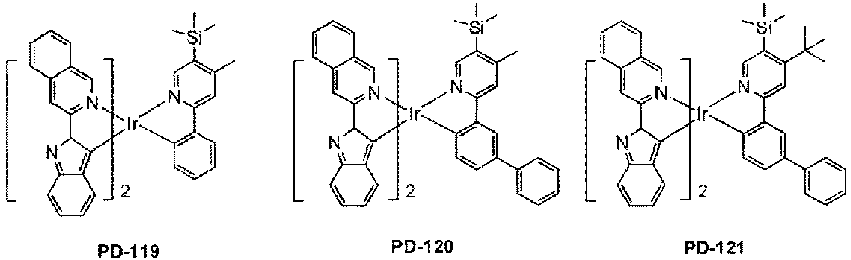

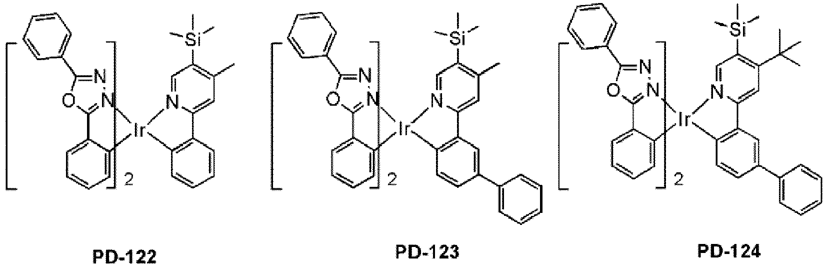

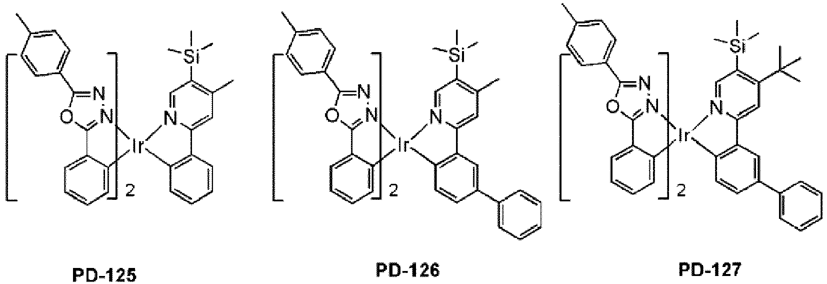

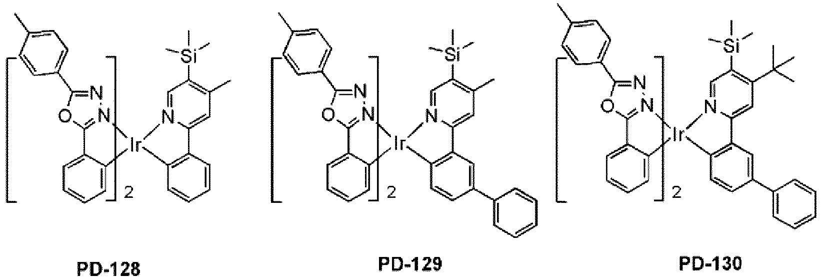

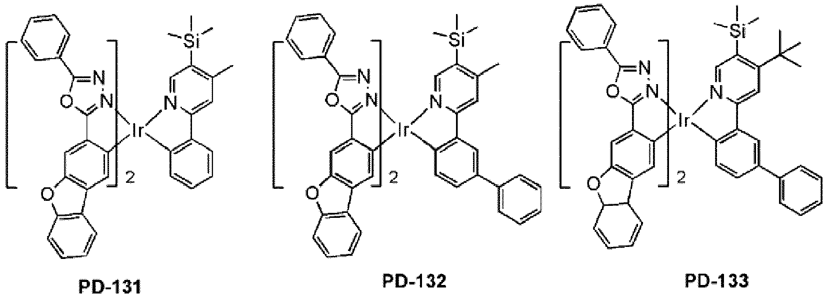

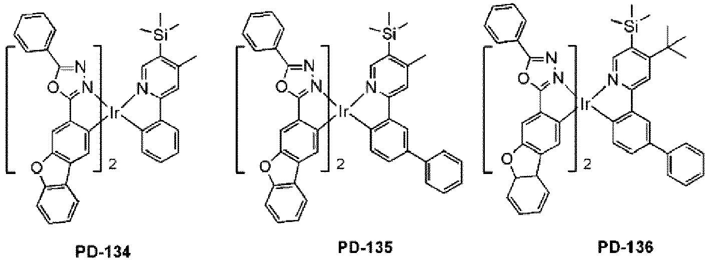

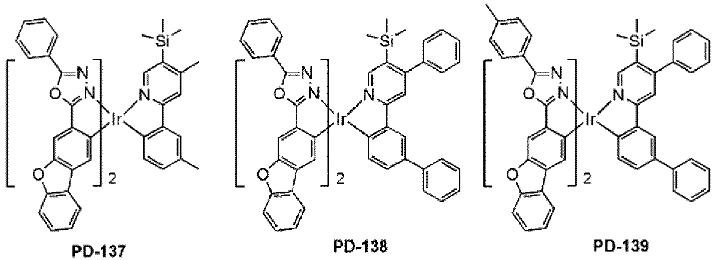

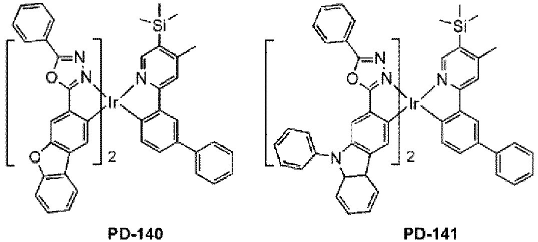

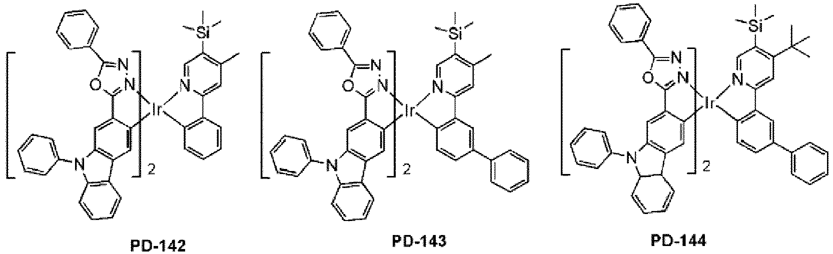

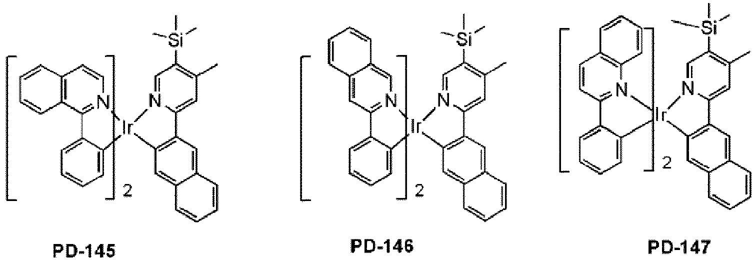

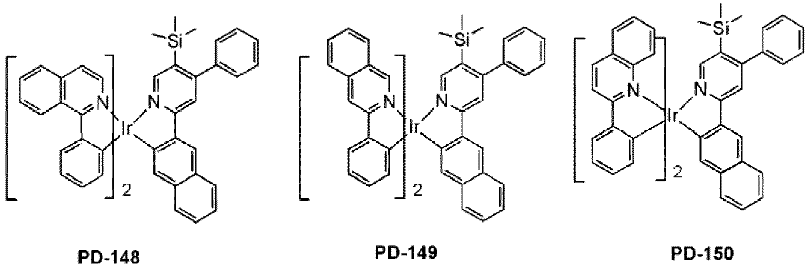

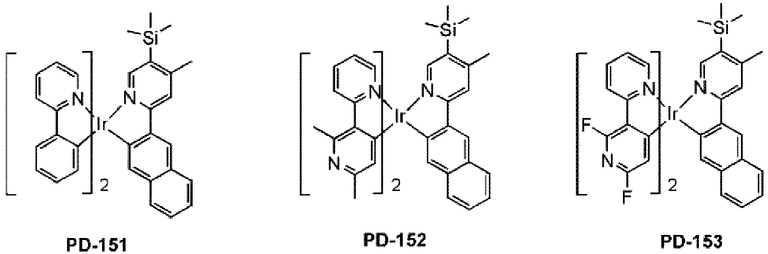

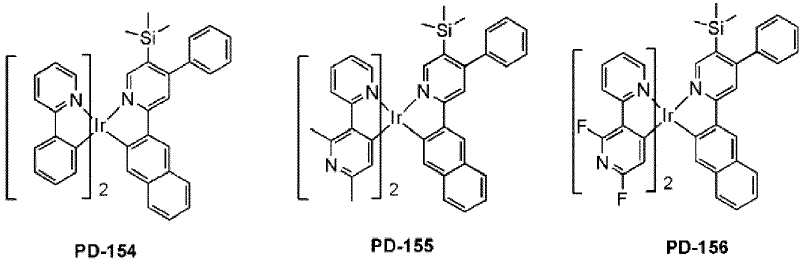

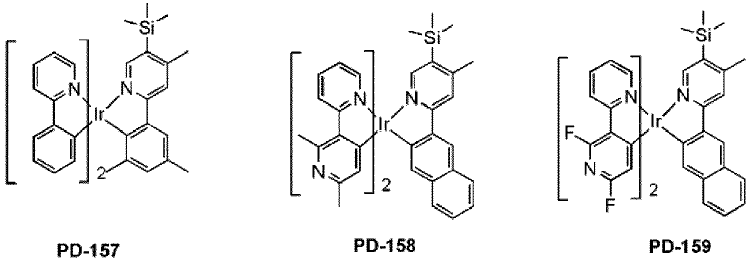

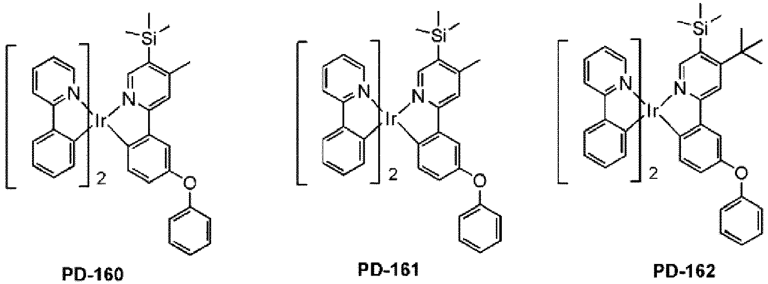

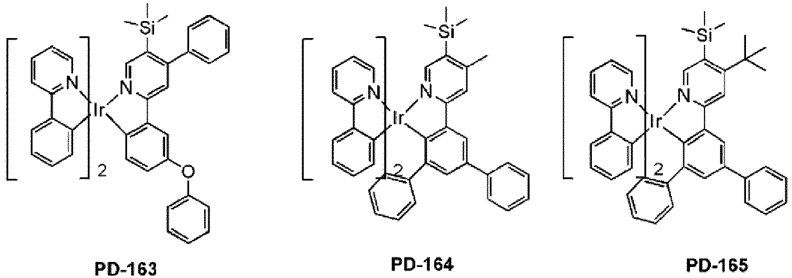

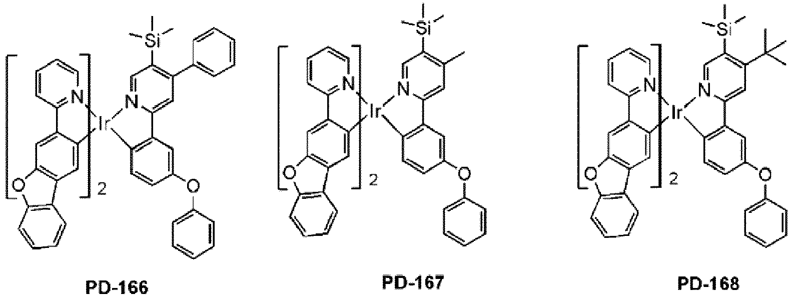

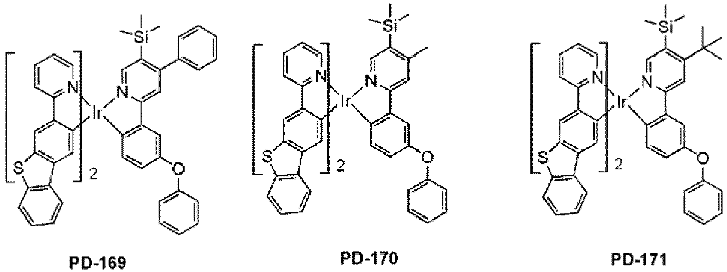

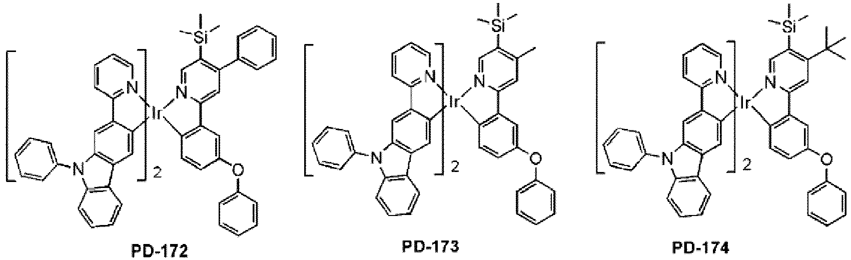

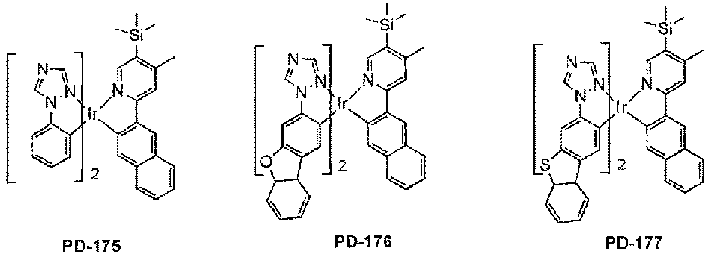

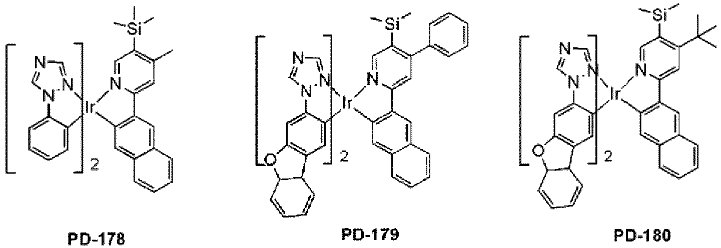

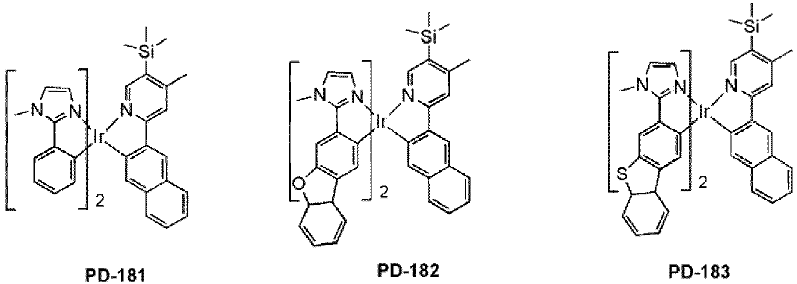

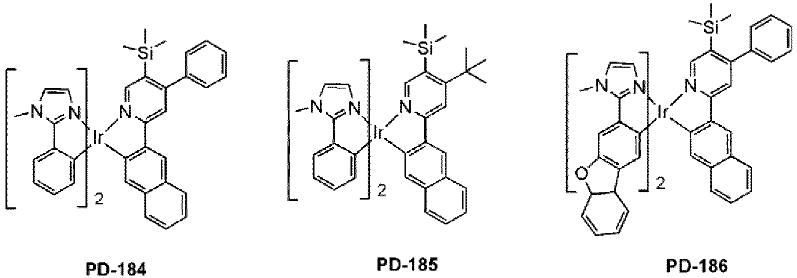

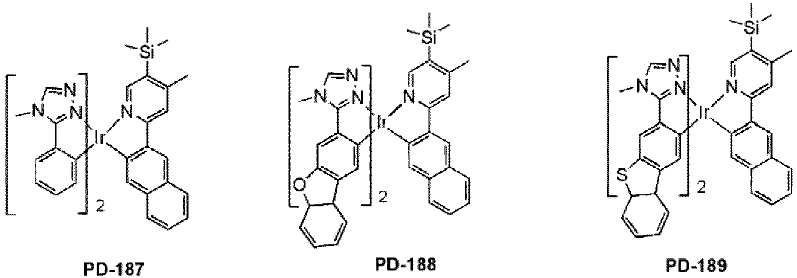

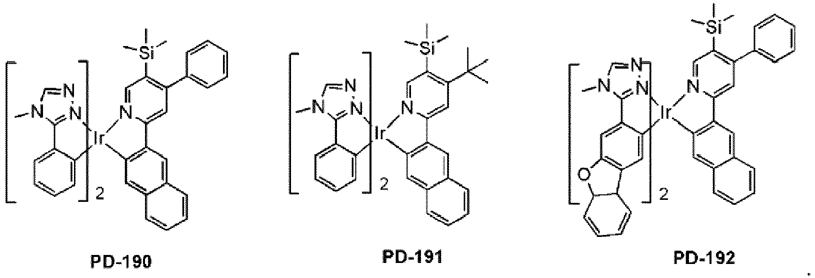

11. Organische lichtemittierende Vorrichtung nach Anspruch 1, wobei
L₂₁ bis L₂₃ jeweils unabhängig ausgewählt sind aus einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer spiro-Fluorenylengruppe, einer Benzofluorenylengruppe, einer Dibenzofluorenylengruppe, einer Phenalenylengruppe, einer Phenanthrenylengruppe, einer Anthrazenylengruppe, einer Fluoranthenylengruppe, einer Triphenylenylengruppe, einer Pyrenylengruppe, einer Chrysenylengruppe, einer Napththacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe und einer Dibenzocarbazolylengruppe; und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer spiro-Fluorenylengruppe, einer Benzofluorenylengruppe, einer Dibenzofluorenylengruppe, einer Phenalenylengruppe, einer Phenanthrenylengruppe, einer Anthrazenylengruppe, einer Fluoranthenylengruppe, einer Triphenylenylengruppe, einer Pyrenylengruppe, einer Chrysenylengruppe, einer Napththacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe und einer Dibenzocarbazolylengruppe, jeweils substituiert mit zumindest einem ausgewählt aus Deuterium, -F, -Cl, - Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₂₀ Alkylgruppe, einer C₁-C₂₀ Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Pentalenylgruppe, einer Indenylgruppe, einer Napththylgruppe, einer Azulenylgruppe, einer Heptalenylgruppe, einer Indacenylgruppe, einer Acenaphthylgruppe, einer Fluorenylgruppe, einer spiro- Fluorenylgruppe, einer Benzofluorenylgruppe, einer Dibenzofluorenylgruppe, einer Phenalenylgruppe, einer Phenanthrenylgruppe, einer Anthrazenylgruppe, einer Fluoranthenylgruppe, einer Triphenylenylgruppe, einer Pyrenylgruppe, einer Chrysenylgruppe, einer Napththacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe einer Thiadiazolylgruppe und einer Imidazopyridinylgruppe.

12. Organische lichtemittierende Vorrichtung nach Anspruch 1, wobei
L₂₁ bis L₂₃ jeweils unabhängig durch eine von Formeln 3-1 bis 3-21 dargestellt sind: 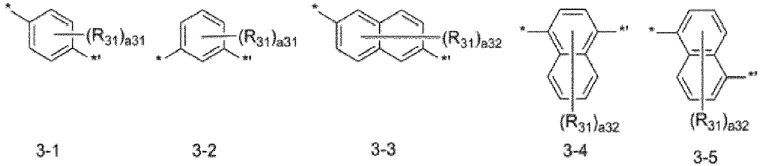 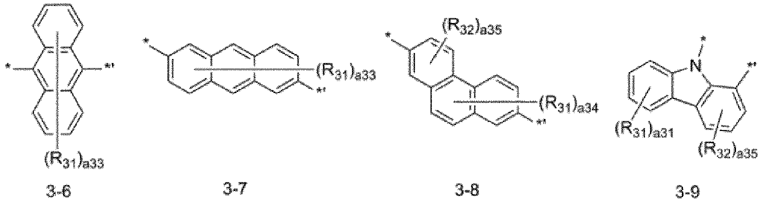 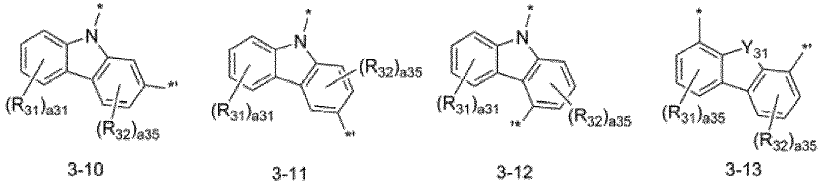 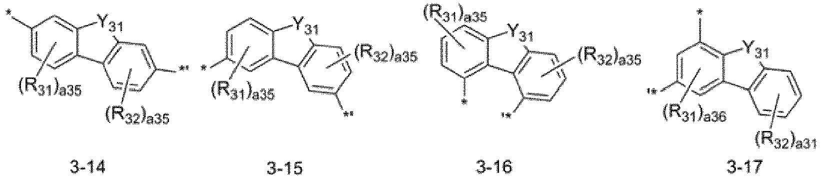 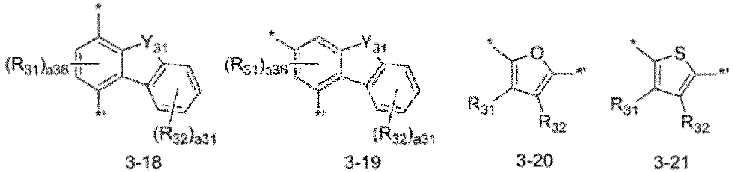 wobei, in Formeln 3-1 bis 3-21
Y₃₁ ausgewählt ist aus C(R₃₃)(R₃₄), N(R₃₃), O, S und Si(R₃₃)(R₃₄);
R₃₁ bis R₃₄ jeweils unabhängig ausgewählt sind aus Wasserstoff, Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₂₀ Alkylgruppe, einer C₁-C₂₀ Alkoxygruppe, einer Phenylgruppe, einer Naphthylgruppe, einer Fluorenylgruppe, einer spiro-Fluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe;
a31 ausgewählt ist aus 1, 2, 3 und 4;
a32 ausgewählt ist aus 1, 2, 3, 4, 5 und 6;
a33 ausgewählt ist aus 1, 2, 3, 4, 5, 6, 7 und 8;
a34 ausgewählt ist aus 1, 2, 3, 4 und 5;
a35 ausgewählt ist aus 1, 2 und 3;
a36 ausgewählt ist aus 1 und 2; und
jedes von * und *' eine Bindungsstelle an eine benachbarte Stelle angibt.

13. Organische lichtemittierende Vorrichtung nach Anspruch 1, wobei
R₂₁ und R₂₂ jeweils unabhängig ausgewählt sind aus einer Phenylgruppe, einer Pentalenylgruppe, einer Indenylgruppe, einer Napththylgruppe, einer Azulenylgruppe, einer Heptalenylgruppe, einer Indacenylgruppe, einer Acenaphthylgruppe, einer Fluorenylgruppe, einer spiro- Fluorenylgruppe, einer Benzofluorenylgruppe, einer Dibenzofluorenylgruppe, einer Phenalenylgruppe, einer Phenanthrenylgruppe, einer Anthrazenylgruppe, einer Fluoranthenylgruppe, einer Triphenylenylgruppe, einer Pyrenylgruppe, einer Chrysenylgruppe, einer Napththacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe einer Thiadiazolylgruppe, einer Imidazopyridinylgruppe und einer Imidazopyrimidinylgruppe; und
einer Phenylgruppe, einer Pentalenylgruppe, einer Indenylgruppe, einer Napththylgruppe, einer Azulenylgruppe, einer Heptalenylgruppe, einer Indacenylgruppe, einer Acenaphthylgruppe, einer Fluorenylgruppe, einer spiro- Fluorenylgruppe, einer Benzofluorenylgruppe, einer Dibenzofluorenylgruppe, einer Phenalenylgruppe, einer Phenanthrenylgruppe, einer Anthrazenylgruppe, einer Fluoranthenylgruppe, einer Triphenylenylgruppe, einer Pyrenylgruppe, einer Chrysenylgruppe, einer Napththacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe einer Thiadiazolylgruppe, einer Imidazopyridinylgruppe und einer Imidazopyrimidinylgruppe, jeweils substituiert mit zumindest einem ausgewählt sind aus Deuterium, -F,-Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₂₀ Alkylgruppe, einer C₁-C₂₀ Alkoxygruppe, einer Phenylgruppe, einer Biphenylgruppe, einer Pentalenylgruppe, einer Indenylgruppe, einer Napththylgruppe, einer Azulenylgruppe, einer Heptalenylgruppe, einer Indacenylgruppe, einer Acenaphthylgruppe, einer Fluorenylgruppe, einer spiro-Fluorenylgruppe, einer Benzofluorenylgruppe, einer Dibenzofluorenylgruppe, einer Phenalenylgruppe, einer Phenanthrenylgruppe, einer Anthrazenylgruppe, einer Fluoranthenylgruppe, einer Triphenylenylgruppe, einer Pyrenylgruppe, einer Chrysenylgruppe, einer Napththacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe einer Thiadiazolylgruppe, einer Imidazopyridinylgruppe und einer Imidazopyrimidinylgruppe.

14. Organische lichtemittierende Vorrichtung nach Anspruch 1, wobei
R₂₁ und R₂₂ jeweils unabhängig ausgewählt sind aus Gruppen, die durch Formeln 5-1 bis 5-14 dargestellt sind: 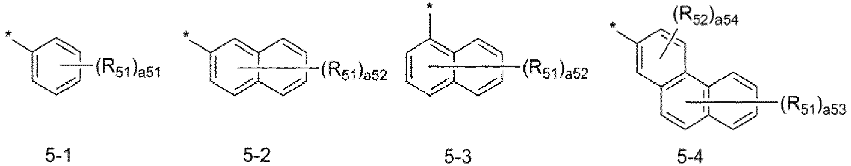 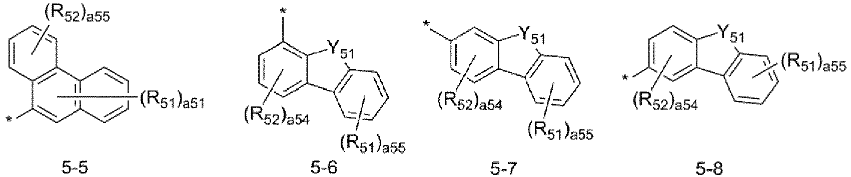 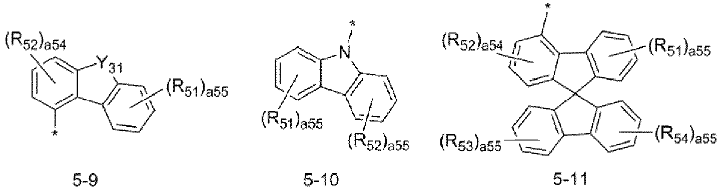 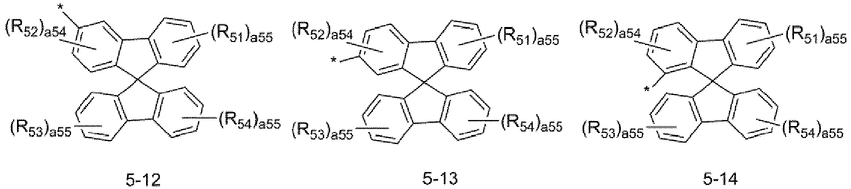
Y₅₁ ausgewählt ist aus C(R₅₃)(R₅₄), N(R₅₃), O und S;
R₅₁ bis R₅₄ jeweils unabhängig ausgewählt sind aus Wasserstoff, Deuterium, -F, -Cl, -Br, -I, einer Hydroxylgruppe, einer Cyanogruppe, einer Nitrogruppe einer Aminogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer C₁-C₂₀ Alkylgruppe, -CD₃, -CF₃, einer C₁-C₂₀ Alkoxygruppe, einer Phenylgruppe, einer Naphthylgruppe, einer Fluorenylgruppe, einer spiro-Fluorenylengruppe, einer Benzofluorenylengruppe, einer Dibenzofluorenylengruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe;
a51 ausgewählt ist aus 1, 2, 3, 4 und 5;
a52 ausgewählt ist aus 1, 2, 3, 4, 5, 6 und 7;
a53 ausgewählt ist aus 1, 2, 3, 4, 5 und 6;
a54 ausgewählt ist aus 1, 2 und 3;
a55 ausgewählt ist aus 1, 2, 4 und 4; und
* eine Bindungsstelle an eine benachbarte Stelle angibt.

15. Organische lichtemittierende Vorrichtung nach Anspruch 1, wobei
R₂₁ und R₂₂ jeweils unabhängig ausgewählt sind aus Gruppen, die durch Formeln 6-1 bis 6-55 dargestellt sind: 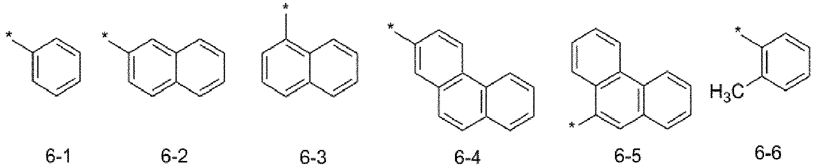 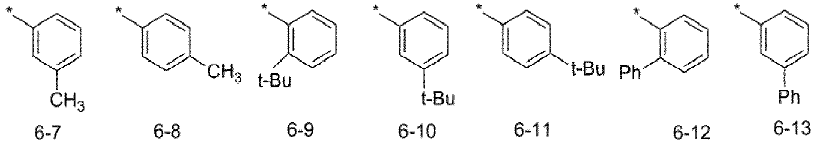 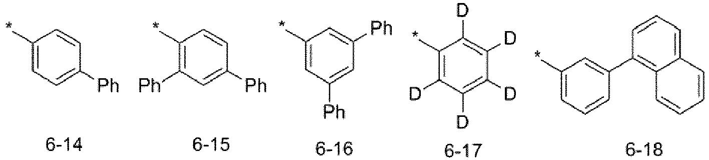 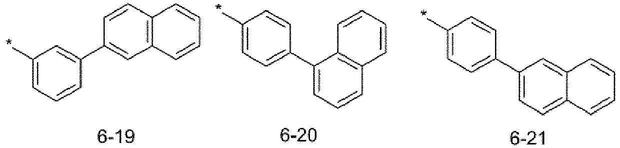 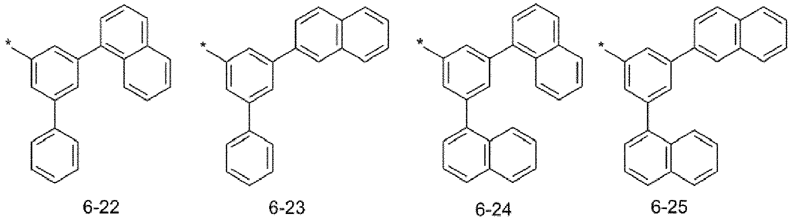 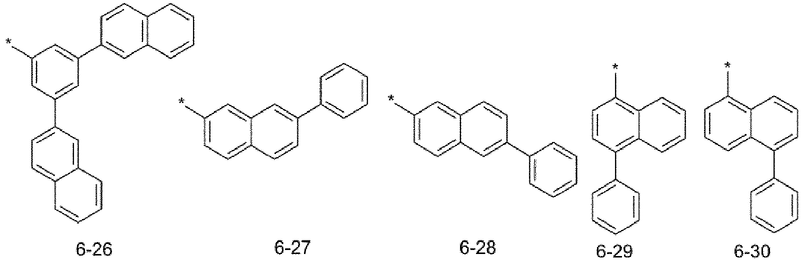 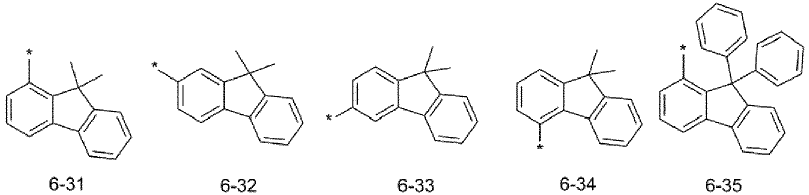 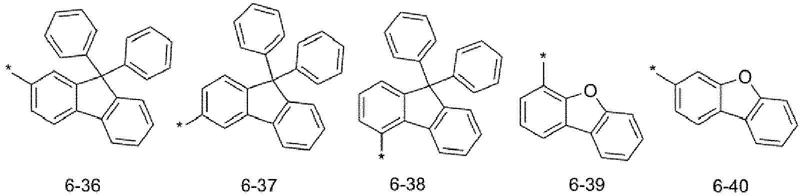 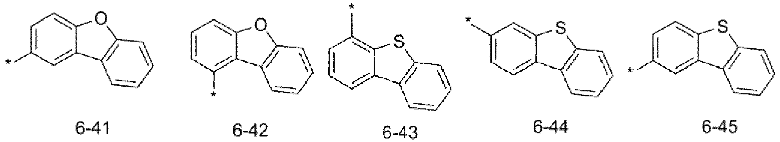 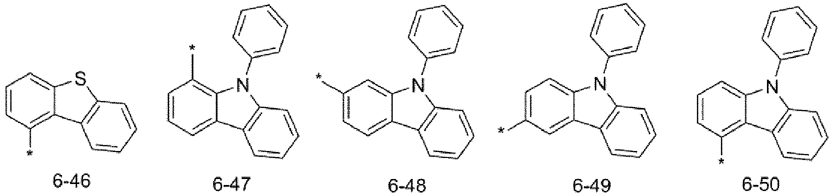 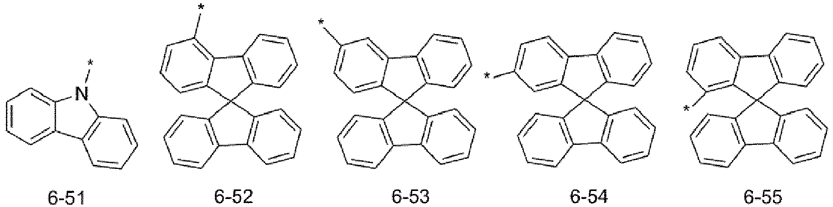 wobei in Formen 6-1 bis 6-55
* eine Bindungsstelle an eine benachbarte Stelle angibt.

16. Organische lichtemittierende Vorrichtung nach Anspruch 1, wobei
R₈₁ bis R₉₆ jeweils unabhängig ausgewählt sind aus 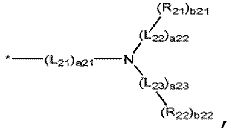 Wasserstoff, Gruppen, die durch Formeln 6-1 bis 6-3 dargestellt sind, und Gruppen, die durch Formeln 6-31 bis 6-55 dargestellt sind: 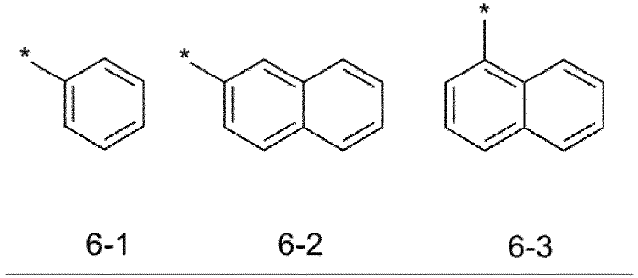 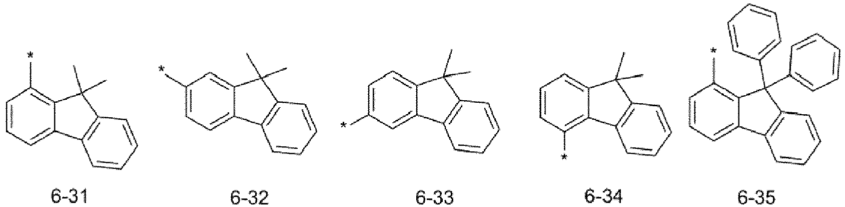 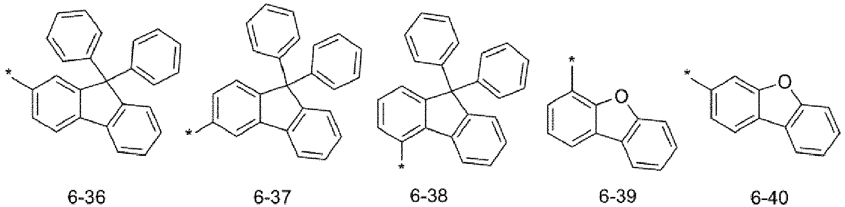 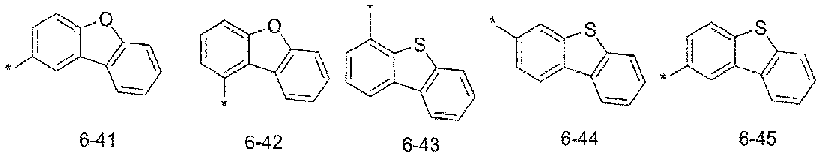 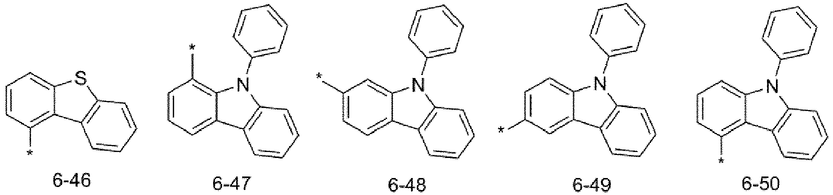 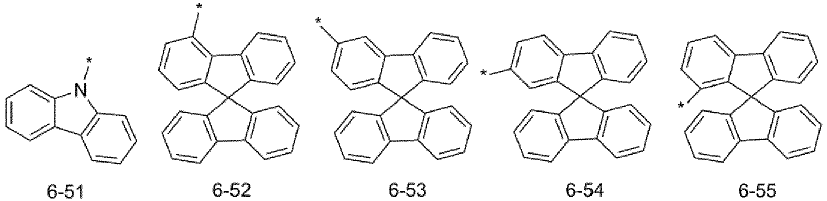 wobei in Formeln 6-1 bis 6-3 und Formeln 6-31 bis 6-55
* eine Bindungsstelle an eine benachbarte Stelle angibt.

17. Organische lichtemittierende Vorrichtung nach Anspruch 1, wobei
die Verbindung auf Aminbasis durch eine von Formeln 2-1 bis 2-6 dargestellt ist: 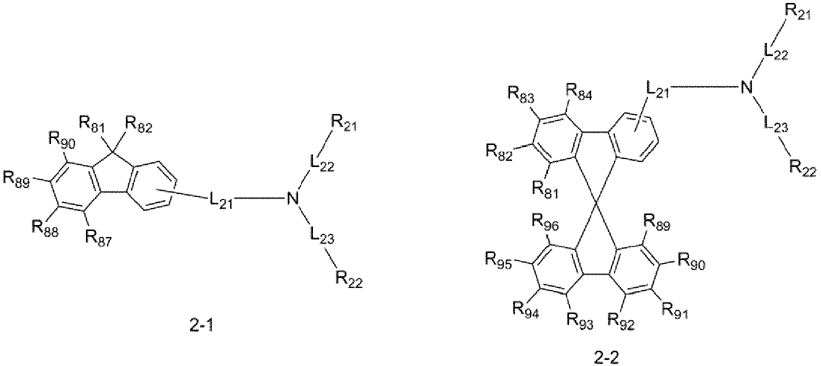 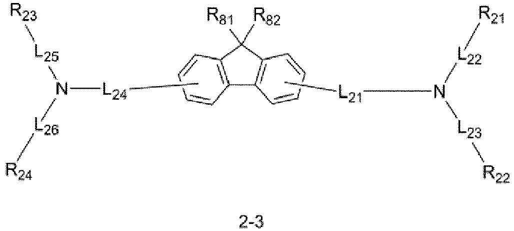 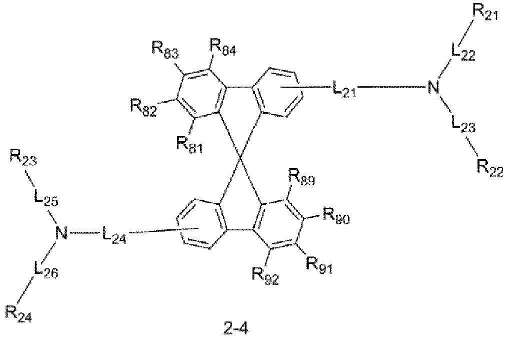 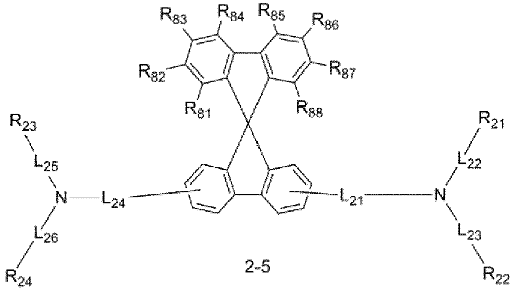 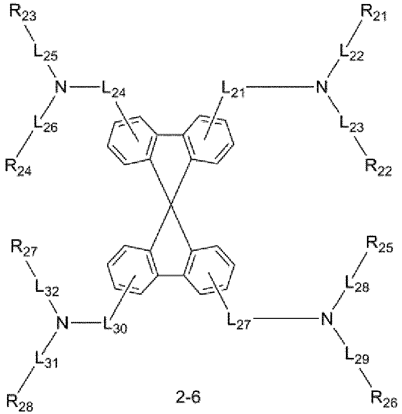 wobei in Formeln 2-1 bis 2-6
L₂₁ bis L₂₃, R₂₁, R₂₂ und R₈₁ bis R₉₆ dieselben wie in Anspruch 1 beschrieben sind;
L₂₄ bis L₃₂ jeweils unabhängig dieselben wie in Verbindung mit L₂₁ beschrieben sind; und
R₂₃ und R₂₈ jeweils unabhängig dieselben wie in Verbindung mit R₂₁ beschrieben sind.

18. Organische lichtemittierende Vorrichtung nach Anspruch 1, wobei die Verbindung auf Aminbasis aus Verbindungen ausgewählt ist, die in der Folge dargestellt sind.

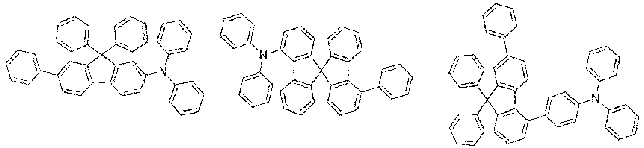

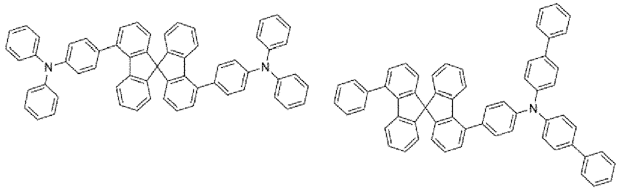

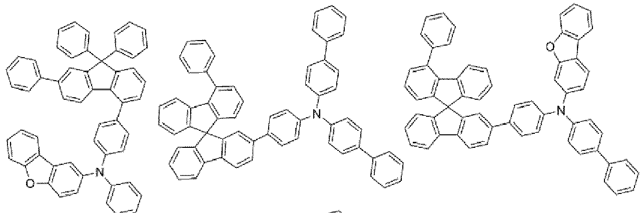

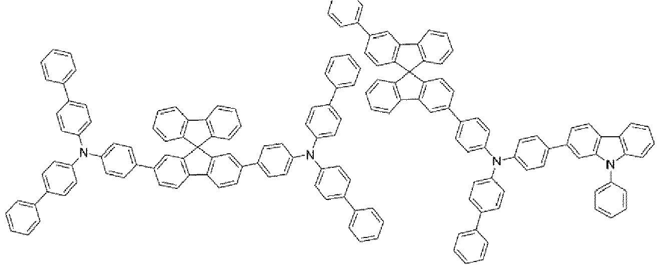

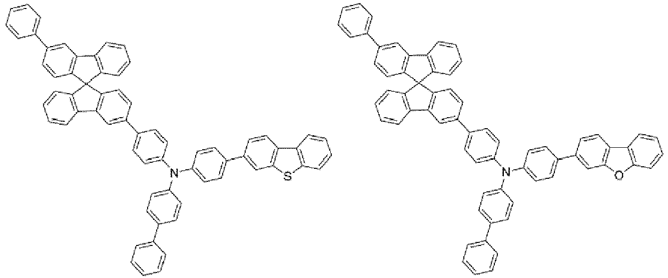

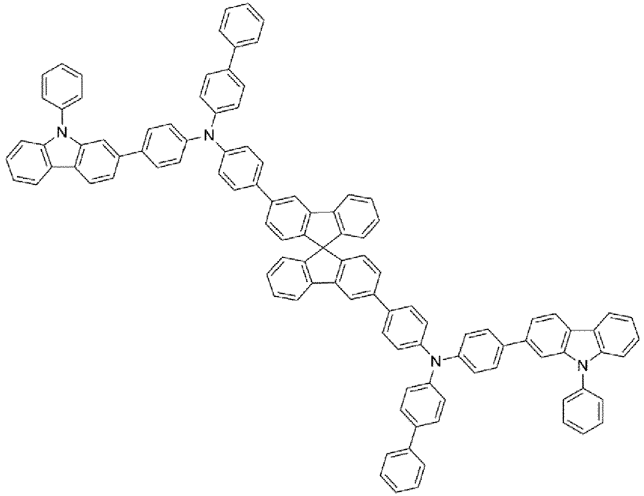

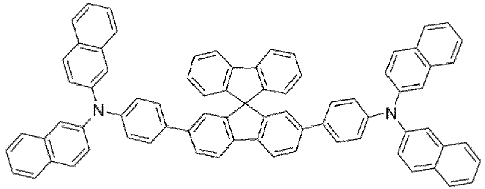

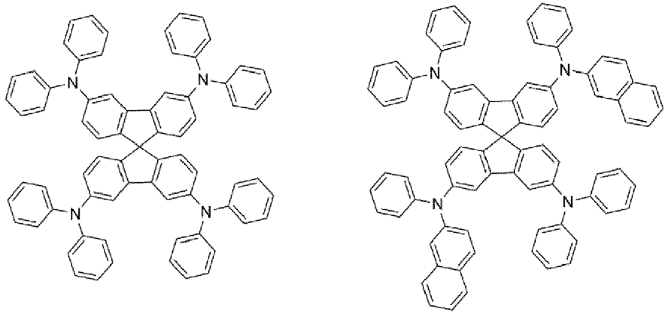

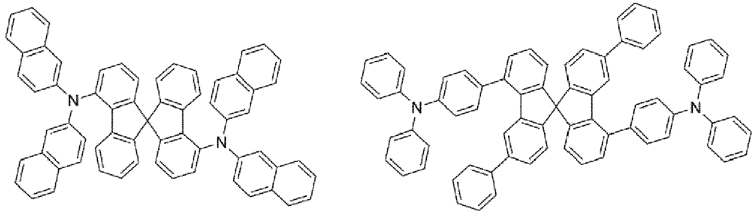

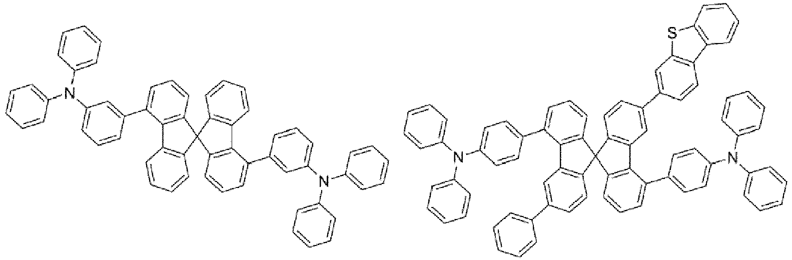

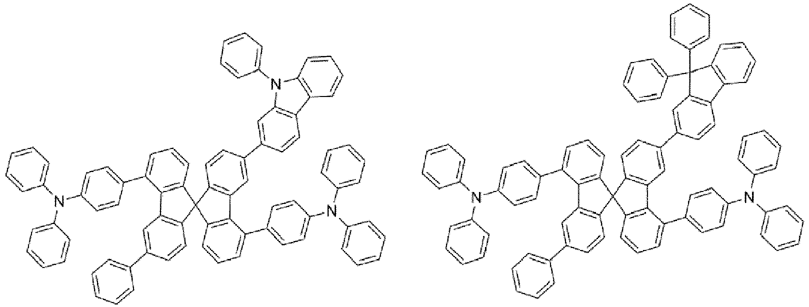

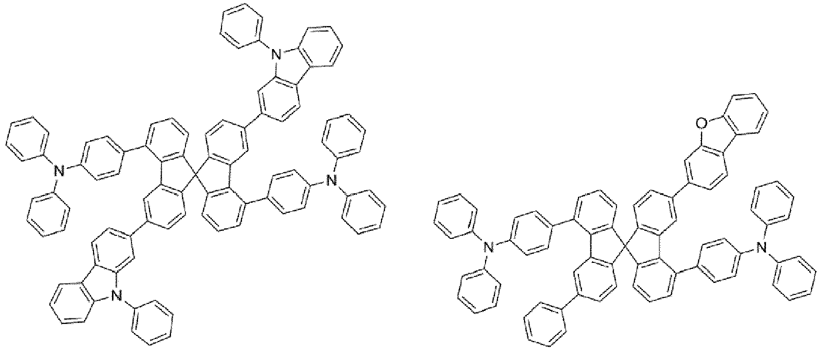

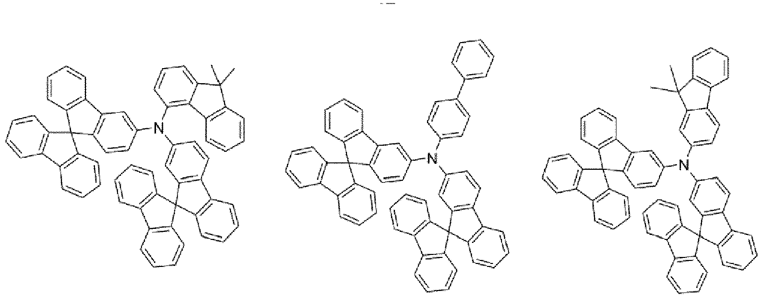

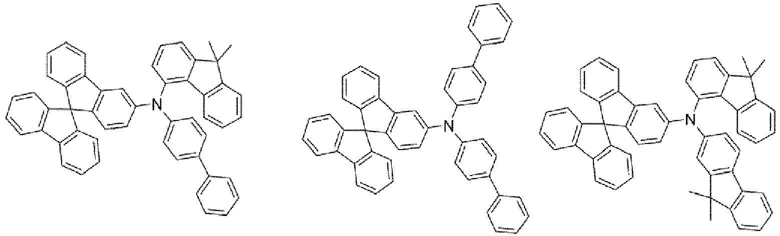

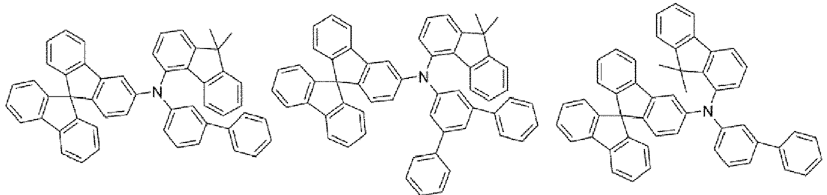

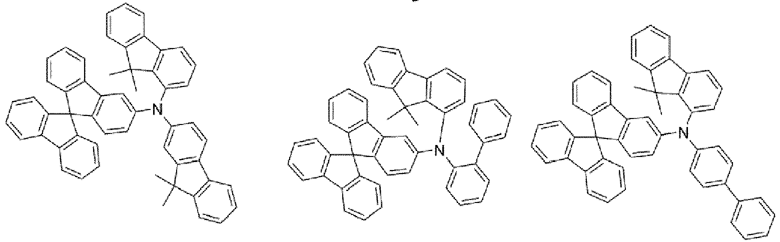

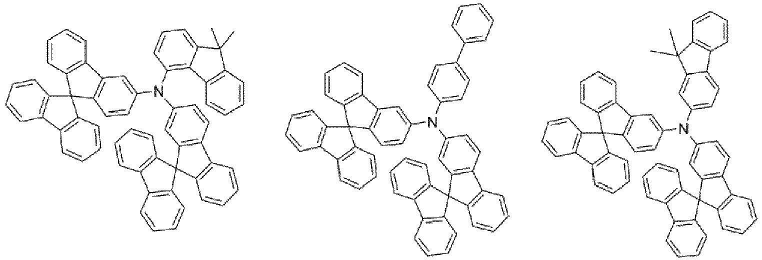

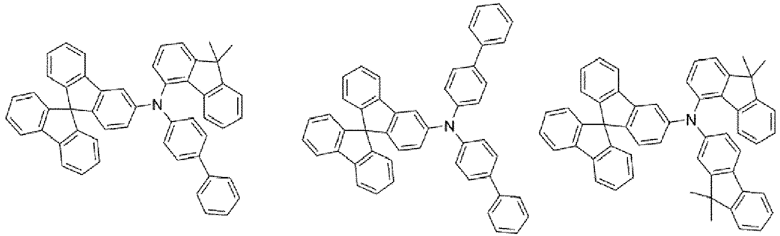

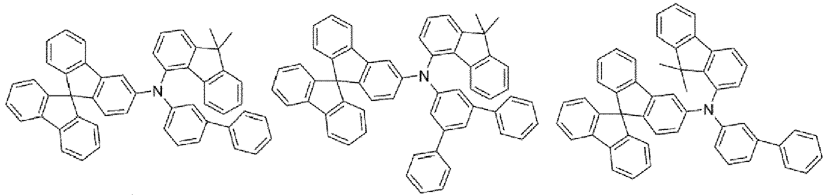

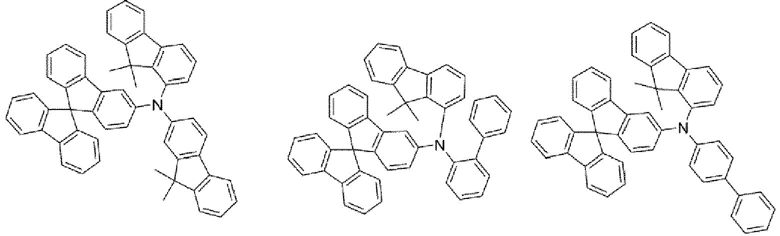

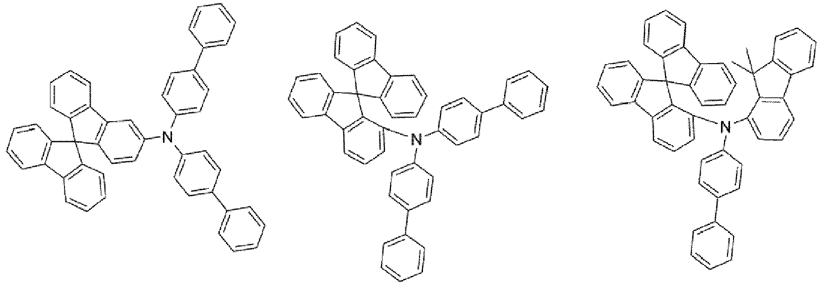

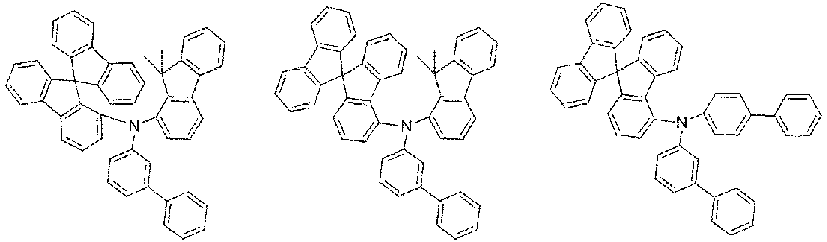

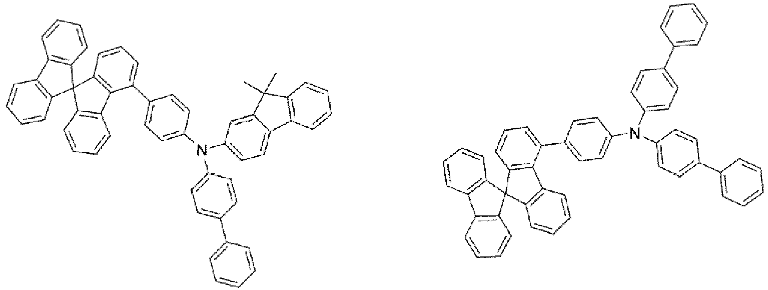

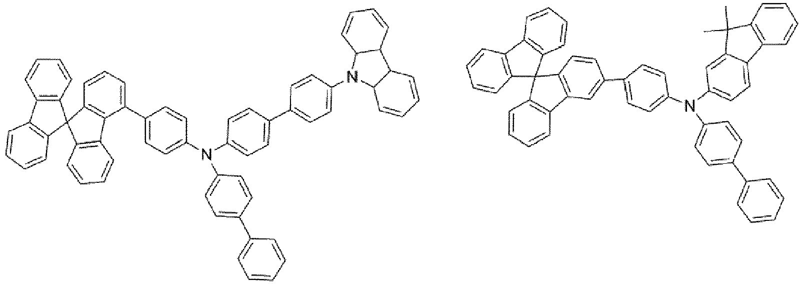

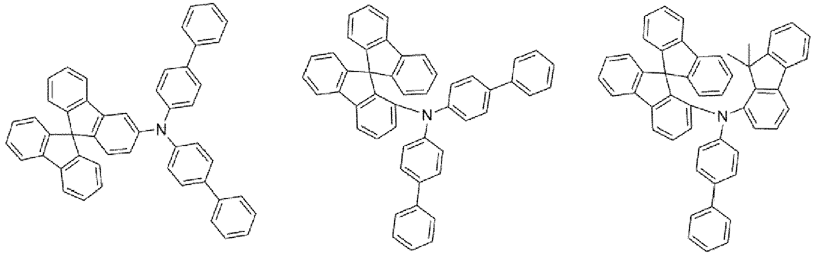

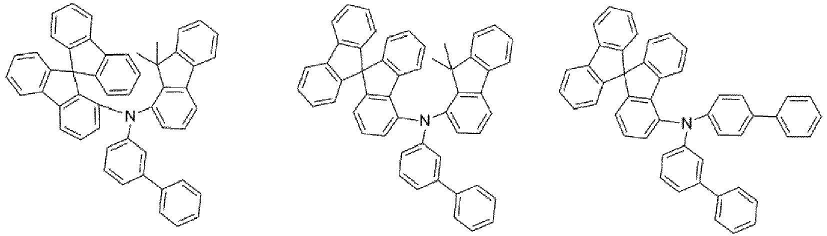

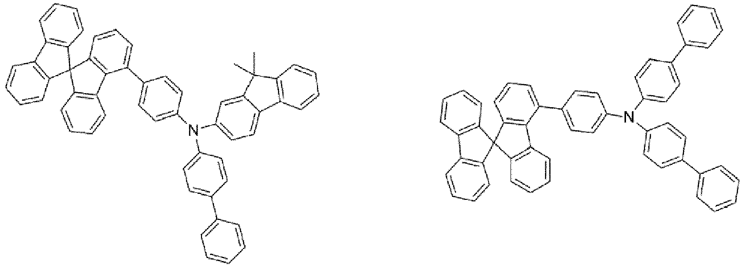

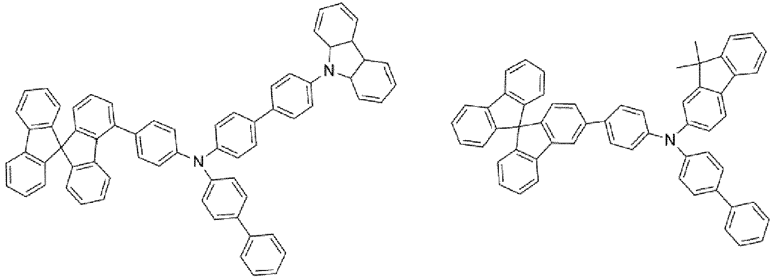

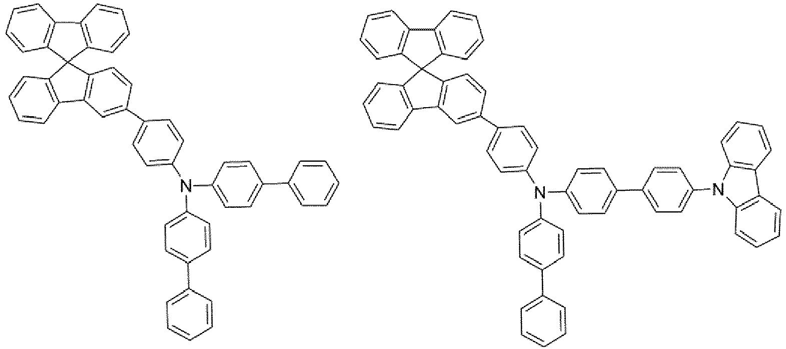

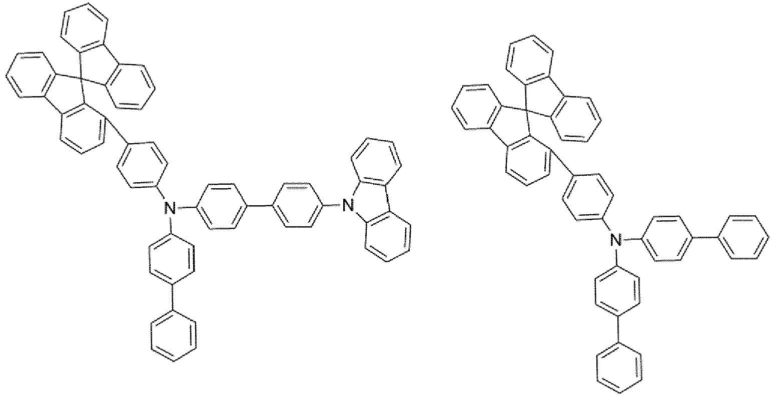

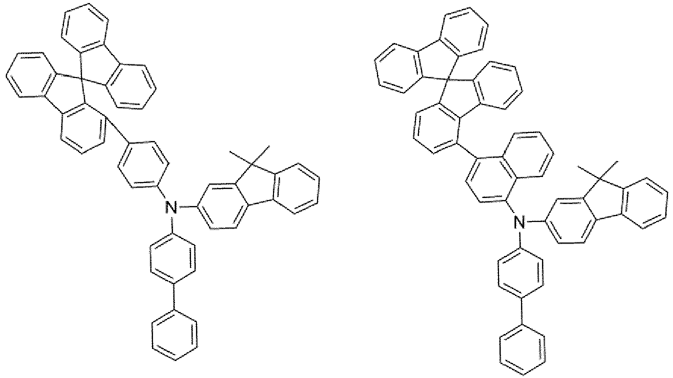

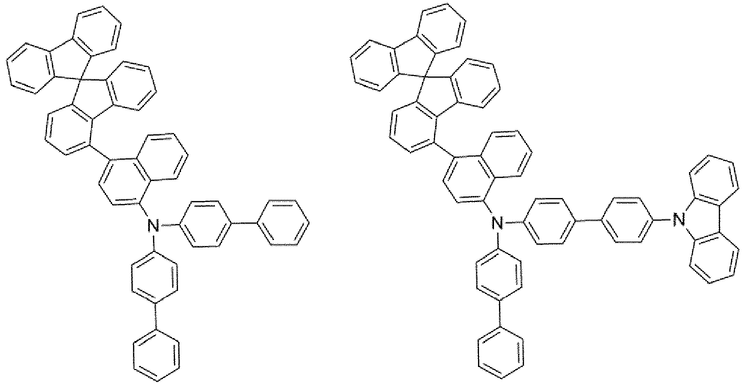

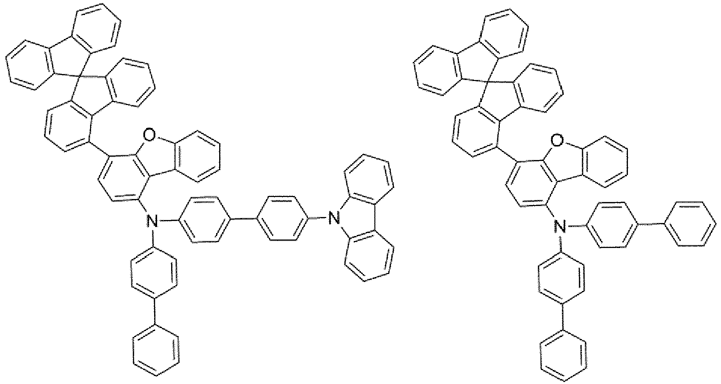

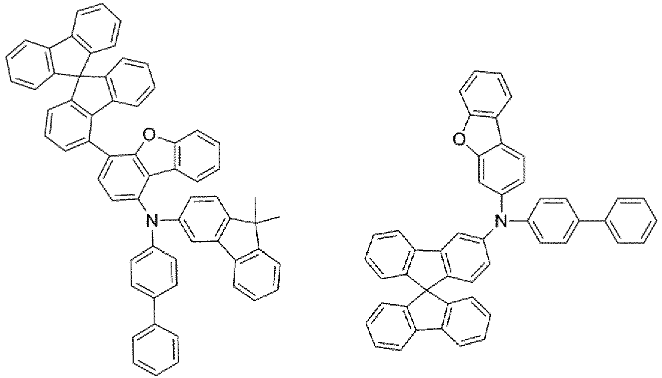

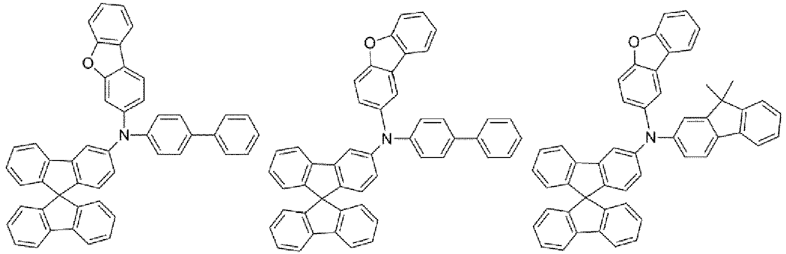

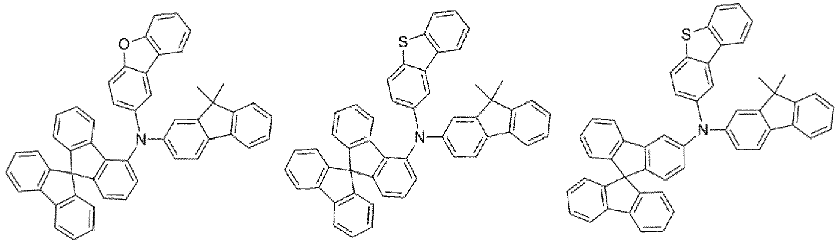

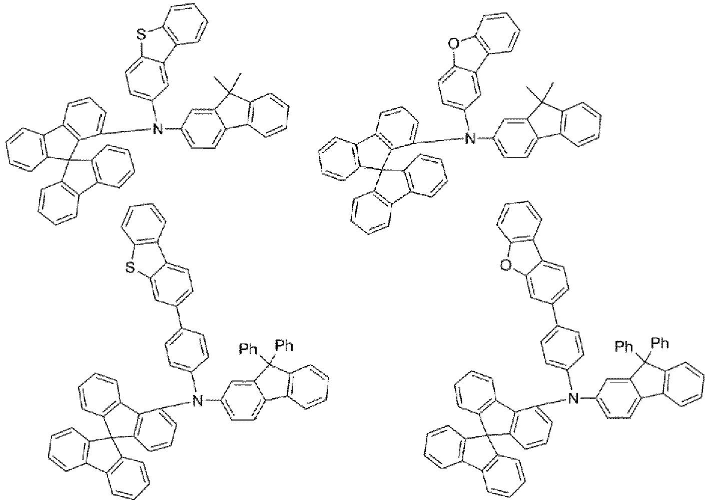

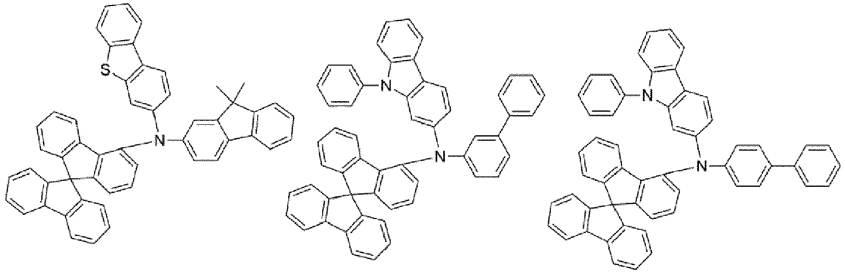

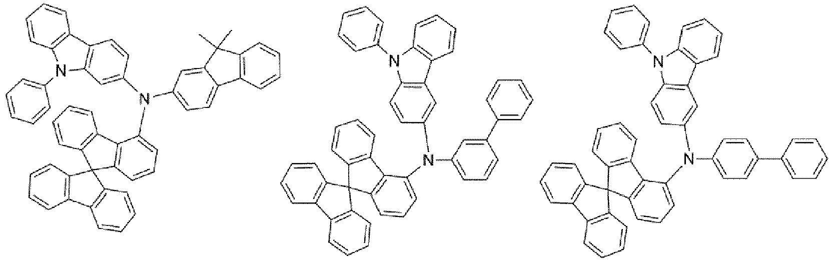

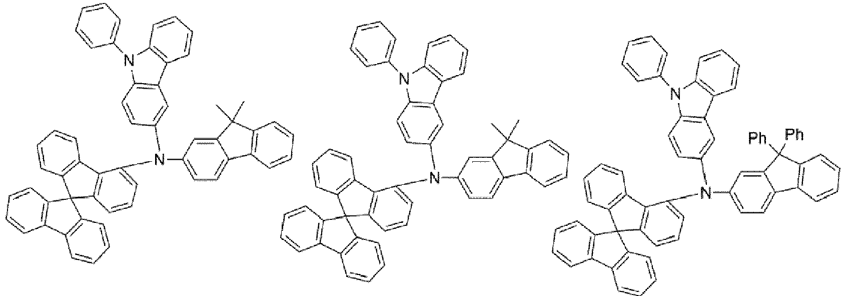

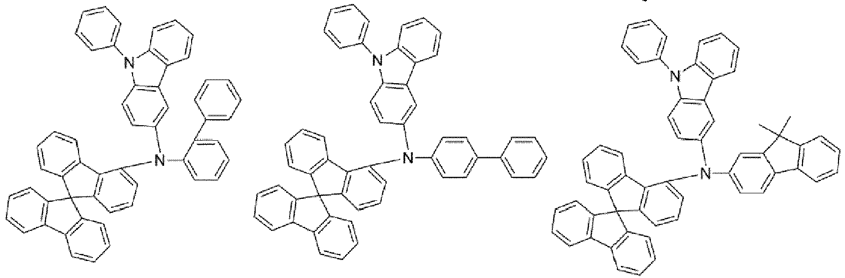

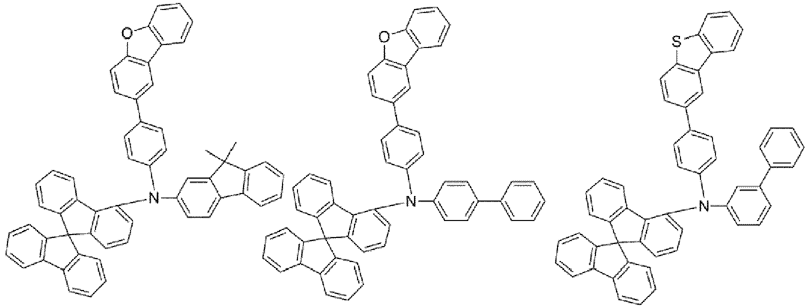

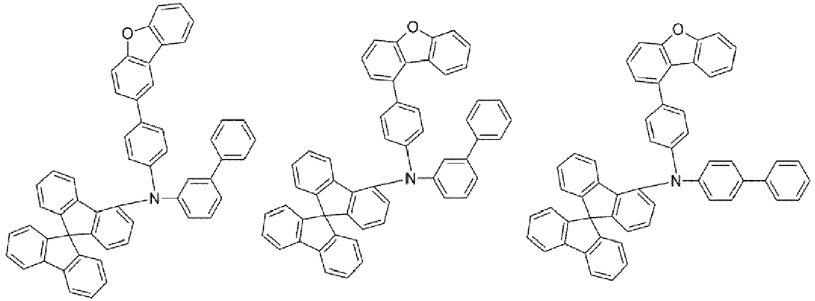

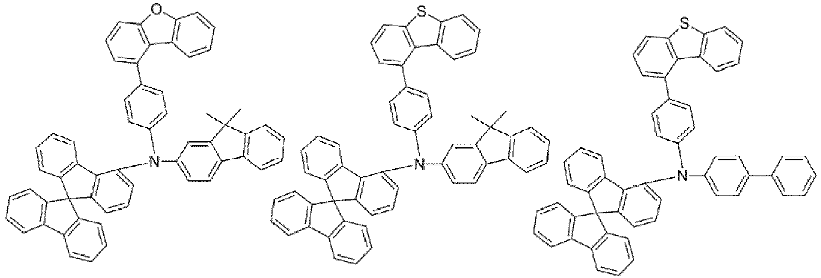

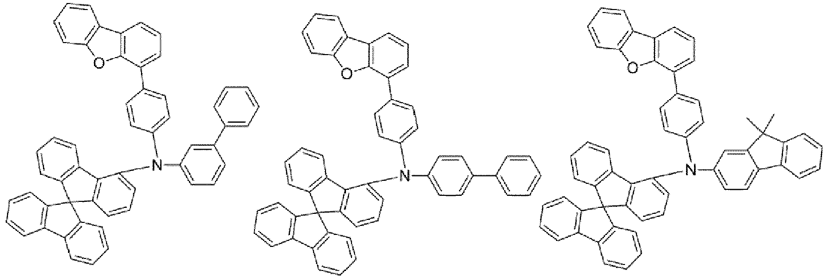

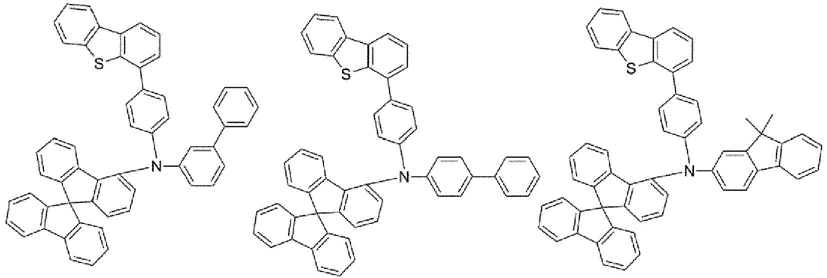

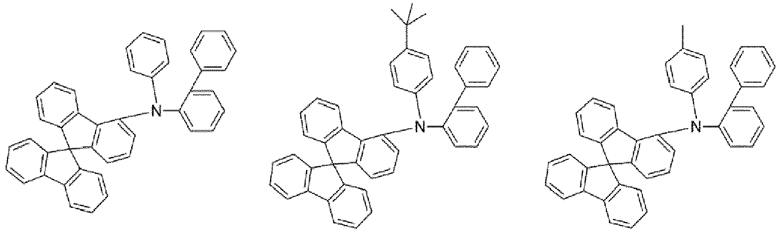

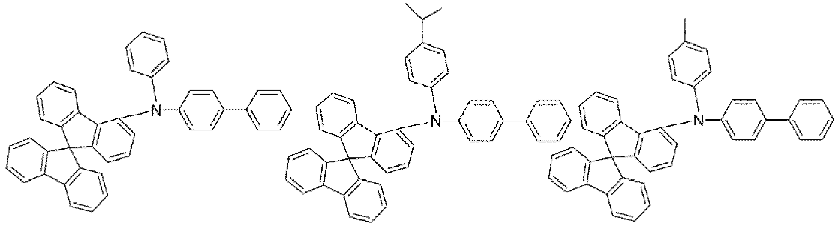

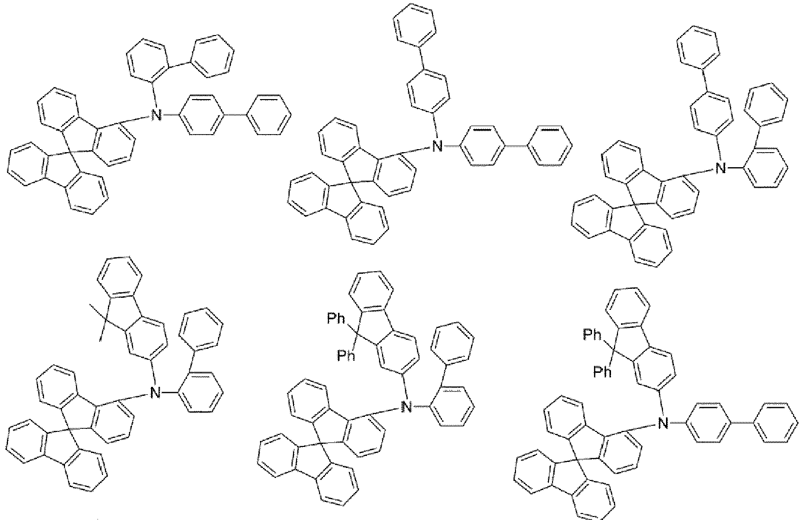

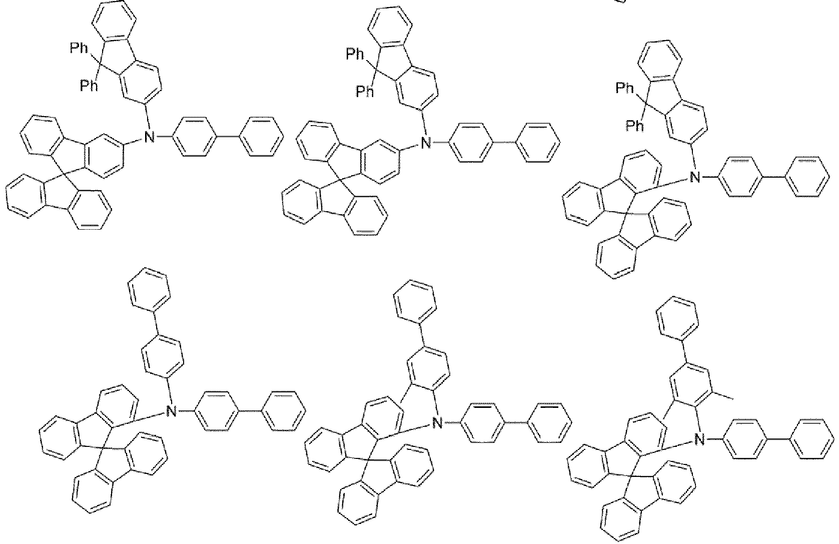

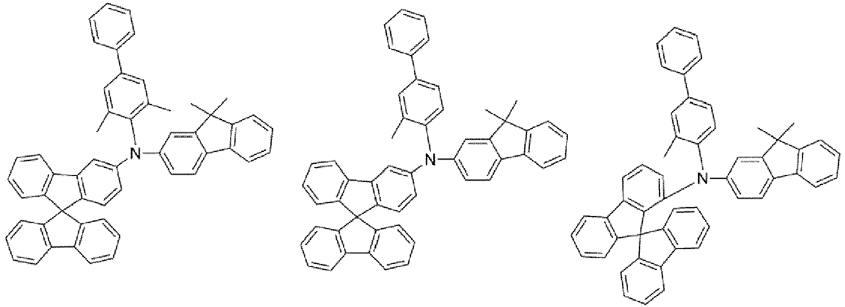

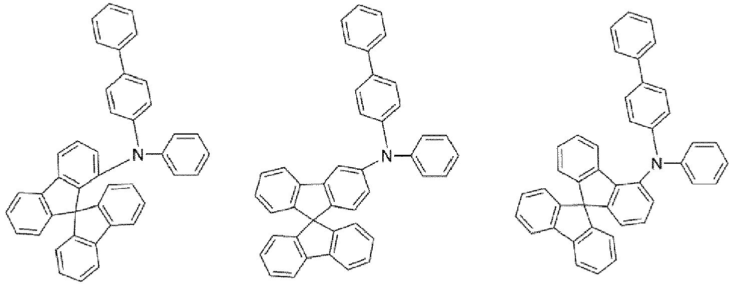

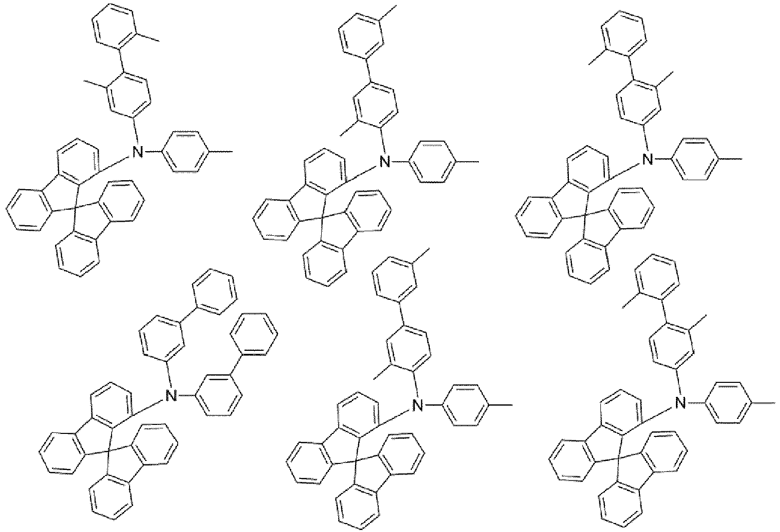

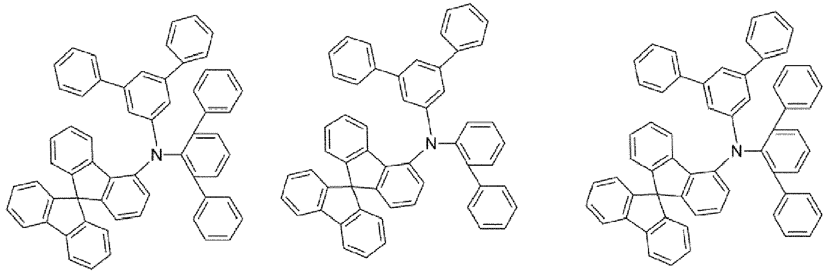

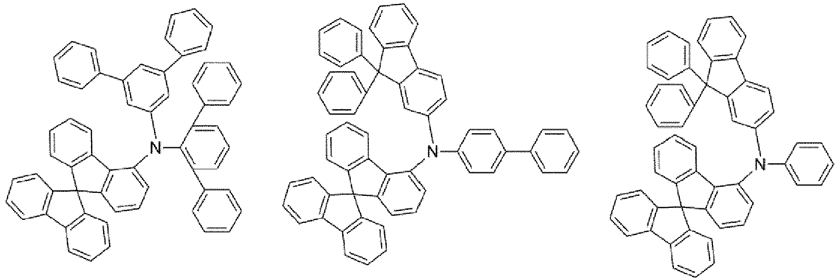

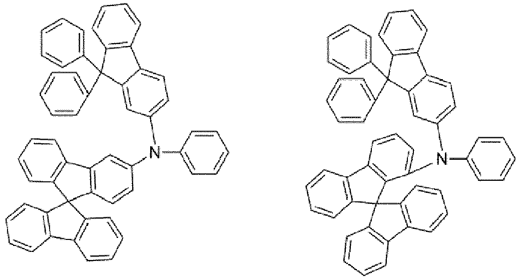

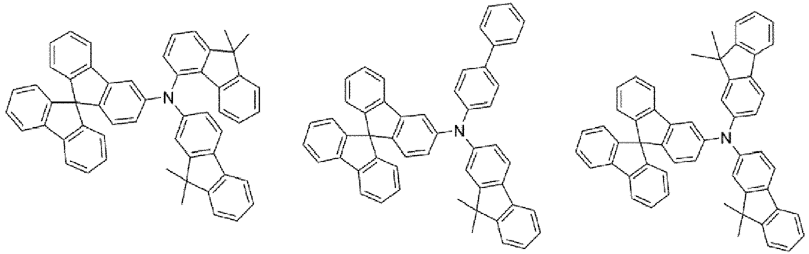

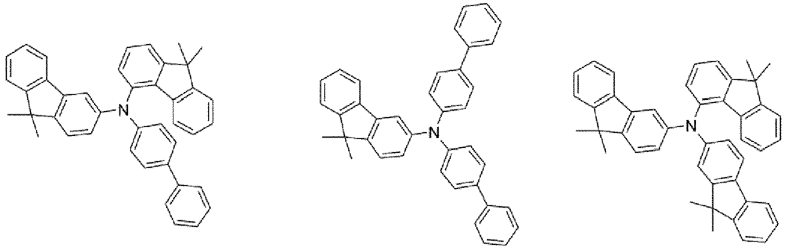

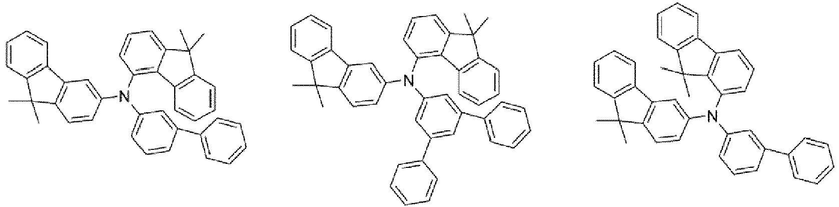

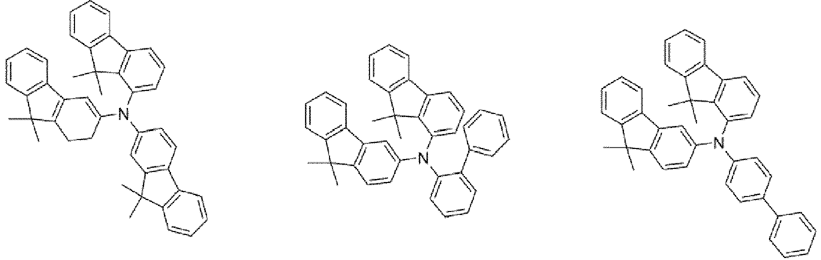

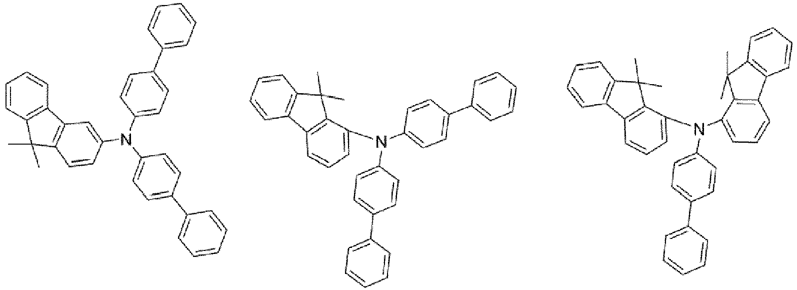

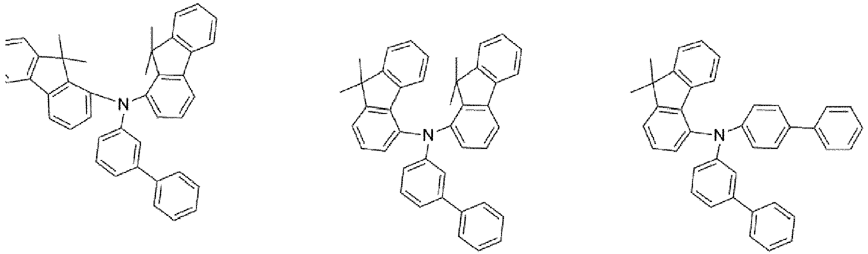

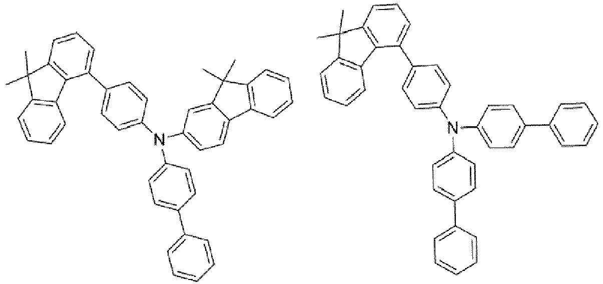

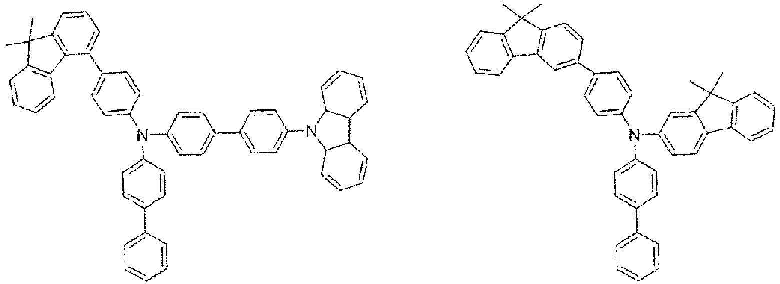

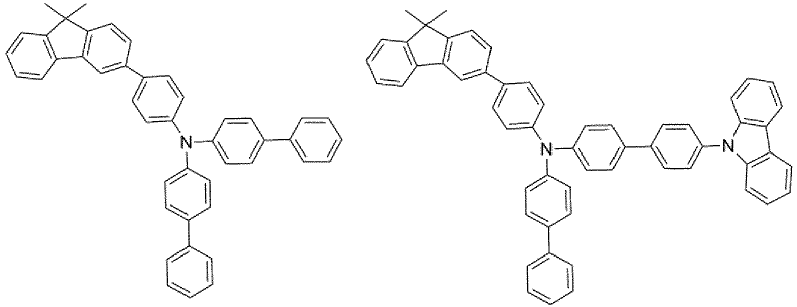

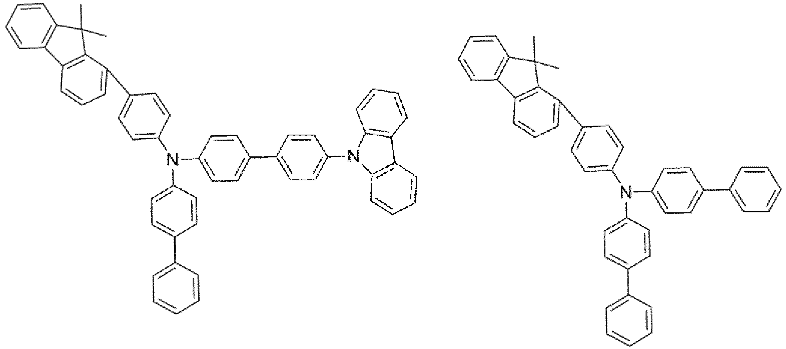

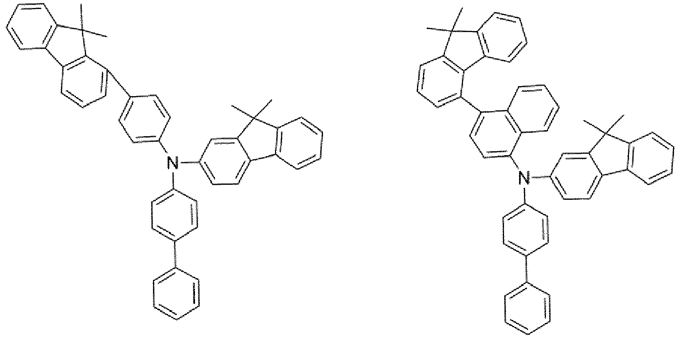

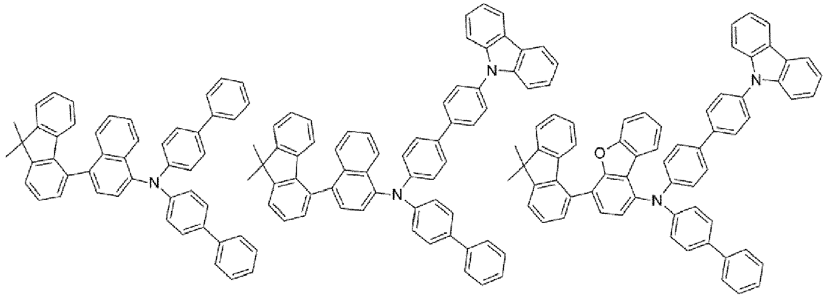

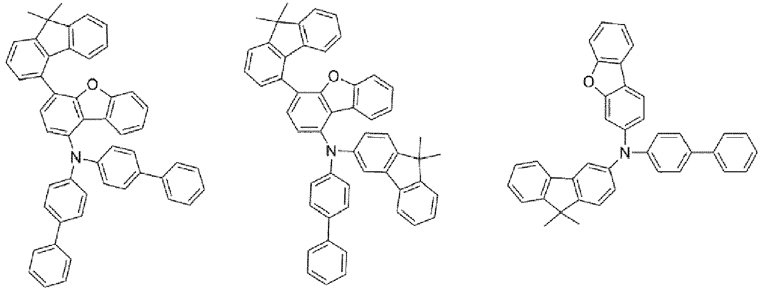

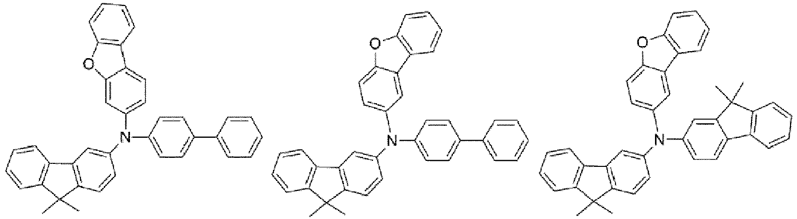

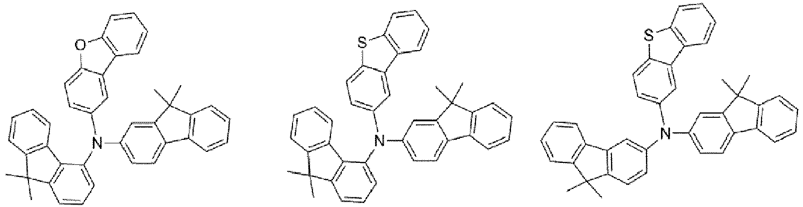

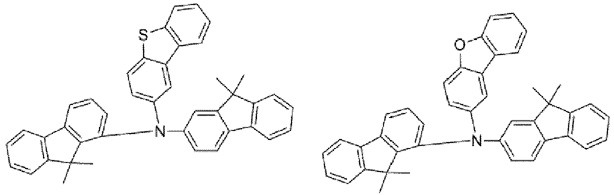

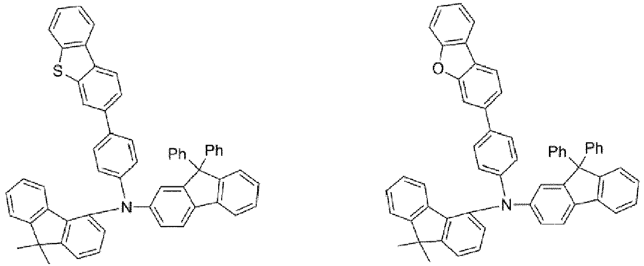

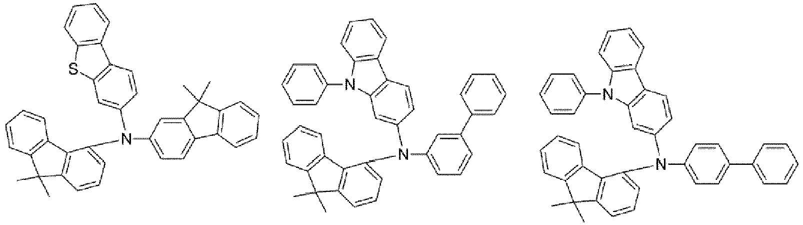

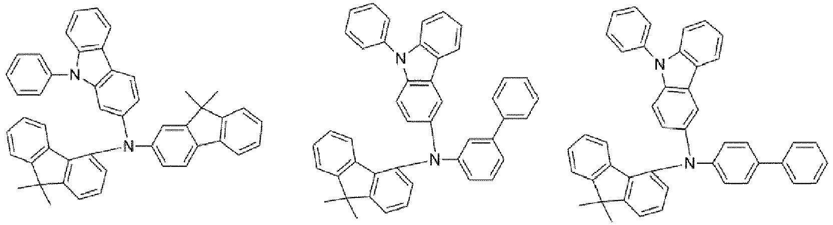

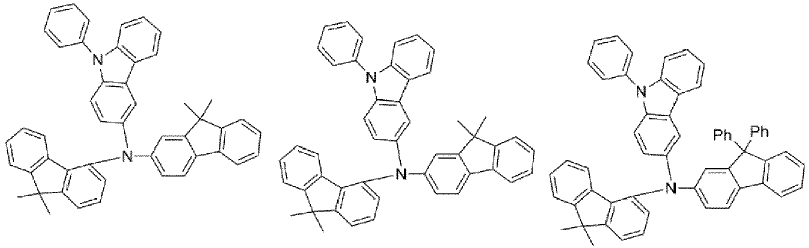

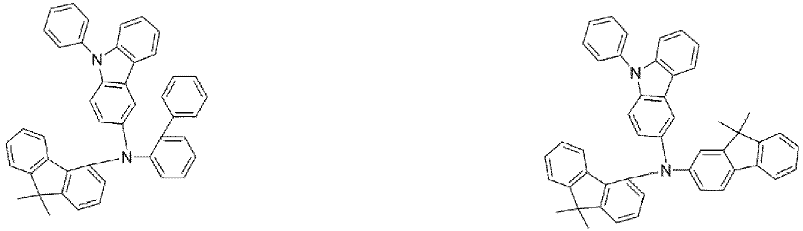

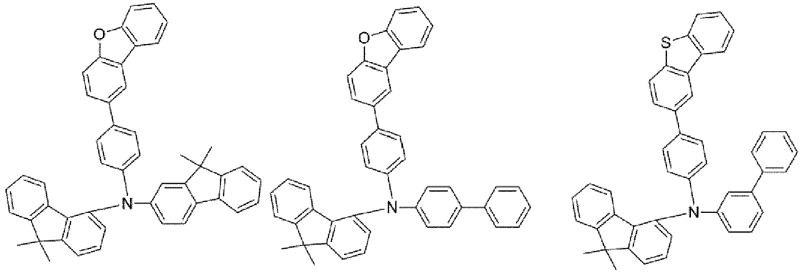

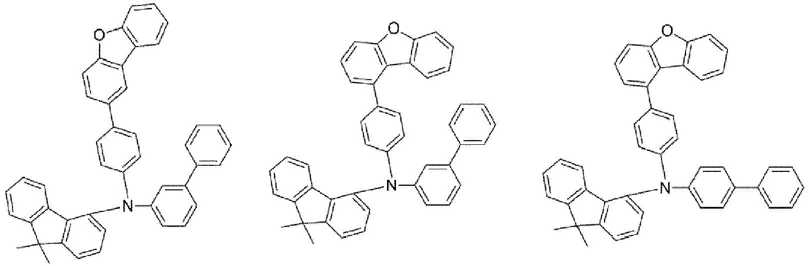

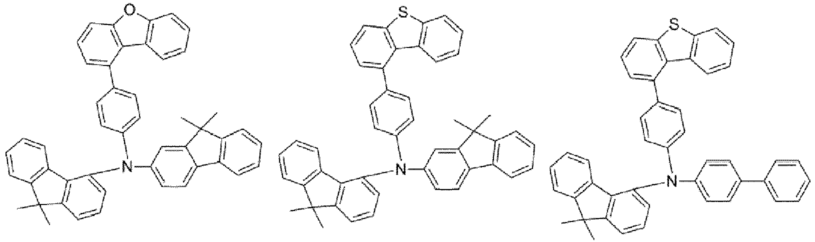

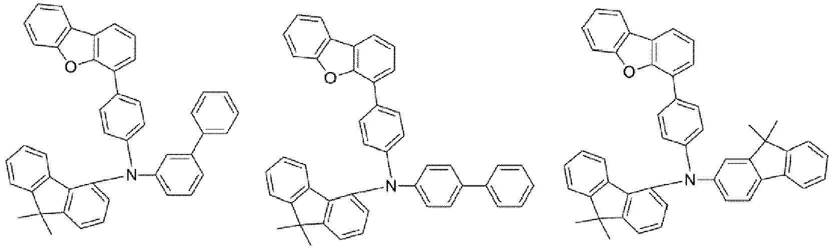

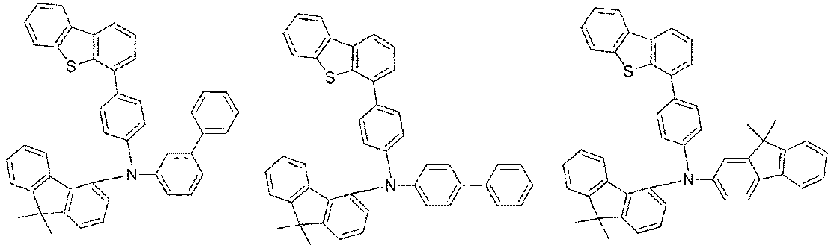

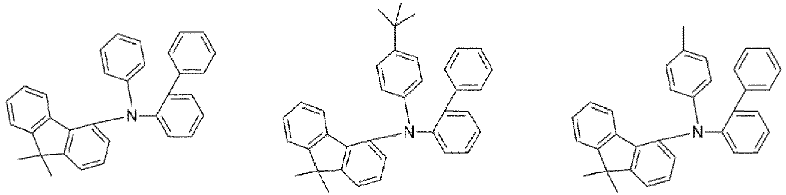

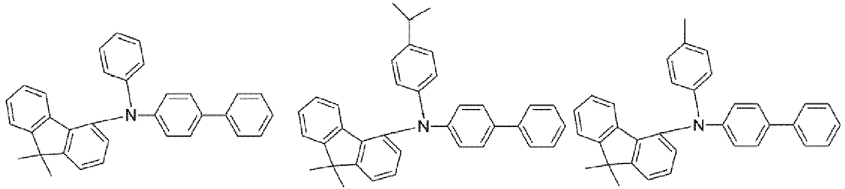

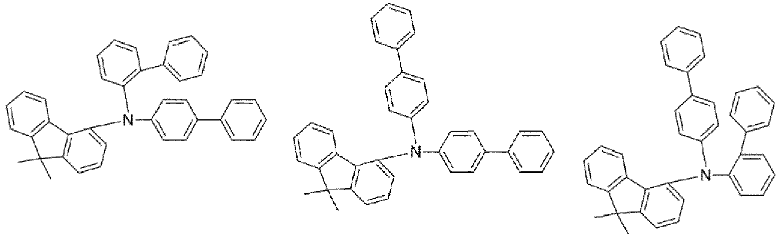

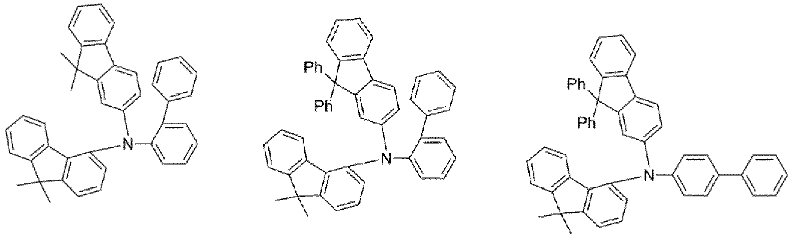

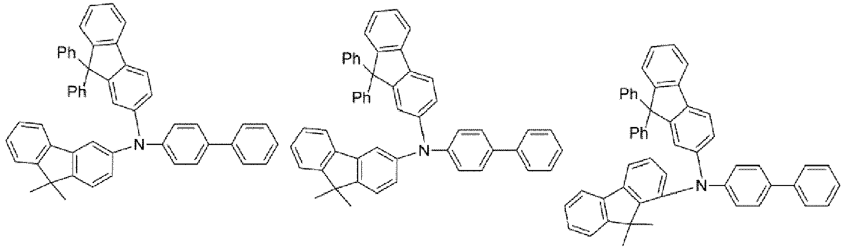

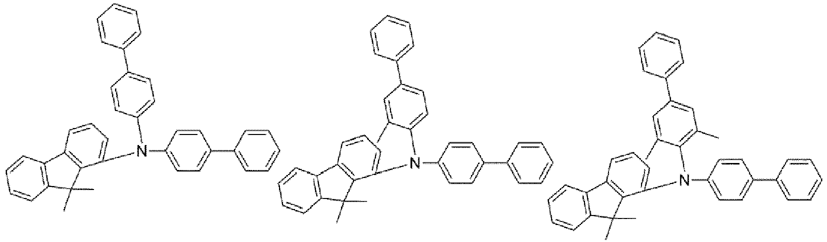

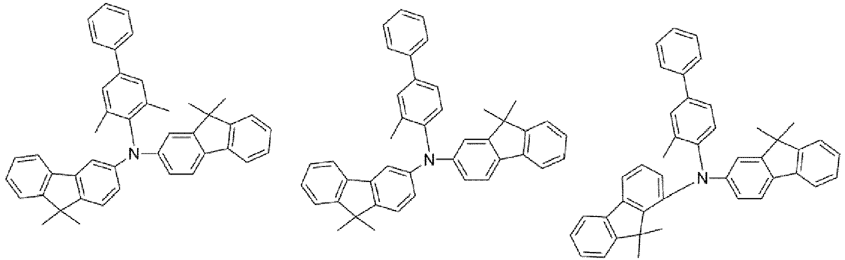

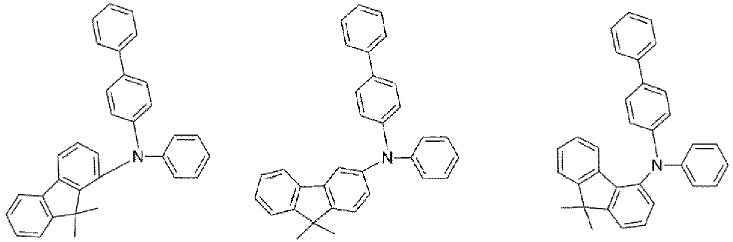

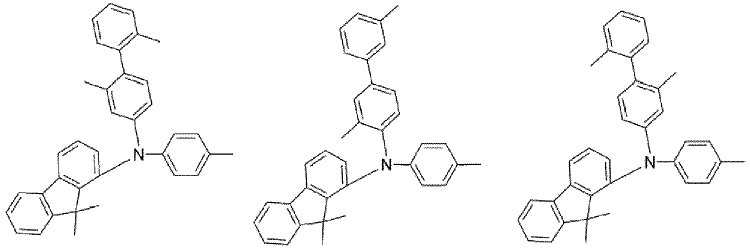

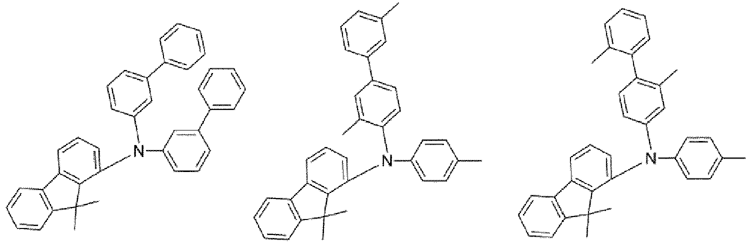

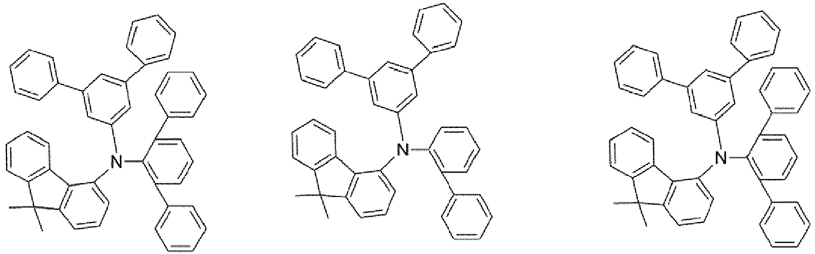

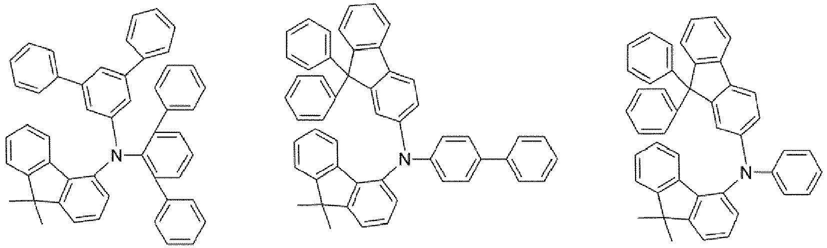

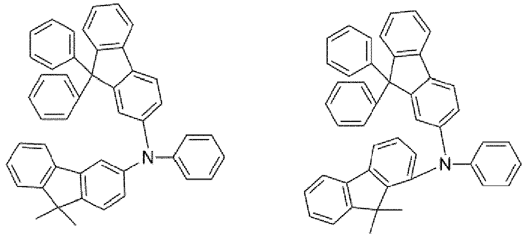

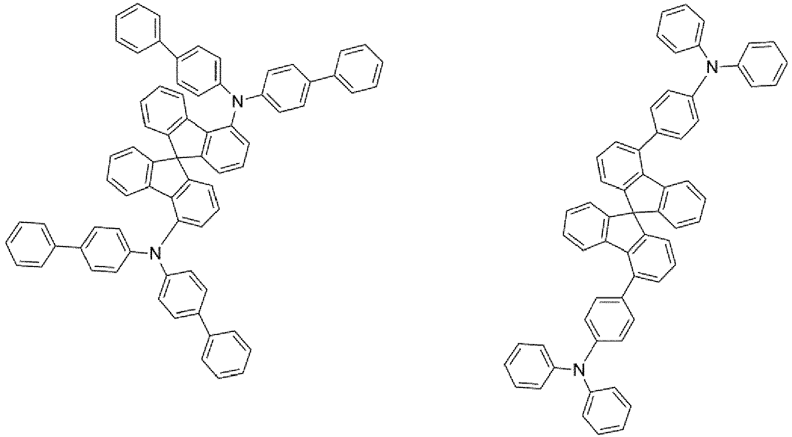

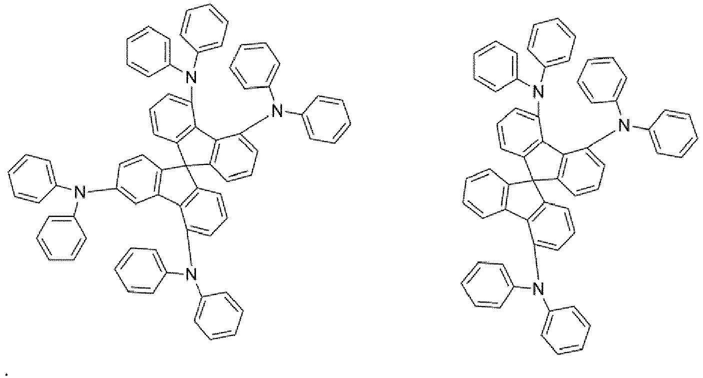

19. Organische lichtemittierende Vorrichtung nach Anspruch 1, wobei
die Lochtransportregion eine Hilfsschicht umfasst, die die Verbindung auf Aminbasis umfasst.

20. Organische lichtemittierende Vorrichtung nach Anspruch 1, wobei
sich die Emissionsschicht neben der Hilfsschicht befindet.

## Revendications

1. Dispositif électroluminescent organique (10) comprenant : une première électrode (110) ; une deuxième électrode (190) ; une couche d'émission entre la première électrode (110) et la deuxième électrode (190) ; et une région de transport de trous entre la première électrode (110) et la couche d'émission, dans lequel la couche d'émission comprend un composé organométallique représenté par la formule 1, et la région de transport de trous comprend un composé à base d'aminé représenté par la formule 2 :
<Formule 1> M(L₁)ₙ₁(L₂)ₙ₂ 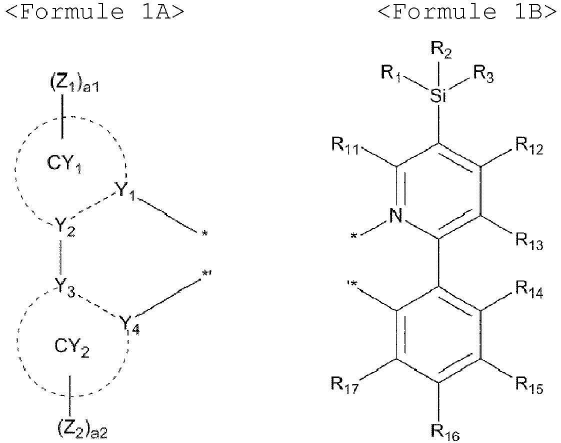 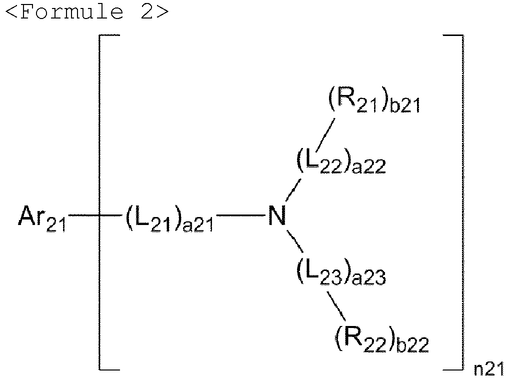 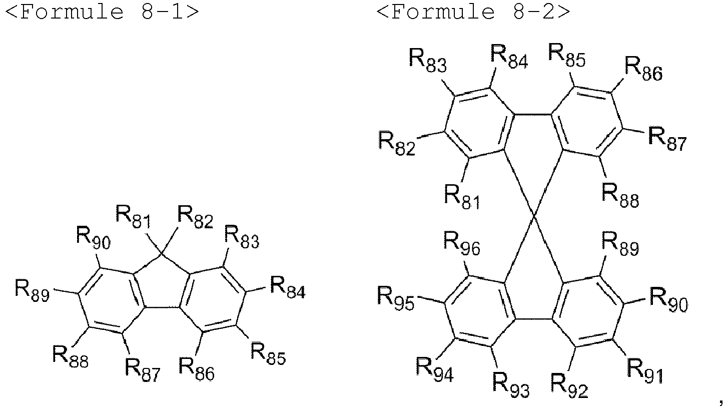
où, dans les formules 1, 1A, 1B, 2, 8-1 et 8-2,
M est choisi parmi l'iridium (Ir), le platine (Pt), l'osmium (Os), le titane (Ti), le zirconium (Zr), le hafnium (Hf), l'europium (Eu), le terbium (Tb), le thulium (Tm) et le rhodium (Rh) ;
L₁ est un ligand représenté par la formule 1A ;
L₂ est un ligand représenté par la formule 1B ;
L₁ et L₂ sont différents l'un de l'autre ;
chacun de n1 et n2 vaut indépendamment 1 ou 2, et la somme de n1 et n2 vaut 2 ou 3, et quand n1 vaut 2, deux des L₁ sont identiques ou différents, et quand n2 vaut 2, deux des L₂ sont identiques ou différents ;
chacun de Y₁ à Y₄ est indépendamment le carbone (C) ou l'azote (N), Y₁ et Y₂ sont liés l'un à l'autre via une liaison simple ou une double liaison, et Y₃ et Y₄ sont liés l'un à l'autre via une liaison simple ou une double liaison,
chacun de CY₁ et CY₂ est indépendamment choisi parmi un groupe cyclique en C₅ à C₆₀ et un groupe hétérocyclique en C₂ à C₆₀, et CY₁ et CY₂ sont éventuellement liés l'un à l'autre via une liaison simple ou un premier groupe de liaison,
chacun de R₁ à R₃ est indépendamment choisi parmi un groupe alkyle en C₁ à C₁₀ ; et
un groupe alkyle en C₁ à C₁₀ substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, et un acide phosphorique ou un sel de celui-ci ;
chacun de Z₁, Z₂ et R₁₁ à R₁₇ est indépendamment choisi parmi l'hydrogène, le deutérium, un groupe hydroxyle, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅) et -B(Q₆)(Q₇), sous réserve que R₁₂ ne soit pas l'hydrogène, et deux substituants voisins choisis parmi R₁₄ à R₁₇ sont éventuellement liés l'un à l'autre pour former un cycle condensé ;
chacun de a1 et a2 est indépendamment un entier de 1 à 5, quand a1 vaut 2 ou plus, une pluralité de Z₁ sont identiques ou différents, et quand a2 vaut 2 ou plus, une pluralité de Z₂ sont identiques ou différents,
chacun de * et *' indique un site de liaison à M dans la formule 1 ;
Ar₂₁ est représenté par l'une des formules 8-1 et 8-2 ; chacun de L₂₁ à L₂₃ est indépendamment choisi parmi un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocycloalcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique condensé non aromatique divalent substitué ou non substitué, et un groupe hétéropolycyclique condensé non aromatique divalent substitué ou non substitué ;
chacun de a21 à a23 est indépendamment choisi parmi 0, 1, 2 et 3 ;
chacun de R₂₁ et R₂₂ est indépendamment choisi parmi un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe hétéroaryle en C₁ à C₆₀ substitué ou non substitué, un groupe polycyclique condensé non aromatique monovalent substitué ou non substitué, et un groupe hétéropolycyclique condensé non aromatique monovalent substitué ou non substitué ;
chacun de b21 et b22 est indépendamment choisi parmi 1, 2 et 3 ;
chacun de R₈₁ à R₉₆ est indépendamment choisi parmi 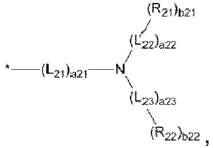 l'hydrogène, le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique condensé non aromatique monovalent substitué ou non substitué, et un groupe hétéropolycyclique condensé non aromatique monovalent substitué ou non substitué ;
n21 est choisi parmi 1, 2, 3 et 4 et, quand n21 vaut 2 ou plus, une pluralité de 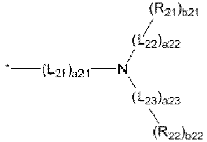 sont identiques ou différents ; et
au moins l'un des substituants du groupe cycloalkylène en C₃ à C₁₀ substitué, du groupe hétérocycloalkylène en C₁ à C₁₀ substitué, du groupe cycloalcénylène en C₃ à C₁₀ substitué, du groupe hétérocycloalcénylène en C₁ à C₁₀ substitué, du groupe arylène en C₆ à C₆₀ substitué, du groupe hétéroarylène en C₁ à C₆₀ substitué, du groupe polycyclique condensé non aromatique divalent substitué, du groupe hétéropolycyclique condensé non aromatique divalent substitué, du groupe alkyle en C₁ à C₆₀ substitué, du groupe alcényle en C₂ à C₆₀ substitué, du groupe alcynyle en C₂ à C₆₀ substitué, du groupe alkoxy en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe aryloxy en C₆ à C₆₀ substitué, du groupe arylthio en C₆ à C₆₀ substitué, du groupe hétéroaryle en C₁ à C₆₀ substitué, du groupe polycyclique condensé non aromatique monovalent substitué, et du groupe hétéropolycyclique condensé non aromatique monovalent substitué est choisi parmi
le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₆₀, un groupe alcényle en C₂ à C₆₀, un groupe alcynyle en C₂ à C₆₀ ; et un groupe alkoxy en C₁ à C₆₀ ;
un groupe alkyle en C₁ à C₆₀, un groupe alcényle en C₂ à C₆₀, un groupe alcynyle en C₂ à C₆₀, et un groupe alkoxy en C₁ à C₆₀, chacun substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅) et -B(Q₁₆)(Q₁₇) ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent, chacun substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui, un acide phosphorique ou un sel de celui-ci, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅) et -B (Q₂₆)(Q₂₇) ; et -N(Q₃₁)(Q₃₂), -Si(Q₃₃)(Q₃₄)(Q₃₅), et -B(Q₃₆)(Q₃₇),
où chacun de Q₁ à Q₇, Q₁₁ à Q₁₇, Q₂₁ à Q₂₇, et Q₃₁ à Q₃₇ est indépendamment choisi parmi l'hydrogène, le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent.

2. Dispositif électroluminescent organique selon la revendication 1, dans lequel M est Ir.

3. Dispositif électroluminescent organique selon la revendication 1, dans lequel Y₁ est N, et chacun de Y₂ à Y₄ est C.

4. Dispositif électroluminescent organique selon la revendication 1, dans lequel :
CY₁ est choisi parmi un pyrrole, un imidazole, un pyrazole, un triazole, une pyridine, une pyrimidine, une pyrazine, une triazine, une quinoline, une isoquinoline, et un oxadiazole ; et
CY₂ est choisi parmi un benzène, un naphtalène, un fluorène, un carbazole, un furane, un thiophène, un benzofurane, un benzothiophène, un dibenzofurane, un dibenzothiophène, un indole, une pyridine, une pyrimidine, une pyrazine, un oxadiazole, et une triazine.

5. Dispositif électroluminescent organique selon la revendication 1, dans lequel chacun de R₁ à R₃ est indépendamment choisi parmi :
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, et un groupe tert-décyle ; et
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, et un groupe tert-décyle, chacun substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, et un acide phosphorique ou un sel de celui-ci.

6. Dispositif électroluminescent organique selon la revendication 1, dans lequel chacun de R₁ à R₃ est indépendamment choisi parmi un groupe méthyle, un groupe éthyle, un groupe n-propyle, un groupe isopropyle, un groupe n-butyle, un groupe isobutyle, un groupe sec-butyle, et un groupe tert-butyle.

7. Dispositif électroluminescent organique selon la revendication 1, dans lequel R₁ à R₃ sont identiques.

8. Dispositif électroluminescent organique selon la revendication 1, dans lequel chacun de Z₁, Z₂ et R₁₁ à R₁₇ est indépendamment choisi parmi :
l'hydrogène, le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, -SF₅, un groupe alkyle en C₁ à C₂₀, et un groupe alkoxy en C₁ à C₂₀ ;
un groupe alkyle en C₁ à C₂₀ et un groupe alkoxy en C₁ à C₂₀, chacun substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe phényle, un groupe naphtyle, un groupe pyridinyle, et un groupe pyrimidinyle ;
un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ; et
un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₂₀, un groupe alkoxy en C₁ à C₂₀, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle,
sous réserve que R₁₂ ne soit pas l'hydrogène.

9. Dispositif électroluminescent organique selon la revendication 1, dans lequel chacun de Z₁, Z₂ et R₁₁ à R₁₇ est indépendamment choisi parmi :
l'hydrogène, -F, un groupe cyano, un groupe nitro, -SF₅, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe phényle, un groupe naphtyle, un groupe pyridinyle, et un groupe pyrimidinyle ; et
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe phényle, un groupe naphtyle, un groupe pyridinyle, et un groupe pyrimidinyle, chacun substitué par au moins l'un choisi parmi -F, un groupe cyano, et un groupe nitro,
sous réserve que R₁₂ ne soit pas l'hydrogène.

10. Dispositif électroluminescent organique selon la revendication 1, dans lequel le composé organométallique est choisi parmi les composés PD-1 à PD-79 et PD-81 à PD-192 :

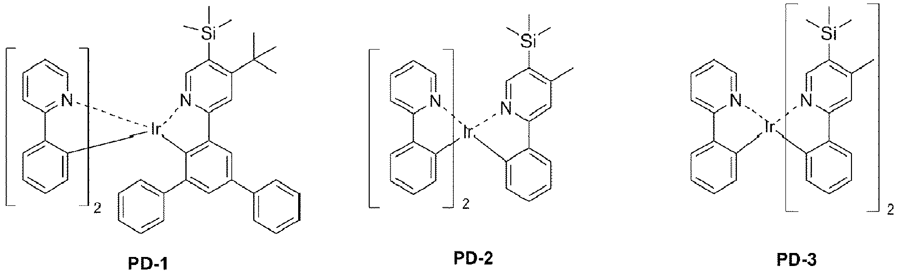

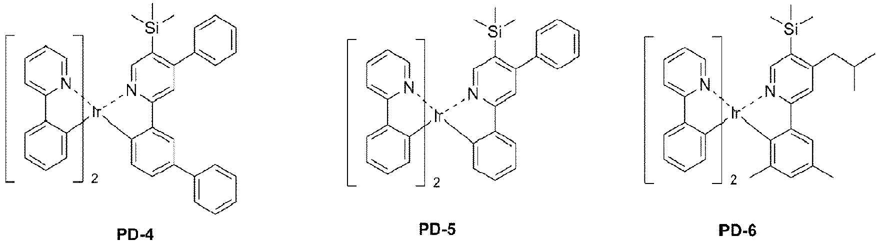

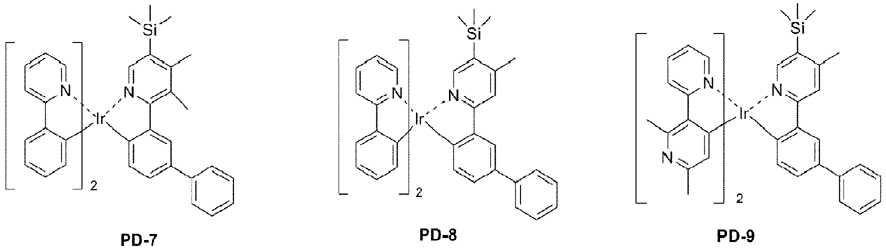

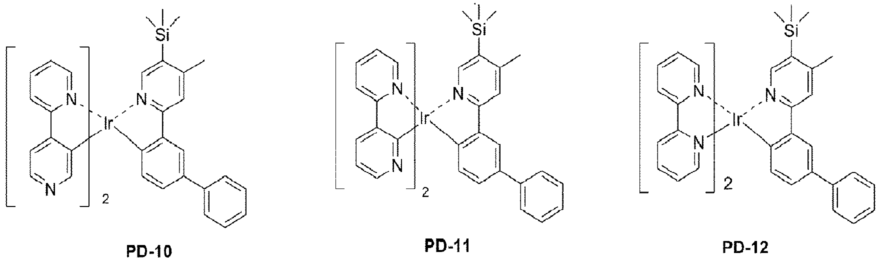

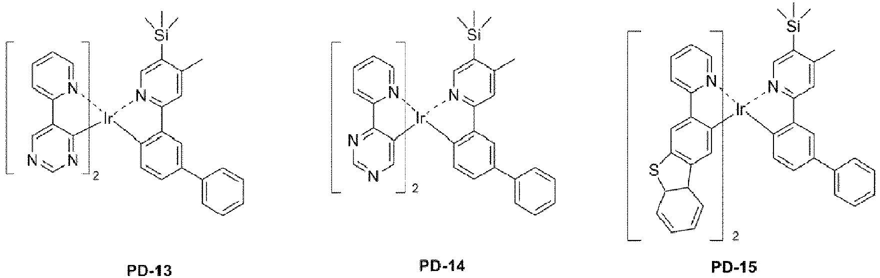

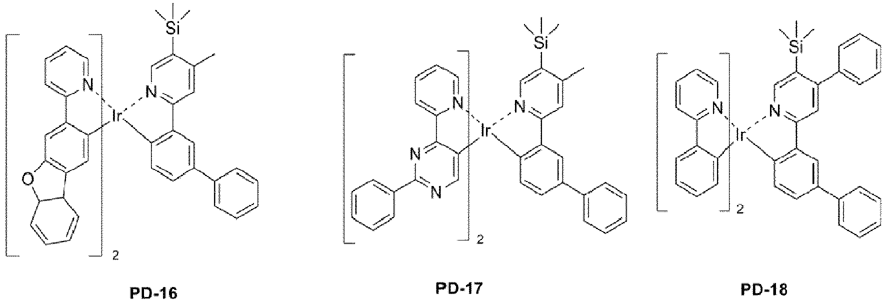

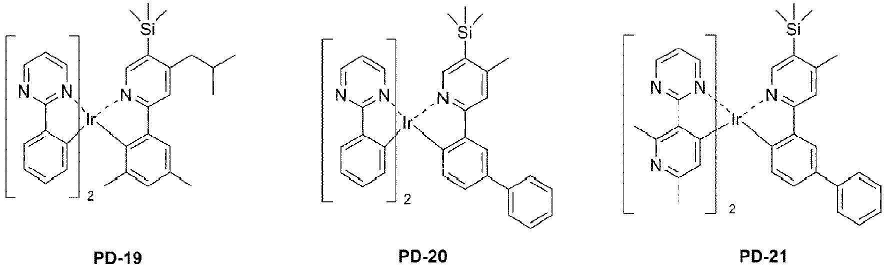

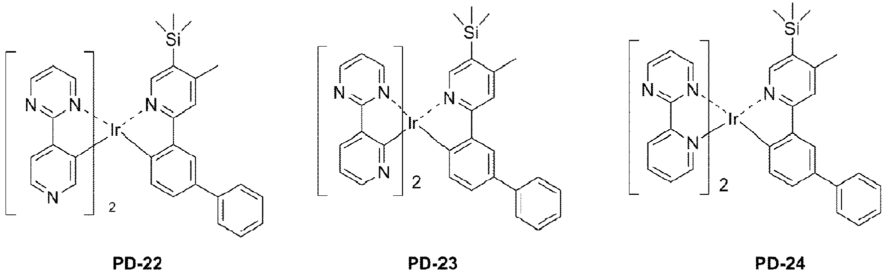

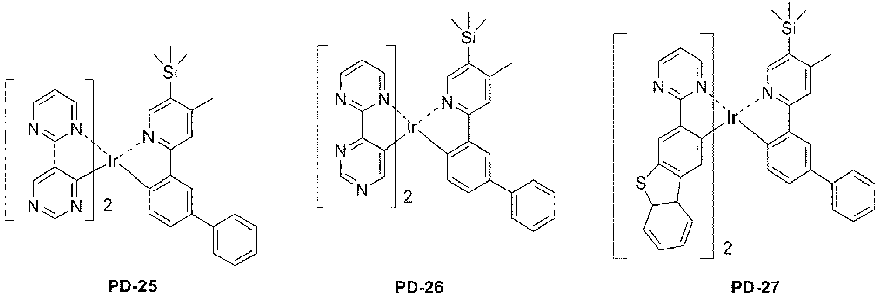

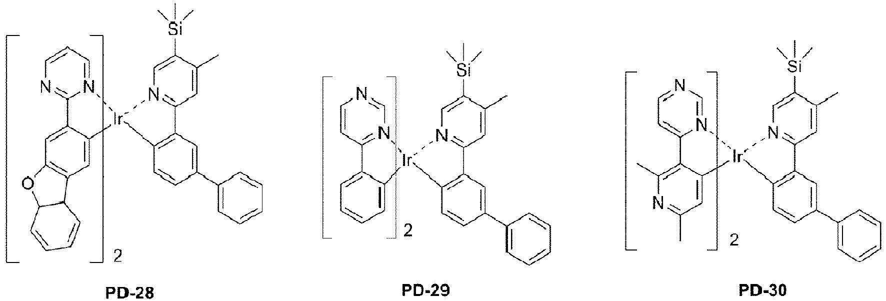

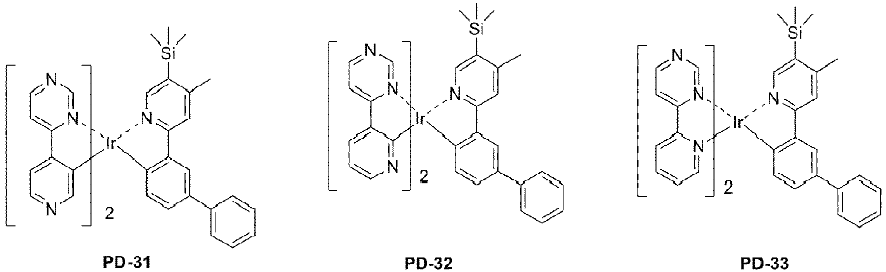

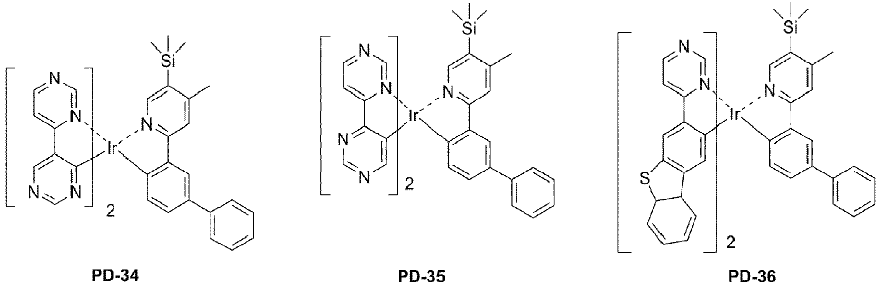

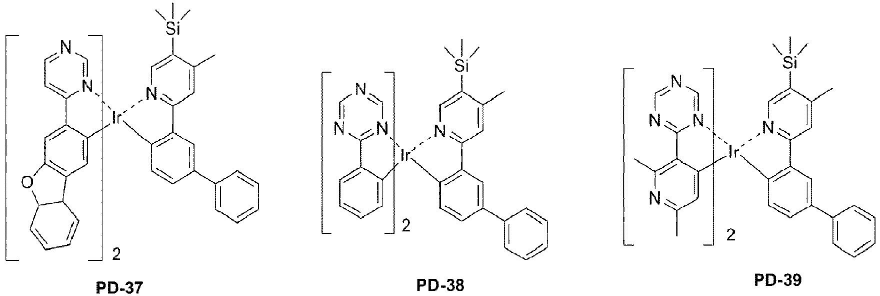

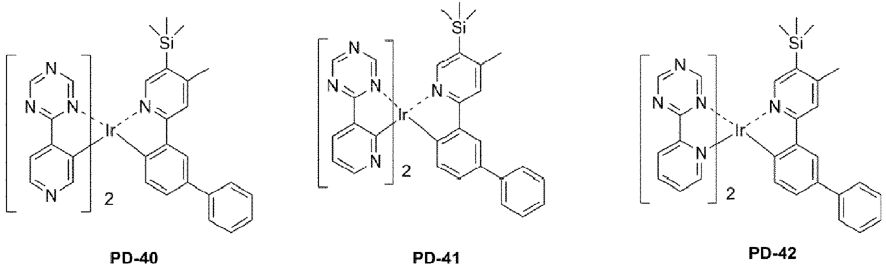

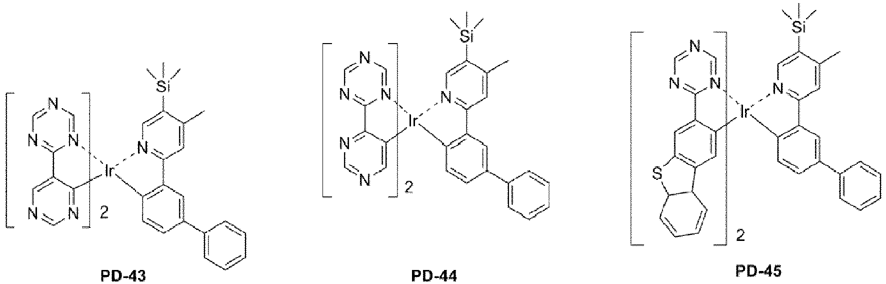

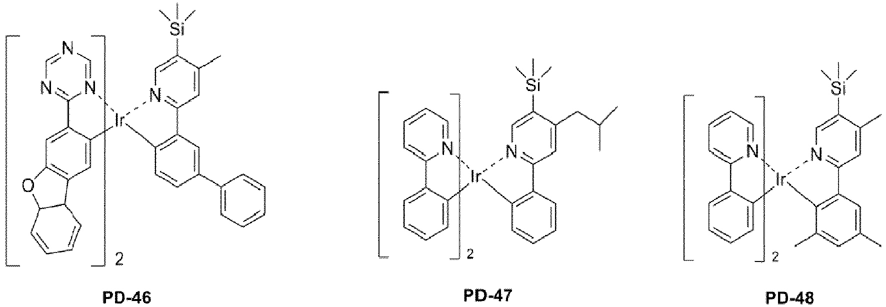

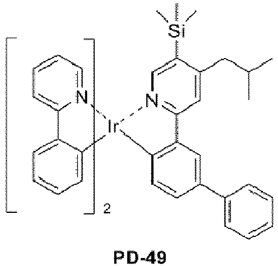

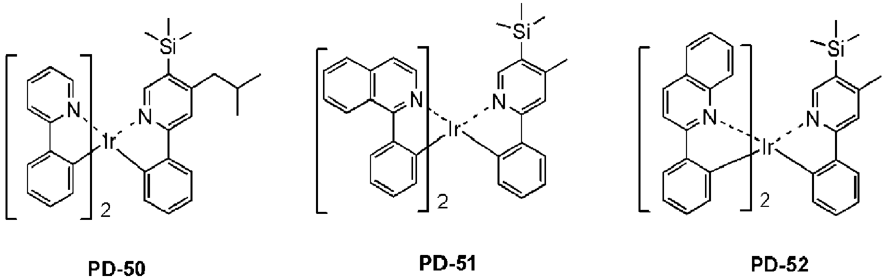

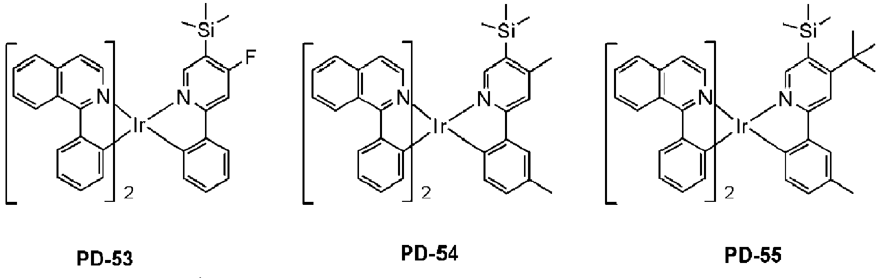

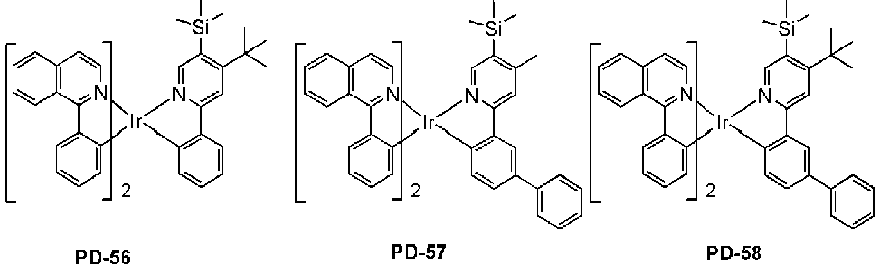

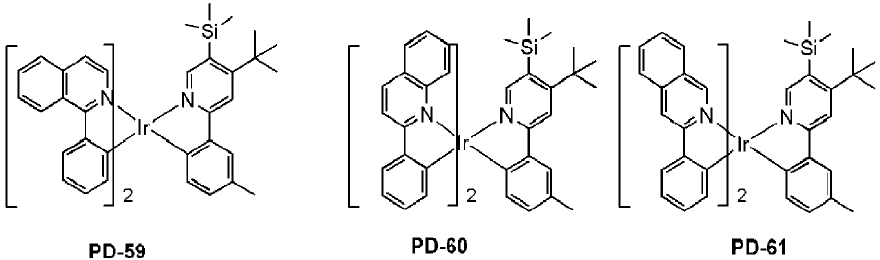

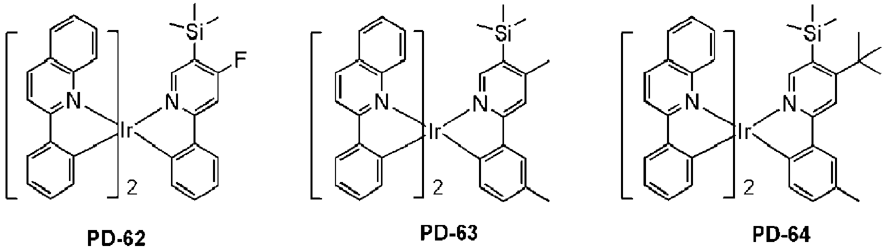

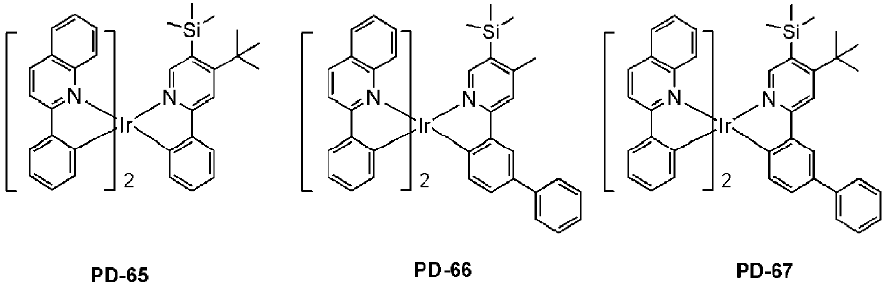

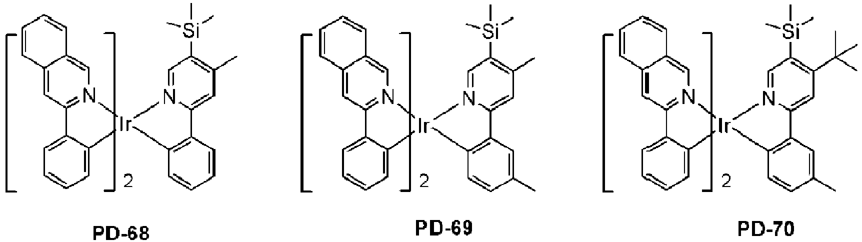

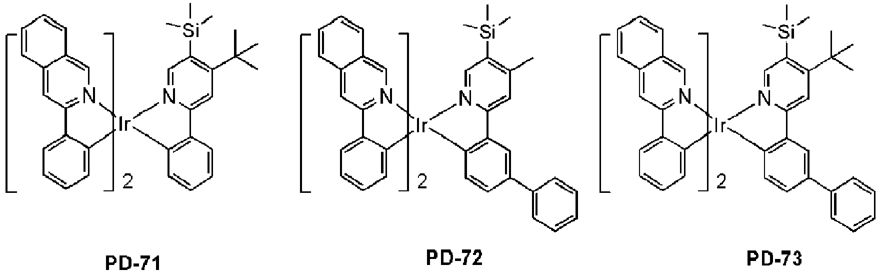

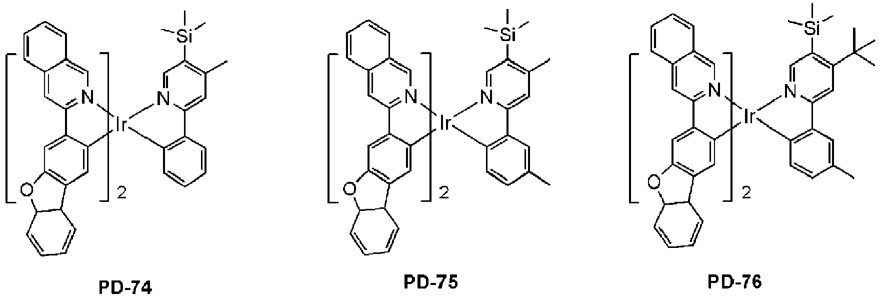

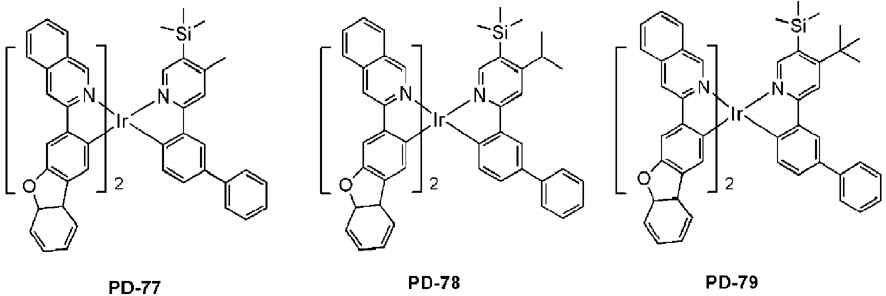

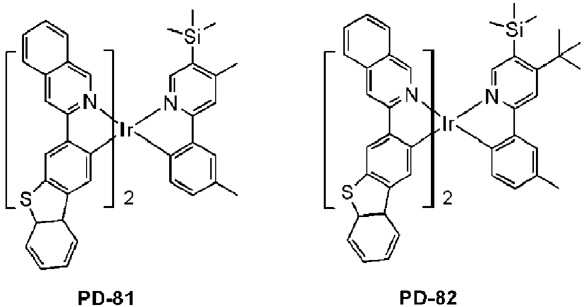

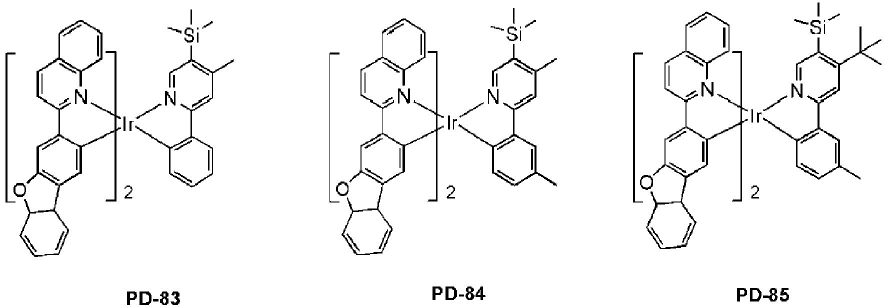

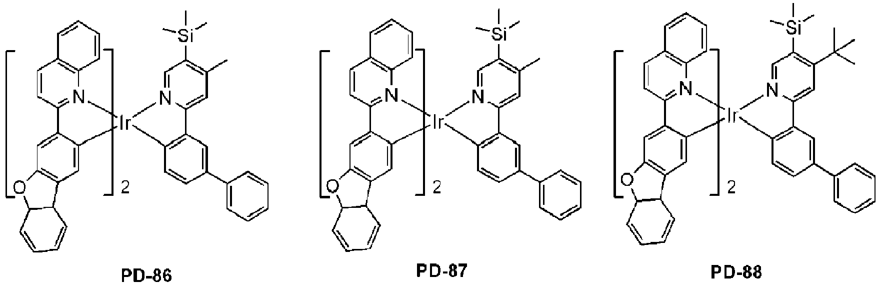

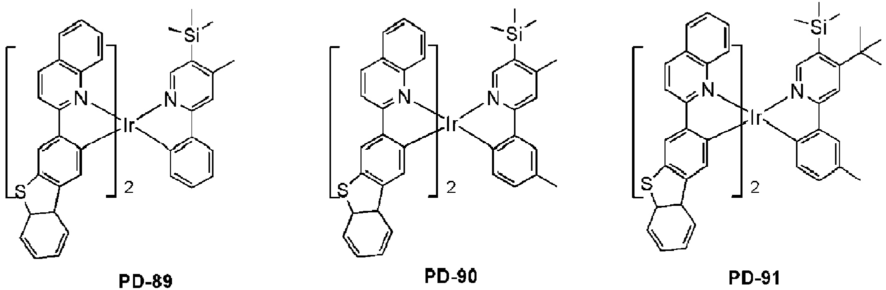

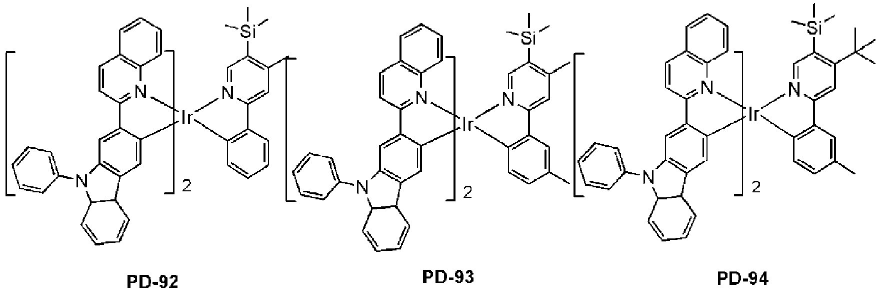

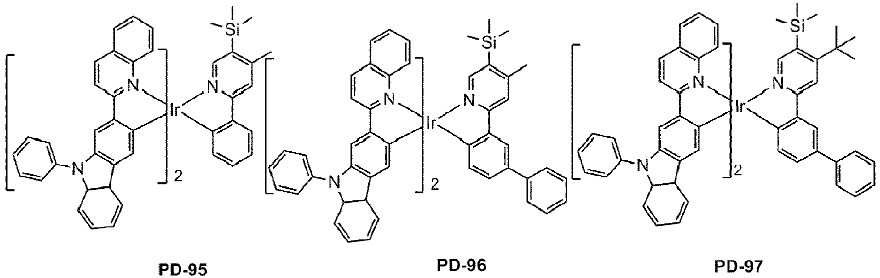

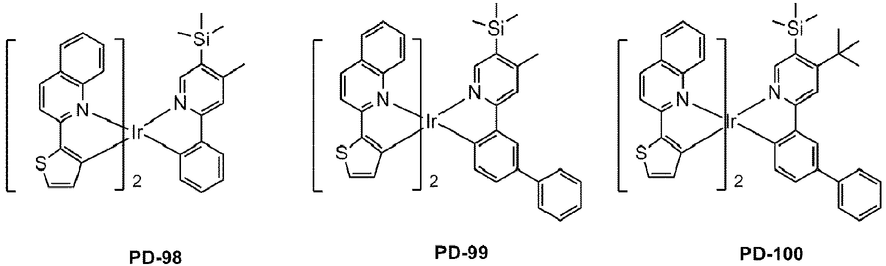

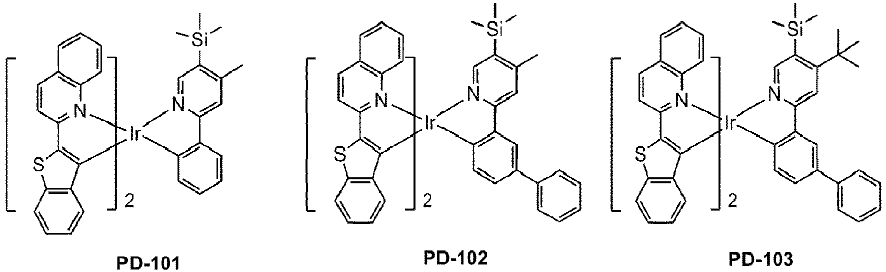

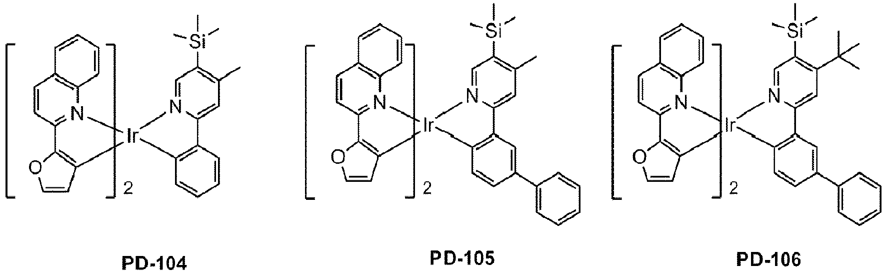

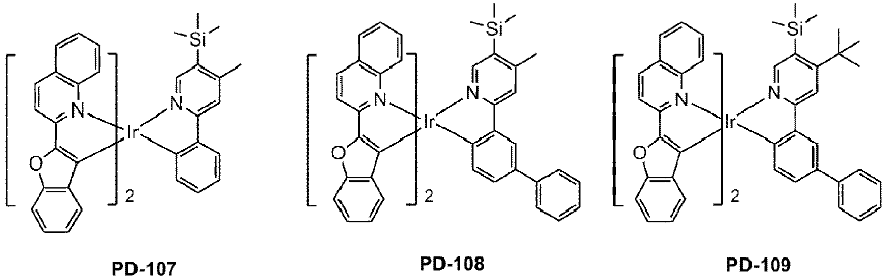

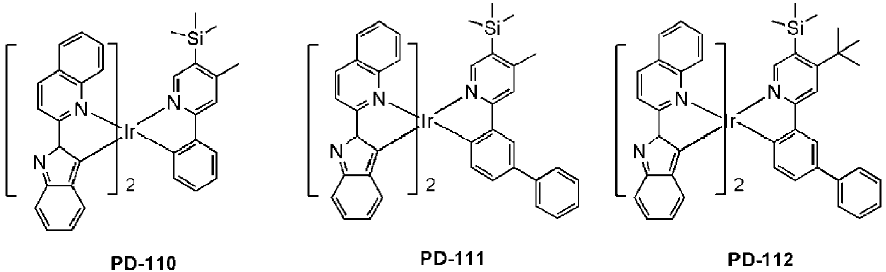

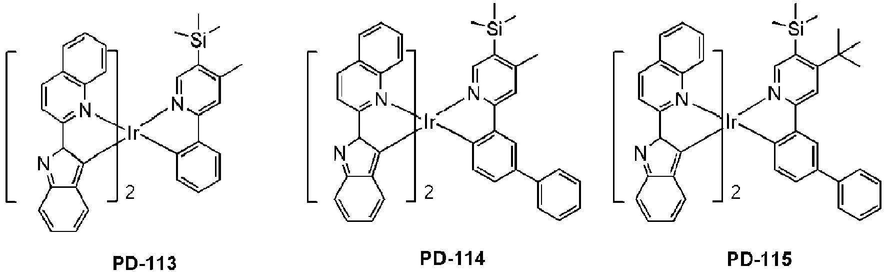

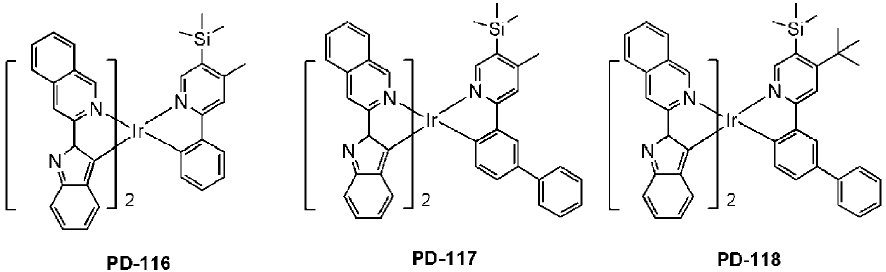

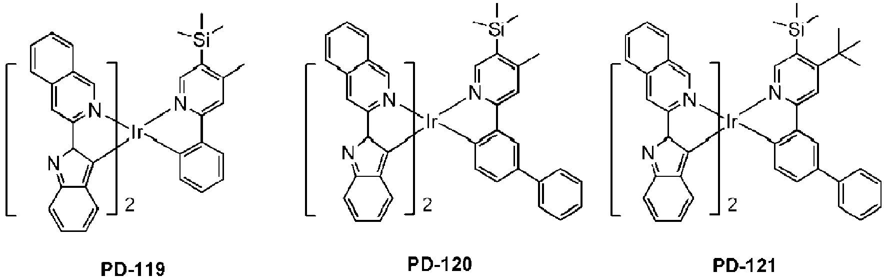

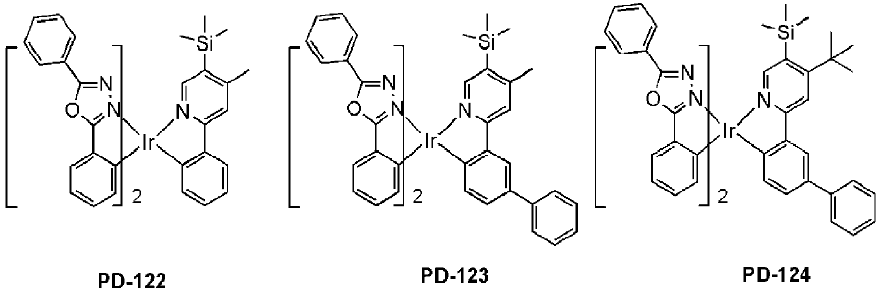

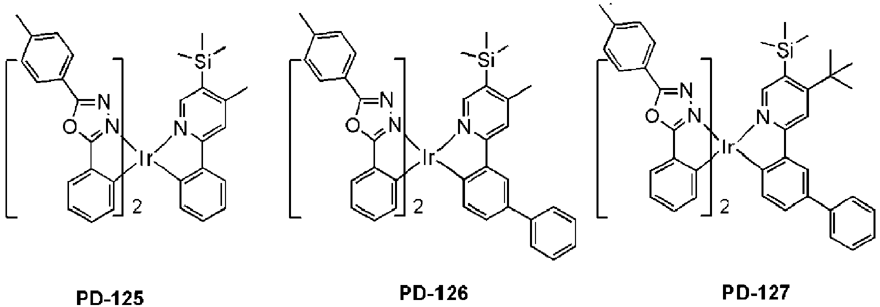

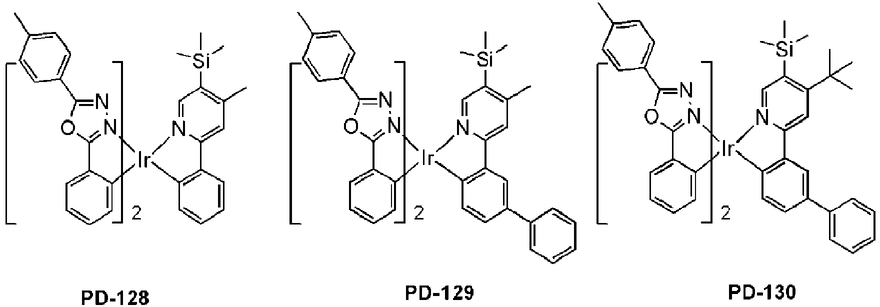

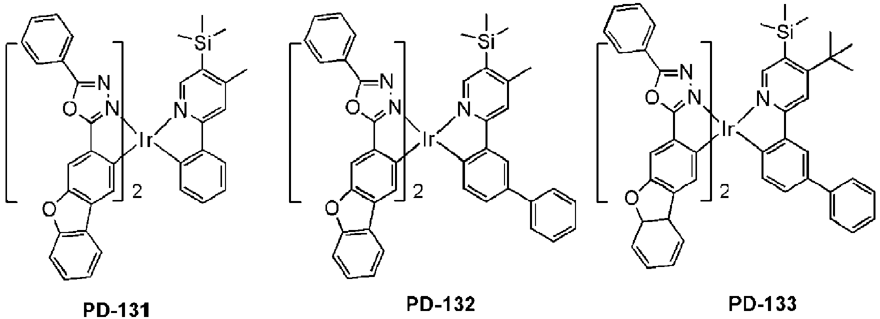

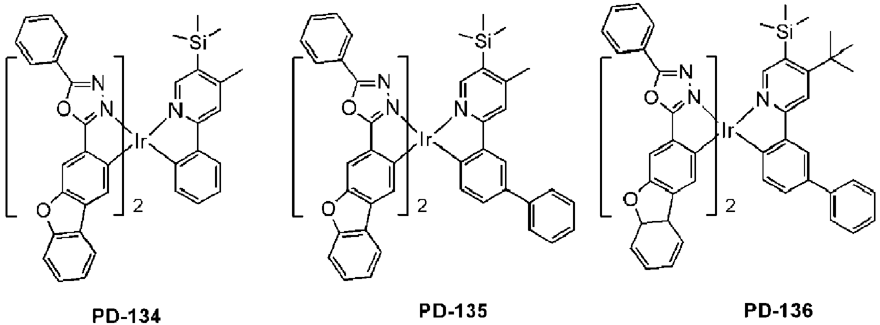

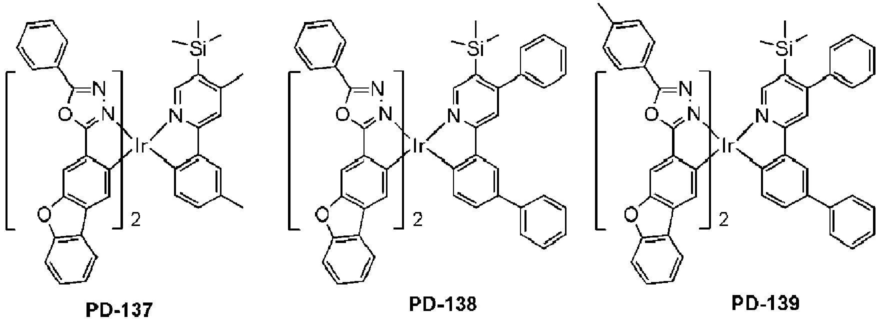

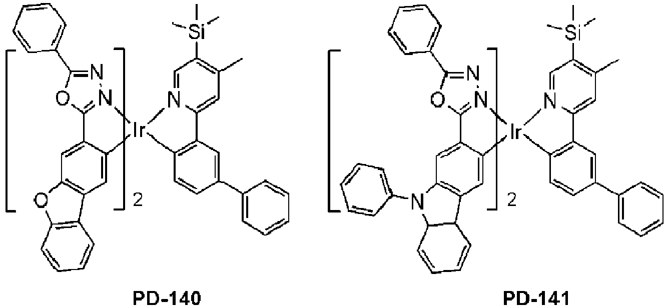

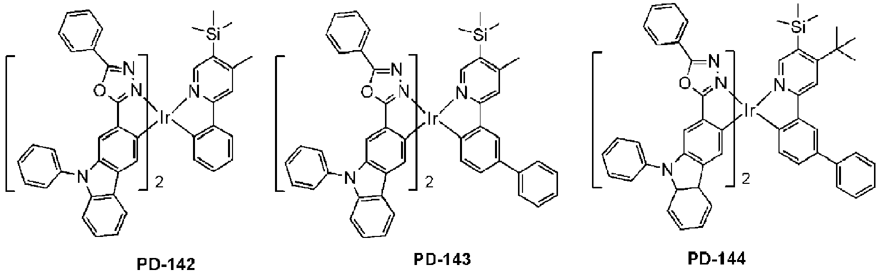

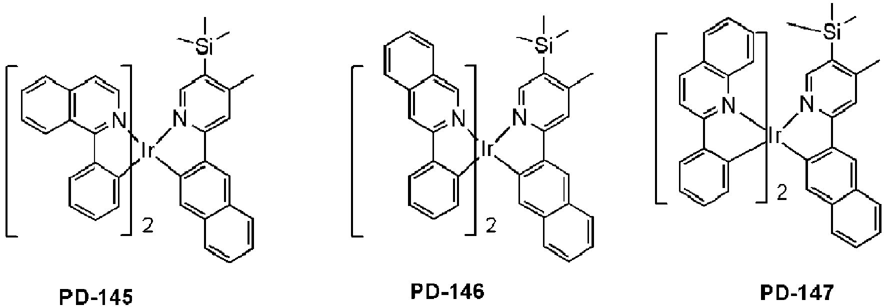

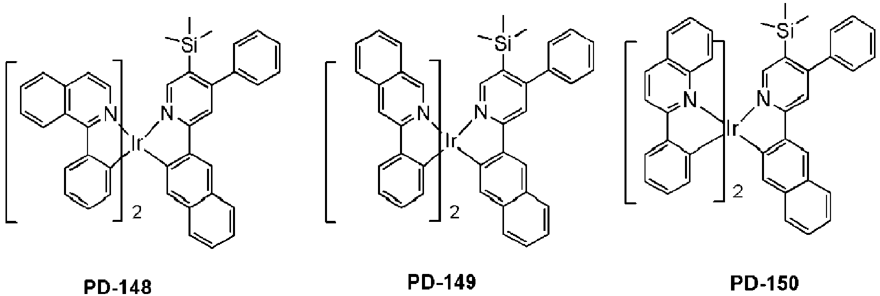

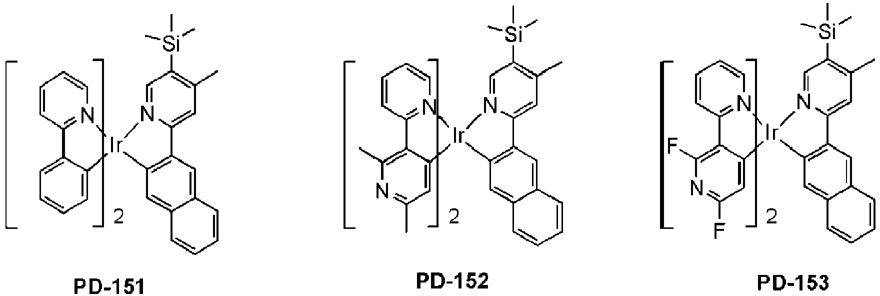

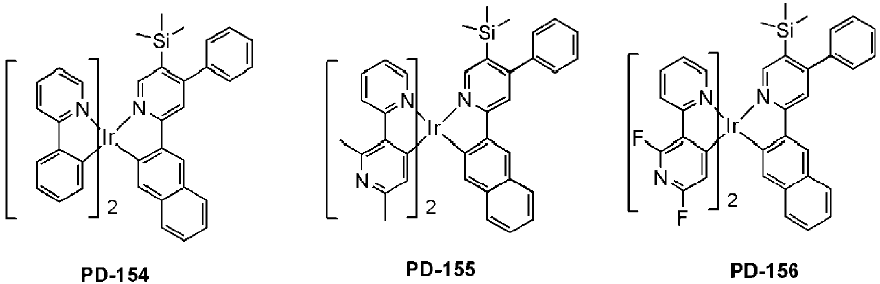

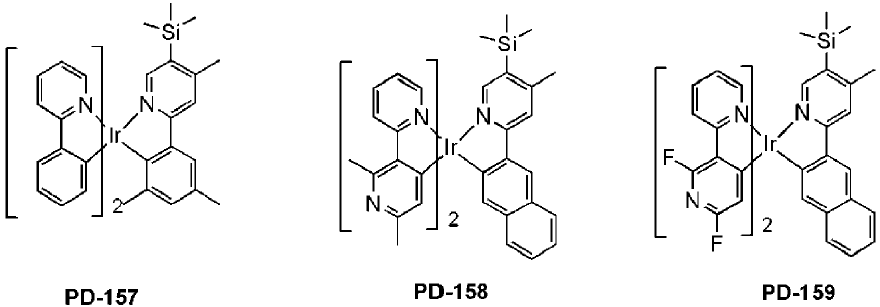

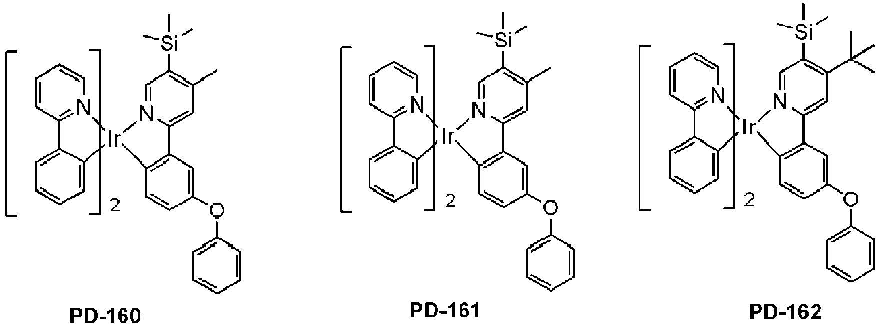

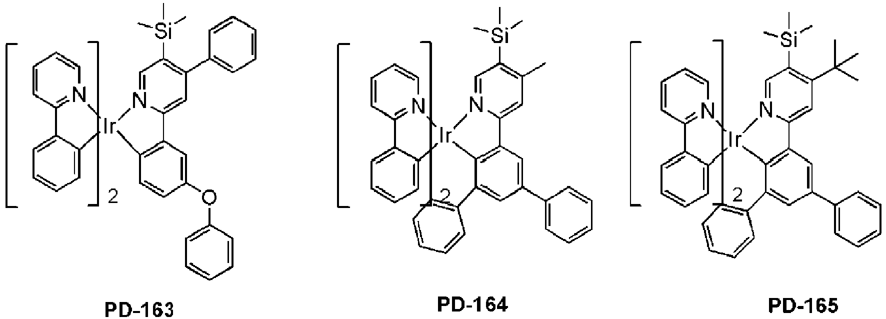

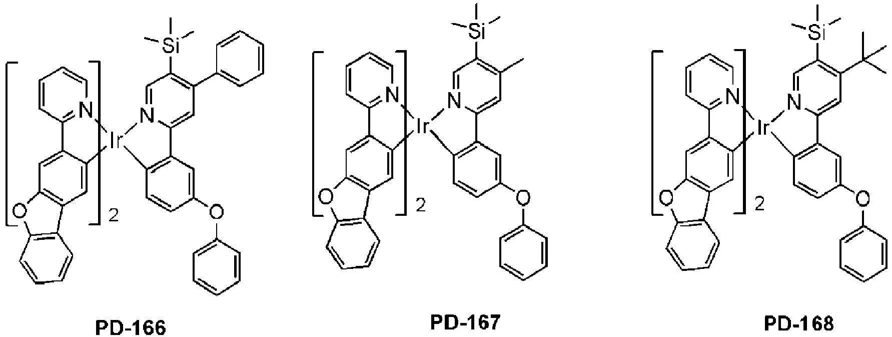

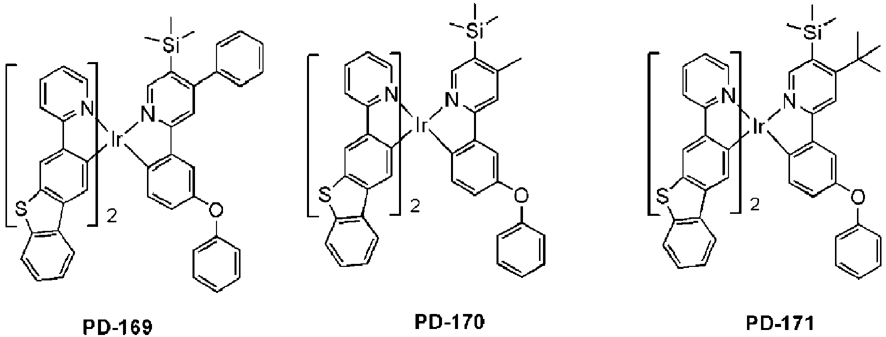

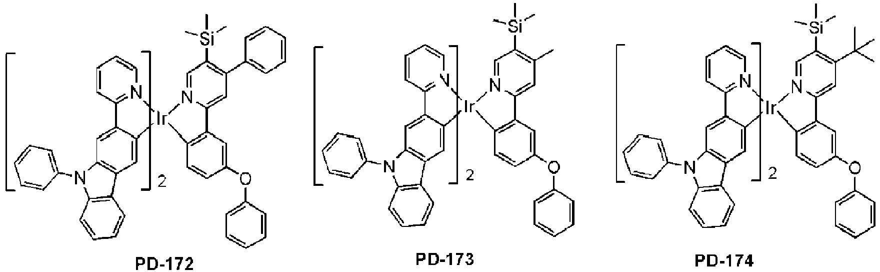

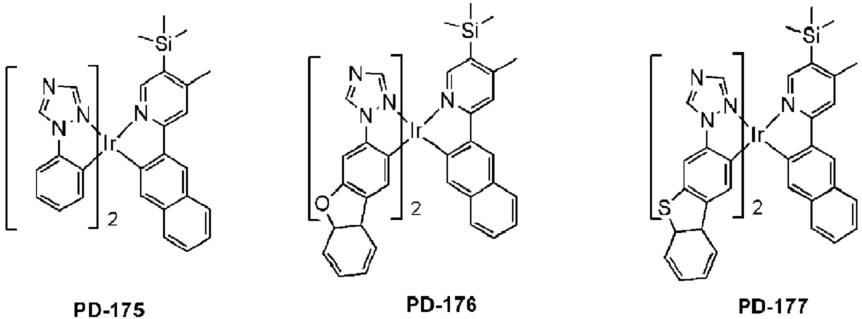

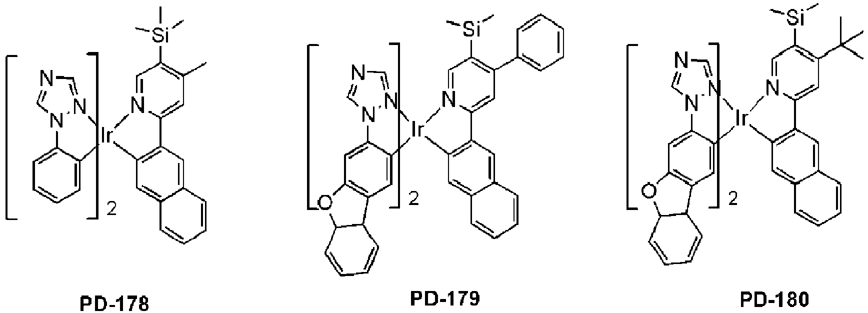

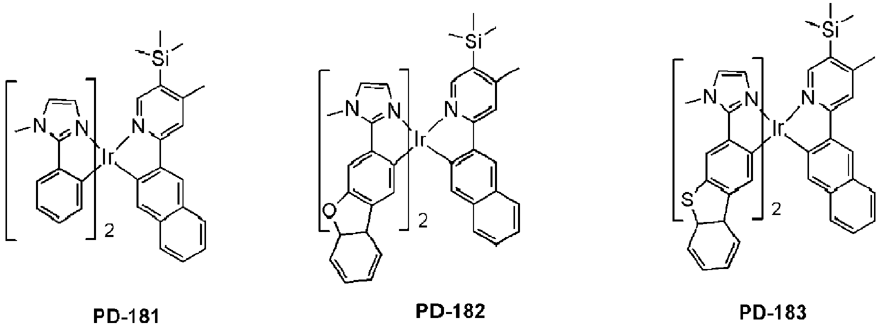

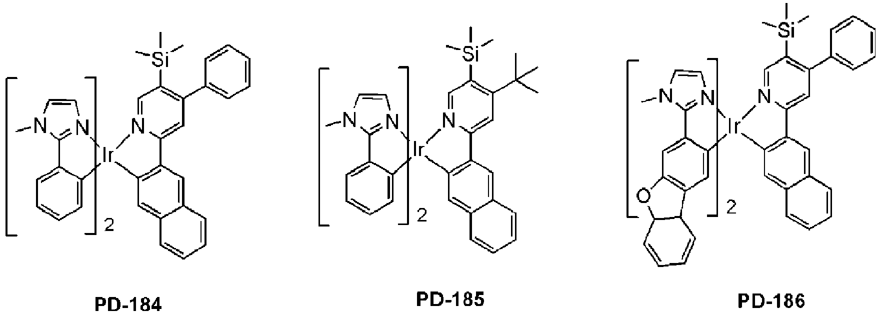

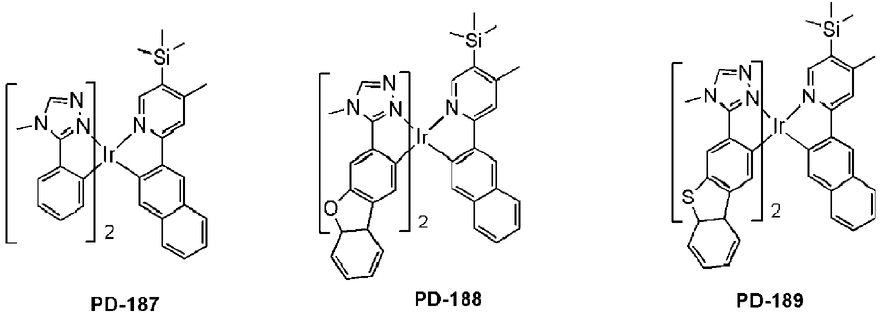

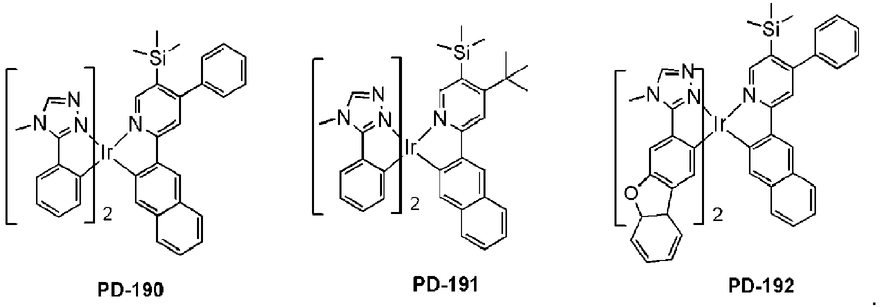

11. Dispositif électroluminescent organique selon la revendication 1, dans lequel chacun de L₂₁ à L₂₃ est indépendamment choisi parmi :
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe benzocarbazolylène, et un groupe dibenzocarbazolylène ; et
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe benzocarbazolylène, et un groupe dibenzocarbazolylène, chacun substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle, et un groupe imidazopyridinyle.

12. Dispositif électroluminescent organique selon la revendication 1, dans lequel chacun de L₂₁ à L₂₃ est indépendamment représenté par l'une des formules 3-1 à 3-21 : 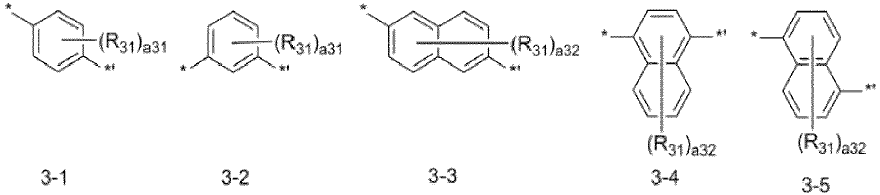 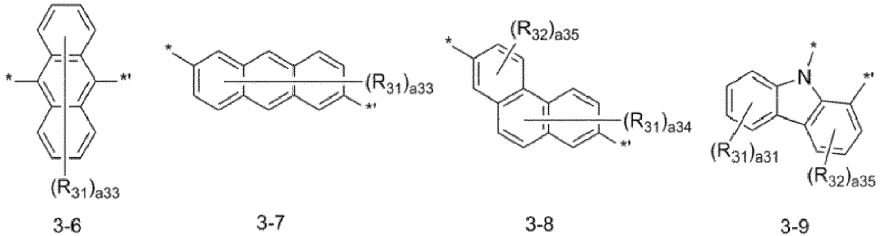 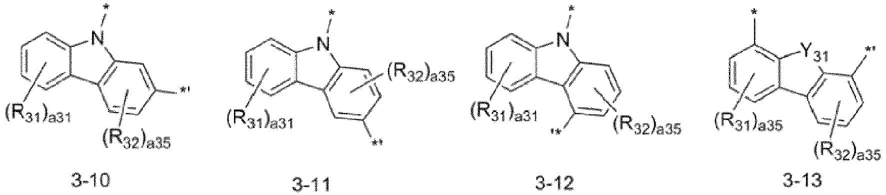 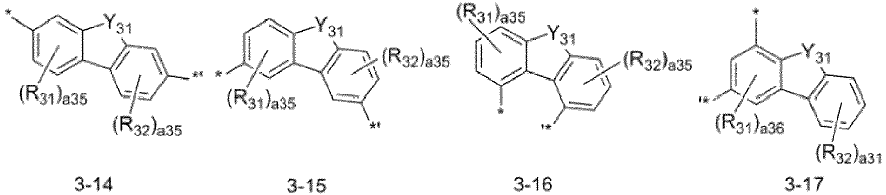 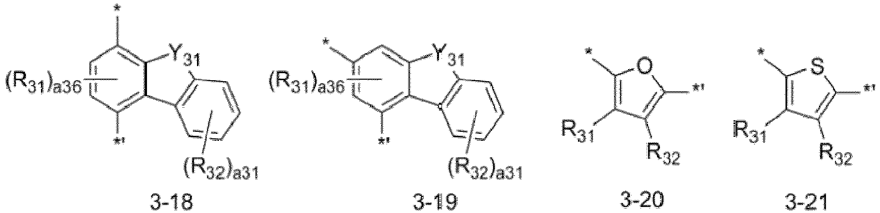 où, dans les formules 3-1 à 3-21,
Y₃₁ est choisi parmi C(R₃₃)(R₃₄), N(R₃₃), O, S, et Si(R₃₃)(R₃₄) ;
chacun de R₃₁ à R₃₄ est indépendamment choisi parmi l'hydrogène, le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₂₀, un groupe alkoxy en C₁ à C₂₀, un groupe phényle, un groupe naphtyle, un groupe fluorényle, un groupe spiro-fluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle ;
a31 est choisi parmi 1, 2, 3 et 4 ;
a32 est choisi parmi 1, 2, 3, 4, 5 et 6 ;
a33 est choisi parmi 1, 2, 3, 4, 5, 6, 7 et 8 ;
a34 est choisi parmi 1, 2, 3, 4 et 5 ;
a35 est choisi parmi 1, 2 et 3 ;
a36 est choisi parmi 1 et 2 ; et
chacun de * et *' indique un site de liaison à un site voisin.

13. Dispositif électroluminescent organique selon la revendication 1, dans lequel chacun de R₂₁ et R₂₂ est indépendamment choisi parmi :
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe thiadiazolyle, un groupe imidazopyridinyle, et un groupe imidazo-pyrimidinyle ; et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe thiadiazolyle, un groupe imidazopyridinyle, et un groupe imidazopyrimidinyle, chacun substitué par au moins l'un choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₂₀, un groupe alkoxy en C₁ à C₂₀, un groupe phényle, un groupe biphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle, un groupe imidazopyridinyle, et un groupe imidazopyrimidinyle.

14. Dispositif électroluminescent organique selon la revendication 1, dans lequel chacun de R₂₁ et R₂₂ est indépendamment choisi parmi les groupes représentés par les formules 5-1 à 5-14 : 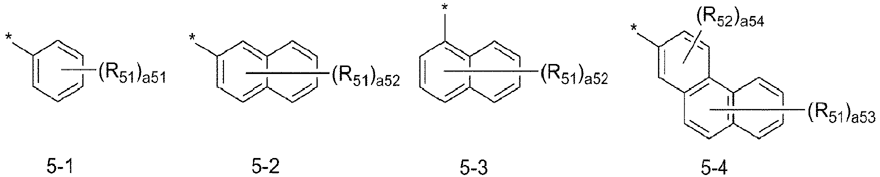 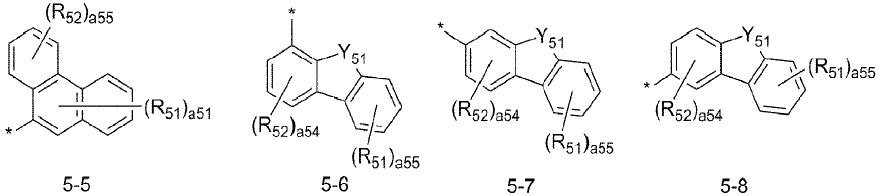 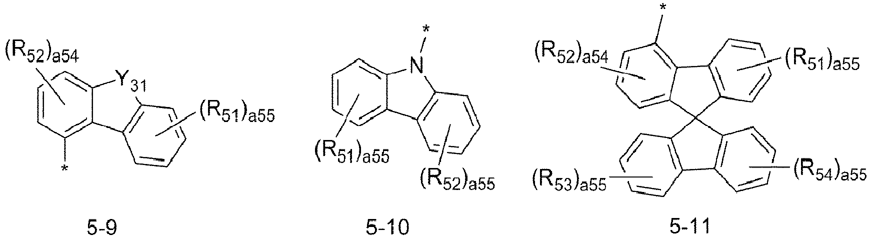 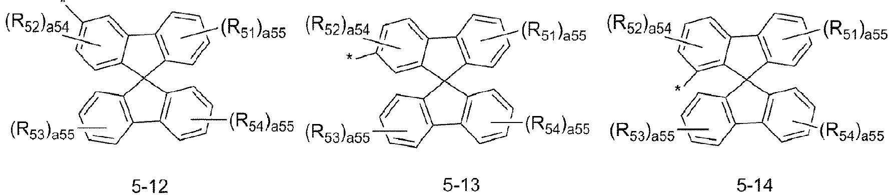 où, dans les formules 5-1 à 5-14,
Y₅₁ est choisi parmi C(R₅₃)(R₅₄), N(R₅₃), O et S ;
chacun de R₅₁ à R₅₄ est indépendamment choisi parmi l'hydrogène, le deutérium, -F, -Cl, -Br, -I, un groupe hydroxyle, un groupe cyano, un groupe nitro, un groupe amino, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₂₀, -CD₃, -CF₃, un groupe alkoxy en C₁ à C₂₀, un groupe phényle, un groupe naphtyle, un groupe fluorényle, un groupe spiro-fluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle ;
a51 est choisi parmi 1, 2, 3, 4 et 5 ;
a52 est choisi parmi 1, 2, 3, 4, 5, 6 et 7 ;
a53 est choisi parmi 1, 2, 3, 4, 5 et 6 ;
a54 est choisi parmi 1, 2 et 3 ;
a55 est choisi parmi 1, 2, 3 et 4 ; et
* indique un site de liaison à un site voisin.

15. Dispositif électroluminescent organique selon la revendication 1, dans lequel chacun de R₂₁ et R₂₂ est indépendamment choisi parmi les groupes représentés par les formules 6-1 à 6-55 : 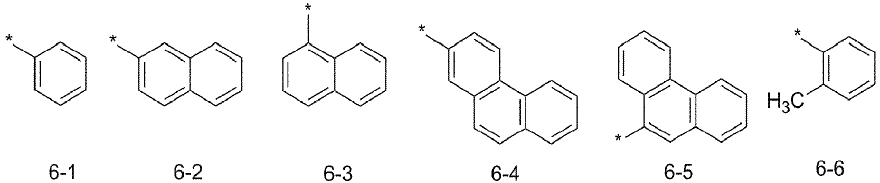 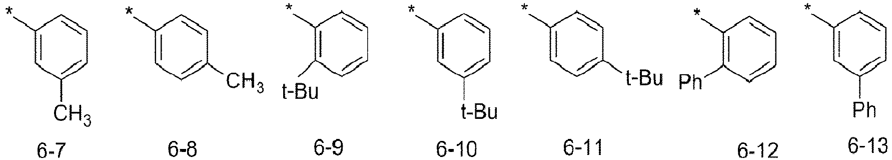 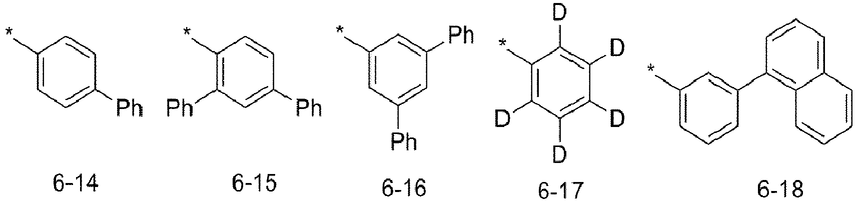 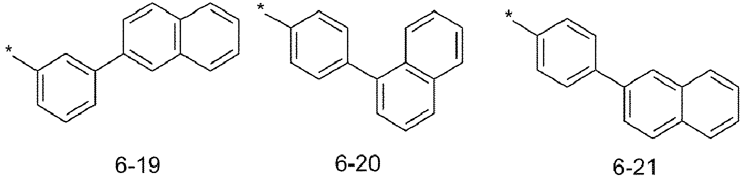 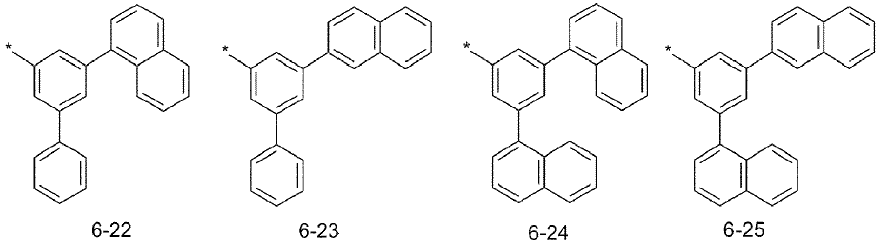 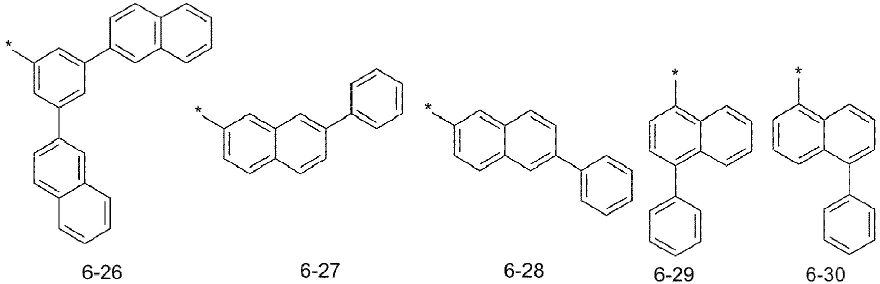 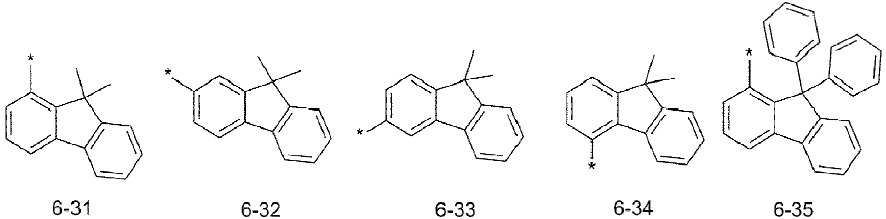 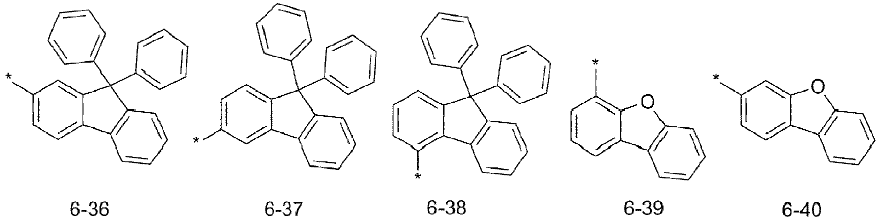 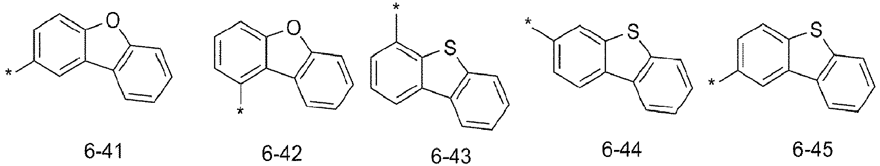 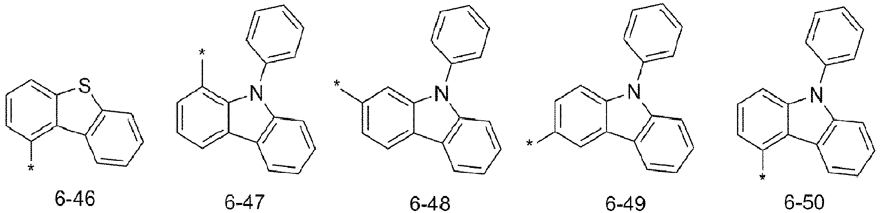 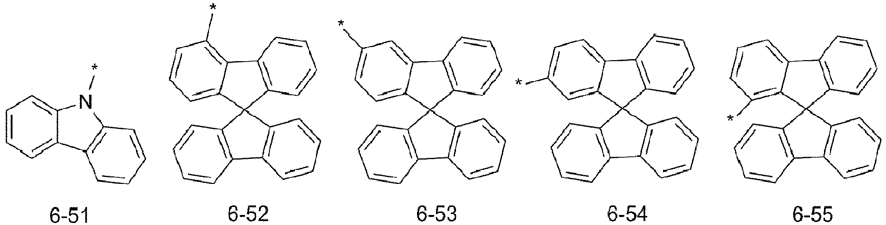 où, dans les formules 6-1 à 6-55, * indique un site de liaison à un site voisin.

16. Dispositif électroluminescent organique selon la revendication 1, dans lequel chacun de R₈₁ à R₉₆ est indépendamment choisi parmi 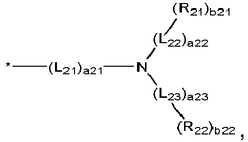 l'hydrogène, les groupes représentés par les formules 6-1 à 6-3 et les groupes représentés par les formules 6-31 à 6-55 : 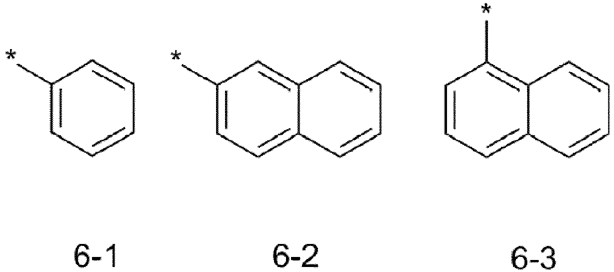 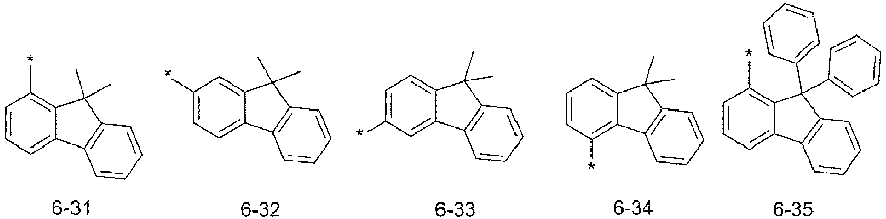 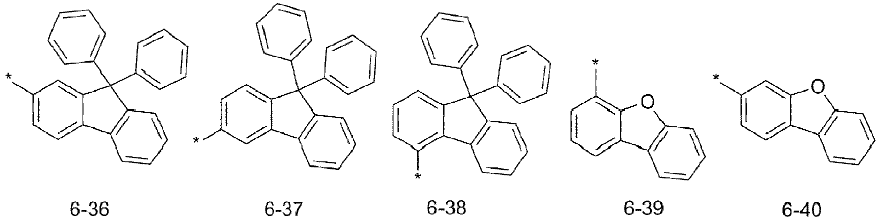 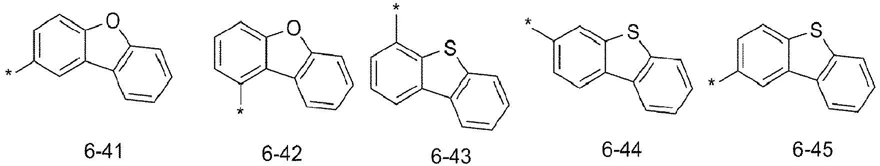 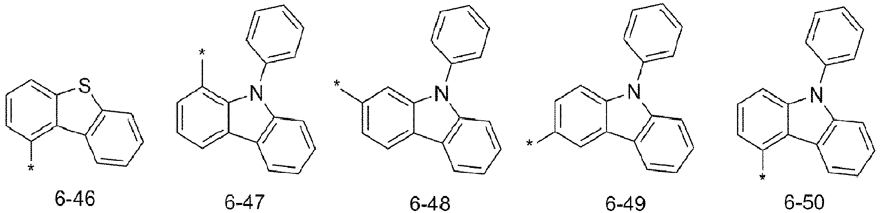 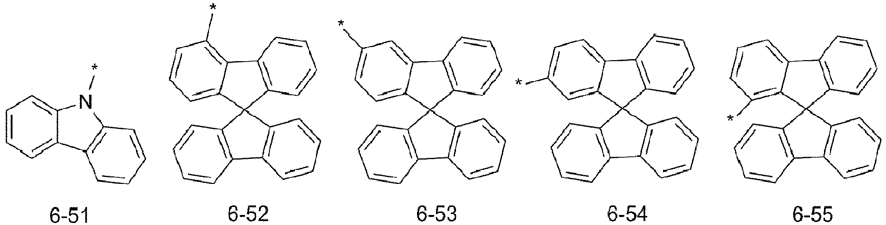 où, dans les formules 6-1 à 6-3 et les formules 6-31 à 6-55, * indique un site de liaison à un site voisin.

17. Dispositif électroluminescent organique selon la revendication 1, dans lequel le composé à base d'amine est représenté par l'une des formules 2-1 à 2-6 : 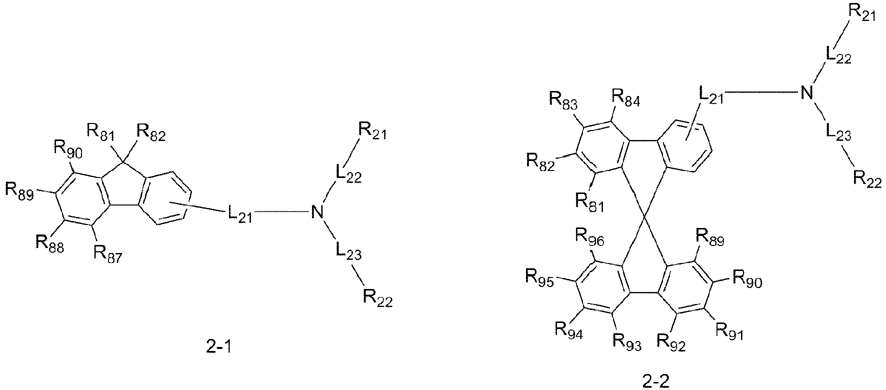 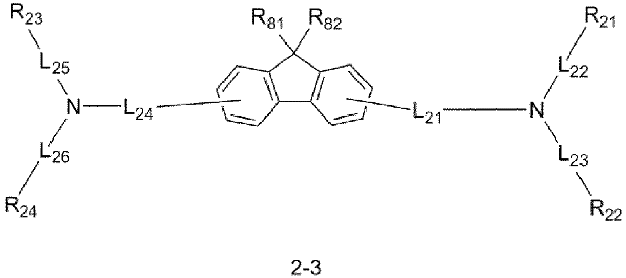 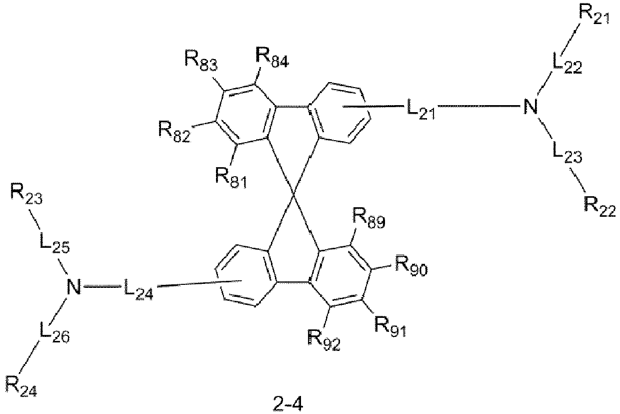 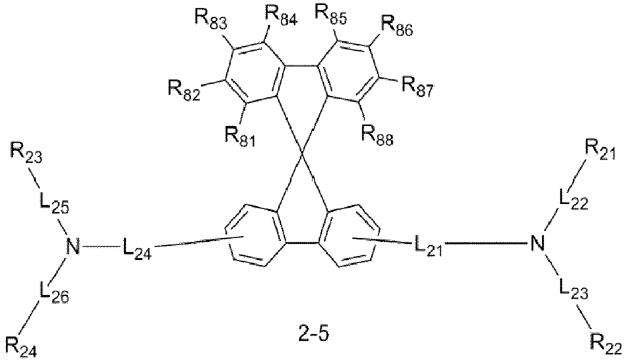 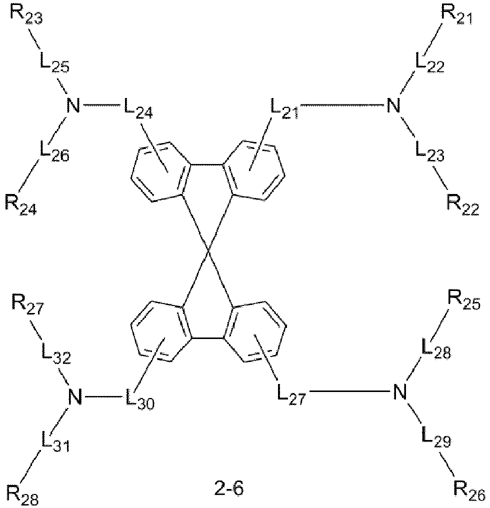 où, dans les formules 2-1 à 2-6,
L₂₁ à L₂₃, R₂₁, R₂₂, et R₈₁ à R₉₆ sont tels que décrits dans la revendication 1 ;
chacun de L₂₄ à L₃₂ est indépendamment tel que décrit en relation avec L₂₁ ; et
chacun de R₂₃ à R₂₈ est indépendamment tel que décrit en relation avec R₂₁.

18. Dispositif électroluminescent organique selon la revendication 1, dans lequel le composé à base d'amine est choisi parmi les composés illustrés ci-dessous :

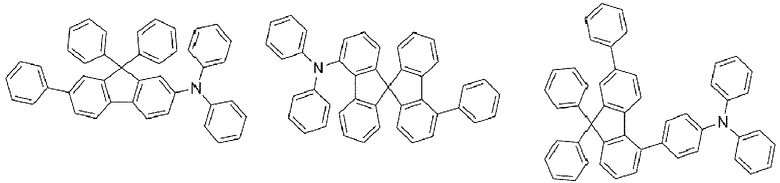

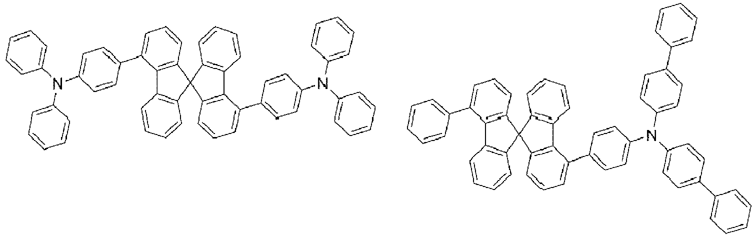

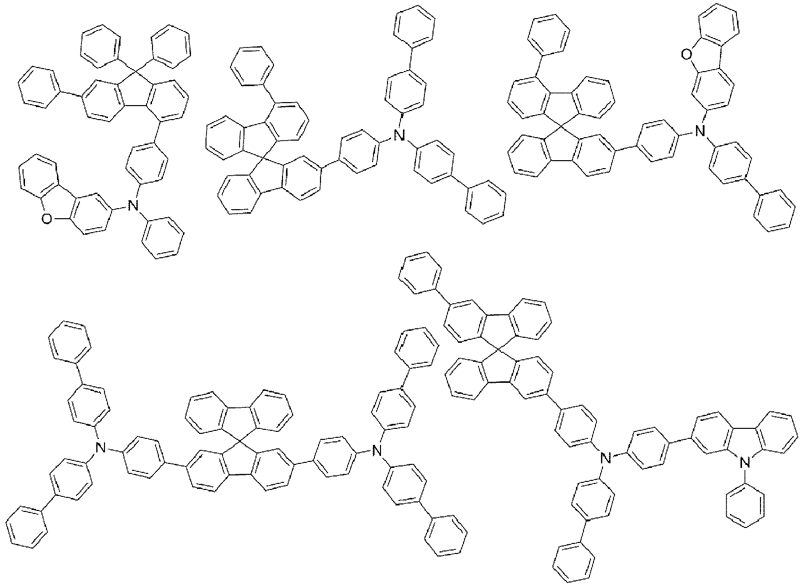

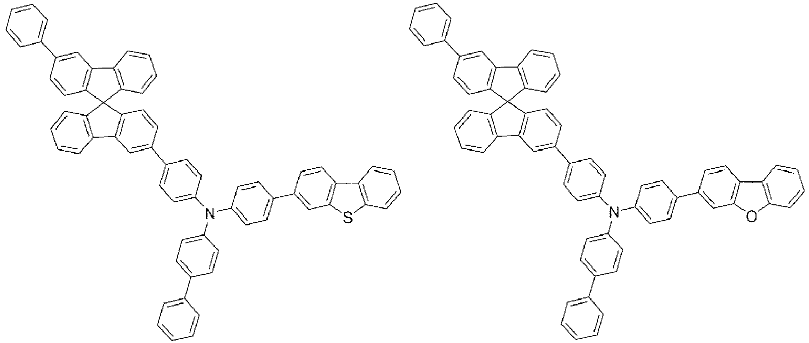

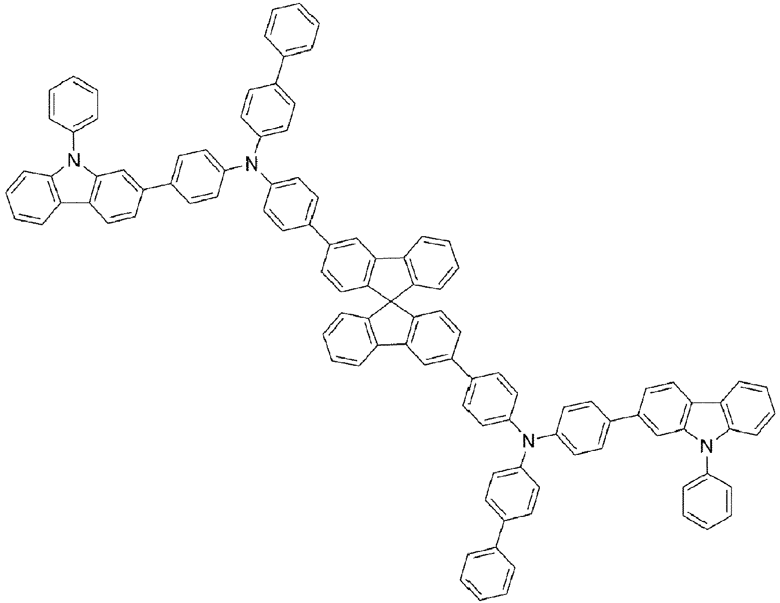

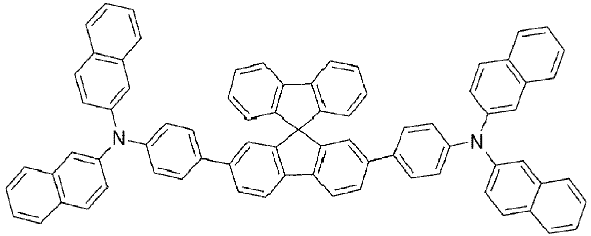

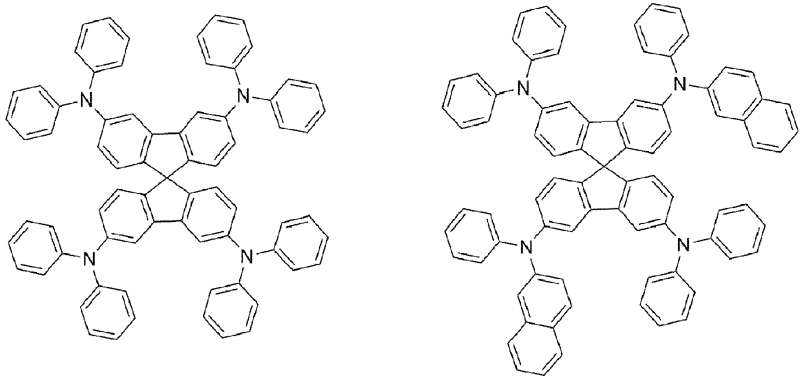

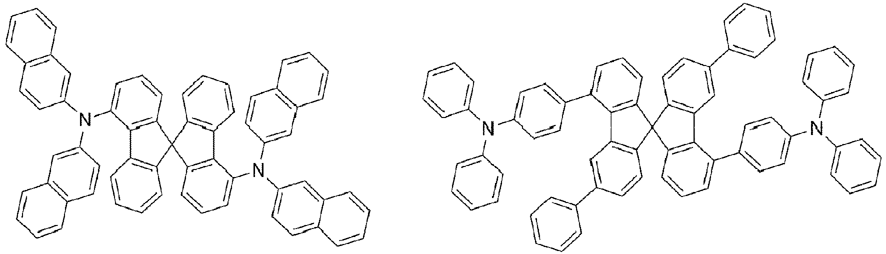

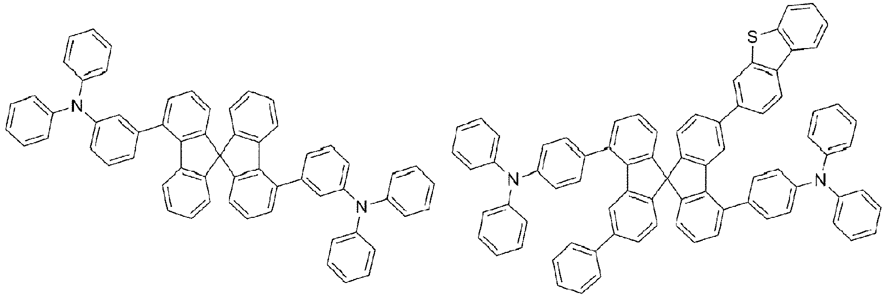

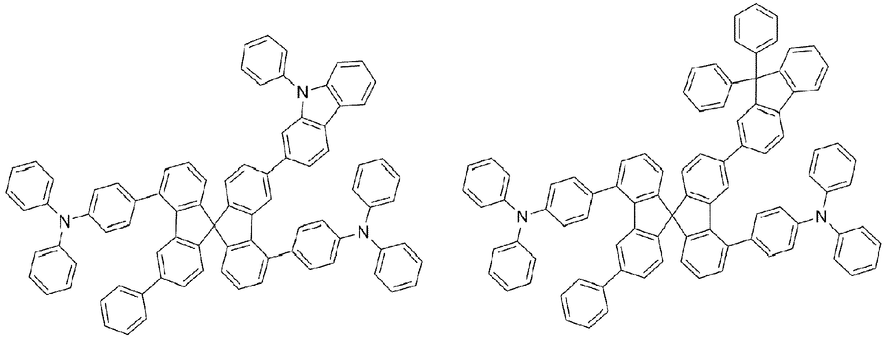

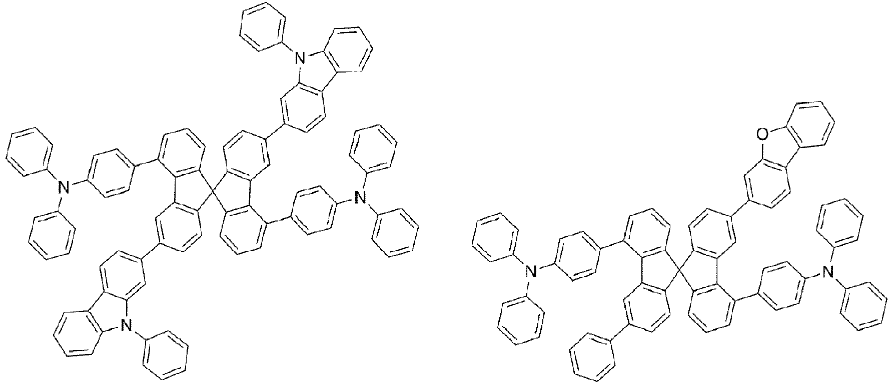

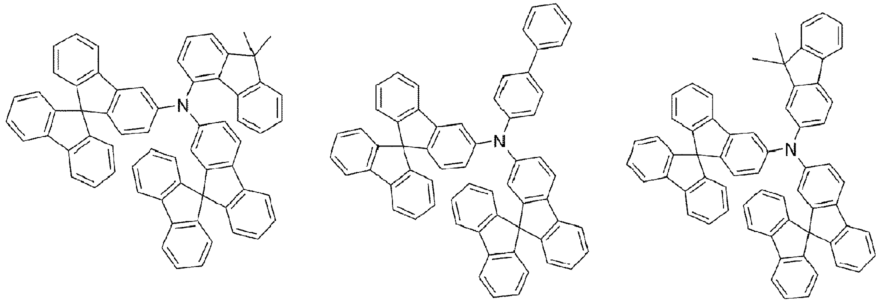

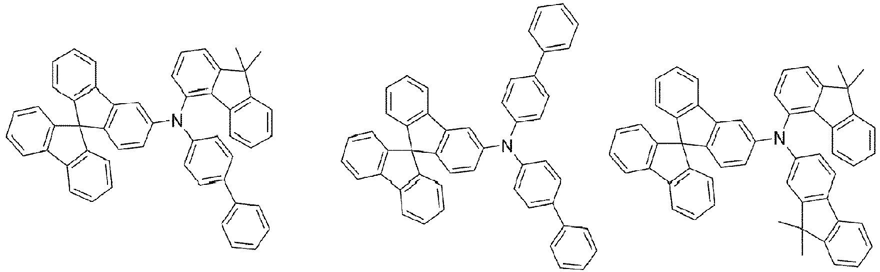

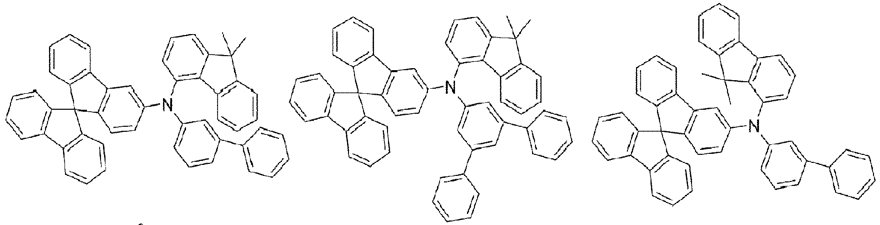

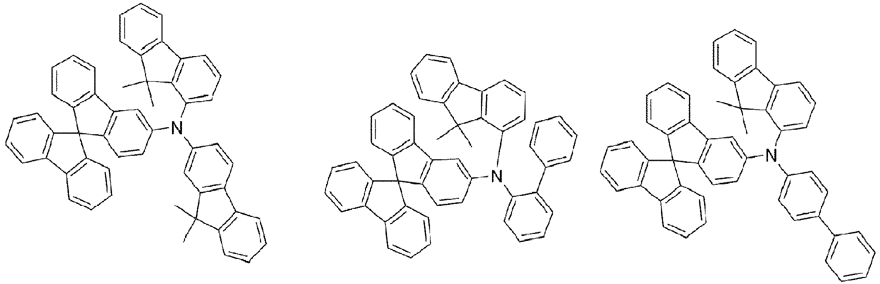

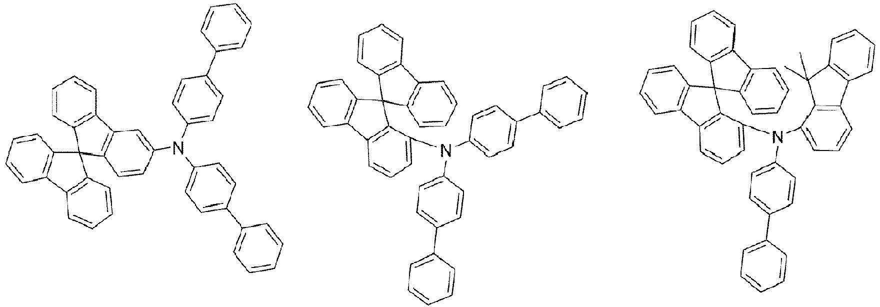

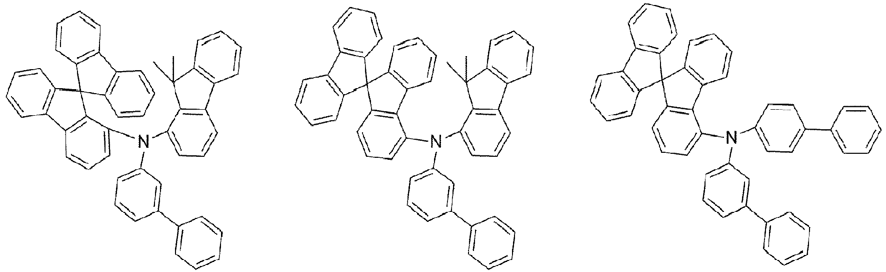

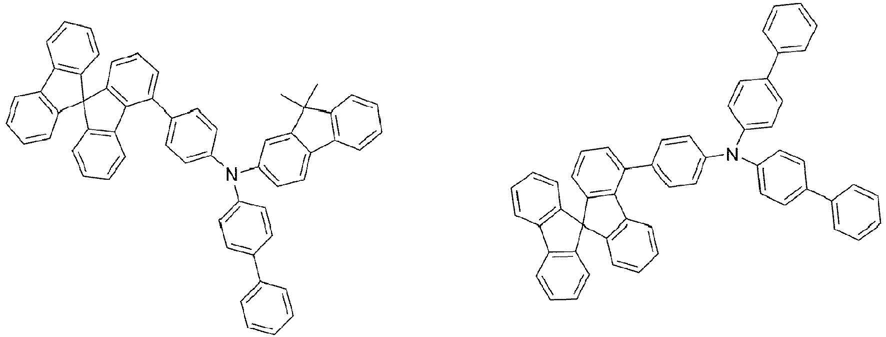

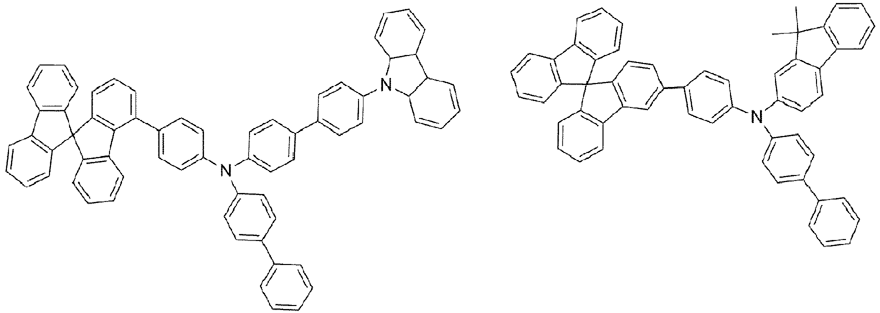

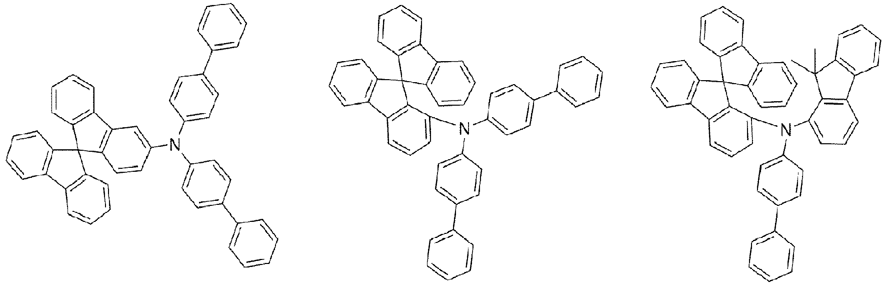

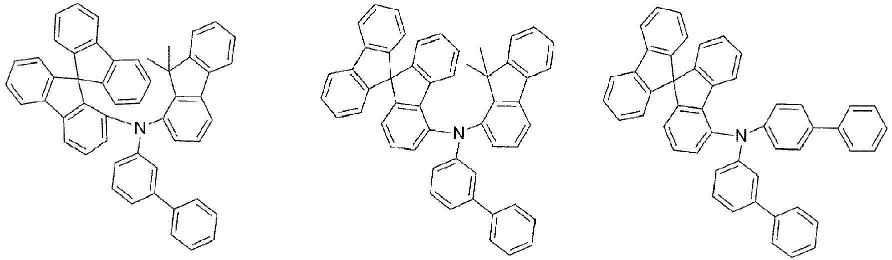

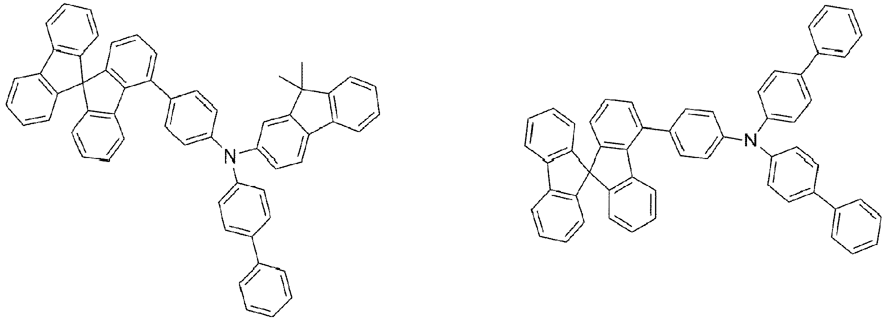

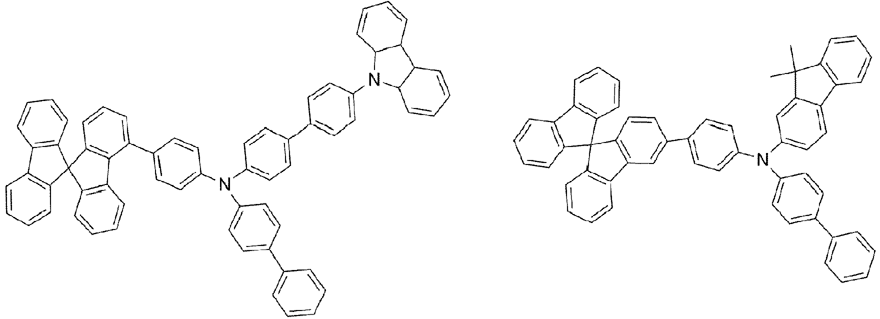

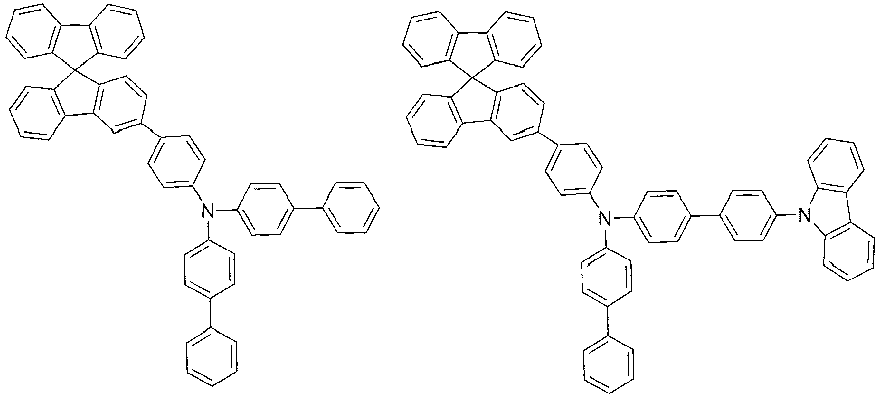

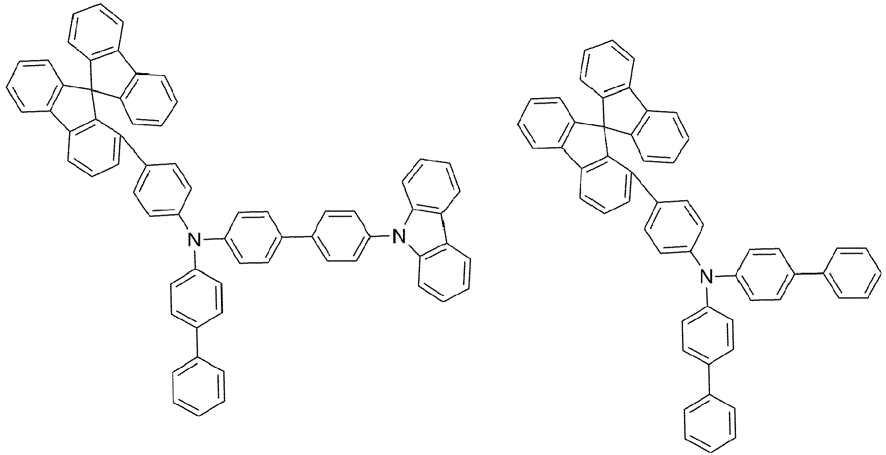

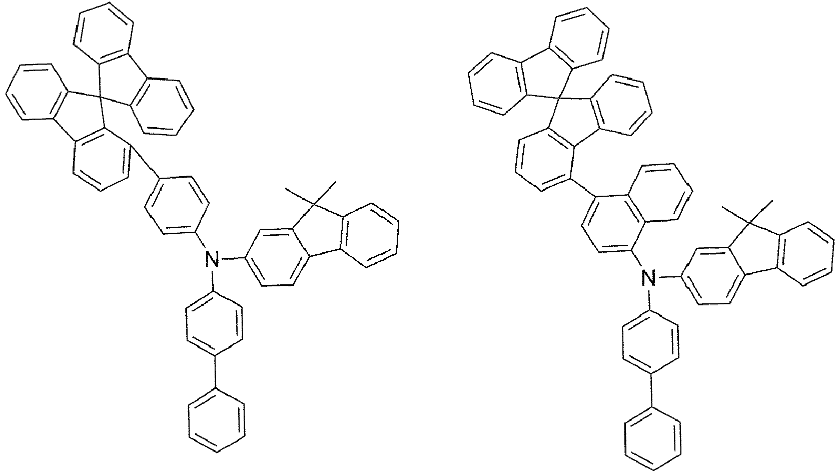

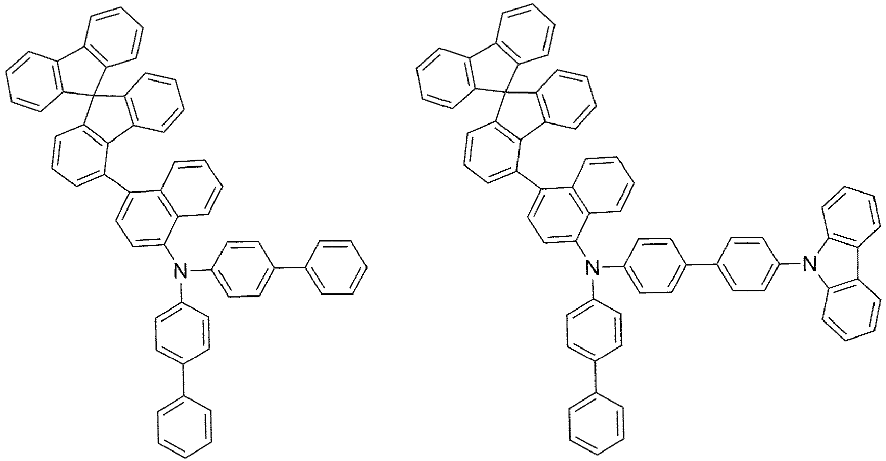

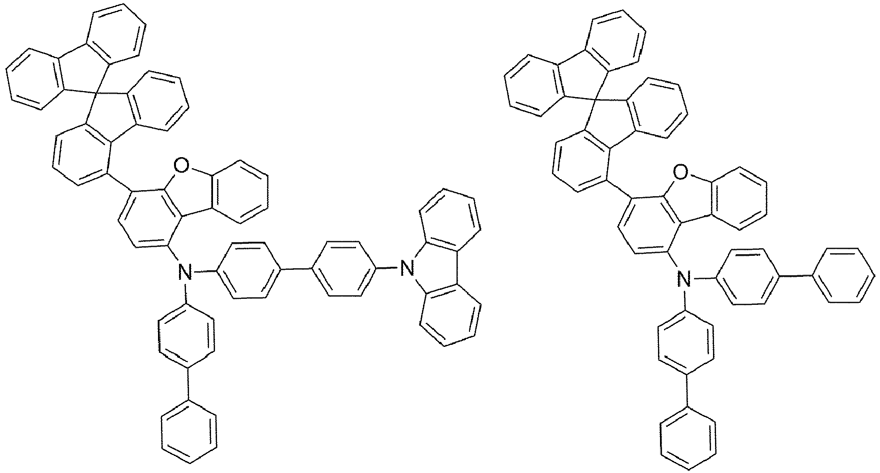

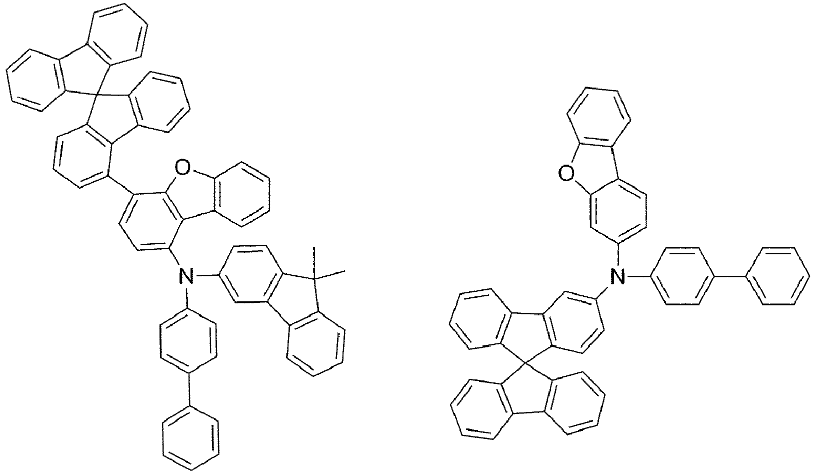

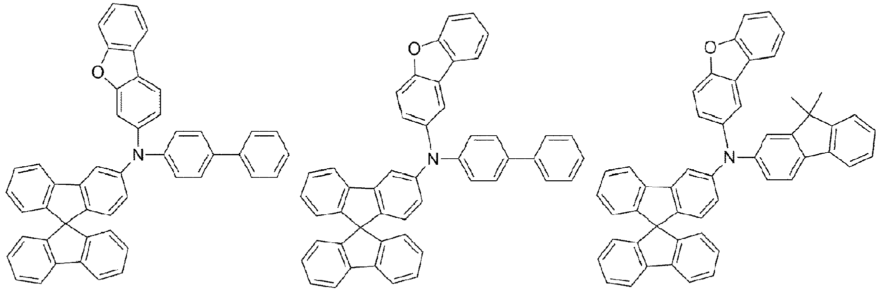

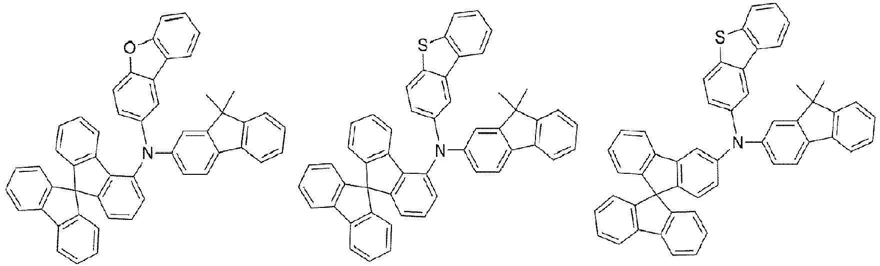

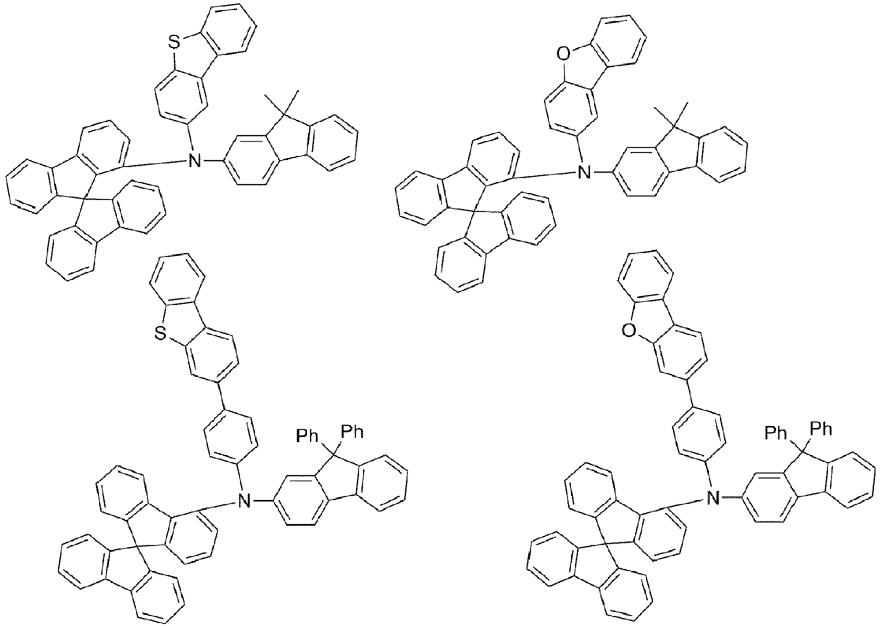

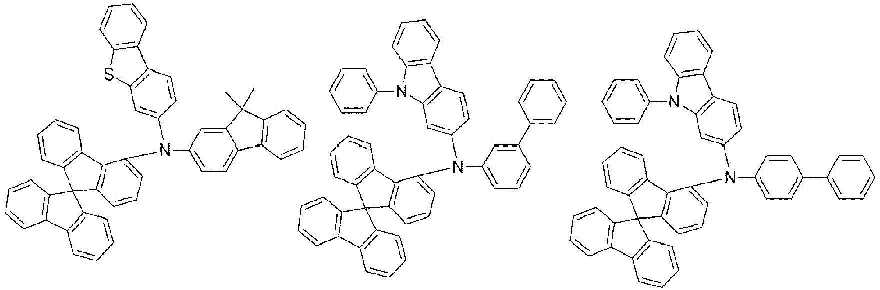

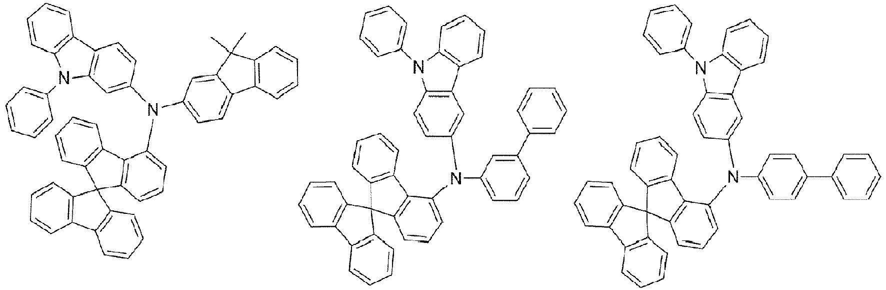

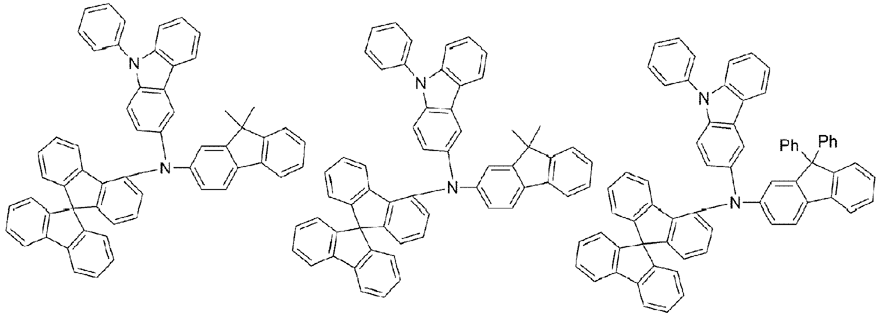

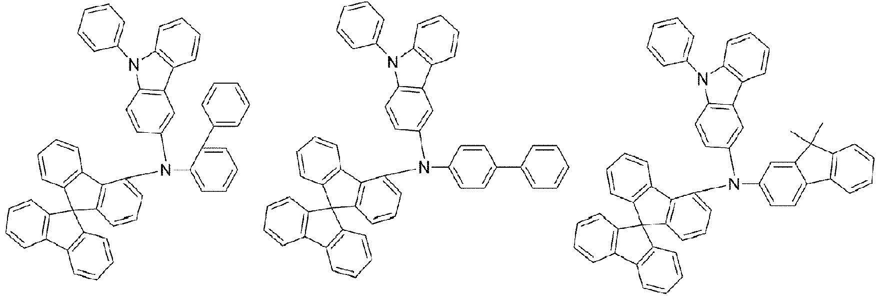

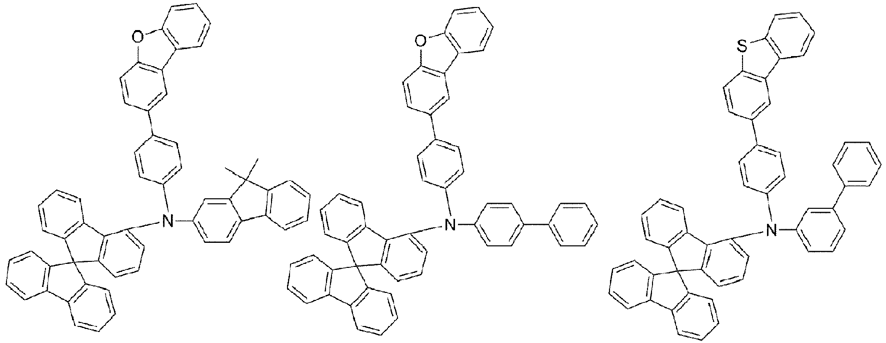

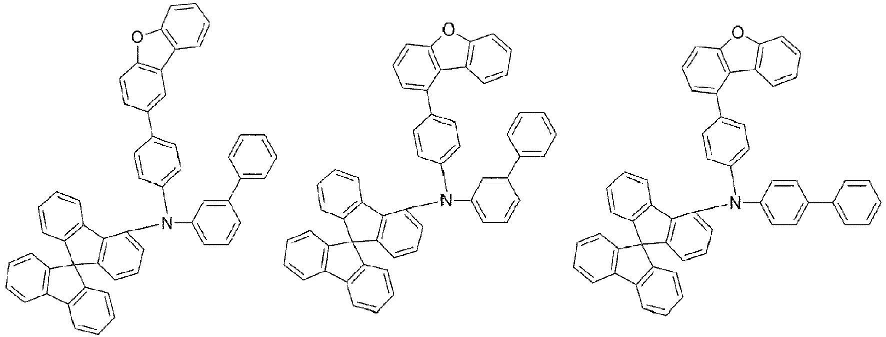

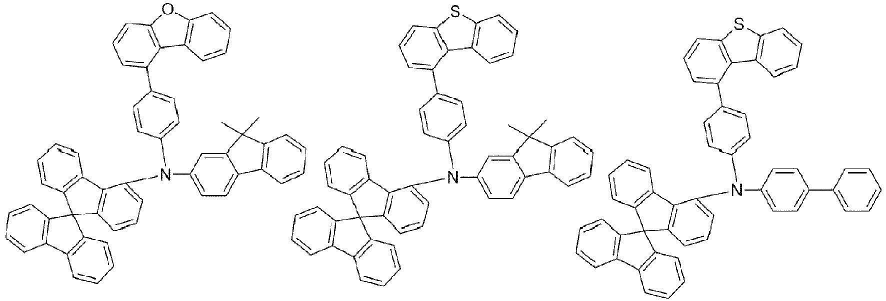

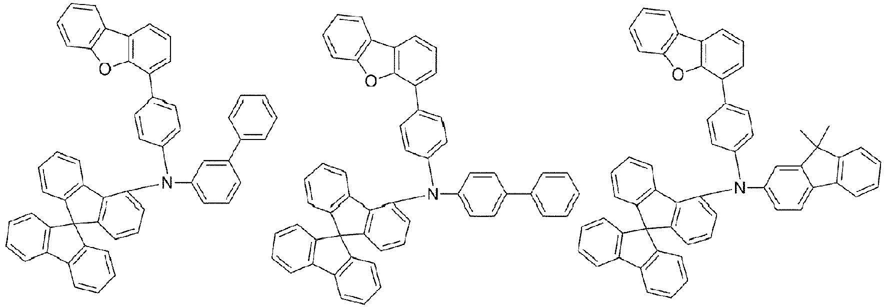

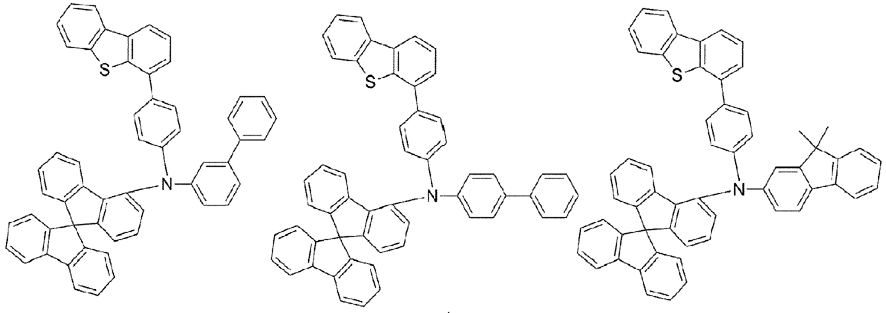

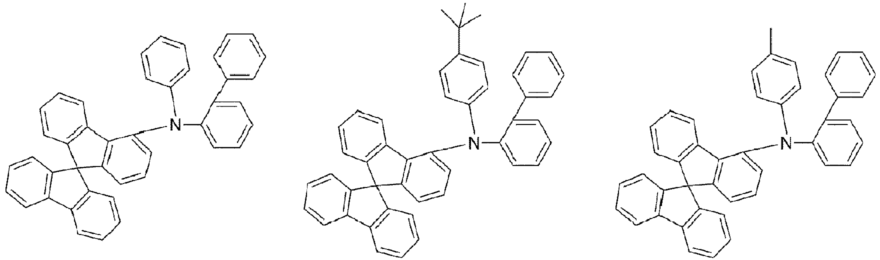

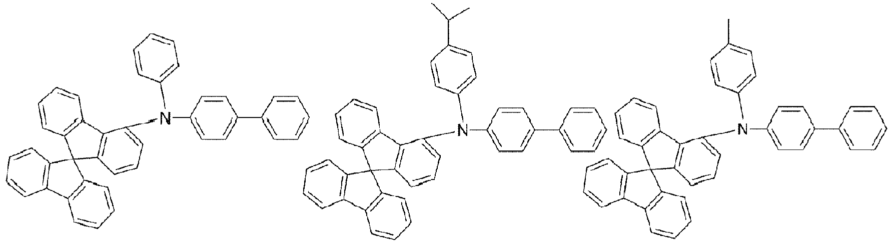

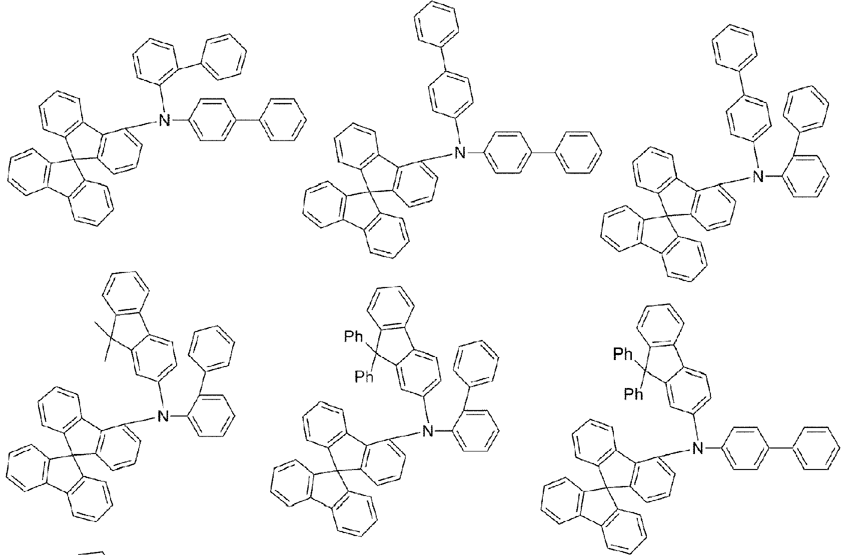

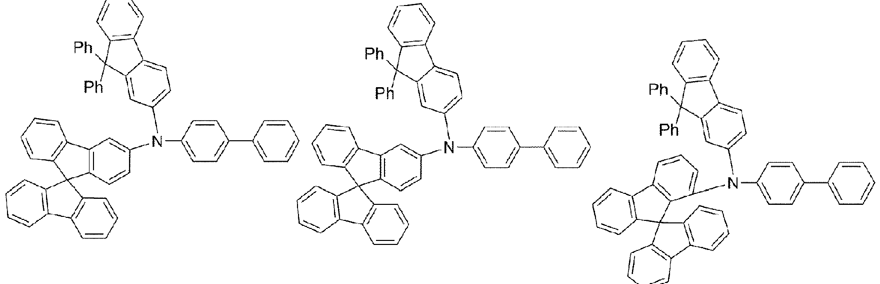

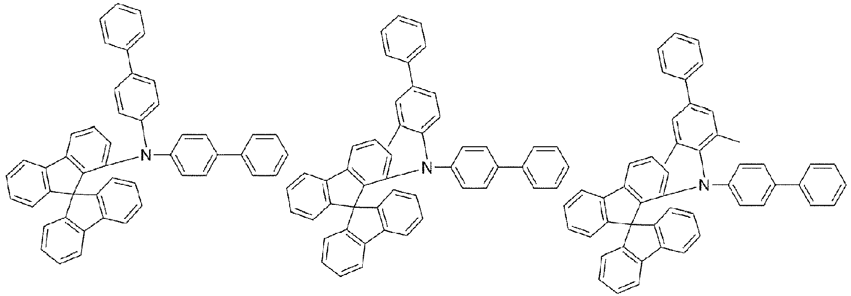

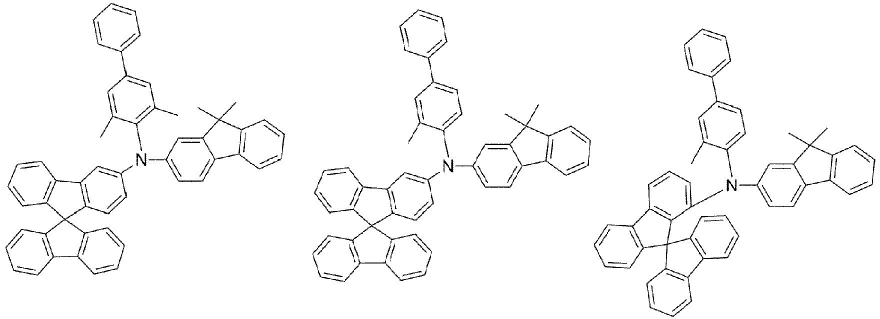

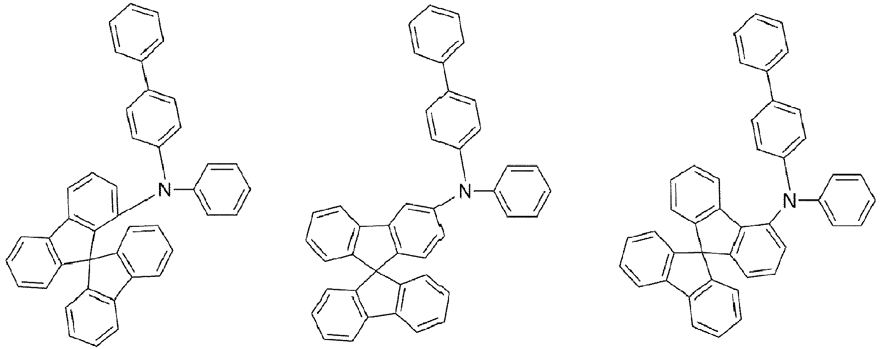

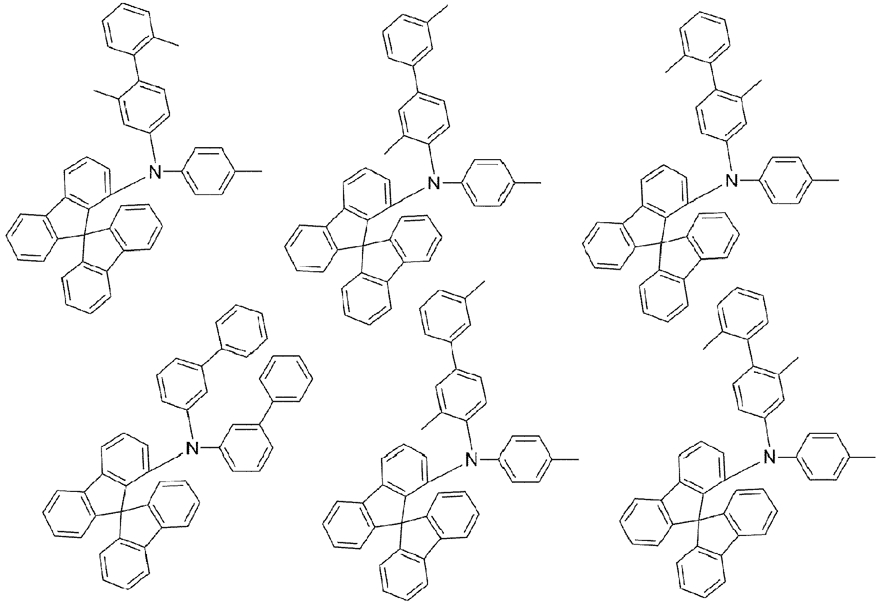

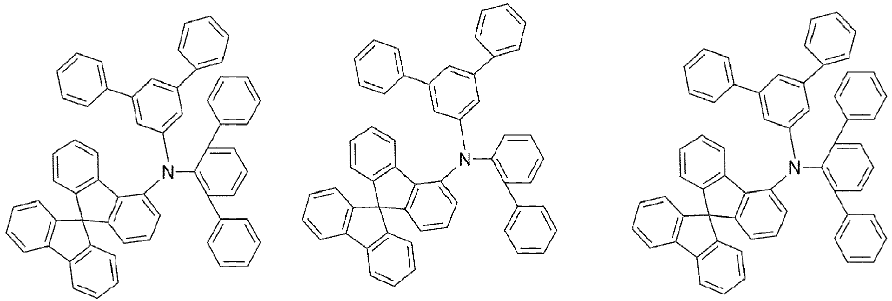

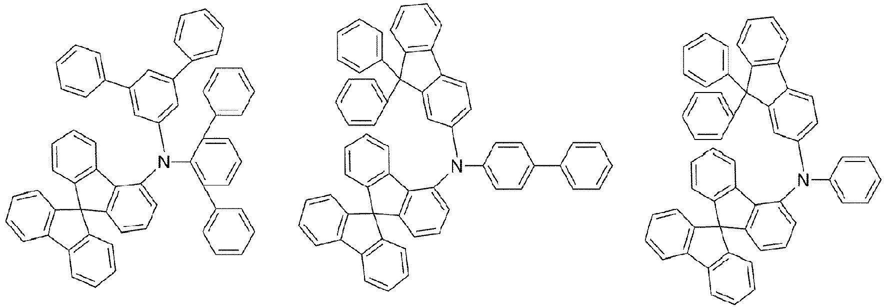

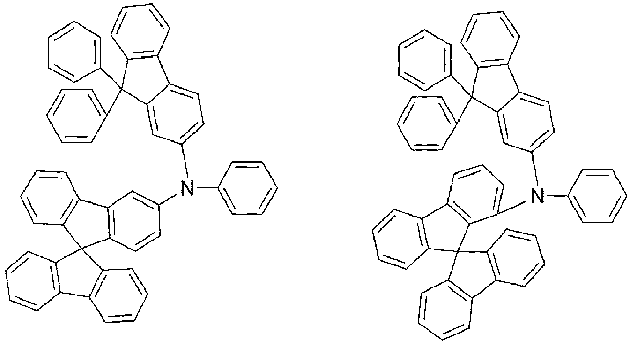

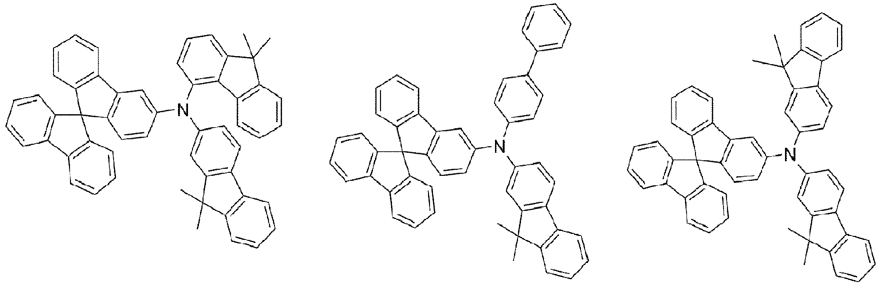

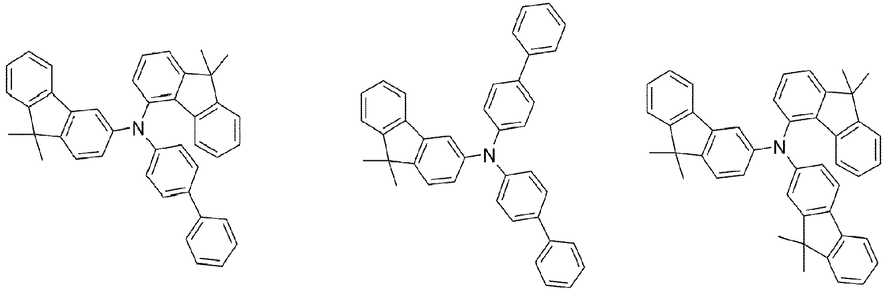

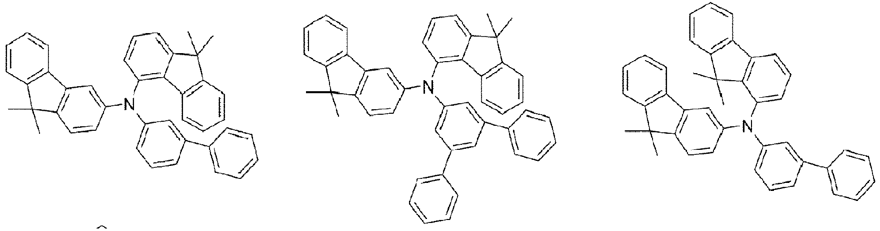

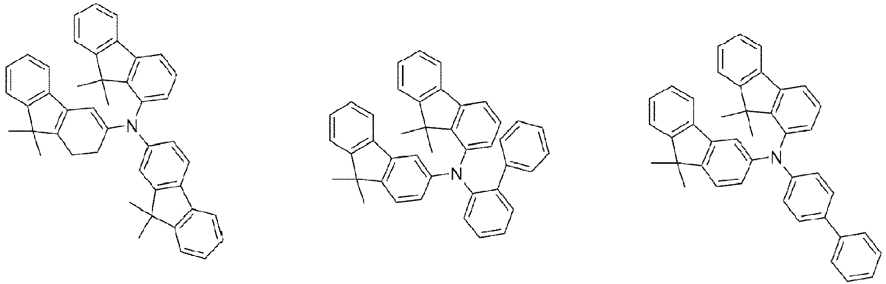

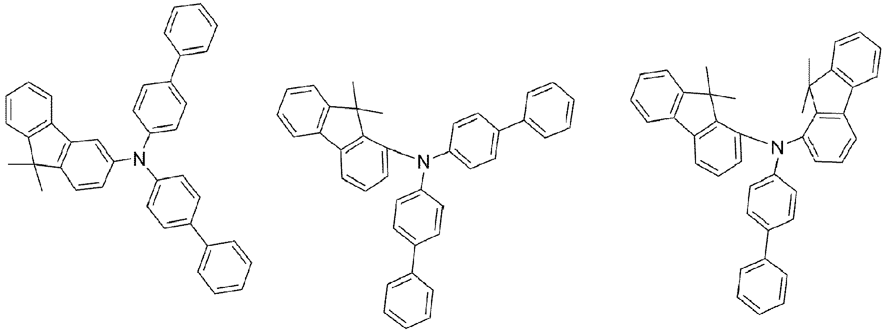

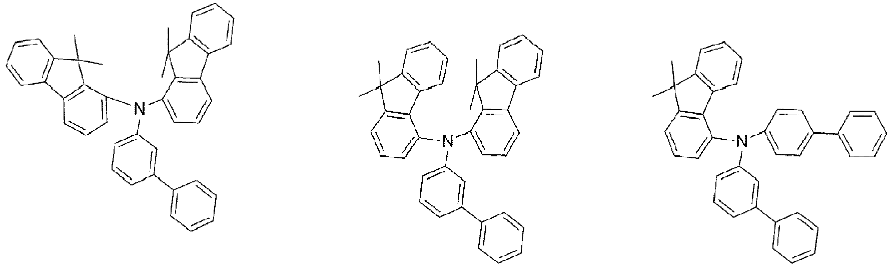

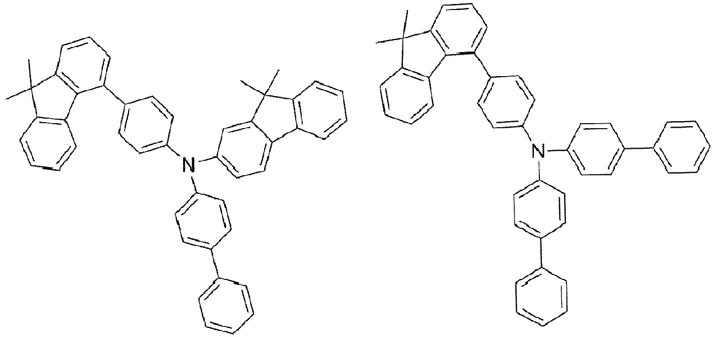

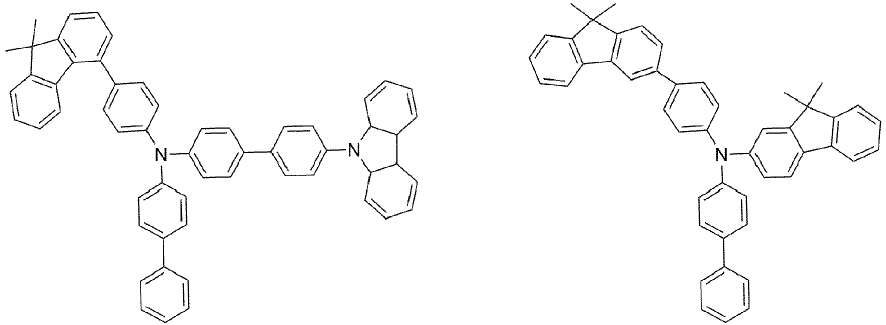

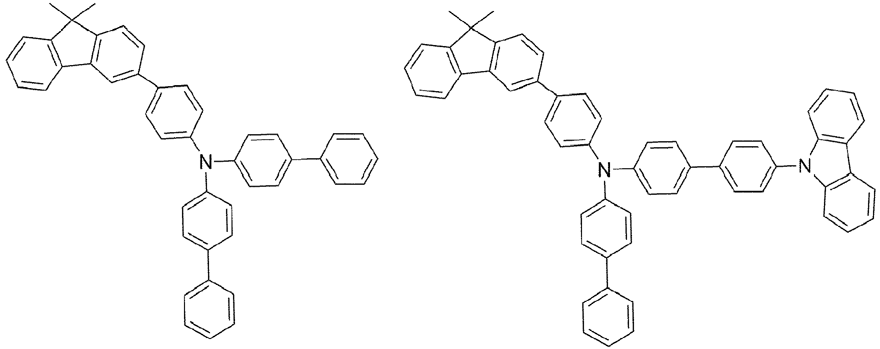

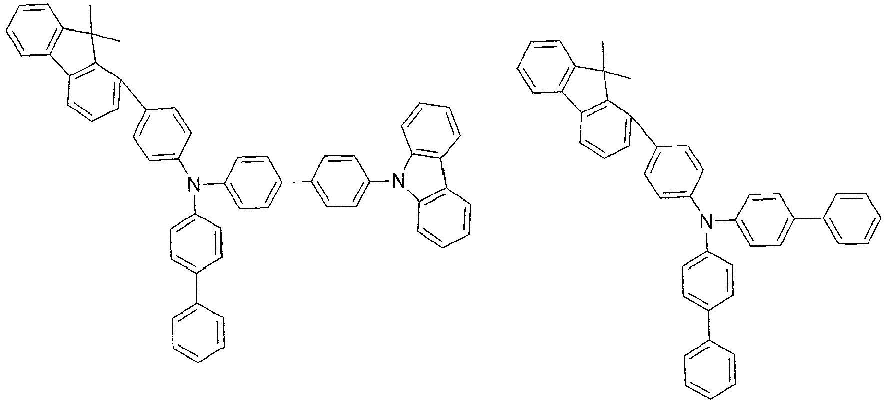

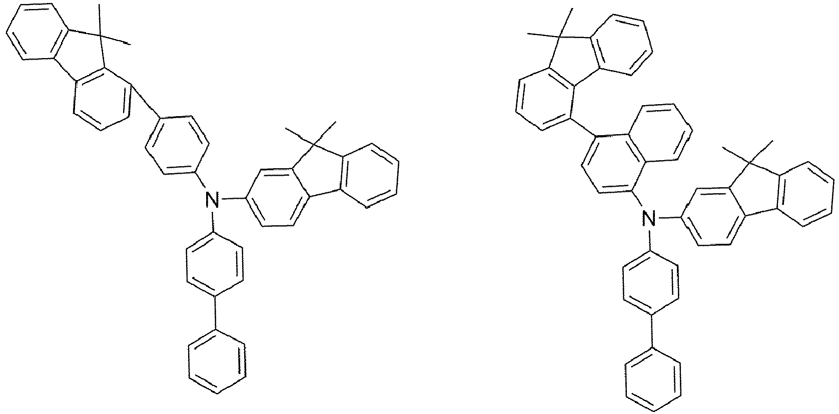

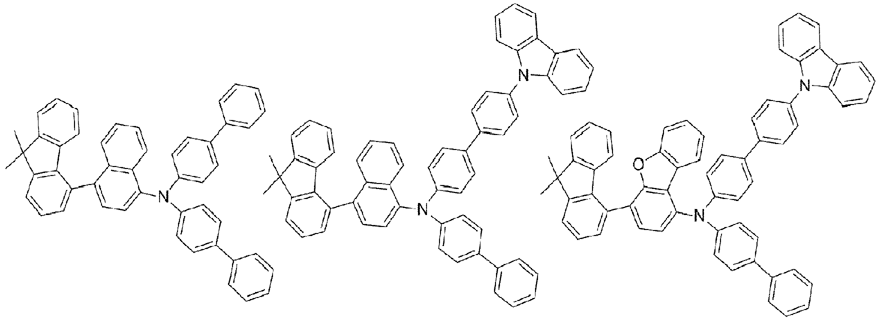

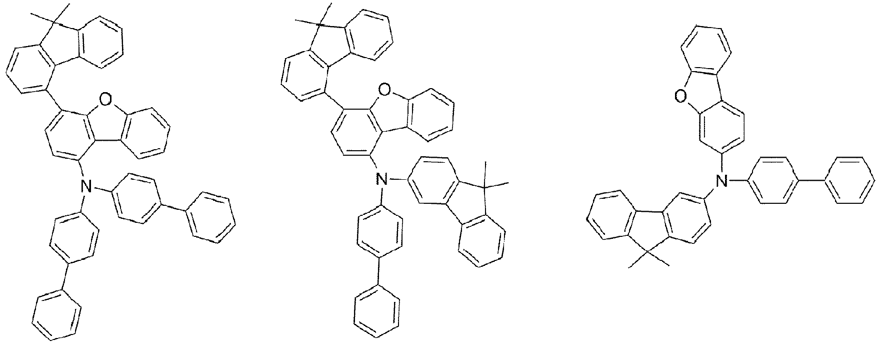

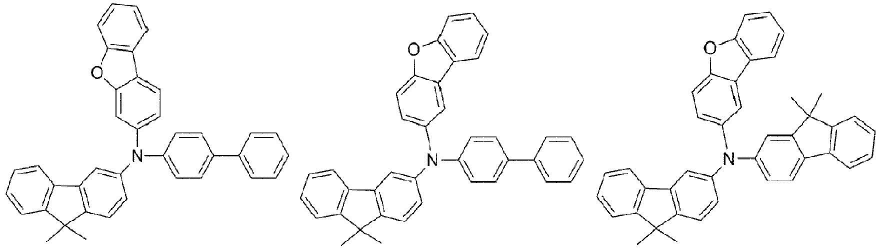

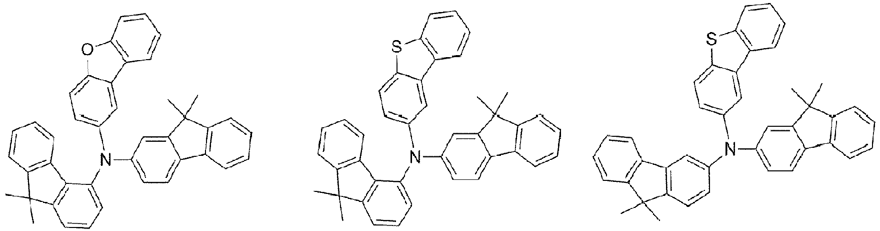

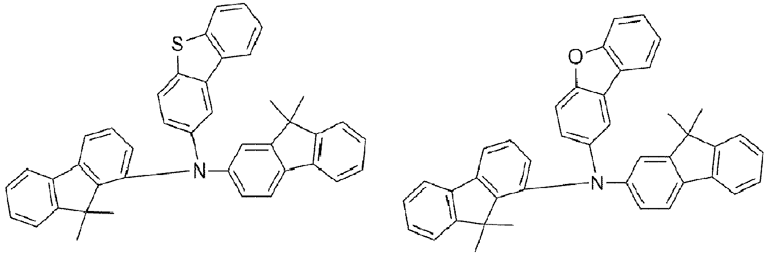

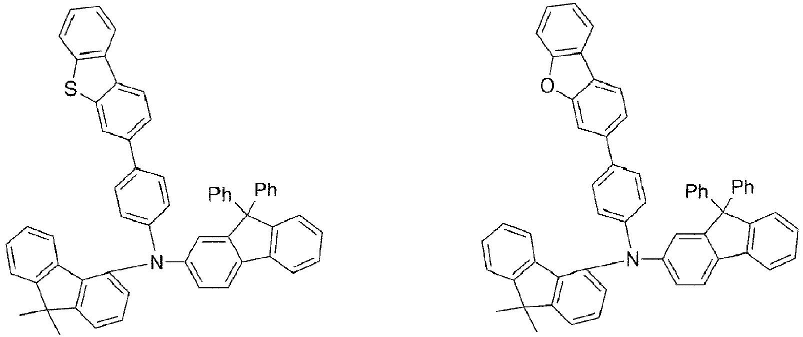

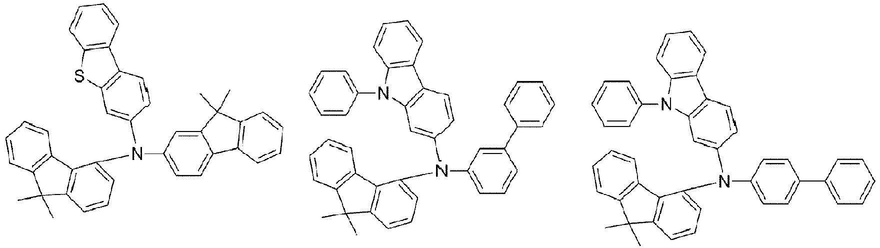

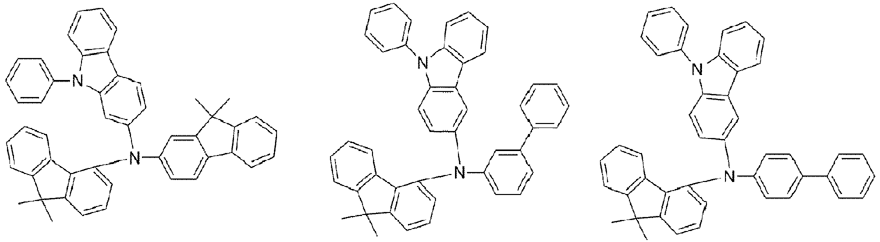

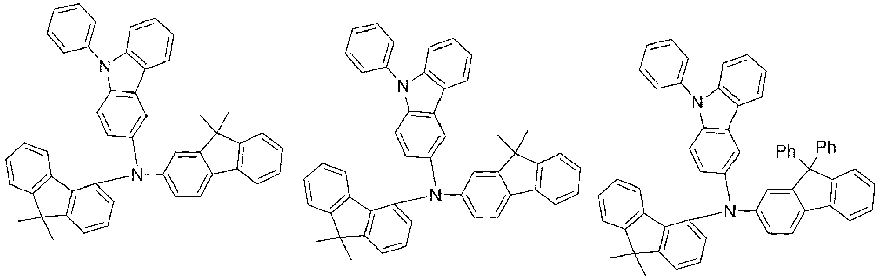

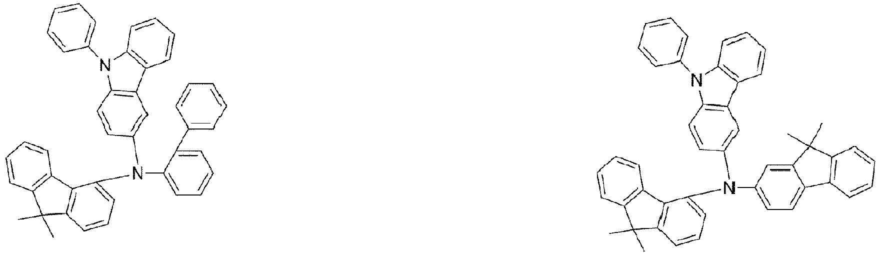

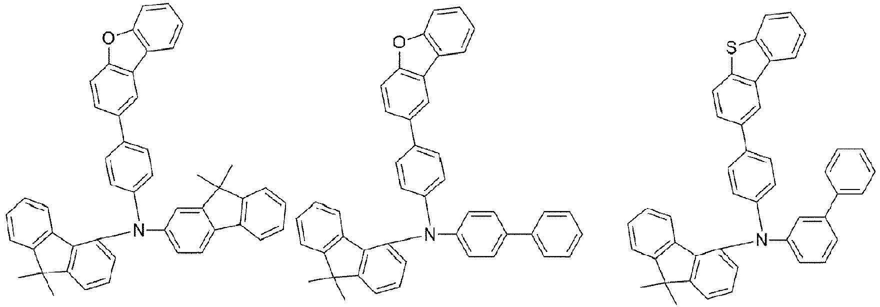

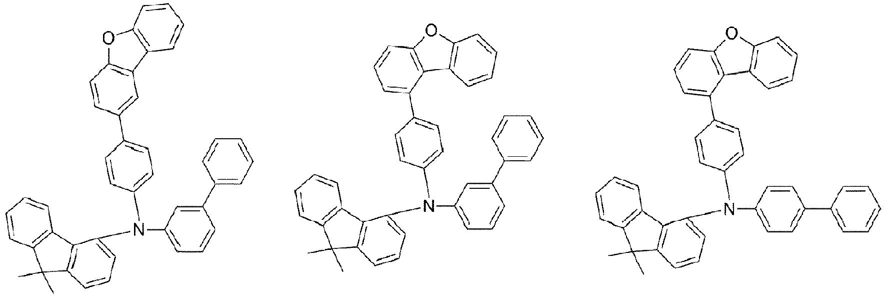

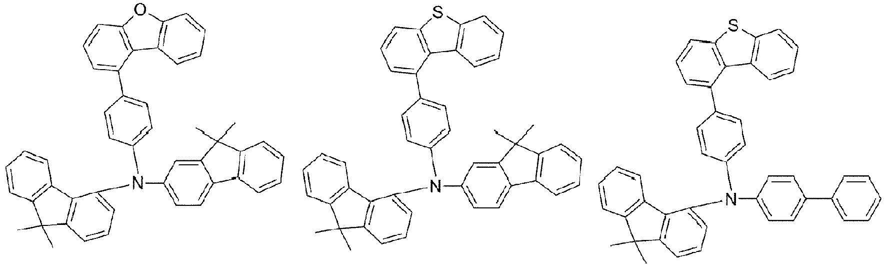

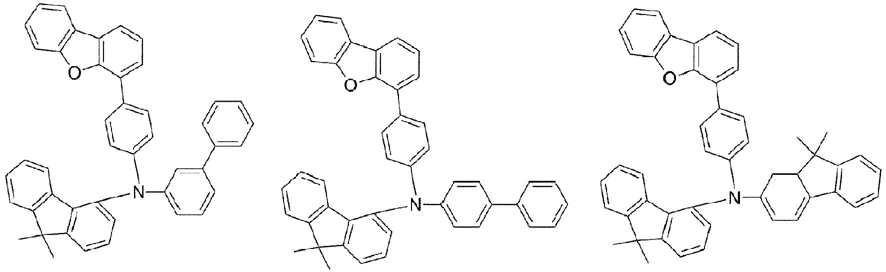

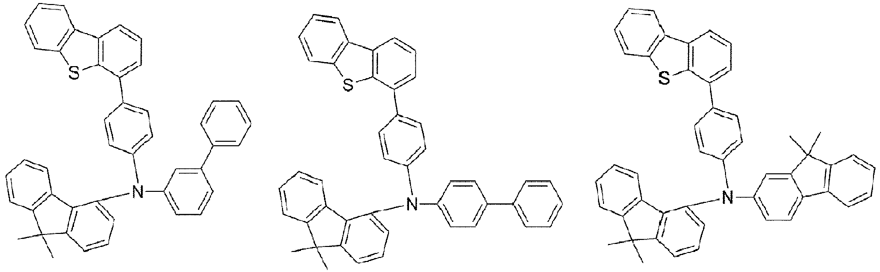

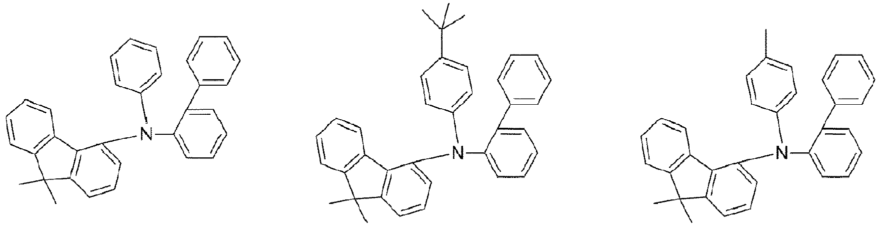

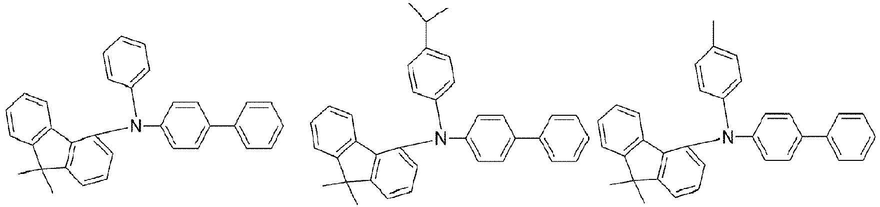

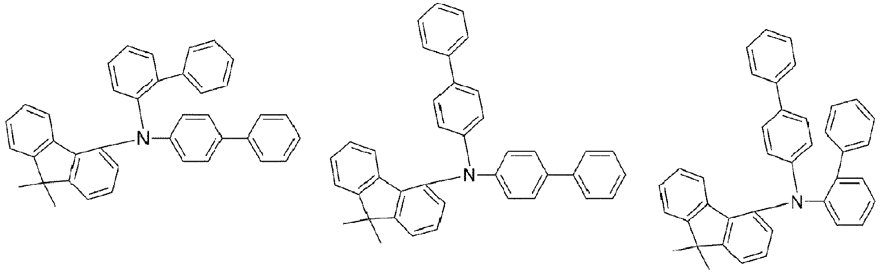

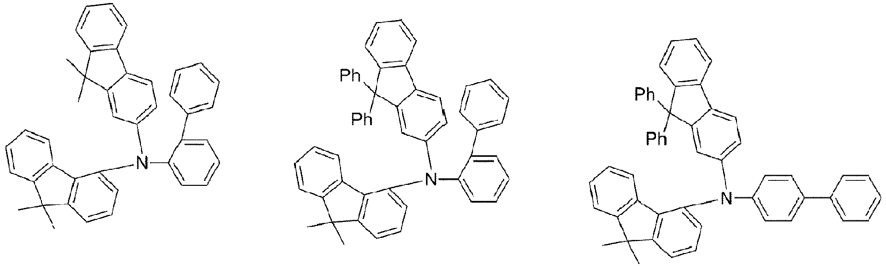

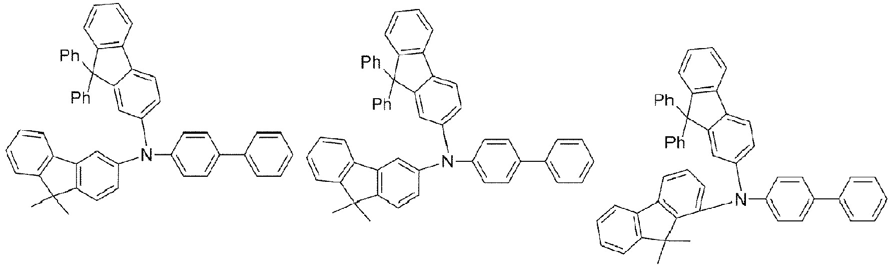

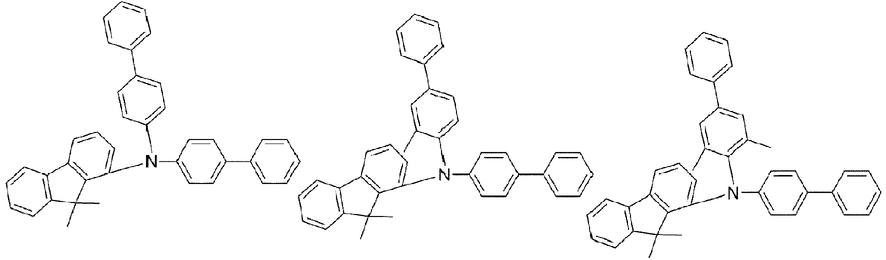

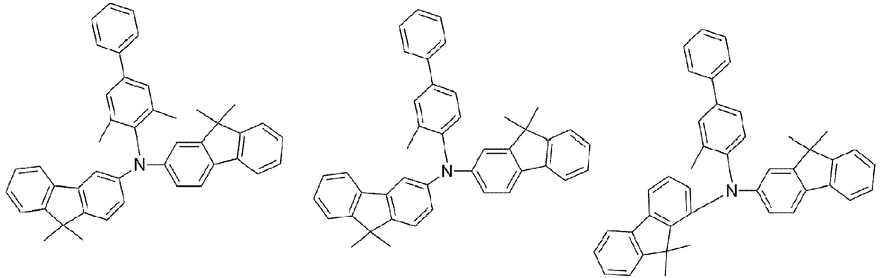

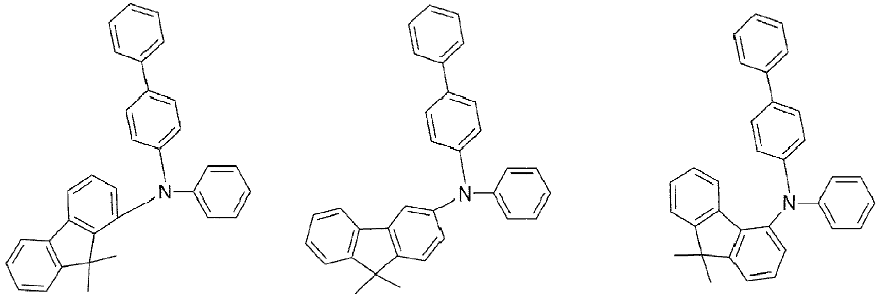

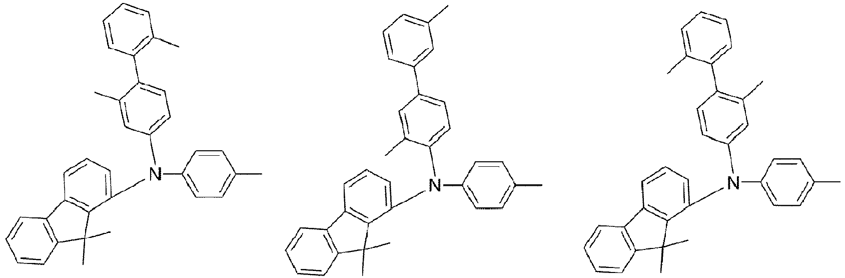

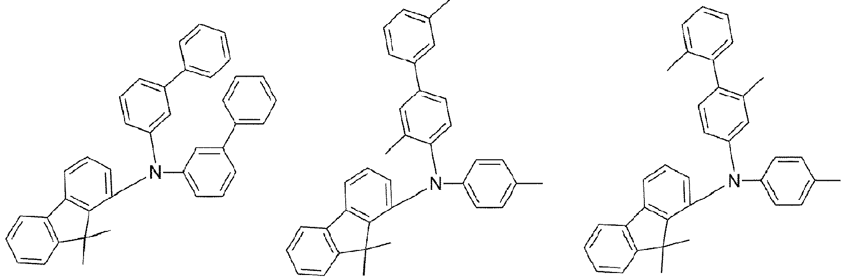

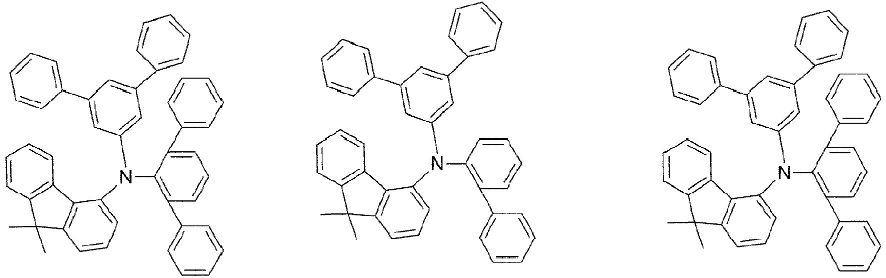

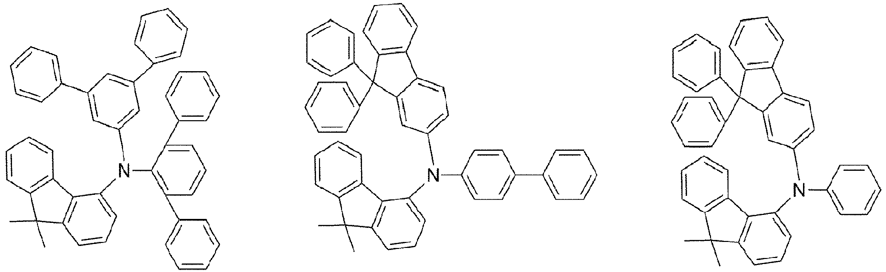

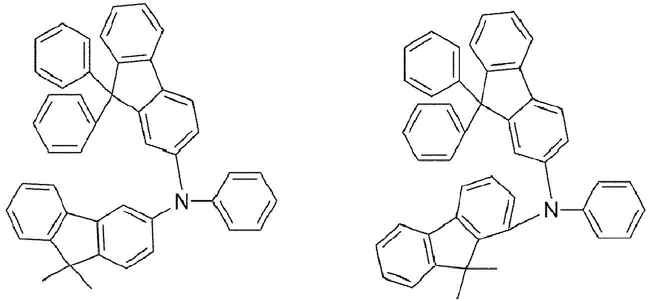

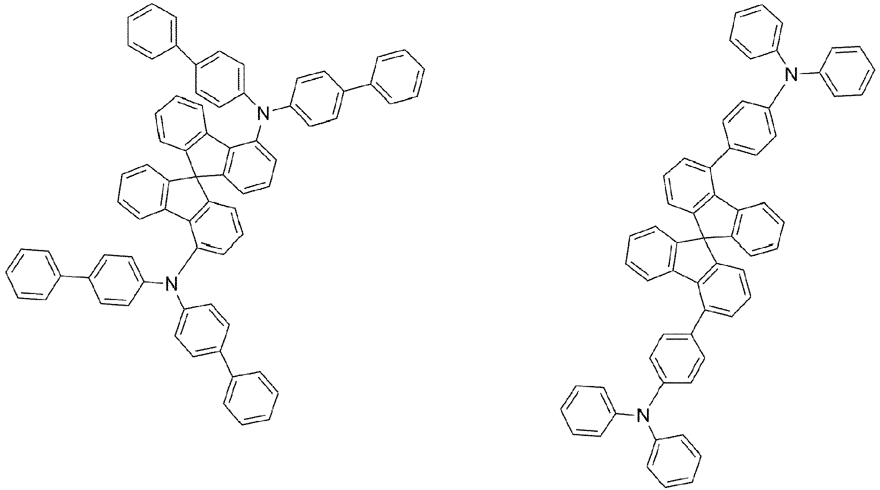

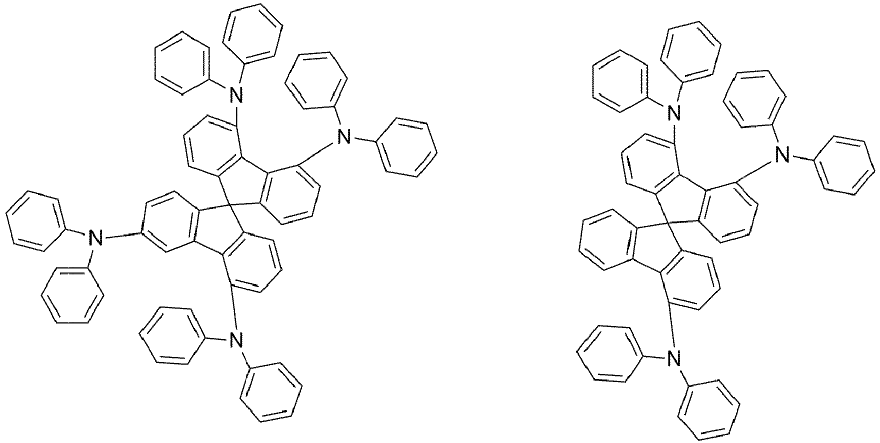

19. Dispositif électroluminescent organique selon la revendication 1, dans lequel la région de transport de trous comprend une couche auxiliaire qui comprend le composé à base d'amine.

20. Dispositif électroluminescent organique selon la revendication 1, dans lequel la couche d'émission est adjacente à la couche auxiliaire.
